(19)

Europäisches
Patentamt
European
Patent Office
Office européen
des brevets

(11) **EP 4 701 366 A1**

(12) **EUROPEAN PATENT APPLICATION**

(43) Date of publication:
**25.02.2026 Bulletin 2026/09**

(21) Application number: **25188599.2**

(22) Date of filing: **31.08.2021**

(51) International Patent Classification (IPC):
*H10D 64/23* (2025.01)      *H10D 30/66* (2025.01)
*H10D 62/10* (2025.01)

(52) Cooperative Patent Classification (CPC):
**H10D 30/66; H10D 8/60; H10D 12/031;**
**H10D 30/665; H10D 30/831; H10D 62/106;**
**H10D 62/393; H10D 62/8325; H10D 64/256;**
**H10D 64/2565; H10D 84/141;** H10D 8/051;
H10D 30/668; H10D 62/127; H10D 62/155;   (Cont.)

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:   **31.08.2020   US 202063072473 P**

(62) Document number(s) of the earlier application(s) in
accordance with Art. 76 EPC:
**21862946.7 / 4 189 744**

(71) Applicant: **GeneSiC Semiconductor Inc.**
**Dulles, VA 20166 (US)**

(72) Inventors:
 • **SUNDARESAN, Siddarth**
   **Dulles, VA 20166 (US)**

 • **SINGH, Ranbir**
   **Dulles, VA 20166 (US)**
 • **PARK, Jaehoon**
   **Dulles, VA 20166 (US)**

(74) Representative: **Marks & Clerk LLP**
   **15 Fetter Lane**
   **London EC4A 1BW (GB)**

Remarks:
 •This application was filed on 09-07-2025 as a
 divisional application to the application mentioned
 under INID code 62.
 •Claims filed after the date of receipt of the divisional
 application (Rule 68(4) EPC).

(54) **DESIGN AND MANUFACTURE OF IMPROVED POWER DEVICES**

(57)     A device is described herein. The device comprises a unit cell on a SiC substrate. The unit cell comprises a gate insulator film, a trench in a well region, a first sinker region having a second conduction type, and a second sinker region having the second conduction type. The first sinker region has a depth that is equal to or greater than a depth of the well region. Each of the first sinker region and the second sinker region is in contact with a region having a first conduction type to form a p-n junction.

FIG. 2A

EP 4 701 366 A1

(52) Cooperative Patent Classification (CPC): (Cont.)
  H10D 62/157; H10D 62/307; H10D 62/328;
  H10D 62/343; H10D 64/411; H10D 64/513;
  H10D 64/518; H10D 64/519; H10D 84/146

**Description**

**CROSS REFERENCE TO RELATED APPLICATIONS**

The present application is related to U.S. Serial No. 16/352,698, filed March 13, 2019, entitled "DESIGN AND MANUFACTURE OF IMPROVED POWER DEVICES"; U.S. Serial No. 16/431,655, filed June 04, 2019, entitled "DESIGN AND MANUFACTURE OF SELF-ALIGNED POWER DEVICES"; U.S. Serial No. 17/342,761, filed June 09, 2021, entitled "DESIGN AND MANUFACTURE OF SELF-ALIGNED POWER DEVICES"; U.S. Serial No. 16/374,025, filed April 03, 2019, entitled "DESIGN AND MANUFACTURE OF POWER DEVICES HAVING INVERSION CHANNEL"; U.S. Serial No. 16/550,249, filed August 25, 2019, entitled "DESIGN AND MANUFACTURE OF ROBUST, HIGH-PERFORMANCE DEVICES"; U.S. Serial No. 17/231,301, filed April 15, 2021, entitled "DESIGN AND MANUFACTURE OF ROBUST, HIGH-PERFORMANCE DEVICES"; U.S. Serial No. 17/242,650, filed April 28, 2021, entitled "DESIGN AND MANUFACTURE OF ROBUST, HIGH-PERFORMANCE DEVICES"; U.S. Serial No. 16/777,928, filed January 31, 2020, entitled "IMPROVED PERFORMANCE SIC SCHOTTKY DIODES"; U.S. Serial No. 17/099,305, filed November 16, 2020, entitled "IMPROVED PERFORMANCE SIC SCHOTTKY DIODES"; U.S. Serial No. 16/670,963, filed October 31, 2019, entitled "SILICON CARBIDE POWER DEVICES"; U.S. Serial No. 16/741,800, filed January 14, 2020, entitled "SILICON CARBIDE POWER DEVICES"; U.S. Serial No. 16/945,781, filed July 31, 2020, entitled "DESIGN AND MANUFACTURE OF POWER DEVICES HAVING INCREASED CROSS OVER CURRENT"; U.S. Serial No. 17/227,897, filed April 12, 2021, entitled "DESIGN AND MANUFACTURE OF POWER DEVICES HAVING INCREASED CROSS OVER CURRENT"; U.S. Serial No. 17/227,921, filed April 12, 2021, entitled "DESIGN AND MANUFACTURE OF POWER DEVICES HAVING INCREASED CROSS OVER CURRENT"; U.S. Serial No. 17/227,936, filed April 12, 2021, entitled "DESIGN AND MANUFACTURE OF POWER DEVICES HAVING INCREASED CROSS OVER CURRENT"; U.S. Serial No. 17/227,951, filed April 12, 2021, entitled "DESIGN AND MANUFACTURE OF POWER DEVICES HAVING INCREASED CROSS OVER CURRENT"; and U.S. Serial No. 17/007,014, filed August 31, 2020, entitled "INVERSION CHANNEL DEVICES ON MULTIPLE CRYSTAL ORIENTATIONS". This application claims priority from the provisional application U.S. Serial No. 63/072,473, filed August 31, 2020, entitled "POWER DEVICES"; and the above-mentioned applications and the disclosure of the above-mentioned applications are herein incorporated by reference in their entirety.

**FIELD OF THE INVENTION**

This invention relates to power semiconductor devices using a vertical silicon carbide (SiC) Double-Implantation Metal oxide semiconductor field-effect transistor (DMOSFET). A power metal oxide semiconductor field-effect transistor (MOSFET) is a specific type of MOSFET designed to handle significant power levels.

Further, this invention relates to 4H-SiC devices, which include diodes and transistors having inter-digitated n-type and P-Type areas such as Junction Barrier Schottky (JBS) diodes, Merged PiN/Schottky (MPS) diodes, Metal oxide semiconductor field effect transistors (MOSFETs) and Junction field effect transistors (JFETs) having inter-digitated N-Type and P-Type areas.

**BACKGROUND OF INVENTION**

Silicon based power devices have long dominated power electronics and power system applications. On the other hand, SiC is a wider bandgap (Eg) material with Eg = 3.3 eV as compared to silicon (Eg = 1.1 eV); therefore, SiC has a higher blocking voltage than Si. SiC has a higher breakdown electric field ($3 \times 10^6$ V/cm to $5 \times 10^6$ V/cm) compared to Si (breakdown electric field for Si is $0.3 \times 10^6$ V/cm) and is a better thermal conductor (3.7 (W/cm-K) for SiC versus 1.6 (W/cm-K) for Si). SiC has been a material of choice for power MOSFETs. However, "[e]ven with the successful introduction of SiC power MOSFETs into the commercial market place, several key reliability issues have not been fully resolved." [Source: Key Reliability Issues for SiC Power MOSFETs, A. Lelis, D. Habersat, R. Green, and E. Mooro of the U.S. Army Research Laboratory, published in ECS Transactions, 58 (4) 87-93 (2013), DOI: 10.1149/05804.0087ecst].

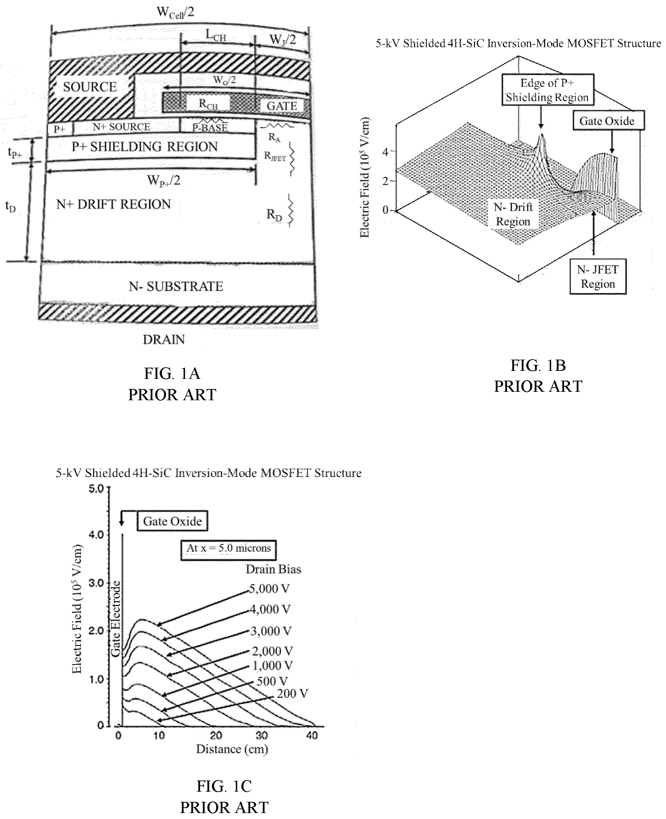

SiC exists in a kind of polymorphic crystalline building known as a polytype, e.g., 3C-SiC, 4H-SiC, 6H-SiC. Fig. 1A is the prior art SiC DMOSFET structure reported by B.J. Baliga in Advanced High-Voltage Power Device Concepts (Springer Press, 2011). Fig. 1B shows the electric field contours simulated for the prior art SiC DMOSFET structure of Fig. 1A. The electric field distribution near the surface of the 5-kV shielded 4H-SiC inversion-mode power MOSFET structure is shown in Fig. 1B to allow examination of the electric field in the junction gate field-effect transistor (JFET) region and the gate region. The sharp peak of the electric field at the edge of the P+ shielding region can be observed in this prior art device which will result in a high electric field in the gate oxide, thereby resulting in a poor performance of this MOSFET device. Fig. 1C shows the electric field distribution in the shielded 4H-SiC inversion-mode MOSFET. The simulated results in the figure show an electric field as high as 4 MV/cm in the gate oxide for the prior art SiC DMOSFET structure of Fig. 1A.

A typical SiC MOSFET device structure such as that shown in Fig. 1A results in high electric field concentration at the corner of the p-well region, which results in a high electric field in the gate oxide layer, especially during high drain bias (blocking mode) operation. The high critical electric fields for breakdown in 4H-SiC ($\approx$ 3 MV/cm) results in a very high (> 5 MV/cm) electric field in the gate oxide. Fowler-Nordheim tunneling currents are observed at such high electric fields in the gate oxide, which can result in trapped charge in the gate oxide, which leads to poor device reliability.

The manufacturing processes for Si uses techniques like diffusion of dopants but these conventional manufacturing processes are not possible for making SiC device because the diffusion coefficients in SiC are negligible at temperatures below 1800 °C. SiC devices are manufactured by ion implantation of both source and p-well regions but ion implantation and deep ion implantation is difficult in SiC. Therefore, there is a long-felt need for improved power devices that address the reliability issues for SiC power MOSFETs.

Further, Due to the limited (10-25 cm2/Vs) MOS channel mobility achievable on the state-of-the-art SiC planar DMOSFETs, it is necessary to form MOS channels with sub-micron channel lengths so that the overall ON resistance of the power MOSFET is not significantly degraded. "[I]f the p-well regions and N+ source regions were formed using different masks, the misalignment of two masks would result in a different channel length on each side of the cell. To avoid the decrease of threshold voltage (Vth) and degrade the breakdown voltage (Vbr), the N+ mask is in a self-aligned fashion with respect to the P-well." [source: Design and Fabrication of 1.2kV 4H-SiC DMOSFET by R. Huang et al. published in 2016 13th China International Forum on Solid State Lighting: International Forum on Wide Bandgap Semiconductors China (SSLChina: IFWS)]. The MOSFET channel region is formed as a result of the offset between the p-well and the N+ source regions in a DMOSFET structure. If the p-well and N+ source regions are formed by two separate masking steps, there will inevitably be a certain amount of lithographic misalignment between these levels, resulting in different (or asymmetric) MOS channel lengths on the two sides of the unit cell. The lithographic misalignment between two masking levels using projection lithography techniques typically used in high-volume semiconductor manufacturing can range from +/- 0.05 $\mu$m to +/- 0.2 $\mu$m or greater, which sets a lower limit on the practically realizable MOS channel lengths without significant asymmetry. For a target channel length of 0.5 $\mu$m, a +/- 0.2 $\mu$m mis-alignment between the N+ source and p-well masking steps can result in a MOS channel length of 0.3 $\mu$m on one side of the unit cell and a MOS channel length of 0.7 $\mu$m on the other side of the unit cell. While the ON resistance of the MOSFET is increased at higher MOS channel lengths, lower than optimal MOS channel lengths can result in undesirable effects such as gate threshold voltage (Vth) degradation and other short-channel effects such as drain-induced barrier lowering (DIBL).

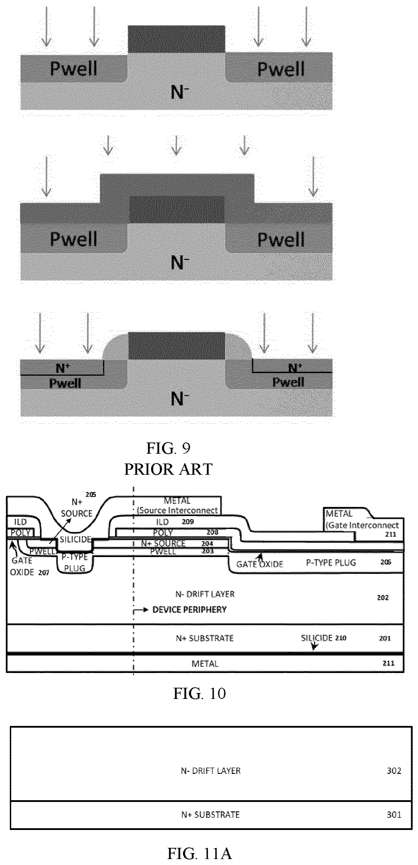

Self-aligned techniques for eliminating the misalignment between p-well and N+ source regions have been proposed in the literature. Self-aligned MOS channel formation with channel length defined by sidewall spacer deposition and etching is one such technique. Fig. 9 is the prior art process flow of self-aligned implantation technique with channel length defined by sidewall spacer deposition and etching as reported by R. Huang et al. in "Design and Fabrication of 1.2 kV 4H-SiC DMOSFET".

Further, "[W]hile SiC power MOSFETs share many similarities to silicon MOSFETs, many challenging differences remain. In particular, the wide-bandgap nature of 4H-SiC (EG=3.26 eV) is both a blessing and a curse, bringing a low intrinsic carrier concentration and a high critical electric field, while presenting challenges with inversion-layer mobility and reliability in passivating dielectric layers." [Source: Challenges in SiC Power MOSFET Design by Kevin Matocha of the GE Global Research Center - Semiconductor Technology Laboratory, Niskayuna, NY USA, published in ISDRS 2007, December 12-14, 2007, College Park, MD, USA]

In a typical SiC planar MOSFET structure as shown in Fig. 1A the metal oxide semiconductor (MOS) channel is formed on the horizontal or 0001 crystal plane of SiC. The channel mobility or field effect mobility on the 0001 crystal plane of SiC tends to be lower as compared to the vertical side wall or what is called as the 11-20 or 10-10 crystal plane. The channel mobility or field effect mobility on the 0001 crystal plane of SiC is in the range of 15 to 25 cm2/ V-sec as compared to silicon MOSFETs where it can be more than 350 cm2/ V-sec. When one makes a planar SiC DMOSFET, the ON resistance tends to be large and the MOSFET is limited by the field effect channel mobility. Therefore, there is a long-felt need for improved power devices that addresses the low channel mobility and high ON resistance in SiC MOSFET.

Further, "[t]hreshold voltage of the power MOSFET is an important design parameter from an application standpoint. A minimum threshold voltage must be maintained at above 1 volt for most system applications to provide immunity against turn-on due to voltage spikes arising from noise. At the same time, a high threshold voltage is not desirable because the voltage available for creating the charge in the channel inversion layer is determined by ($V_G$ - $V_T$) where $V_G$ is the applied gate bias and $V_T$ is the threshold voltage." [source: B.J. Baliga, Silicon Carbide Power Devices, Springer Press (2005), Page 234]

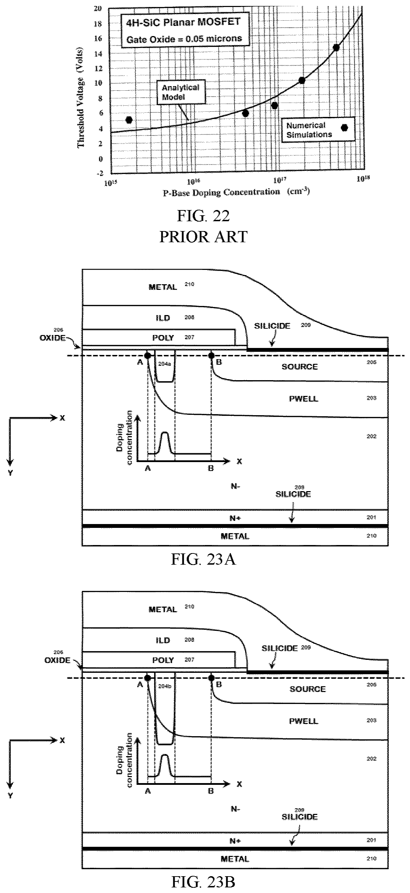

Fig. 22 [source: B.J. Baliga, Silicon Carbide Power Devices, Springer Press (2005), Page 235] shows the threshold voltage of 4H-SiC planar MOSFETSs for the case of a gate oxide thickness of 0.1 microns. The results obtained for a silicon power MOSFET with the same gate oxide thickness is also provided in the figure for comparison.

In the race to achieve lower $R_{DS, ON}$ of planar gate SiC MOSFETs with high breakdown voltage ratings, it is a common practice to make the channel lengths ($L_{CH}$) as short as possible which reduces a great part of the conduction loss that is associated to the channel. The trade-off in doing so is that, as the channel lengths are becoming shorter, the MOSFET devices become susceptible to undesirable phenomena such as the DIBL effect (the Drain Induced Barrier Lowering effect) which is responsible for the poor device performance including but not limited to the roll-off of the threshold voltage ($V_{TH}$) at high drain bias and the increase of the drain leakage ($I_L$) at high drain bias. A conventional approach to mitigate this problem is to uniformly increase the doping concentration in the channel region, but this approach suffers from a higher than optimal gate threshold voltage and on-resistance, which can offset the gains achieved from the channel length reduction.

Further, there has been a continuous trend toward higher operating frequencies especially in motor control and switch mode power supplies. In power supplies, operation at high frequencies is attractive because of the reduction in size and power losses in the passive components (inductors and capacitors) which leads to a more efficient, compact system design. To accomplish higher frequency operation, it is essential to use power transistors and rectifiers with improved switching performance. SiC's electronic parameters superiority would enable dramatic improvement in this regard.

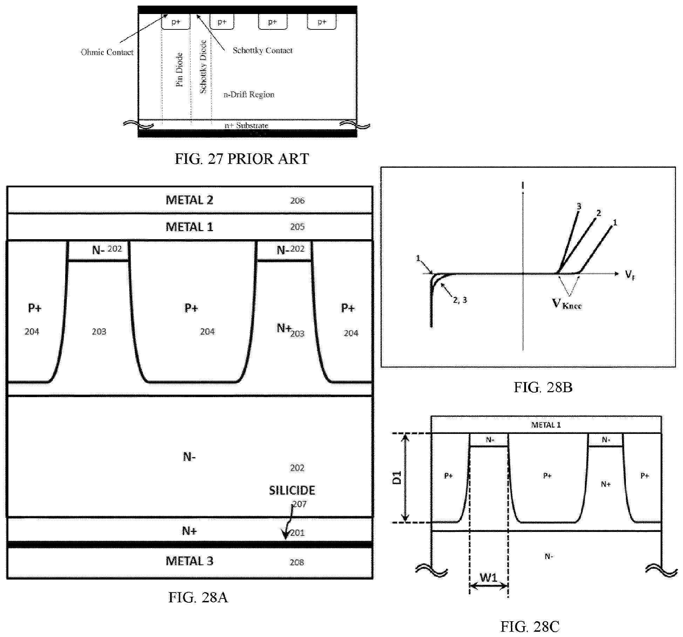

Fig. 27 is the prior art structure of a MPS diode, consisting of interdigitated pin and Schottky diodes connected in parallel as reported in "T. Kimoto and J.A. Cooper, Fundamentals of Silicon Carbide Technology, IEEE Press (2014), page 296]". The MPS diode as shown in the prior art in Fig. 27 has metal layer on top which forms ohmic contacts to the P+ regions and Schottky contacts to the n- regions, so the overall device consists of interdigitated Schottky and pin diodes connected in parallel. The P+ anode regions are spaced far enough apart that their depletion regions do not touch under zero or forward bias. This leaves a conductive path through the n- drift regions between each Schottky or non-Schottky contact and the N+ substrate. As forward bias is applied the Schottky or non-Schottky regions conduct first since the current density of the Schottky Barrier Diode is orders of magnitude higher than the pin diode at the same forward voltage. The Schottky or non-Schottky regions therefore effectively clamp the voltage drop across the pin regions and the pin regions do not conduct. As a result, virtually all of the forward current is due to electrons injected from the n- drift region through the Schottky or non-Schottky contact into the metal. Since the P+ regions do not inject holes into the drift region, no minority carrier charge is stored and the turn-off transient is fast, minimizing switching loss. With no conductivity modulation, the series resistance of the drift region is determined by its thickness and doping. This relatively high resistance leads to a voltage drop $V_{DR}$ that dominates the total voltage drop at high currents. In a Schottky diode, this poses a problem under high surge current events, since the pure Schottky diode can go into thermal runaway, with catastrophic consequences.

Further, "[A] silicon carbide (SiC) device may include a gate electrode disposed above a SiC semiconductor layer, wherein the SiC semiconductor layer comprises: a drift region having a first conductivity type; a well region disposed adjacent to the drift region, wherein the well region has a second conductivity type; and a source region having the first conductivity type disposed adjacent to the well region, wherein the source region comprises a source contact region and a pinch region, wherein the pinch region is disposed only partially below the gate electrode, wherein a sheet doping density in the pinch region is less than $2.5 \times 10^{14}$ cm$^{-2}$, and wherein the pinch region is configured to deplete at a current density greater than a nominal current density of the SiC device to increase the resistance of the source region." [source: Silicon carbide device and method of making thereof, Peter Almern Losee, Ljubisa Dragoljub Stevanovic, Gregory Thomas Dunne, Alexander Viktorovich Bolotnikov, published as US9899512B2 on February 20, 2018].

US20190013312A1 discloses body regions numbered 3, 5, respectively, that accommodate a first and a second source region numbered 4, 6, of the N type, extending from the upper surface 2A into the interior of the body regions 3, 5 and states: "A first metallization layer extends over the first surface and forms, in direct contact with the implanted structure and with the JFET region, a JBS diode." [source: MOSFET device of silicon carbide having an integrated diode and manufacturing process thereof, Mario Giuseppe Saggio, Simone RASCUNA, published at USPTO as US20190013312A1 on January 10, 2019].

"An n-MOSFET device (11) has an n-type channel (2) between a substrate (1) and a gate structure (7, 8), the channel (2) being formed by a layer of n-doped germanium of a thickness such that the channel (2) is fully-depleted with no applied gate voltage whereby the device (11) is operative in accumulation mode." [source: Germanium n-mosfet devices and production methods, Daniele Caimi, Athanasios Dimoulas, Jean Fompeyrine, Chiara Marchiori, Christophe P. Rossel, Marilyne Sousa, Axelle M. Tapponnier, David J. Webb, published as WO2011013042A1 on February 03, 2011].

US9318597B2 discloses that a semiconductor device that includes a vertical field-effect-transistor (FET) and a bypass diode. It further states that the vertical FET device includes a substrate, a drift layer formed over the substrate, a gate contact and a plurality of source contacts located on a first surface of the drift layer opposite the substrate, a drain contact located on a surface of the substrate opposite the drift layer, and a plurality of junction implants, each of the plurality of junction implants laterally separated from one another on the surface of the drift layer opposite the substrate and extending downward toward the substrate and that each of the one or more bypass diodes are formed by placing a Schottky metal contact on the first surface of the drift layer, such that each Schottky metal contact runs between two of the plurality of junction implants. [source: Layout configurations for integrating schottky contacts into a power transistor device, Vipindas Pala, Edward Robert Van Brunt, Lin Cheng, John Williams Palmour, published as US9318597B2 at USPTO on April 19, 2016].

US9876104B2 discloses a multi-cell MOSFET device including a MOSFET cell with an integrated Schottky diode wherein the MOSFET includes n-type source regions formed in p-type well regions which are formed in an n-type drift layer, a p-type body contact region is formed on the periphery of the MOSFET, and the source metallization of the device forms a Schottky contact with an n-type semiconductor region adjacent the p-type body contact region of the device. [source: High voltage semiconductor devices and methods of making the devices, Kevin Matocha, Kiran Chatty, Sujit Banerjee, published as US9876104B2 on January 23, 2018].

US8436367B1 discloses that a SiC Power Semiconductor device of the Field Effect Type (MOSFET, IGBT or the like) with "muted" channel conduction, negative temperature coefficient of channel mobility, in situ "ballasted" source resistors and optimized thermal management of the cells for increased Safe Operating Area is described. Controlling the location of the Zero Temperature Crossover Point (ZTCP) in relationship to the drain current is achieved by the partition between the "active" and "inactive" channels and by adjusting the mobility of the carriers in the channel for the temperature range of interest." [source: SiC power vertical DMOS with increased safe operating area, Dumitru Sdrulla, Marc Vandenberg, published at USPTO as US8436367B1 on May 07, 2013].

Considering the knowledge of persons skilled in the art, there is a long-felt need for power devices having increased third quadrant cross over current to overcome performance and reliability issues.

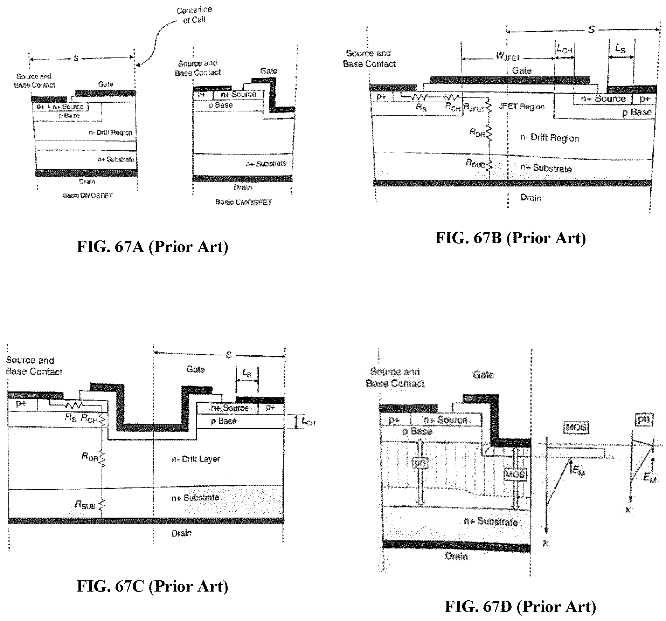

Further, FIG. 67A shows two implementations of a power MOSFET in the form of a vertical, planar DMOSFET and a vertical trench UMOSFET. The term DMOSFET derives from the silicon device of the same name, where the n+ source and p-base regions are formed by diffusion of n-type and p-type impurities through the same mask opening (hence "double diffused" MOSFET). In SiC, the same structure is formed by double implantation. The term UMOSFET derives from the U-shaped geometry, but the term trench MOSFET is also used. Historically, the first SiC power MOSFETs were UMOSFETs, but they were joined soon by ion implanted DMOSFETs. [SOURCE: T. Kimoto, J.A. Cooper in Fundamentals of Silicon Carbide Technology, IEEE Press (2014), pages 320-324.]

Because of their trench geometry, UMOSFETs present both opportunities and challenges relative to planar devices such as the DMOSFETs. The UMOSFET can be fabricated in a smaller surface area than the DMOSFET, since the MOS channel is oriented perpendicular to the surface. It is also easier to form a short sub-micron channel since the channel length is determined by epi-growth. However, the MOS channel is formed on an etched non-polar face of the crystal, and the properties of the gate oxide are different from those on the (1000) plane. The channel mobility or field effect mobility on the 0001 crystal plane tends to be lower as compared to the vertical side wall or what is called as the 11-20 or 10-10 crystal plane. The channel mobility can be in the range of 15-25 cm2/Vs on the 1000 plane whereas it can be as high as 60-80 cm2/Vs on the 11-20 or 10-10 crystal planes of SiC. [SOURCE: T. Kimoto, J.A. Cooper in Fundamentals of Silicon Carbide Technology, IEEE Press (2014), pages 320-324.]

FIG. 67B and 67C show major resistances in the vertical DMOSFET and the UMOSFET respectively and it is apparent that the geometry of the device effectively eliminates the JFET resistance present in the DMOSFET. FIG. 67D illustrates the electric fields in the UMOSFET in the blocking state, the trench corners are significant locations of significant field crowding. Because the oxide field is ~ 2.5X higher than the peak field in the semiconductor (due to Gauss' law of electrostatics), this is a serious problem inherent to the UMOSFET device design. [SOURCE: T. Kimoto, J.A. Cooper in Fundamentals of Silicon Carbide Technology, IEEE Press (2014), pages 320-324.]

Therefore, there is a long-felt need to combine the desirable features of the planar DMOSFET and the trench UMOSFET into a single device that can be advantageously and flexibly designed to exploit the specific benefits of each device structure for a given application. Furthermore, there is a long-felt need to incorporate junction barrier Schottky (JBS) or merged PiN Schottky (MPS) rectifier elements into the hybrid DMOSFET / UMOSFET device geometry.

## SUMMARY OF INVENTION

One or more aspects of the present invention are disclosed herein.

In one aspect, a device is described herein. The device comprises a unit cell on a SiC substrate. The unit cell comprises a gate insulator film, a trench in a well region, a first sinker region having a second conduction type, and a second sinker region having the second conduction type. The first sinker region has a depth that is equal to or greater than a depth of the well region. Each of the first sinker region and the second sinker region is in contact with a region having a first conduction type to form a p-n junction.

In an embodiment, the device comprises a semiconductor metal-insulator-semiconductor transistor component.

In another embodiment, the well region is next to an insulator-semiconductor interface; and a source region of the first conduction type formed within the well region.

In yet another embodiment, a depth of the trench is greater than or equal to a thickness of the source region.

In yet another embodiment, the first sinker region is located below the trench.

In yet another embodiment, a depth of the second sinker region is less than the depth of the first sinker region.

In yet another embodiment, a depth of the second sinker region is greater than the depth of the well region.

In yet another embodiment, the device has an on-resistance of less than 4 milliohm centimeter squared, a gate threshold voltage of greater than 1.5 Volt, a breakdown voltage of greater than 500 Volt, and an electric field of less than 3.5 megavolt per cm in the gate insulator film.

In another aspect, a device comprising a unit cell on a SiC substrate is described. The unit cell comprises a gate insulator film, a trench in a well region, a first sinker region of a second conduction type, a second sinker region of the second conduction type, and a source region. The source region is in direct contact with the second sinker region.

In an embodiment, the device comprises a semiconductor metal-insulator-transistor component.

In another embodiment, the unit cell further comprises a semiconductor body of a first conduction type that comprises a drift zone; the well region of the second conduction type next to an insulator-semiconductor interface; and the source region of the first conduction type formed within the well region.

In yet another embodiment, a depth of the trench is greater than or equal to a thickness of the source region.

In yet another embodiment, a depth of the trench is greater than a depth of the source region.

In yet another embodiment, the device has an avalanche energy of greater than 10 Joule per centimeter squared, calculated by dividing an avalanche energy in Joules by a total die area in centimeter squared.

In yet another embodiment, an avalanche failure is located within the unit cell.

In another aspect, a device comprising a unit cell on a SiC substrate is disclosed. The unit cell comprises a gate insulator film, a trench in a well region, a first sinker region of a second conduction type, a second sinker region of the second conduction type, and a source region. The first sinker region has a depth that is greater than a depth of the second sinker region. The second sinker has a width that is greater than that of the first sinker

In another embodiment, the first sinker region is located below the trench.

In yet another embodiment, the depth of the second sinker region is less than the depth of the first sinker region.

In yet another embodiment, the depth of the second sinker region is greater than a depth of the well region.

In yet another aspect, a device comprising a unit cell on a Silicon Carbide (SiC) substrate is disclosed. The unit cell comprises a first conductivity type first source region; a first conductivity type second source region; a second conductivity type well region; and a silicide layer. The device comprises a vertical Silicon Carbide (SiC) double-implantation metal oxide semiconductor field-effect transistor (DMOSFET) comprising a drain terminal on a backside of the SiC substrate and a source terminal on a topside of the SiC substrate. The first conductivity type second source region comprises a thickness lower than a thickness of the first conductivity type first source region. The first conductivity type second source region is interspersed between the second conductivity type well region and the silicide layer. The first conductivity type second source region comprises a sheet of source region located between a recessed SiC trench region and the second conductivity type well region.

In an embodiment, the sheet of source region comprises a thin sheet of source region.

In another embodiment, first conductivity type second source region comprises at least one of (a) a target thickness and (b) a target doping concentration.

In yet another embodiment, the target thickness of the first conductivity type second source region ranges from 1 nm to 1 $\mu$m and the target doping concentration ranges from $10^{15}$ cm$^{-3}$ to $10^{21}$ cm$^{-3}$.

In yet another embodiment, the first conductivity type second source region comprises a sheet of source region located between the silicide layer and the second conductivity type well region.

In yet another embodiment, the device is capable of carrying a drain current of less than negative 500 milliamperes at a drain voltage of negative 3 volts.

In yet another aspect, a device comprising a unit cell on a silicon carbide (SiC) substrate. The unit cell comprises a first conductivity type source region; a second conductivity type well region; and a second conductivity type shield region. The second conductivity type shield region is confined within the second conductivity type well region.

In an embodiment, the second conductivity type shield region is located within a metal oxide semiconductor field-effect transistor (MOSFET) channel.

In another embodiment, the second conductivity type shield region is located closer to an edge of the second conductivity type well region.

In yet another embodiment, a doping concentration inside the second conductivity type well region is non-uniform in a lateral direction.

In yet another embodiment, a doping concentration inside the second conductivity type shield region is higher than a doping concentration inside the second conductivity type well region.

In yet another embodiment, the second conductivity type shield region extends beyond a vertical extent of the second conductivity type well region.

In yet another embodiment, the device further comprises a trench region in the second conductivity type well region. The trench region comprises a depth of one of greater than and equal to a thickness of the first conductivity type source region.

In yet another embodiment, the device comprises a gate oxide layer in contact with the second conductivity type well region and the first conductivity type source region. The device comprises a double-implantation metal oxide semiconductor field-effect transistor (DMOSFET).

In yet another embodiment, the device comprises multiple second conductivity type shield regions within a metal oxide semiconductor field-effect transistor (MOSFET) channel.

In yet another embodiment, the multiple second conductivity type shield regions are located closer to an edge of the second conductivity type well region.

In yet another embodiment, the multiple second conductivity type shield regions extend beyond a vertical extent of the second conductivity type well region.

In yet another embodiment, the second conductivity type shield region is buried within the second conductivity type well region.

In yet another aspect, a device comprising a unit cell on a silicon carbide (SiC) substrate is disclosed. The device comprises a first conductivity type source region; a second conductivity type well region; and a second conductivity type shield region. The second conductivity type shield region is confined within the second conductivity type well region. The second conductivity type shield region shields a metal oxide semiconductor field-effect transistor (MOSFET) channel from a high potential applied to a drain terminal.

In an embodiment, the device further comprises a trench region in the second conductivity type well region, the trench region comprises a depth of one of greater than and equal to a thickness of the first conductivity type source region.

In another embodiment, the device comprises a gate threshold voltage of greater than 2.5 volts, a breakdown voltage of greater than 3300 volts at a gate to source voltage of 0 volt, an on-resistance of less than 15 milliohm centimeter squared, and a short-circuit withstand time of greater than 4 microseconds at a drain voltage of 1500 volts.

In yet another embodiment, the device comprises a gate threshold voltage of greater than 2 volts, a breakdown voltage of greater than 1200 volts at a gate to source voltage bias of 0 volt, an on-resistance of less than 4.5 milliohm centimeter squared, and a short-circuit withstand time of greater than 2.5 microseconds at a drain voltage of 800 volts.

In yet another embodiment, the device comprises a gate threshold voltage of greater than 2.5 volts, a breakdown voltage of greater than 6500 volts at a gate to source voltage of 0 volt, an on-resistance of less than 50 milliohm centimeter squared, and a short-circuit withstand time of greater than 4 microseconds at a drain voltage of 3600 volts.

In yet another embodiment, the device comprises a gate threshold voltage of greater than 2.5 volts, a breakdown voltage of greater than 10000 volts at a gate to source voltage of 0 volt, an on-resistance of less than 100 milliohm centimeter squared, and a short-circuit withstand time of greater than 4 microseconds at a drain voltage of 5000 volts.

In yet another embodiment, the device comprises a gate threshold voltage of greater than 2.5 volts, a breakdown voltage of greater than 13000 volts at a gate to source voltage of 0 volt, an on-resistance of less than 400 milliohm centimeter squared, and a short-circuit withstand time of greater than 4 microseconds at a drain voltage of 10000 volts.

In yet another embodiment, the second conductivity type shield region shields the metal oxide semiconductor field-effect transistor (MOSFET) channel from the high potential applied to the drain terminal during one of an off-state and a blocking operation.

In yet another aspect, a method is described herein. The method comprises forming a silicon carbide (SiC) metal oxide semiconductor field-effect transistor (MOSFET); forming a second conductivity type well region; forming a first conductivity type source region within the second conductivity type well region; and forming a second conductivity type shield region. The second conductivity type shield region is located outside the first conductivity type source region.

In an embodiment, the second conductivity type shield region is located within the second conductivity type well region.

In another embodiment, the second conductivity type shield region extends beyond the second conductivity type well region.

In yet another embodiment, the SiC MOSFET is manufactured on SiC epi-wafer comprising a doping ranging from $10^{14}$ to $10^{18}$ cm$^{-3}$ and a thickness ranging from 1 micrometers ($\mu$m) to 300 micrometers ($\mu$m).

In yet another embodiment, forming the second conductivity type well region comprises: depositing a hard mask comprising at least one of a silicon dioxide layer, a silicon nitride layer, a polysilicon layer, a silicon oxynitride layer, and a metallic layer with a total thickness ranging from 50 nanometers to 5 micrometers; patterning the hard mask; etching the hard mask; and performing one of an ion-implantation and an epitaxial growth using second conductivity type ions. The step of performing the ion-implantation comprises implanting the second conductivity type ions at energies ranging from 10 keV to 1000 keV, and at implant doses ranging from $10^{12}$ cm$^{-2}$ to $10^{15}$ cm$^{-2}$. The second conductivity type ions comprise one of aluminum and boron.

In an embodiment, forming the second conductivity type shield region comprises forming the second conductivity type shield region closer to an edge of the second conductivity type well region.

In another embodiment, forming the second conductivity type shield region comprises forming the second conductivity type shield region confined within the second conductivity type well region.

In yet another embodiment, the method further comprises forming a metal oxide semiconductor field-effect transistor (MOSFET) channel.

In yet another embodiment, forming the second conductivity type shield region comprises forming the second conductivity type shield region in contact with the metal oxide semiconductor field-effect transistor (MOSFET) channel.

In yet another embodiment, forming the second conductivity type shield region comprises forming multiple second conductivity type shield regions in contact with the metal oxide semiconductor field-effect transistor (MOSFET) channel.

In yet another embodiment, forming the first conductivity type source region comprises forming the first conductivity type source region using one of nitrogen and phosphorus ions.

In yet another embodiment, the method further comprises forming a gate oxide layer; forming a polysilicon gate layer; forming an interlayer dielectric (ILD) layer; forming a silicide region; and forming an interconnect metal layer.

In yet another embodiment, forming the gate oxide layer comprises performing either one or a stacked combination of a thermal oxidation and a chemical vapor deposition (CVD) of a dielectric layer of one of a silicon dioxide layer, a silicon nitride layer, and a silicon oxynitride layer. The gate oxide layer is formed with a thickness ranging from 10 nanometers to 100 nanometers.

In yet another embodiment, forming the polysilicon gate layer comprises depositing a polysilicon layer using one of a plasma-enhanced chemical vapor deposition (PECVD) and a low-pressure chemical vapor deposition (LPCVD) through one of an in-situ doping and a subsequent drive-in doping.

In yet another embodiment, forming the interlayer dielectric (ILD) layer comprises depositing one of at least one of a silicon dioxide layer, a silicon nitride layer, and a silicon oxynitride layer; and a stacked combination of the silicon dioxide layer, the silicon nitride layer, and the silicon oxynitride layer. The ILD layer comprises a thickness one of greater than and equal to 50 nanometers.

In yet another embodiment, forming the silicide region comprises forming a nickel silicide region on an exposed SiC surface.

In yet another embodiment, forming the second conductivity type shield region comprises forming the second conductivity type shield region extending beyond a vertical extent of the second conductivity type well region.

In yet another aspect, a method is described herein. The method comprises forming a silicon carbide (SiC) metal oxide semiconductor field-effect transistor (MOSFET); forming a second conductivity type well region; forming a first conductivity type source region within the second conductivity type well region; and forming a second conductivity type shield region. The second conductivity type shield region is located outside the first conductivity type source region. A doping concentration in the second conductivity type well region within a metal oxide semiconductor field-effect transistor (MOSFET) channel is non-uniform. At least a portion of the second conductivity type shield region is located within the second conductivity type well region.

In an embodiment, doping concentration profiles of the second conductivity type shield region at different locations are different.

In another embodiment, doping concentration profiles of the second conductivity type shield region at different locations are not different.

In yet another aspect, a semiconductor component is described herein. The semiconductor component comprises a semiconductor body of a first conduction type comprising a voltage blocking layer; and islands of a second conductivity type on a contact surface; and a metal layer on the voltage blocking layer. The metal layer and the voltage blocking layer includes a Schottky contact, and a first conductivity type layer comprising the first conduction type not in contact with the Schottky contact that is interspersed between the islands of the second conductivity type.

In an embodiment, a vertical extent of the first conductivity type layer is lower than a bottom of the islands of the second conductivity type.

In another embodiment, a vertical extent of the first conductivity type layer is higher than a bottom of the islands of the second conductivity type.

In yet another embodiment, a doping concentration within the first conductivity type layer is non-uniform in a direction that is perpendicular to the Schottky contact.

In yet another embodiment, a vertical extent of the first conductivity type layer is higher or lower than a bottom of the islands of the second conductivity type.

In yet another embodiment, the first conductivity type layer has a doping concentration that does not vary in any direction along the contact surface.

In yet another embodiment, the first conductivity type layer has a first doping concentration that is higher than a second doping concentration of a drift region.

In yet another embodiment, the first conductivity type layer has a first doping concentration that is lower than a second doping concentration of a drift region.

In yet another embodiment, the Schottky contact comprises a metal comprising Al, Ag, Au, Mo, Ni, Ti, W, TixWy, TixNy, or combinations thereof.

In yet another aspect, a diode comprising P+ islands interspersed within a N+ region and a N- region contacts with a Schottky layer.

In an embodiment, a vertical extent of the N+ region is lower than a bottom of the P+ islands.

In another embodiment, a vertical extent of the N+ region is higher than a bottom of the P+ islands.

In yet another embodiment, a doping concentration within the N+ region is non-uniform in a direction that is perpendicular to the Schottky layer.

In yet another embodiment, a vertical extent of the N+ region is higher or lower than a bottom of the P+ islands.

In yet another aspect, a diode comprising N+ islands interspersed within a P+ region and a P- region contacts with a Schottky layer.

In an embodiment, a vertical extent of the P+ region is lower than a bottom of the N+ islands.

In another embodiment, a vertical extent of the P+ region is higher than a bottom of the N+ islands.

In yet another embodiment, a doping concentration within the P+ region is non-uniform in a direction that is perpendicular to the Schottky layer.

In yet another embodiment, a vertical extent of the P+ region is higher or lower than a bottom of the N+ islands.

In an aspect, a metal-insulator-semiconductor field effect transistor is disclosed herein. The metal-insulator-semiconductor field effect transistor comprises a unit cell on a SiC substrate. The unit cell comprises a trench in a well region having a second conduction type, a source region of a first conduction type, a first sinker region having a second conduction type, and a second sinker region having the second conduction type. The first sinker region has a depth that is equal to or greater than a depth of the well region. Each of the first sinker region and the second sinker region is in contact with a region having a first conduction type to form a p-n junction.

In an embodiment, the first sinker region has a depth that is greater than a depth of the second sinker region. The second sinker has a width that is greater than that of the first sinker.

In another aspect, a metal-insulator-semiconductor field effect transistor is disclosed herein. The metal-insulator-semiconductor field effect transistor comprises a unit cell on a silicon carbide (SiC) substrate. The unit cell comprises: a first conductivity type source region; a second conductivity type well region; and a second conductivity type shield region. The second conductivity type shield region is located outside the first conductivity type source region.

In an embodiment, the second conductivity type shield region extends beyond a vertical extent of the second conductivity type well region.

In another embodiment, the device further comprises a trench region in the second conductivity type well region. The trench region comprises a depth that is greater than and equal to a thickness of the first conductivity type source region.

In yet another embodiment, the device further comprises a sinker region of a first conduction type that is located directly below the trench region.

In yet another aspect, a semiconductor component is disclosed herein. The semiconductor component comprises a semiconductor body of a first conduction type comprising a voltage blocking layer; and islands of a second conductivity type on a contact surface; and a metal layer on the voltage blocking layer. The metal layer and the voltage blocking layer includes a Schottky contact, and a first conductivity type layer comprising the first conduction type not in contact with the Schottky contact that is interspersed between the islands of the second conductivity type.

In an embodiment, a vertical extent of the first conductivity type layer is lower than a bottom of the islands of the second conductivity type.

In another embodiment, a doping concentration within the first conductivity type layer is non-uniform in a direction that is perpendicular to the Schottky contact.

In yet another aspect, a silicon carbide diode is disclosed herein. The silicon carbide diode comprises first conduction type islands interspersed within a second region of a first conduction type and a first region of the first conduction type in contact with a metal layer.

## BRIEF DESCRIPTION OF THE FIGURES

The patent or application file contains at least one drawing executed in color. Copies of this patent or patent application publication with color drawing(s) will be provided by the Office upon request and payment of the necessary fee.

**Fig. 1A** shows the prior art SiC DMOSFET structure reported by B.J. Baliga in Advanced High-Voltage Power Device Concepts, Springer Press, 2011.

**Fig. IB** shows the electric field contours simulated for the prior art SiC DMOSFET structure in Fig. 1A.

**Fig. IC** shows the electric field distribution for the prior art SiC DMOSFET structure in Fig. 1A.

**Fig. 2A** shows an embodiment of a SiC DMOSFET with the P+ plug region to ground the p-well region with the N+ source contact.

**Fig. 2B** shows the breakdown simulation of the SiC DMOSFET structure in Fig. 2A.

**Fig. 3** shows an embodiment of a SiC DMOSFET where the P+ plug region in Fig. 2a is replaced with a deep P-type Sinker#1 region.

**Fig. 4A to Fig. 4R** are cross sectional views showing the process steps for manufacturing the SiC DMOSFET structure in Fig. 3.

**Fig. 5A** shows an embodiment of a SiC DMOSFET where a P-type Sinker#2 region under the N+ source region is formed in addition to the deep P-type Sinker#1 region.

**Fig. 5B** shows the breakdown simulation of the SiC DMOSFET structure designed according to embodiments shown in Fig. 3 and Fig. 5A.

**Fig. 6A to Fig. 6J** are cross sectional views showing the process steps for manufacturing the SiC DMOSFET structure in Fig. 5A.

**Fig. 7A** shows an embodiment of a SiC DMOSFET where a trench is etched into the N+ source region before implanting the P-type Sinker#1 region.

**Fig. 7B** shows the breakdown simulation of the SiC MOSFET structure in Fig. 7A.

**Fig. 8A to Fig. 8BB** are cross sectional views showing the process steps for manufacturing the SiC DMOSFET structure in Fig. 7A.

**Fig.** 9 shows the prior art SiC DMOSFET process flow for self-aligned MOS channel formation.

**Fig. 10** shows an embodiment of a SiC DMOSFET structure for removal of a parasitic N+ source region formed in the periphery.

**Fig. 11A to Fig. 11GG** are cross sectional views showing the process steps for manufacturing the SiC DMOSFET structure in Fig. 10.

**Fig. 12** shows an embodiment of a SiC DMOSFET with a dedicated process step utilized for masking the implantation of the N+ source region in the device periphery.

**Fig. 13A to Fig. 13GG** are cross sectional views showing the process steps for manufacturing the SiC DMOSFET structure in Fig. 12.

**Fig. 14** shows an embodiment of a SiC DMOSFET with a dedicated process step for masking the implantation of the N+ source region in the device periphery as well as the N+ source region in the active region to enable ohmic contact to the p-well region

**Fig. 15A to Fig. 15FF** are cross sectional views showing the process steps for manufacturing the SiC DMOSFET structure in Fig. 14.

**Fig. 16** shows an embodiment of a SiC DMOSFET where the polysilicon gate metallization layers are segmented in the peripheral region.

**Fig. 17A to Fig. 17FF** are cross sectional views showing the process steps for manufacturing the SiC DMOSFET structure in Fig. 16.

**Fig. 18** shows an embodiment of a SiC DMOSFET with a portion of the MOS channel on (1000) and a second portion on (11-20) or (11-00) crystal planes.

**Fig. 19A to Fig. 19U** are cross sectional views showing the process steps for manufacturing the SiC DMOSFET structure in Fig. 18.

**Fig. 20** shows an embodiment of a SiC DMOSFET with a portion of the MOS channel on (1000) and a second portion on (11-20) or (11-00) crystal planes and a deeper p-well trench and formation of a second p-well region under the N+ source region

**Fig. 21A to Fig. 21V** are cross sectional views showing the process steps for manufacturing the SiC DMOSFET structure in Fig. 20.

**Fig. 22** is the prior art and shows the plot of threshold voltage versus p-base doping concentration for a 4H-SiC Planar MOSFET.

**Figs. 23A to Fig. 23D** shows embodiments of a SiC DMOSFET structure for field shielding within the p-well region.

**Figs. 24A to Fig. 24U** are cross sectional views showing the process steps for manufacturing the SiC DMOSFET structure in Fig. 23A.

**Figs. 25A to Fig. 25D** show embodiments of a SiC DMOSFET structure for field shielding formed buried within the p-well structure.

**Figs. 26A to Fig. 26U** are cross sectional views showing the process steps for manufacturing the SiC DMOSFET structure in Fig. 25A.

**Fig. 27** is the cross-sectional schematic of a prior-art SiC MPS diode.

**Fig. 28A** is an embodiment of MPS diode structure with buried N+ regions.

**Fig. 28B** the I-V characteristic for the embodiment described in Fig. 28A.

**Fig. 28C** is the comparison of the cross-sections of the devices in Fig. 28A.

**Figs. 29A to Fig. 29L** are cross sectional views showing the process steps for manufacturing the SiC MPS diode shown in Fig. 28A.

**Fig. 30** is an embodiment of MPS diode structure where the bottom of the N+ region is higher than the bottom of the P+ region.

**Figs. 31A to Fig. 31L** are cross sectional views showing the process steps for manufacturing the SiC MPS diode shown in Fig. 30.

**Fig. 32A to Fig 32F** are embodiments of MPS diode structures with multiple N sub-regions, P sub-regions or both

**Fig. 33AA to Fig. 33AL** are cross sectional views showing the process steps for manufacturing the SiC MPS diode shown in Fig. 32A.

**Fig. 33BA to Fig. 33BL** are cross sectional views showing the process steps for manufacturing the SiC MPS diode shown in Fig. 32B.

**Fig. 33EA to Fig. 33EL** are cross sectional views showing the process steps for manufacturing the SiC MPS diode shown in Fig. 32E.

**Fig. 33FA to Fig. 33FL** are cross sectional views showing the process steps for manufacturing the SiC MPS diode shown in Fig. 32F.

**Fig. 34** is an embodiment of MPS diode structure with two different types of P+ wells depending on their depths which are in comparison to the depth of the N+ layer.

**Figs. 35A to Fig. 35P** are cross sectional views showing the process steps for manufacturing the SiC MPS diode shown in Fig. 34.

**Fig. 36A** is the blocking performances of the devices of this invention with varying ratios of W1/D1.

**Fig. 36B** is the blocking I-V curves of the devices of this invention with varying ratios of W1/D1.

**Fig. 36C** is the forward I-V curves of the devices of this invention with varying ratios of W1/D1.

**Fig. 36D** is the performance of differential specific on-resistances of the devices of this invention with varying ratios of W1/D1.

**Fig. 37A** shows the device structure of DMOSFET according to an embodiment.

**Fig. 37B** shows the device structure of junction field effect transistors (JFET) according to an embodiment.

**Fig. 38** shows an example of the n-type layer formed using ion-implantation according to an embodiment.

**Fig. 39A to 39C** shows the N Layer vertical extent with respect to the P+ gate layer in a JFET according to various embodiments.

**Fig. 40A to 40C** shows the N Layer vertical extent with respect to the p-well layer in a DMOSFET according to various embodiments.

**Fig. 41A to 41E** a cross-sectional schematic of a vertical JFET showing the process steps for the device shown in Fig. 37B.

**Fig. 42A to 42D** a cross-sectional schematic of a power MOSFET structure showing the process steps for the device shown in Fig. 37A.

**Fig. 43A and Fig. 43B** show the output and breakdown I-V characteristics of 1200 V SiC DMOSFETs fabricated using the teachings of this invention.

**Fig. 44A and Fig. 44B** show the transfer (ID v/s VGS) characteristics of 1200 V SiC MOSFETs fabricated using the teachings of this invention.

**Fig. 45** is a single-pulse avalanche energy measured for a 1200 V SiC MOSFET fabricated using the teachings of this invention.

**Fig. 46** is a photograph showing a SiC DMOSFET fabricated using the teachings of these inventions and tested for single-pulse avalanche energy test.

**Fig. 47A and Fig. 47B** are output characteristics of two 3.3 kV SiC MOSFETs fabricated using the teachings of these inventions.

**Fig. 47C** is the transfer characteristics of two 3.3 kV SiC MOSFETs fabricated using the teachings of these inventions.

**Fig. 47D** is a short-circuit test measured for two 3.3 kV SiC MOSFETs fabricated using the teachings of this invention.

**FIG. 48A** illustrates an embodiment of a cross sectional structure of a unit cell of a double-implantation metal oxide semiconductor field-effect transistor (DMOSFET) comprising a first conductivity type second source region within a first conductivity type first source region.

**FIG. 48B** illustrates an embodiment of a cross sectional structure of one or more unit cells of the DMOSFET, comprising one or more unit cells of an integrated Schottky diode, each DMOSFET unit cell comprising the first conductivity type second source region within the first conductivity type first source region.

**FIG. 48C** illustrates an embodiment of a cross sectional structure of one or more unit cells of a trench gate MOSFET, comprising one or more unit cells of the integrated Schottky diode, each MOSFET unit cell comprising the first conductivity type second source region within the first conductivity type first source region.

**FIG. 49A to 49T** illustrates an embodiment of a process of manufacturing the DMOSFET structure shown in FIG. 48A.

**FIG. 50A** illustrates an embodiment of a voltage-current characteristic of a SiC DMOSFET with conventional p-n junction vs the SiC DMOSFET with deactivated p-n junction (i.e., the first conductivity type second source region).

**FIG. 50B** is a perspective view that illustrates an embodiment of sides of the DMOSFET in relation to a dice.

**FIG. 50C and 50D** illustrate current flow paths through the MOSFET and through an intrinsic anti-parallel diode region in an H-bridge circuit respectively.

**FIG. 51A** illustrates an embodiment of a cross sectional structure of a unit cell of a double-implantation metal oxide semiconductor field-effect transistor (DMOSFET) comprising a first conductivity type second source region within a first conductivity type first source region.

**FIG. 51B** illustrates an embodiment of a cross sectional structure of one or more unit cells of the DMOSFET, comprising one or more unit cells of an integrated Schottky diode, each DMOSFET unit cell comprising the first conductivity type second source region within the first conductivity type first source region.

**FIG. 52A to 52T** illustrate an embodiment of a process of manufacturing the DMOSFET structure shown in FIG. 51A.

**FIG. 53A** illustrates an embodiment of a cross sectional structure of a unit cell of a double-implantation metal oxide semiconductor field effect transistor (DMOSFET) comprising a first metal region in direct contact with a second conductivity type well contact region.

**FIG. 53B** illustrates an embodiment of a cross sectional structure of one or more unit cells of the DMOSFET, comprising one or more unit cells of an integrated Schottky diode, each DMOSFET unit cell comprising the first metal region in direct contact with the respective second conductivity type well contact region.

**FIG. 53C** illustrates an embodiment of a third quadrant current conduction through an intrinsic p-n junction diode region vs a Schottky diode region connected in parallel to the DMOSFET.

**FIG. 53D** illustrates an embodiment of a third quadrant current conduction through the DMOSFET after connecting the one or more Schottky diode regions in series with the one or more body diode regions of the DMOSFET.

**FIG. 54A to 54X** illustrate an embodiment of a process of manufacturing the DMOSFET structure shown in FIG. 53A.

**FIG. 55A, 55B & 55C** illustrate an embodiment of cross-sectional structures of a unit cell of a double-implantation metal oxide semiconductor field effect transistor (DMOSFET) comprising a second conductivity type well contact region that meanders at three different locations respectively.

**FIG. 55D, 55E & 55F** illustrates an embodiment of cross-sectional structures of one or more unit cells of a diode integrated DMOSFET, each DMOSFET unit cell comprising the second conductivity type well contact region that meanders at three different locations respectively.

**FIG. 56A to 56T** illustrate an embodiment of a process of manufacturing the DMOSFET structure shown in FIG. 55A.

**FIG. 57A to 57T** illustrate an embodiment of a process of manufacturing the DMOSFET structure shown in FIG. 55B.

**FIG. 58A to 58T** illustrate an embodiment of a process of manufacturing the DMOSFET structure shown in FIG. 55C.

**FIG. 59A, 59B & 59C** illustrate an embodiment of cross sectional structures of a unit cell of a double-implantation metal oxide semiconductor field effect transistor (DMOSFET) comprising a second conductivity type well contact region that meanders at three different locations respectively, allowing a second conductivity type well region to be in contact with a source metal only through the second conductivity type well contact region.

**FIG. 59D, 59E & 59F** illustrate an embodiment of cross sectional structures of one or more unit cells of a diode integrated DMOSFET, each DMOSFET unit cell comprising the second conductivity type well contact region that meanders at three different locations respectively, allowing the second conductivity type well region to be in contact with the source metal only through the second conductivity type well contact region.

**FIG. 59G** illustrates an embodiment of a cross sectional structure of one or more unit cells of a diode integrated trench gate MOSFET, comprising one or more unit cells of an integrated Schottky diode, each MOSFET unit cell comprising the second conductivity type well contact region at the first location, allowing the second conductivity type well region to be in contact with the source metal only through the second conductivity type well contact region.

**FIG. 60A to 60T** illustrate an embodiment of a process of manufacturing the DMOSFET structure shown in FIG. 59A.

**FIG. 61A to 61T** illustrate an embodiment of a process of manufacturing the DMOSFET structure shown in FIG. 59B.

**FIG. 62A to 62T** illustrate an embodiment of a process of manufacturing the DMOSFET structure shown in FIG. 59C.

**FIG. 63** illustrates an embodiment of a cross-sectional structure of one or more unit cells of a power MOSFET, a first unit cell of the one or more unit cells comprising a first metal oxide semiconductor (MOS) interface on a horizontal surface of a semiconductor substrate and a trench sidewall, and a second unit cell of the one or more unit cells comprising a second metal oxide semiconductor (MOS) interface formed solely on the trench sidewall.

**FIG. 64A to 64AB** are cross-sectional views illustrating an embodiment of a process of manufacturing the MOSFET structure shown in FIG. 63.

**FIG. 65** illustrates an embodiment of a cross-sectional structure of one or more unit cells of a power MOSFET, a first unit cell of the one or more unit cells comprising a first metal oxide semiconductor (MOS) interface on a horizontal surface of a semiconductor substrate and a trench sidewall, and a second unit cell of the one or more unit cells comprising a metal region formed adjacent to a first conductivity type drift layer of the MOSFET.

**FIG. 66A to 66AA** are cross-sectional views illustrating an embodiment of a process of manufacturing the MOSFET structure shown in FIG. 65.

**FIG. 67A** shows two implementations of a power MOSFET in the form of a vertical, planar DMOSFET and a vertical trench UMOSFET.

**FIG. 67B** and **67C** show major resistances in a vertical DMOSFET and a UMOSFET respectively and it is apparent that the geometry of the device effectively eliminates JFET resistance present in the DMOSFET.

**FIG. 67D** illustrates electric fields in a UMOSFET in a blocking state, trench corners are significant locations of significant field crowding.

Other features of the present embodiments will be apparent from the accompanying drawings and from the detailed description that follows.

## DETAILED DESCRIPTION

### Definitions and General Techniques

Unless otherwise defined herein, scientific, and technical terms used in connection with the present invention shall have the meanings that are commonly understood by those of ordinary skill in the art. Further, unless otherwise required by context, singular terms shall include pluralities and plural terms shall include the singular. Generally, nomenclatures used in connection with, and techniques of, semiconductor processing described herein are those well-known and commonly used in the art.

The methods and techniques of the present invention are generally performed according to conventional methods well known in the art and as described in various general and more specific references that are cited and discussed throughout the present specification unless otherwise indicated. The nomenclatures used in connection with, and the procedures and techniques of semiconductor device technology, semiconductor processing, and other related fields described herein are those well-known and commonly used in the art.

For simplicity and clarity of illustration, the drawing figures illustrate the general manner of construction, and descriptions and details of well-known features and techniques may be omitted to avoid unnecessarily obscuring the present disclosure. Additionally, elements in the drawing figures are not necessarily drawn to scale. For example, the dimensions of some of the elements in the figures may be exaggerated relative to other elements to help improve understanding of embodiments of the present disclosure. The same reference numerals in different figures denotes the same elements.

The terms "first," "second," "third," "fourth," and the like in the description and in the claims, if any, are used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "include," and "have," and any variations thereof, are intended to cover a non-exclusive inclusion, such that a process, method, system, article, device, or apparatus that comprises a list of elements is not necessarily limited to those elements, but may include other elements not expressly listed or inherent to such process, method, system, article, device, or apparatus.

The terms "left," "right," "front," "back," "top," "bottom," "over," "under," and the like in the description and in the claims, if any, are used for descriptive purposes and not necessarily for describing permanent relative positions. It is to be understood that the terms so used are interchangeable under appropriate circumstances such that the embodiments of the apparatus, methods, and/or articles of manufacture described herein are, for example, capable of operation in other orientations than those illustrated or otherwise described herein.

No element, act, or instruction used herein should be construed as critical or essential unless explicitly described as such. Also, as used herein, the articles "a" and "an" are intended to include items, and may be used interchangeably with "one or more." Furthermore, as used herein, the term "set" is intended to include items (e.g., related items, unrelated items, a combination of related items, and unrelated items, etc.), and may be used interchangeably with "one or more." Where only one item is intended, the term "one" or similar language is used. Also, as used herein, the terms "has," "have," "having," or the like are intended to be openended terms. Further, the phrase "based on" is intended to mean "based, at least in part, on" unless explicitly stated otherwise.

The following terms and phrases, unless otherwise indicated, shall be understood to have the following meanings.

The term "unit cell" as used herein refers to a piece of a pattern in a semiconductor which is repeated in the semiconductor.

The term "SiC" as used herein refers to silicon carbide which is a compound semiconductor and is a mixture of silicon and carbon with the chemical formula SiC. Silicon is covalently bonded with carbon. In 4H-SiC, 4H is written in the Ramsdell classification scheme here the number indicates the layer, and the letter indicates the Bravais lattice. That means in a 4H-SiC structure four hexagonal layers of SiC are present. SiC exists in a kind of polymorphic crystalline building known as a polytype, e.g., 3C-SiC, 4H-SiC, 6H-SiC. Presently 4H-SiC is used in power device manufacturing. [Source: A complete analytical potential based solution for a 4H-SiC MOSFET in nanoscale, M K Yadav, K P Pradhan and P K Sahu Published 24 May 2016 • © 2016 Vietnam Academy of Science & Technology]

The term "substrate" as used herein refers to the supporting material on or in which the components of an integrated circuit are fabricated or attached.

The term "JFET" as used herein refers to junction gate field-effect transistor which is a three-terminal semiconductor device that can be used as electronically controlled switches, amplifiers, or voltage-controlled resistors. A FET (field-effect transistor) is a unipolar transistor in which current carriers are injected at a source terminal and pass to a drain terminal through a channel of semiconductor material whose conductivity depends largely on an electric field applied to the semiconductor from a control electrode. There are two main types of FETs, a junction FET, and an insulated-gate FET. In the junction FET, the gate is isolated from the channel by a pn-junction. In an insulated-gate FET, the gate is isolated from the channel by an insulating layer so that the gate and channel form a capacitor with the insulating layer as the capacitor dielectric.

The term "MOSFET" as used herein refers to a metal oxide semiconductor field-effect transistor. which is a four-terminal device with source(S), gate (G), drain (D) and body (B) terminals. The body of the MOSFET is frequently connected to the source terminal making it a three-terminal device like field effect transistor.

The term "DMOSFET" as used herein refers to double-implantation metal oxide semiconductor field-effect transistor. A common physical structure of SiC MOSFETs is the planar double-implanted MOSFET in 4H-SiC (SiC-DMOSFET).

The term "dopant" as used herein refers to an impurity added from an external source to a material by diffusion, coating, or implanting into a substrate, such as changing the properties thereof. In semiconductor technology, an impurity may be added to a semiconductor to modify its electrical properties or to a material to produce a semiconductor having desired electrical properties. N-type (negative) dopants (e.g., such as phosphorus for a group IV semiconductor) typically come from group V of the periodic table. When added to a semiconductor, n-type dopants create a material that contains conduction electrons. P-type (positive) dopants (e.g., such as boron for a group IV semiconductor) typically come from group III and result in conduction holes (i.e., vacancies in the electron shells).

The term "drain" as used herein refers to the electrode of a field effect transistor which receives charge carriers which pass through the transistor channel from the source electrode.

The term "source" as used herein refers to the active region/electrode to which the source of charge carriers is connected in a field effect transistor,

The term "gate" as used herein refers to the control electrode or control region that exerts an effect on a semiconductor region directly associated therewith, such that the conductivity characteristic of the semiconductor region is altered in a temporary manner, often resulting in an on-off type switching action. The control electrode or control region of a field effect transistor is located between the source and drain electrodes, and regions thereof.

The term "impurity" as used herein refers to A foreign material present in a semiconductor crystal, such as boron or arsenic in silicon, which is added to the semiconductor to produce either p-type or n-type semiconductor material, or to otherwise result in material whose electrical characteristics depend on the impurity dopant atoms.

The term "PN junction" as used herein refers to the interface and region of transition between p-type and n-type semiconductors.

The term "polysilicon" as used herein refers to a polycrystalline form of silicon.

The term "P-type" as used herein refers to extrinsic semiconductor in which the hole density exceeds the conduction electron density.

The term "bandgap" as used herein refers to the difference between the energy levels of electrons bound to their nuclei (valence electrons) and the energy levels that allow electrons to migrate freely (conduction electrons). The band gap depends on the particular semiconductor involved.

The term "breakdown" as used herein refers to a sudden change from high dynamic electrical resistance to a very low dynamic resistance in a reverse biased semiconductor device (e.g., a reverse biased junction between p-type and n-type semiconductor materials) wherein reverse current increases rapidly for a small increase in reverse applied voltage, and the device behaves as if it had negative electrical resistance.

The term "channel" as used herein refers to a path for conducting current between a source and drain of a field effect transistor.

The term "chip" as used herein refers to a single crystal substrate of semiconductor material on which one or more active or passive solid-state electronic devices are formed. A chip may contain an integrated circuit. A chip is not normally ready for use until packaged and provided with external connectors.

The term "contact" as used herein refers to the point or part of a conductor which touches another electrical conductor or electrical component to carry electrical current to or from the conductor or electrical component.

The term "die" as used herein refers to a tiny piece of semiconductor material, separated from a semiconductor slice, on which one or more active electronic components are formed. Sometimes called a chip. N+ substrate.

The term "sinker" as used herein refers to deep implanted regions at key locations within the DMOSFET structure

The term "plug" as used herein refers to the structure used to ground the well and the source contact.

The term "drift layer" as used herein refers to lightly doped region to support the high voltage in power MOSFET

The term "well" used herein refers certain to regions in a metal-oxide-semiconductor (MOS) transistor. MOS transistors are always created in a "well" region. A PMOS (positive-channel MOS) transistor is made in an N-doped region, called "n-well" region. Similarly, an NMOS transistor (negative-channel MOS) is made in a "P-type" region called "p-well". This ensures that the leakage between two transistors, through the bottom side, is low due to the reverse bias between the transistor areas and the well region.

The term "source interconnect metallization" as used herein refers to interconnection metallization that interconnects thousands of MOSFETs using fine-line metal patterns.

The term "self-aligned" used herein refers to processing steps in manufacturing of semiconductor devices. It is often necessary to achieve precise alignment between structures fabricated at different lithographic stages of integrated circuit fabrication. Stringent requirements on lithographic alignment tolerance can be relaxed if the structures are "self-aligned" which means one is forced into a specific position relative to the other for a wide range of lithographically defined positions.

The term "device" as used herein refers to the physical realization of an individual electrical element in a physically independent body which cannot be further divided without destroying its stated function.

The term "surface" as used herein refers to the outer or exterior boundary of a thing.

The term "trench" as used herein refers to electrical isolation of electronic components in a monolithic integrated circuit by the use of grooves or other indentations in the surface of the substrate, which may or may not be filled with electrically insulative (i.e., dielectric) material.

The term "dielectric" as used herein refers to a non-conductor of electricity, otherwise known as an insulator.

The term "mobility" as used herein refers to the facility with which carriers move through a semiconductor when subjected to an applied electric field. Electrons and holes typically have different mobilities in the same semiconductor.

The term "RIE" as used herein refers to reactive ion etching which is an etching technology used in microfabrication. RIE is a type of dry etching which has different characteristics than wet etching. RIE uses chemically reactive plasma to remove material deposited on wafers. The plasma is generated under low pressure (vacuum) by an electromagnetic field. High-energy ions from the plasma attack the wafer surface and react with it.

The term "ILD" as used herein refers to interlayer dielectric, a dielectric material used to electrically separate closely spaced interconnect lines arranged in several levels (multilevel metallization) in an advanced integrated circuit.

The term "CVD" as used herein refers to chemical vapor deposition is a method used to produce high quality, high-performance, solid materials, typically under vacuum. The process is often used in the semiconductor industry to produce thin films. In typical CVD, the wafer (substrate) is exposed to one or more volatile precursors, which react and/or decompose on the substrate surface to produce the desired deposit. Frequently, volatile by-products are also produced, which are removed by gas flow through the reaction chamber.

The term "PECVD" as used herein refers to plasma-enhanced chemical vapor deposition process used to deposit thin films from a gas state (vapor) to a solid state on a substrate. Chemical reactions are involved in the process, which occur after creation of a plasma of the reacting gases.

The term "LPCVD" as used herein refers to low pressure chemical vapor deposition technology that uses heat to initiate a reaction of a precursor gas on the solid substrate. This reaction at the surface is what forms the solid phase material.

The term "DIBL" as used herein refers to drain induced barrier lowering and is a short-channel effect in MOSFETs referring originally to a reduction of threshold voltage of the transistor at higher drain voltages. In a classic planar field-effect transistor with a long channel, the bottleneck in channel formation occurs far enough from the drain contact that it is electrostatically shielded from the drain potential by the combination of the substrate and gate, and so classically the threshold voltage was independent of drain voltage. In short-channel devices this is no longer true: The drain potential can gate the channel, and so a high drain voltage can open the bottleneck and turn on the transistor prematurely.

The term "ICP" as used herein refers to inductively coupled plasma etching technology often used in specialty semiconductor markets for device manufacturing. This technology can combine both chemical reactions and ion-induced etching. The independent control of ion flux enables high process flexibility. ICP etching is based on the use of an inductively coupled plasma source. The ICP source generates a high-density plasma due to inductive coupling between the RF antenna and the plasma. The antenna, located in the plasma generation region, creates an alternating RF magnetic field, and induces RF electric fields, which energize electrons that participate in the ionization of gas molecules and atoms at low pressure. Due to the absence of an electric field near the reactor walls there is virtually no ion bombardment or erosion of the walls.

The term "p-shield" as used herein refers to a carefully designed p-type doped region strategically located close to or within the MOSFET channel region, with the objective of shielding the MOSFET channel from the high potential applied to the drain terminal during off-state or blocking operation.

The terms "first conductivity type region" and "second conductivity type region" as used herein, are used to describe n-type and p-type regions respectively for a N type device. For a P type device "first conductivity type region" and "second conductivity type region" are used to describe p-type and n-type regions respectively.

The term "I-V Characteristic Curves" used herein refers to Current-Voltage Characteristic Curves or simply I-V curves of an electrical device or component, refers to a set of graphical curves which are used to define its operation within an electrical circuit.

The term "MV/cm" as used herein refers to Megavolt per centimeter and refers to unit of electric field.

The term "avalanche failure" as used herein refers to a phenomenon that can occur in both insulating and semiconducting materials. It is a form of electric current multiplication that can allow very large currents within materials which are otherwise good insulators. It is a type of electron avalanche. The avalanche process occurs when carriers in the transition region are accelerated by the electric field to energies sufficient to create mobile or free electron-hole pairs via collisions with bound electrons. The voltage at which the breakdown occurs is called the breakdown voltage. Avalanche failure can cause structural damage to a semiconductor device.

The term "avalanche energy" as used herein is defined as the amount of energy the MOSFET can withstand when it is set into avalanche mode or its breakdown voltage is exceeded.

The term "topside" as used herein refers to the outer side/top of the DMOSFET. The topside of the vertical SiC DMOSFET may comprise a source terminal.

The term "bottom side" as used herein refers to the underside/base of the DMOSFET. The bottom side of the vertical SiC DMOSFET may comprise a drain terminal.

The term "front side" as used herein refers to a side of the DMOSFET which is visible in front.

The term "back side" as used herein refers to the rear side of the DMOSFET. The back side of the vertical SiC DMOSFET may comprise the drain terminal.

The term "plus" used herein refers to certain regions in a metal-oxide-semiconductor (MOS) transistor where doping concentration is excessive.

The term "active region" as used herein refers to a region of the DMOSFET where the current conduction happens.

The term "depletion region" as used herein refers to a region where flow of charged carriers decreases over a given time.

The term "thermal budget" as used herein refers to the total amount of thermal energy transferred to a wafer during the given elevated temperature operation.

The term "work function" as used herein refers to minimum quantity of energy required to remove an electron to infinity from the surface of a given metal.

As defined herein, two or more elements are "integral" if they are comprised of the same piece of material. As defined herein, two or more elements are "non-integral" if each is comprised of a different piece of material.

The term "trench sidewalls" as used herein refers to walls that form sides of the trench region.

The term "bottom portion" as used herein refers to the base of the trench region.

The term "crystal plane" as used herein refers to an imaginary plane inside a crystal of a semiconductor substrate in which large concentrations of atoms are present.

The term "MOS interface" as used herein refers to a region/path that electrically interconnects two regions.

The term "horizontal surface" as used herein refers to an unetched surface on topside of the semiconductor substrate.

The term "RF" as used herein refers to Radio frequency. Radio frequency is an oscillation rate of an alternating electric current or voltage or of a magnetic, electric, or electromagnetic field or mechanical system.

Embodiments relate to SiC DMOSFET power devices where the p-well regions effectively shield the sensitive gate oxide from the high electric fields present in SiC especially during high drain bias or blocking mode operation.

An embodiment relates to using a P+-plug to ground the p-well region with the N+ source contact.

An embodiment relates to making the lateral spacing between the p-well regions narrow enough to suppress the electric field in the gate oxide while ensuring the ON-resistance is not high.

An embodiment relates to replacing the P+ plug region of the DMOSFET with a deep P-type Sinker#1 region.

Embodiments relate to formation of one or more deep implanted sinker regions at certain locations within the MOSFET device structure such as a first P-type sinker region at the center of the MOSFET unit cell whose depth may be equal to or greater than the depth of the p-well region.

Embodiment relates to forming a second P-type sinker region under the N+ source region, whose depth may be equal to or greater than the p-well region, but less than or equal to the depth of the first P-type sinker region.

Embodiment relates to boron implantation which may be advantageously used for forming the deep sinker regions since boron has a larger implant range than aluminum that can result in deeper implant profiles

Embodiment relates to the formation of a first trench with desired shape which may be etched in the N+ source region, prior to the formation of the first P-type sinker region, which may serve to increase the depth of the first P-type sinker region. The depth of the first trench may range from 0.01 $\mu$m up to 2 $\mu$m. The depth of the resulting first sinker region may be 0% to 100% larger than the depth of the p-well region. The depth of the first P-type sinker region can be as large as the entire epitaxial layer.

Embodiment relating to the formation of the first trench in the N+ source region may reduce or eliminate the need for expensive ultra-high energy implantation steps for forming the first P-type sinker region.

Embodiment relating to the first trench may be advantageously used to remove the N+ source implant from the first P-type sinker region, which may be desirable to prevent compensation of the first P-type sinker region by the N+ source implant. This is especially useful if the N+ source region is self-aligned to the p-well region.

Embodiment relates to a gradually decreasing implant concentration which may be employed for forming the first and second P-type sinker regions in lieu of a box-shaped implant profile, as this may be advantageous in appropriately shaping the electric field under high drain bias. The doping in the P-type sinker regions may be varied linearly from a maximum value close to the SiC surface to a value equal to or slightly higher than the drift layer doping concentration at the other end of the P-type sinker regions.

Embodiment of a design of the first and second sinker regions may simplify the design of the p-well region, which can be designed to support metal-oxide-semiconductor (MOS) channel formation and may be advantageously designed for achieving low on-resistance, without compromising other performance metrics, such as reverse leakage current and electric field in gate oxide.

SiC devices in power electronics feature fast switching times, high blocking voltage capabilities, and the ability to operate at high temperatures. These characteristics, along with recent advancements in manufacturing processes, suggest that SiC has the potential to revolutionize power electronics as a successor to traditional silicon-based (Si) devices. SiC is a wide band gap material (3.3 eV) and has a higher breakdown electric field ($3 \times 10^6$ V/cm to $5 \times 10^6$ V/cm) compared to Si (Si band gap is 1.1 eV and breakdown electric field for Si is $0.3 \times 10^6$ V/cm). SiC is a better thermal conductor (3.7 (W/cm-K) for SiC versus 1.6 (W/cm-K) for Si) which enables SiC devices to operate at extremely high-power levels and still dissipate the large amounts of excess heat generated. These material properties of SiC offer multiple advantages of using SiC instead of Si on power devices. In a comparison of SiC and Si semiconductor die with identical structures and dimensions, the SiC die exhibits a lower specific ON resistance and a higher breakdown voltage than the Si die.

The disclosed embodiments herein provide novel techniques for SiC DMOSFET design and fabrication for shaping of the electric field over the device structure and reducing concentration of electric fields at singular points. The embodiments herein reduce the electric field in the gate oxide region to less than 3.5 MV/cm and improve the device reliability.

The manufacturing process in Si uses techniques like diffusion of dopants but these conventional manufacturing processes are not possible for making SiC device because the diffusion coefficients in SiC are negligible at temperatures below 1800 °C. SiC devices are manufactured by ion implantation of both source and p-well regions but ion implantation and especially deep ion implantation is difficult in SiC. In the embodiments herein, the ion implantation of source and p-well regions are made deep with novel techniques.

The increased reliability, higher operating temperature, increased efficiency, higher voltage capabilities of the SiC devices of the embodiments herein as compared to the silicon devices make them highly desirable in the electric vehicle and renewable energy industries. Traction inverters in electric vehicles are subjected to high thermal (> 150°C) and load cycling and renewable energy converters are subjected to extreme environmental conditions. The embodiments described herein for the SiC devices maximize power conversion efficiency to >98% for example while providing high reliability thus making it an ideal candidate for electric vehicles to minimize maintenance and downtime, which is expensive for the operators of the electric vehicles.

The disclosed embodiments change the way in which SiC power DMOSFET devices can effectively shield the sensitive gate oxide from the high electric fields present in 4H-SiC especially during high drain bias (blocking mode operation).

In embodiments herein, SiC power DMOSFET devices overcome the trade-off between achieving a low ON resistance and achieving a robust blocking performance, which implies a low electric field in the structure close to a gate oxide.

Embodiments herein include a unit cell of a SiC power DMOSFET comprising a vertical MOSFET. Certain regions of the SiC power DMOSFET device are a p-well region, which is formed by an implantation, an N+ source region, a N- drift layer, and an N+ substrate. In the embodiment herein, during the ON state the current flows vertically from the drain, through the inversion layer which is formed at the top of the p-well layer, when a gate voltage is applied to this device in through the N+ source region and out through the source metallization. In the OFF state or the blocking state, in the embodiments herein a voltage is supported across the p-well and N- drift layer junction. There is a PN junction which is formed between the p-well and the N drift layer. The voltage applied to the structure is supported across this PN junction in the reverse bias.

In the embodiments herein, a power MOSFET has several physical dimensions, including: the pitch of the unit cell, which is the repeat unit for the MOSFET; the channel length, which is the portion of the p-well in which the inversion channels is formed; the distance between two successive p-wells, referred to as the junction gate field-effect transistor (JFET) region or the JFET gap; the thickness of the gate oxide; and an inter-layer dielectric (ILD) layer, which is used to insulate the source interconnect metallization from the poly-silicon gate.

In the embodiments herein, the advantage of using SiC over Si is that for similar chip sizes, SiC can support much higher power density. The amount of voltage one can support in SiC can be ten times more than in Si, and the current that the SiC chip can carry through the MOSFET can be 10 to 50 times more than in Si. SiC MOSFETs form a convenient switch, because one can achieve much higher power density. The performance advantage relates to the trade-off between voltage and current. Voltage blocking and current conduction capability, is about 200 times better in the case of SiC as compared to Si.

In the embodiment herein, the P+ plug, which is in the center of the SiC DMOSFET unit cell, is replaced by the PS#1 region. In the embodiment the PS#1 region extends below the p-well region. During the blocking condition, the electric field, or the main region where the breakdown can happen, is at the center of the unit cell of a SiC DMOSFET, which is basically between the PS#1 region and the N- drift layer. SiC structures tend to break down between the p-well and the N- drift layer, and especially at the curvature of the p-well region. In the embodiments herein, the structure will break down between the PS#1 region and the N- drift layer. Here the location of the breakdown has been moved towards the center of the unit cell which results in a lower electric field closer to the gate oxide region. There is a reduced electric field close to the gate oxide region in the embodiment due to PS#1 region, and this should make for a more robust device.

The embodiments herein have difference in structure, difference in the method of manufacturing, difference in the functionality of the devices, and difference in the results that the devices produce than the prior art SiC devices. Simulation data of the embodiments herein show the differences in performance and results of structures. In addition to the PS#1 region, the devices of the embodiments herein also have a PS#2 region, which is placed under the N+ source region. This improves the electric field profile in the embodiment in a way that during the blocking mode of operation, the voltage is shed across a larger area of the unit cell, which results in even more robust operation. In the embodiments herein, the PS#2 region could be deeper than the p-well region and could be made shallower than the PS#1 region. In the embodiment herein of all the P-type regions in the SiC DMOSFET structure, the deepest of them is the PS#1 region, the intermediate one is the PS#2 region, and the shallower one is the p-well region. The embodiments herein show more appropriate electric field shaping from these PS#1 and PS#2 structures.

In the embodiments herein, another advantage of including the PS#2 region is that the PS#2 serves as a secondary p-well region. The design of the p-well region needs to satisfy several different constraints. The electrical dose in the p-well region can be large enough such that the desired breakdown voltage is realized while at the same time, the doping of the p-well region near the gate oxide region where the MOS channel is formed, can be low enough such that a reasonably low threshold voltage is realized.

In the embodiment the p-well region could now satisfy conflicting requirements. By placing the PS#2 under the N+ source region, it relaxes the design of the p-well region, whose purpose now is solely for channel definition and channel formation. In embodiments herein, the p-well does not have to be designed with the objective of supporting the breakdown voltage. The embodiments herein give a lot more flexibility to the designer to design the p-well region suitably only for MOS channel formation.

In the embodiment herein, the PS#1 is formed after a trench is etched into the N+ source region which is in the middle of the unit cell of the SiC DMOSFET. The advantage of this trench is that it moves the electric field location farther away from the gate oxide interface and to the middle of the unit cell of the SiC DMOSFET. In the embodiment etching a recess trench into the N+ source region, effectively creates a deeper PS#1 region. The electric field moves even further away from the gate oxide region, which would make for more robust blocking capability. In the embodiments herein, one of the reasons for doing the trench is because ion implantation and particularly deep ion implantation in SiC is difficult. Deep PS#1 sinker region can be made because of source trench. In the embodiments herein etching a trench and then doing the ion implantation, allows to make a deeper PS#1 region, which is effective and achieves the functionality.

In the embodiments herein since the trench helps in making a deeper PS#1 due to the source trench allows to make a thinner oxide region by reducing the oxide. SiC DMOSFET needs a thicker oxide to prevent them from breaking down in a dielectric field. In the embodiments herein by introducing the P-type sinker regions, one can use thinner oxide.

In the embodiments herein, the SiC DMOSFET devices are made using a series of masking steps followed by either ion implantation or etching and a deposition step. In the embodiments herein, the unit cell is produced where a series of structures are made using photolithography that is used to mask certain portions of the wafer or certain portion of device, and implementing certain steps, and then removing that mask, and doing the other steps. To minimize the number of steps is of great importance to realize cost-effectiveness. That is, the cost structure is lower if one can somehow reduce the number of steps. Also, certain steps in manufacturing of SiC are expensive, and the embodiments herein minimize the number of those expensive steps. For example, ion implantation is a relatively expensive step in SiC. p-well, P-plug, and N+ source regions are made using ion implantation. Ion implantations are expensive steps, particularly deeper ion implantation is even more expensive. So, minimizing deep ion implantation is of importance. Further, P-type Implantation is 5 to 10 times more expensive than doing N-type Implantation, since P-type implantation needs to be performed at higher temperatures (400-1000°C) in contrast to N-type implants which can be performed at room-temperature. So, minimizing P-type implants is also of importance.

In the embodiments, herein the wafer goes through a series of ion implantation steps first, which is typically called the front end of the process, then there is a high temperature annealing, which is used to anneal out the implant damage and electrically activate the implants. The back end of the process typically consists of forming the gate oxide, ILD and other metallization steps.

In the embodiments herein to make the SiC DMOSFET structure, photolithography would be used to mask a certain part of the wafer to create a p-well region, following which, a next masking step could be used to realize an N+ source region, followed by another masking step would be used to realize the P+ plug region. The wafers would need to be annealed to activate the implanted regions. After this, a gate oxide or a gate dielectric can be grown by either thermal oxide or using a deposited oxide. A gate metallization can be formed using a polysilicon or other refractory metals. The gate metallization is then selectively patterned and etched to access the N+ source regions, following which the ILD is deposited and then patterned to realize the window for creating these ohmic contacts for the N+ source regions. The ohmic contact can be realized on the backside of the wafer, which is the drain, for the drain region. At the end of the process, a source interconnect metallization is used to connect the various unit cells.

SiC MOSFET is typically produced in several masking steps. Some of these masking steps could be for forming implanted regions, while other masking steps are for forming structures such as gate oxide, ILD etc. The embodiments herein are all done in 11 masking steps without increasing a masking step for any additional feature like PS#1, PS#2, source trench formations or other structures in the embodiments.

In SiC, ion implantation is a method to introduce dopants since diffusion does not work well. So, to realize the PS#1 region to be deeper than the p-well region, requires higher implantation energy. In the embodiments herein typically either aluminum or boron is used for realizing P-type regions in SiC. So, for realizing the PS#1 region and a deep PS#1 region, in the embodiments herein boron implantation is used in lieu of aluminum implantation, since for a given energy, the boron implantation can result in deeper regions as compared to aluminum implantation. Another way to realize a deep PS#1 region is to use a much higher energy and still use aluminum as the P-type dope.

In an embodiment herein, a p-well region is formed, following which, the N+ source region is formed. While forming the N+ source region, ion implantation is performed to realize the PS#2 region. The same masking step is used for forming the N+ source region and the PS#2 region. In the embodiment herein, this enables one to realize a PS#2 region exactly under the N+ source region.

In the embodiments herein, the N+ source implant is made self-aligned to the p-well implant, to reduce or even eliminate misalignment which could occur if the two regions are realized in different masking steps.

In the embodiment herein to realize sub 0.5-micron channel lengths or sub 1-micron channel lengths the first p-well region is formed using a traditional implantation masking step. A dielectric layer of a sufficient thickness is deposited, and then using photolithography, one would selectively pattern this layer, and then perform ion implantation, to realize the p-well region. Once this is done, a second dielectric layer is deposited on top of this patterned first dielectric layer, and then subjected to a blanket etch. This results in a dielectric spacer region which then defines the region which is subjected to the N+ source implant. So, by choosing an appropriate thickness of the second dielectric layer, one can define the MOS channel length.

In the embodiment herein to realize a channel which is 0.5-micron wide first create a p-well region using conventional photolithography technique, for example one may deposit and pattern silicon dioxide layer, then one may deposit a second silicon dioxide layer of a thickness equal to like 0.5-micron. When one etches this layer down, one would realize a spacer which would be 0.5-micron also. When one performs the N+ source implant, one would have effectively an MOS channel length of 0.5-micron.

In the embodiment, the channel length is formed not by the limitations of lithography techniques, but by the ability of depositing dielectric layers, for example silicon dioxide, where one has much better control. One can deposit dielectric or silicon dioxide layers with a resolution which is much better than what lithography can allow.

In one method called the subtractive method, the process first fabricates a N+ source, then deposits a dielectric layer, and then forms the P+ layer through the poly-silicon variation. The embodiments herein do the additive method, where first one does the p-well, and then deposits the dielectric of a controlled thickness, which will define the channel length, and then put the N+ source. So, the order of N+ and p-well is reversed in the embodiments herein when compared to how prior art SiC DMOSFET's are formed.

The embodiments herein avoid implanting N+ source region in the gate region. In a SiC MOSFET structure there exists a parasitic NPN transistor, that can get triggered not during normal operation but when you're switching this device from OFF to ON or ON to OFF with extremely high speed.

In the embodiments herein, the trench into the N+ source region is formed prior to the implantation of the PS#1 region results in a deeper PS#1 region. But another benefit of doing this is that one can also remove the N+ source regions from the portions of the device that do not want the N+ source region to be implanted. So, that is the secondary benefit of having a trench etched into the N+ source region. The same masking step is used for performing the SiC dry etch, and then implanting the PS#1 region. This is achieved with just one masking step. In an embodiment, the PS#2 region is formed along with the N+ source region with the same masking step. The SiC trench and the PS#1 region are again formed using the same masking step. In this embodiment, four features are made using two masking steps.

In the embodiments herein, the cost of PS#1 sinker is reduced, because one does not have to employ deep ion implantation. Deep ion implantation, which are high doses, is expensive. And on the periphery, having a deep P+ is also beneficial, to prevent breakdown regions that can be formed. In the embodiments herein, one is avoiding the breakdown region at the periphery because one is using a single step for creating PS#1 and the trench. When one forms the MOS channel in a self-aligned fashion, N+ source region is formed everywhere where one has a p-well region, which extends to even the periphery of the device. In the embodiments herein, one avoids the breakdown at the periphery due to formation of trench and PS#1.

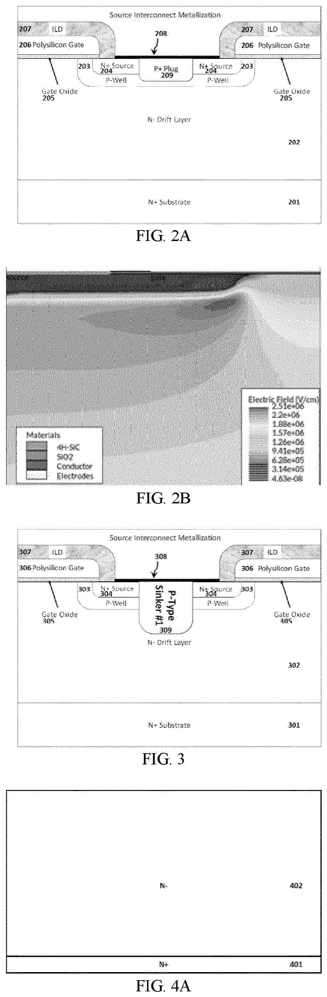

An embodiment shown in Fig. 2A is the unit cell of a cross-sectional structure of a SiC DMOSFET. The key regions of this device are a p-well region **203,** which is formed by ion- implantation or epitaxial re-growth of a p-type species such as aluminum or boron. There is an N+ source region **204,** N- drift layer **202,** and an N+ substrate **201.** In the ON state when a gate voltage is applied to the polysilicon gate **206,** the current flows vertically from the drain **201,** through the inversion layer which is formed at the top of the p-well layer **203,** through the N+ source region **204,** and out through the source metallization **208.** In the OFF state or the blocking state, a voltage is supported across the p-well **203,** N- drift layer **202** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **205.** Another feature is an ILD layer **207** which is used to insulate the source interconnect metallization **208** from the poly-silicon gate **206.** At the very center of the unit cell, there is a P+ plug layer **209** which is grounded with the N+ source metallization. The purpose of the P+ plug in SiC DMOSFET is to ground the p-well region with the N+ source contact. Typically, the depth of the P+ plug implant is made shallower than the p-well region as shown in Fig. 2A. The DMOSFET device structure can result in high electric field concentration at the corner of the p-well region **203,** which results in a high electric field in the gate oxide layer **205,** especially during high drain bias (blocking mode) operation. The high critical electric fields for breakdown in 4H-SiC ($\approx 3$ MV/cm) results in a very high (> 5 MV/cm) electric field in the gate oxide. Fowler-Nordheim tunneling currents are observed at such high electric fields in the gate oxide, which can result in trapped charge in the gate oxide, which leads to poor device reliability. In the embodiment herein, the lateral spacing between p-well regions (JFET region) is made narrow enough to suppress the electric field in the gate oxide while making sure that the MOSFET ON-resistance is low enough.

Fig. 2B is the breakdown simulation of a SiC MOSFET shown in Fig. 2A. The simulation shows the peak electric field located at the corner of the p-well region, which results in a certain high electric field in the gate oxide layer. The electric field is strongly concentrated at the corner of the p-well region because that is the region of maximum curvature. (this embodiment has limitation)

An embodiment shown in Fig. 3 is the cross-sectional unit cell of a SiC DMOSFET. The key regions of this device are a p-well region **303,** which is formed by ion- implantation or epitaxial re-growth of a p-type species such as aluminum or boron. There is an N+ source region **304,** N- drift layer **302,** and an N+ substrate **301.** In the ON state when a gate voltage is applied to the polysilicon gate **306,** the current flows vertically from the drain **301,** through the inversion layer which is formed at the top of the p-well layer **303,** through the N+ source region **304,** and out through the source metallization **308.** There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **305.** Another feature is an ILD layer **307** which is used to insulate the source interconnect metallization **308** from the poly-silicon gate **306.** Here the P+ plug region **209** of the SiC DMOSFET from Fig. 2A is replaced with a deep P-type Sinker #1 (PS#1) region **309.** The depth of the PS#1 region, is greater than the depth of the p-well region. During the OFF state or the blocking condition, the structure shown in Fig. 2A, will break down between the p-well **203** and the N- drift layer **202** especially at the curvature of the p-well region. But with the PS#1 region **309** being introduced in Fig. 3 the electric field or the main region where the breakdown will happen, is now at the very center of the drawing, which is basically between the PS#1 region **309** and the N- drift layer **302.** The presence of the deeper PS#1 region results in moving the peak electric field location from the corner of the p-well region **303** to the PS#1 region **309.** The location of the peak electric field in 4H-SiC during high drain bias operation has been moved farther away from the gate oxide **305.** The electric field in the gate oxide **305** is now lower than that of Fig. 2A device.

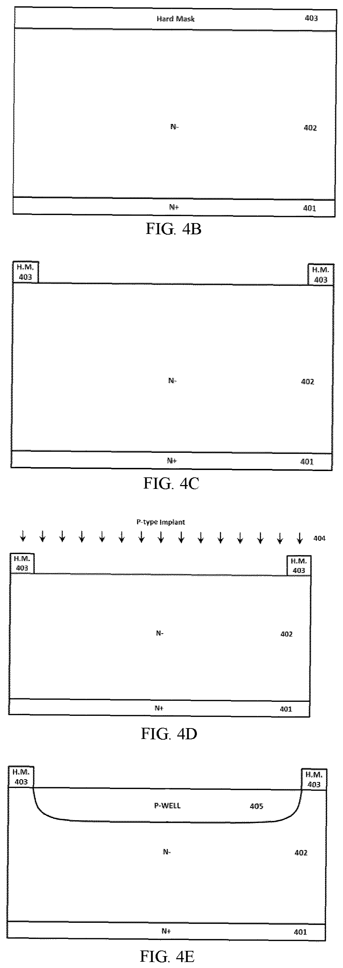

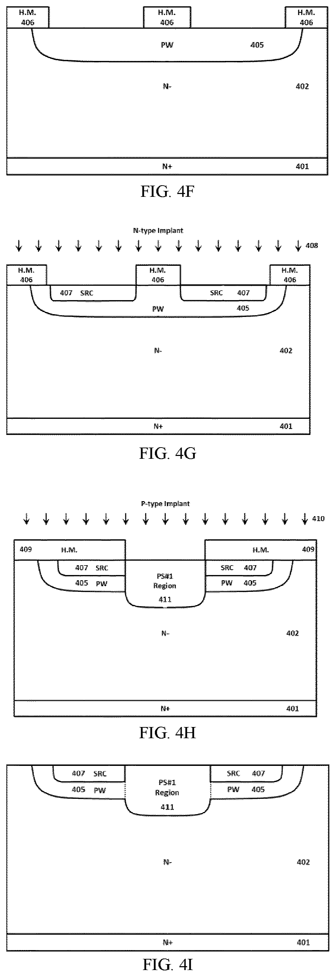

Fig. 4A to Fig. 4R describes the process of manufacturing the structure shown in Fig. 3. The manufacturing process for a SiC DMOSFET is on a SiC substrate **401** and starts with using a 4H-SiC Si-face epi-wafer with suitable doping ($10^{14}$ - $10^{18}$ cm$^{-3}$) and thickness (1 $\mu$m to 300 $\mu$m) for the epilayer **402** shown in Fig. 4A. A blanket hard mask **403** (comprising a CVD deposited layer of silicon dioxide, silicon nitride, silicon oxynitride, or a metallic layer such as nickel, with thickness ranging from 50 nm to 5 $\mu$m) is deposited in Fig. 4B and then patterned using photolithography followed by a dry etch (using a reactive ion-etch for example) as shown in Fig. 4C. A P-type implantation **404** (comprising boron or aluminum, at energies ranging from 10 keV to 800 keV, at implant doses ranging from $10^{12}$ cm$^{-2}$ to $10^{15}$ cm$^{-2}$) in Fig. 4D is performed to create a p-well **405** in Fig. 4E. The mask **403** is removed, and another hard mask layer **406** is deposited (comprising a CVD deposited layer of silicon dioxide, silicon nitride, silicon oxynitride, or a metallic layer such as nickel, with thickness ranging from 50 nm to 5 $\mu$m) and patterned in Fig. 4F to define the N+ source region. Notice that the center of the unit cell is masked for source (SRC) implantation. The SRC (N+ source region) **407** is formed by implantation of the n-type (N+) impurity **408** (comprising nitrogen or phosphorus, at energies ranging from 10 keV to 500 keV, at implant doses ranging from $10^{13}$ cm$^{-2}$ to $10^{16}$ cm$^{-2}$) as shown in Fig. 4G. After removing the hard mask **406** another hard mask layer **409** is deposited and patterned in Fig. 4H. The PS#1 region **411** is formed by implantation of the p-type impurity **410** in Fig. 4H. The deep PS#1 region can be formed using ion-implantation of aluminum or boron, which are commonly used p-type dopants in 4H-SiC.

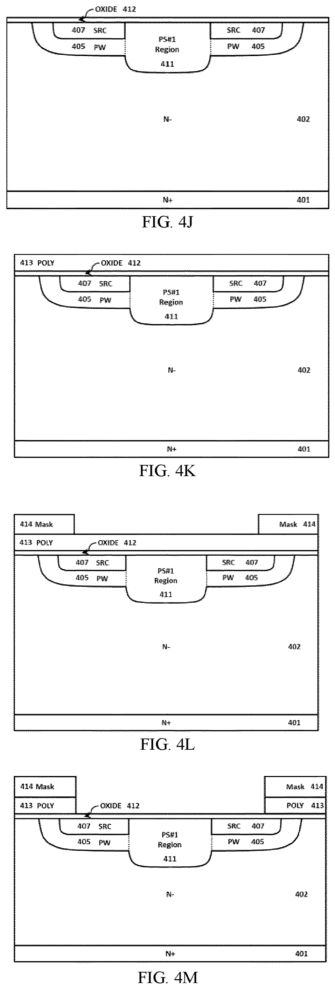

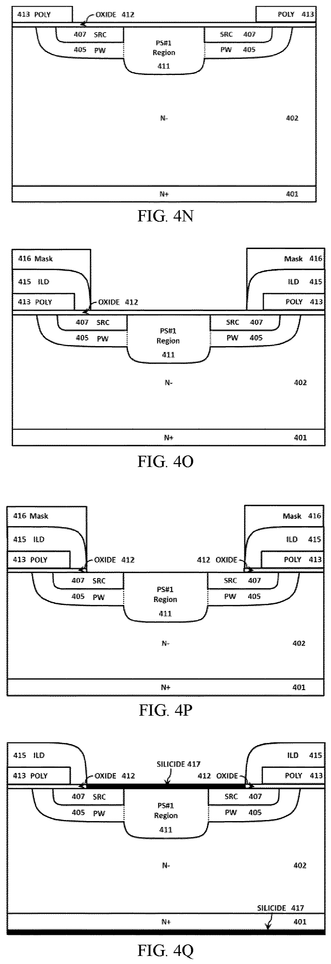

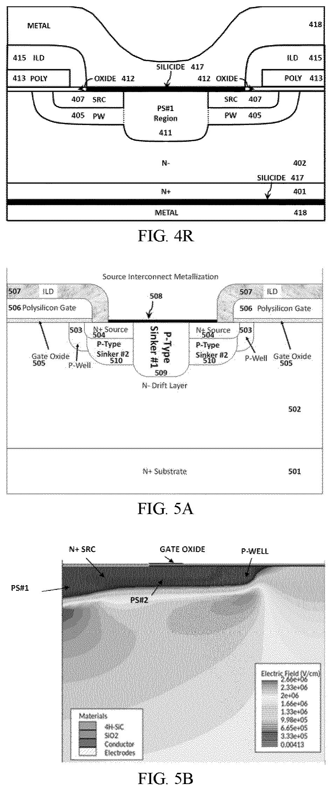

Boron can be advantageously used for forming this deep P-type Sinker region, since it has significantly higher implant range as compared to aluminum, and deep implants using boron can be formed with lower ion-implantation energies. In one example, the PS#1 region can be formed with boron implantation with a 20-50% higher depth as compared to the p-well region. The boron implant may comprise of energies ranging from 10 keV to 800 keV, at implant doses ranging from $10^{12}$ cm$^{-2}$ to $10^{15}$ cm$^{-2}$. In a related embodiment of this invention, the doping profile of the PS#1 region can be formed with gradually decreasing doping concentration with a peak value at the SiC surface. This graded doping profile for the PS#1 region can prevent the formation of sharp corners in the 3-Dimensional landscape and is beneficial for spreading the peak electric field during high drain bias operation over a larger area which results in a higher breakdown voltage. In one example, the PS#1 region can be formed with a peak doping in the range of $10^{19}$ cm$^{-3}$ to $10^{20}$ cm$^{-3}$ close to the SiC surface, which linearly decreases as a function of depth into the silicon carbide to the background N-drift layer doping (in the range of $10^{14}$-$10^{16}$ cm$^{-3}$). A linearly graded doping profile of the PS#1 region results in a sufficient portion of the drain potential being supported within the PS#1 region and not only the N- drift region. This results in a pseudo charge-balanced structure, which promotes breakdown over a larger SiC region, which results in a lower critical electric field at breakdown and consequently a lower electric field in the gate insulator. This is followed by the removal of the hard mask **409** (using either dry or wet etching techniques commonly practiced by those in the field) in Fig. 4I. Then the oxide layer **412** which is the gate oxide is either thermally grown or deposited using chemical vapor deposition (CVD) in Fig. 4J. The thickness of the gate oxide could range from 10 nm to 100 nm. Either dry or wet thermal oxidation could be used for oxide growth. Plasma-enhanced CVD (PECVD) or low-pressure CVD (LPCVD) could be used for gate oxide deposition. A polysilicon gate layer is then deposited on the top **413** in Fig. 4K. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. A hard mask **414** is deposited on top and patterned as shown in Fig. 4L. The polysilicon gate layer **413** is etched by using the patterned mask layer **414** in Fig. 4M. The mask layer **414** is then removed from the top in Fig. 4N. An interlayer dielectric (ILD) layer **415** (comprising 50 nm - 1000 nm thick silicon dioxide, silicon nitride, silicon oxynitride layers or a stacked combination thereof) is deposited on the wafer; a hard mask **416** is deposited and patterned on top to define the ILD opening; the ILD layer is patterned using the hard mask **416** as shown in Fig. 4O. Further the gate oxide is etched using the same mask **416** in Fig. 4P. The mask **416** is then removed and a nickel silicide region **417** is formed on the exposed SiC surface in Fig. 4Q. Interconnect metal layers **418** (either Al or Ag or Au) is deposited and patterned on the top and bottom of the chip in Fig. 4R.

The main problem in the prior art device in Fig. 1A as recognized by the authors of this invention is that the p-well regions do not effectively shield the sensitive gate oxide from the high electric fields present in 4H-SiC especially during high drain bias (blocking mode operation). The presence of the deeper PS#1 region results in moving the peak electric field location from the corner of the p-well region to the PS#1 region. In other words, the location of the peak electric field in 4H-SiC during high drain bias operation has been moved farther away from the gate oxide.

The advantage of this embodiment is that the breakdown location has been moved from the corner of the p-well region to the base of the newly formed PS#1 region, which is both farther away from the gate oxide interface and deeper into the semiconductor. The electric field in the gate oxide for the device structure incorporating the PS#1 region is now significantly lower than the prior art device which is shown using device simulation using SILVACO ATLAS in Fig. 5B.

An embodiment shown in Fig. 5A is the cross-sectional unit cell of a vertical power DMOSFET. The key regions of this device are a p-well region **503,** which is formed by ion-implantation or epitaxial re-growth of a p-type species such as aluminum or boron. There is an N+ source region **504,** N- drift layer **502,** and an N+ substrate **501.** In the ON state when a gate voltage is applied to the polysilicon gate **506,** the current flows vertically from the drain **501,** through the inversion layer which is formed at the top of the p-well layer **503,** through the N+ source region **504,** and out through the source metallization **508.** There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **505.** Another feature is an ILD layer **507** which is used to insulate the source interconnect metallization **508** from the poly-silicon gate **506.** Here a second P-type Sinker #2 (PS#2) region **510** under the N+ source region **504** is formed in addition to the PS#1 region **509** already described in an embodiment shown in Fig. 3. The PS#2 region is formed deeper than the p-well region **503** but shallower than the PS#1 region **509.** For example, the PS#2 region **510** can be made 20% deeper than the p-well region **503,** while the PS#1 region **509** can be made 20% deeper than the PS#2 region **510.**

The presence of the PS#2 region results in a sharing of the peak electric field under high drain bias operation between the PS#1 and PS#2 regions. The presence of the PS#2 region alleviates a local maximum of the peak electric field in the device structure under high drain bias conditions. In the prior art SiC MOSFET shown in Fig. 1A, the design of the p-well region needs to satisfy conflicting requirements. The electrical dose in the p-well region under the N+ source region must be high enough to prevent reach-through breakdown under off-state (high drain bias) operation. But, at the same time, the surface doping of the p-well region must be low enough to maintain a reasonably low gate threshold voltage and device ON resistance. In this context, the PS#2 region introduced in this embodiment can be thought of as a secondary p-well region and can be designed with the main purpose of preventing reach-through breakdown and for appropriately shaping the electric field profile under high drain bias operation. The presence of the PS#2 region frees up the constraint in the design of the primary p-well region, which can be used for ON-state related device metrics such as gate threshold voltage and ON resistance. Since with the introduction of the PS#2 region, p-well region does not have to be designed with the objective of supporting the breakdown voltage it gives a lot more flexibility to the designer to design the p-well region suitably for just MOS channel formation.

Breakdown simulation Fig. 5B of a SiC DMOSFET designed according to the two embodiments described in Fig. 3 and Fig. 5A shows that the peak electric field location has been moved away from the corner of the p-well region to the center of the unit cell, which results in a lower electric field in the gate oxide layer.

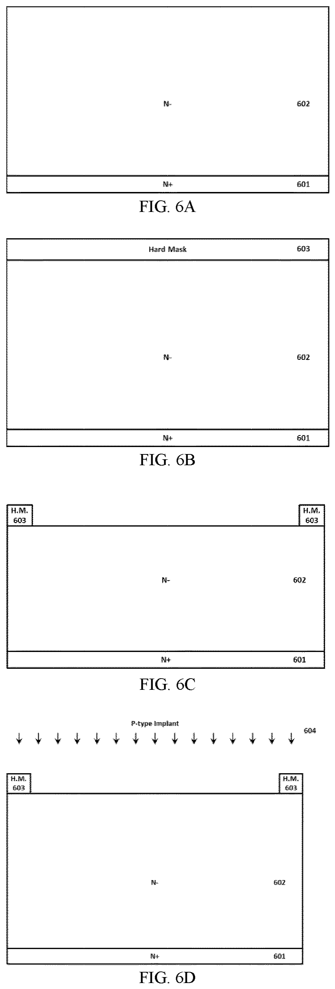

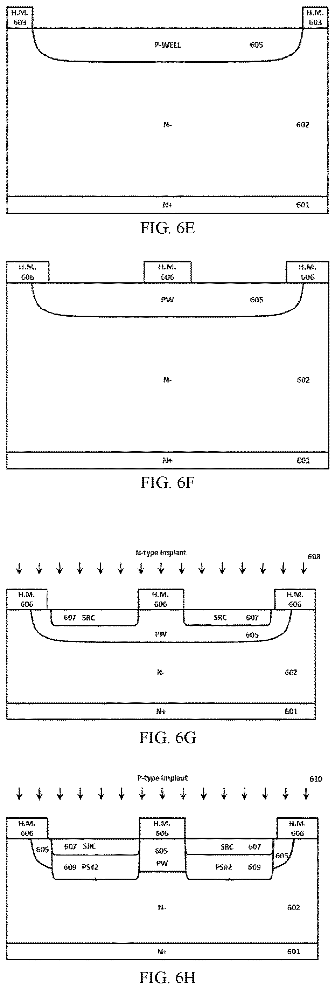

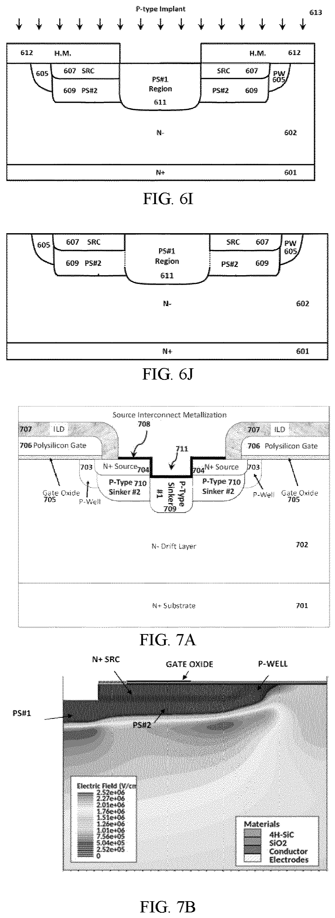

Fig. 6A to Fig. 6J describes the process of manufacturing the structure shown in Fig. 5a. The manufacturing process for a SiC DMOSFET is on a SiC substrate **601** and starts with using a 4H-SiC Si-face epi-wafer with suitable doping ($10^{14}$ - $10^{18}$ cm$^{-3}$) and thickness (1 $\mu$m to 300 $\mu$m) for the epilayer **602** shown in Fig. 6A. A blanket hard mask **603** (comprising a CVD deposited layer of silicon dioxide, silicon nitride, silicon oxynitride, or a metallic layer such as nickel, with thickness ranging from 50 nm to 5 $\mu$m) is deposited in Fig. 6B and then patterned using photolithography followed by a dry etch (using a reactive ion-etch for example) as shown in Fig. 6C. A P-type implantation **604** (comprising Boron or Aluminum, at energies ranging from 10 keV to 800 keV, at implant doses ranging from $10^{12}$ cm$^{-2}$ to $10^{15}$ cm$^{-2}$) is performed in Fig. 6D to create a p-well **605** in Fig. 6E. The mask **603** is removed, and another hard mask layer **606** is deposited (comprising a CVD deposited layer of silicon dioxide, silicon nitride, silicon oxynitride, or a metallic layer such as nickel, with thickness ranging from 50 nm to 5 $\mu$m) and patterned in Fig. 6F to define the N+ source region. Notice that the center of the unit cell is masked for source (SRC) implantation. The SRC (N+ source region) **607** is formed by implantation of the n-type (N+) impurity **608** (comprising nitrogen or phosphorus, at energies ranging from 10 keV to 500 keV, at implant doses ranging from $10^{13}$ cm$^{-2}$ to $10^{16}$ cm$^{-2}$) as shown in Fig. 6G. The PS#2 region **609** is formed by implantation of the P type impurity **610** as shown in Fig. 6H. The deep PS#2 region can be formed using ion-implantation of aluminum or boron, which are commonly used p-type dopants in 4H-SiC. Boron can be advantageously used for forming this deep P-type Sinker region, since it has significantly higher implant range as compared to aluminum, and deep implants using boron can be formed with lower ion-implantation energies. If using aluminum, the PS#2 region may comprise implant energies ranging from 100 keV to 1 MeV and implant dose ranging from $10^{13}$ cm$^{-2}$ to $10^{16}$ cm$^{-2}$. If using boron, the PS#2 region may comprise implant energies ranging from 50 keV to 800 keV and implant dose ranging from $10^{13}$ cm$^{-2}$ to $10^{16}$ cm$^{-2}$. The same hard mask **606** utilized for forming the N+ source region is utilized for defining the ion-implanted PS#2 region. In this case, the PS#2 region is self-aligned under the N+ source region. The hard mask **606** is removed and another hard mask layer **612** is deposited and patterned in Fig. 6I. The PS#1 region **611** is formed by implantation of the P-type impurity **613** that may comprise aluminum or boron. Boron can be advantageously used for forming the PS#1 region, since it has significantly higher implant range as compared to aluminum, and deep implants using boron can be formed with lower ion-implantation energies. If using aluminum, the PS#1 region may comprise implant energies ranging from 100 keV to 1 MeV and implant dose ranging from $10^{13}$ cm$^{-2}$ to $10^{16}$ cm$^{-2}$. If using boron, the PS#1 region may comprise implant energies ranging from 50 keV to 800 keV and implant dose ranging from $10^{13}$ cm$^{-2}$ to $10^{16}$ cm$^{-2}$. PS#2 region can be formed with a depth higher than that of the p-well region but lower than that of the PS#1 region. As a second example of this embodiment, the PS#2 region can be made 20% deeper than the p-well region, while the PS#1 region can be made 20% deeper than the PS#2 region. In a related embodiment of this invention, the doping profile of the PS#1 and PS#2 regions can be formed with gradually decreasing doping concentration with a peak value at the SiC surface. This graded doping profile for the PS#1 and PS#2 regions can prevent the formation of sharp corners in the 3-Dimensional landscape and is beneficial for spreading the peak electric field during high drain bias operation over a larger area which results in a higher breakdown voltage. As examples, the PS#1 and PS#2 regions can be formed with a peak doping in the range of $10^{19}$ cm$^{-3}$ to $10^{20}$ cm$^{-3}$ close to the SiC surface and close to the N+ Source region, respectively. The doping concentration in the PS#1 and PS#2 regions may linearly decrease as a function of depth into the silicon carbide to the background N-drift layer doping (in the range of $10^{14}$-$10^{16}$ cm$^{-3}$). A linearly graded doping profile of the PS#1/PS#2 regions results in a sufficient portion of the drain potential being supported within the PS#1/PS#2 regions and not only the N- drift region. This results in a pseudo charge-balanced structure, which promotes breakdown over a larger SiC region, which results in a lower critical electric field at breakdown and consequently a lower electric field in the gate insulator. The formation of the PS#1 region is followed by the removal of the hard mask **612** (dry or wet etch) in Fig. 6J. The remaining steps in the process to create the structure shown in Fig. 5A exactly follows the same steps shown in Fig. 4J to Fig. 4R.

This "staircase" arrangement of the PS#1 and PS#2 regions with certain depths can result in an even lower electric field in the gate oxide under high drain bias operation. Yet another benefit of the PS#2 region is that the p-well region can be made shallower and with a lower implant dose, which can reduce the device ON-resistance while simultaneously increasing the gate threshold voltage, both of which are desirable from an applications standpoint. Thus, a better trade-off between the off-state and on-state performance is enabled by the teachings of this invention.

An embodiment shown in Fig. 7A is the cross-sectional unit cell of a SiC DMOSFET. The key regions of this device are a p-well region **703,** which is formed by ion- implantation or epitaxial re-growth of a p-type species such as aluminum or boron. There is an N+ source region **704,** N- drift layer **702,** and an N+ substrate **701.** In the ON state when a gate voltage is applied to the polysilicon gate **706,** the current flows vertically from the drain **701,** through the inversion layer which is formed at the top of the p-well layer **703,** through the N+ source region **704,** and out through the source metallization **708.** There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **705.** Another feature is an inter-layer dielectric (ILD) layer **707** which is used to insulate the source interconnect metallization **708** from the poly-silicon gate **706.** Here a trench **711** is etched into the N+ source region **704** before implanting the PS#1 region **709.** Here PS#2 region **710** under the N+ source region **704** is formed in addition to the PS#1 region **709.** The PS#2 region is formed deeper than the p-well region **703** but shallower than the PS#1 region **709.** It is desirable to move the electric field location as far away from the gate oxide interface for robust blocking capability of the device operation which improves the device reliability. Moving the breakdown location to the middle of the unit cell which is furthest away from the gate oxide **705** is an embodiment and by etching a recess trench **711** into the N+ source region **704,** you have effectively created a deeper PS#1 region than what was in Fig. 3 and Fig. 5A and moved the electric field even further away from the gate oxide region.

The PS#1 region is designed with the greatest depth among the P-type Sinker regions. While boron implantation is one technique to create such deep P-type regions in SiC technology, when you consider the maximum range of commercial ion-implanters available it becomes clear that ion implantation in SiC is not an easy process and deep ion implantation is particularly difficult. The function of the N+ source region which is also referred to as source trench is that the PS#1 region can be realized with lower ion-implantation energies, which lowers the cost and time of this implantation step, without any compromise in implantation depth. In the embodiment herein, a trench can be dry etched into SiC after the implantation of the N+ source region but before the implantation of the PS#1 region. The same hard mask layer used for the PS#1 implant can be used for etching the source trench into the SiC. In this embodiment herein, the hard mask layer is first patterned, followed by dry etching the trench into SiC, which is immediately followed by ion-implantation of the PS#1 region. The formation of the source trench naturally extends the depth of the PS#1 region. Hence, the PS#1 region can be realized with lower ion-implantation energies, which lowers the cost/time of this implantation step, without any compromise in implant depth. The formation of the source trench also removes the N+ source region and enables a direct connection of the P-well region with the N+ source ohmic contact thereby grounding the p-well and shorting the P-well region with the N+ source region.

Fig. 7B is the breakdown simulation of a SiC MOSFET designed according to Embodiment shown in Fig. 7A which shows that the peak electric field location has been moved away from the corner of the p-well region to the center of the unit cell, which results in a lower electric field in the gate oxide layer.

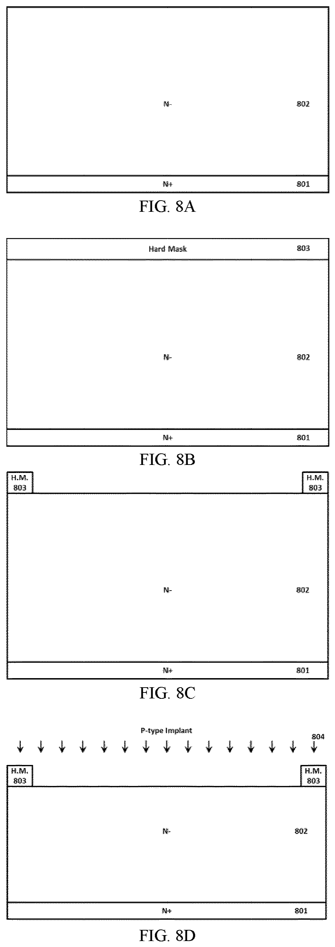

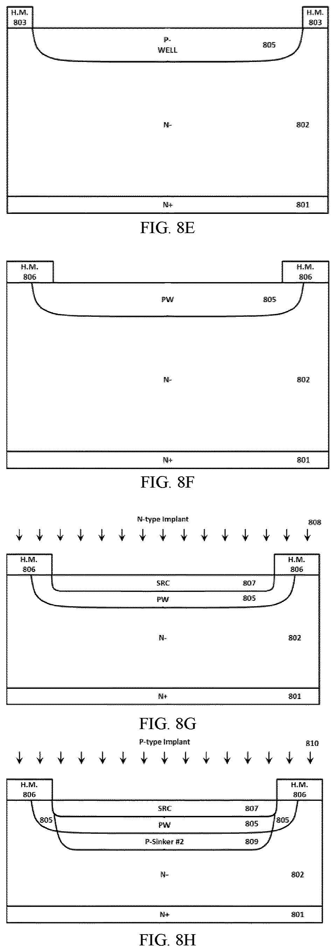

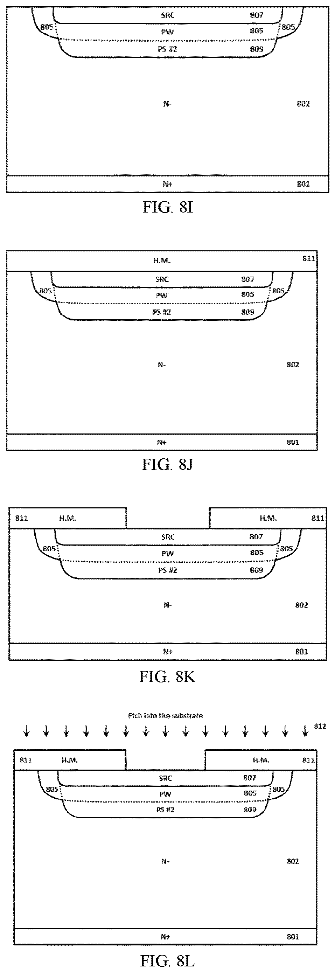

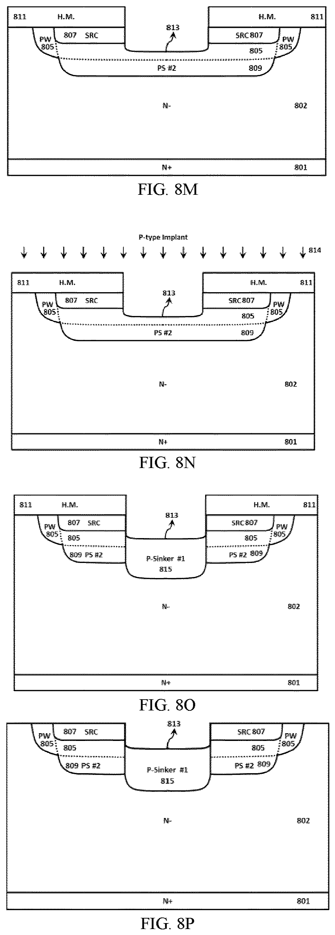

Fig. 8A to Fig. 8BB describes the process of manufacturing the SiC DMOSFET structure shown in Fig. 7A. The manufacturing process for a SiC DMOSFET is on a SiC substrate **801** and starts with using a 4H-SiC Si-face epi-wafer with suitable doping ($10^{14}$ - $10^{18}$ cm$^{-3}$) and thickness (1 $\mu$m to 300 $\mu$m) for the epilayer **802** shown in Fig. 8A. A blanket hard mask **803** (comprising a CVD deposited layer of silicon dioxide, silicon nitride, silicon oxynitride, or a metallic layer such as nickel, with thickness ranging from 50 nm to 5 $\mu$m) is deposited in Fig. 8B and then patterned using photolithography followed by a dry etch (using a reactive ion-etch for example) as shown in Fig. 8C. A P-type implantation **804** (comprising boron or aluminum, at energies ranging from 10 keV to 800 keV, at implant doses ranging from $10^{12}$ cm$^{-2}$ to $10^{15}$ cm$^{-2}$) in Fig. 8D is performed to create a p-well **805** in Fig. 8E. The mask **803** is removed, and another hard mask layer **806** is deposited (comprising a CVD deposited layer of silicon dioxide, silicon nitride, silicon oxynitride, or a metallic layer such as nickel, with thickness ranging from 50 nm to 5 $\mu$m) and patterned in Fig. 8F to define the N+ source region. The N+ source region **807** is formed by implantation of the n-type (N+) impurity **808** (comprising Nitrogen or Phosphorus, at energies ranging from 10 keV to 500 keV, at implant doses ranging from $10^{13}$ cm$^{-2}$ to $10^{16}$ cm$^{-2}$) as shown in Fig. 8G. The PS#2 region **809** is formed by the implantation of the P-type impurity **810** in Fig. 8H. The deep PS#2 region can be formed using ion-implantation of aluminum or boron, which are commonly used p-type dopants in 4H-SiC. Boron can be advantageously used for forming this deep P-type Sinker region, since it has significantly higher implant range as compared to aluminum, and deep implants using boron can be formed with lower ion-implantation energies. The patterned hard mask **806** is removed from the top in Fig. 8I. Another hard mask layer **811** is formed on the top in Fig. 8J and patterned in Fig. 8K. The patterned mask **811** is used to etch **812** into the substrate in Fig. 8L for creating a recessed region. The source trench which is the recessed region **813** is formed in the substrate by penetrating the source region in Fig. 8M. A P-type implant **814** in Fig. 8N is performed for creating the PS#1 region. If using aluminum, the PS#1 region may comprise implant energies ranging from 100 keV to 1 MeV and implant dose ranging from $10^{13}$ cm$^{-2}$ to $10^{16}$ cm$^{-2}$. If using boron, the PS#1 region may comprise implant energies ranging from 50 keV to 800 keV and implant dose ranging from $10^{13}$ cm$^{-2}$ to $10^{16}$ cm$^{-2}$. The PS#1 **815** is formed by the self-aligned implantation of the p-type impurity in Fig. 8O. As described more completely in the above embodiments, a linearly graded doping profile of the PS#1/PS#2 regions may be preferable utilized in lieu of a uniform (abrupt) doping profile, which results in a sufficient portion of the drain potential being supported within the PS#1/PS#2 regions and not only the N- drift region. This results in a pseudo charge-balanced structure, which promotes breakdown over a larger SiC region, which results in a lower critical electric field at breakdown and consequently a lower electric field in the gate insulator.

PS#1 region is designed with the greatest depth among the P-type Sinker regions using Boron implantation and the formation of the trench naturally extends the depth of the PS#1 region. The same hard mask used for etching the source trench **811** is utilized to define the PS#1 region. As will be apparent to those in the field of this invention, the SiC trench can be formed using dry etching techniques including reactive ion-etching, inductively coupled plasma (ICP)-RIE, etc. While a 90° sidewall slope is shown for this trench region in Fig. 7A, it is advantageous to form the trench regions with lower angle (60-90°) sidewalls, since this will reduce the curvature of the PS#1 region, and therefore improve the blocking performance of the device.

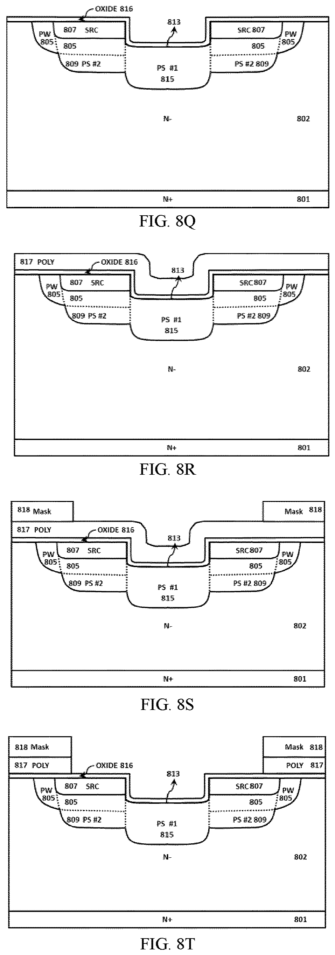

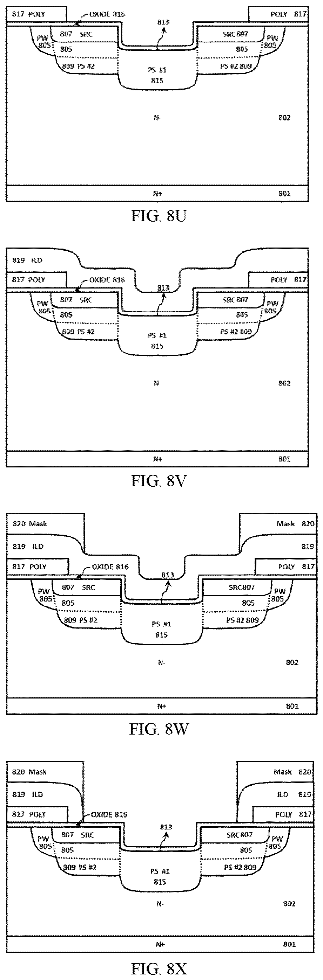

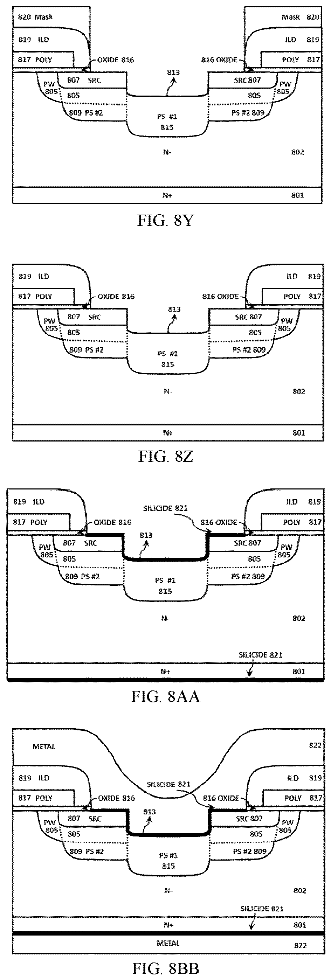

The patterned hard mask **811** is removed from the top in Fig. 8P. An oxide layer **816** for gate oxide is grown in Fig. 8Q. A polysilicon gate layer is deposited on the top **817** in Fig. 8R. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of $POCl_3$ followed by a drive-in step at temperatures ranging from 700-900°C. A hard mask **818** is deposited on top and patterned as shown in Fig. 8S. The polysilicon gate layer **817** is etched by using the patterned mask layer **818** in Fig. 8T. The mask layer **818** is then removed from the top in Fig. 8U. An interlayer dielectric (ILD) layer **819** (comprising 50 nm - 1000 nm thick silicon dioxide, silicon nitride, silicon oxynitride layers or a stacked combination thereof) is deposited on the wafer in Fig. 8V. A hard mask **820** is deposited and patterned on top to define the ILD opening in Fig. 8W. The ILD layer is patterned using the hard mask **820** as shown in Fig. 8X. Further the gate oxide **816** is etched using the same mask **820** in Fig. 8Y. The mask **820** is then removed in Fig. 8Z. A nickel silicide region **821** is formed on the exposed SiC surface in Fig. 8AA. Interconnect metal layers **822** (either Al or Ag or Au) are deposited and patterned on the top and bottom of the chip in Fig. 8BB.

The advantage of the embodiment herein is that by etching the source trench region, prior to the implantation of the PS#1 region, the breakdown location has been moved further into the semiconductor and farther away from the gate oxide layer. Due to the inherent hardness of silicon carbide, the observed range (depth) of ion-implanted dopants is significantly lower than in silicon. For example, forming deep (> 0.3 $\mu$m) ion-implanted layers in silicon carbide requires extremely high implantation energies (> 300 keV), which requires doubly or triply ionized implantation species, which drastically reduces the throughput and increase the cost of these ion-implantation steps. Forming the source trench as described in this embodiment obviates the need for doubly/triply ionized implantation steps, and low-cost with high-throughput singly ionized implantation can be utilized for realizing the PS#1 region.

Embodiments relate to SiC DMOSFET power devices that can be used for fabricating self-aligned power MOSFETs.

An embodiment relates to increasing MOS channel density.

An embodiment relates to increasing effective field-effect mobility.

An embodiment relates to improved device reliability.

An embodiment relates to reducing ON resistance for a given chip size.

An embodiment relates to design and manufacturing of self-aligned power devices.

An embodiment relates to design and manufacturing MOS channels with sub-micron channel lengths.

An embodiment relates to removal of the parasitic N+ source region inadvertently formed in the periphery of the device.

An embodiment relates to proper grounding of the p-well region with the source ohmic contact in the active region of the device

An embodiment relates to removal of the parasitic NPN transistor formed in active and peripheral regions of self-aligned power devices.

An embodiment relates to a combination of an appropriately located source trench and ion-implanted P+ plug region to enable proper grounding of the p-well region in the main active MOSFET region and removal of a parasitic N+ source region formed in the periphery of the MOSFET

An embodiment relates to the formation of highly doped P+ plug regions in the periphery of the MOSFET, especially under the gate pad and gate bus regions.

An embodiment relates to the suppression of false turn-on of the MOSFET during fast switching transitions, at vulnerable locations, due to threshold voltage lowering by the body bias effect.

An embodiment relates to the improvement of the maximum dV/dt rating of the MOSFET.

An embodiment relates to the improvement of the maximum avalanche energy rating of the MOSFET.

An embodiment relates to a dedicated process step being utilized for masking the implantation of the N+ source region in the device periphery. The P+ plug region is formed first in this embodiment, while the source trench is created later on in the process at the ILD etch step.

An embodiment relates to a dedicated hard mask applied after the sidewall spacer is formed and before the N+ source implantation. This layer prevents the formation of the N+ source region in the device periphery and hence parasitic NPN structures in the device periphery are avoided.

An embodiment relates to a p-well region (P-Well#2) placed under the N+ source region and electrically connected to the main p-well region. The P-Well#2 provides additional electrical dose under the N+ source implant, to prevent reach-through breakdown, especially after the source trench formation.

An embodiment relates to a dedicated process step is utilized for masking the implantation of the N+ source region in the device periphery as well as the N+ source region in the middle of the unit cell in the active region to enable ohmic contact to the p-well region.

An embodiment relates to the formation of the segmented polysilicon gate metallization in the periphery of the device instead of a contiguous gate bus which will decrease the gate-body capacitance of the MOSFET.

An embodiment relates to the decrease of the gate capacitance of the MOSFET.

An embodiment relates to the increase of the switching speed of the MOSFET.

The embodiments described herein show novel techniques for design and manufacture of self-aligned SiC DMOSFET power devices. Due to limited mobility achievable on SiC planar DMOSFET it is necessary to form n-well channels that are submicron length, so that the overall power and ON resistance of the MOSFET are not degraded.

In a MOSFET, the channel region is formed due to the offset between the p-well and the N+ source region. If the p-well and the N+ source regions are formed by two separate masking steps, there can be lithographic misalignment, which will result in asymmetric MOSFET channel lengths on the two sides of a unit cell. In the embodiments described herein, to minimize this asymmetry in the MOS channel length, the p-well and the N+ source implant are done in a self-aligned fashion. There are several techniques proposed in the literature for achieving self-aligned MOSFET, including ones that use an oxide spacer approach to form a self-aligned p-well and N+ source regions, with the N+ source implant under p-well implant.

The embodiments herein describe several innovative techniques during self-aligned channel formation that not only allow for the elimination of the misalignment error during manufacturing of SiC MOSFETs, but also allow the possibility of reducing the channel length. The channel lengths can be made smaller with narrow spacers. While the self-aligning process does provide the benefits of making an arbitrarily short channel length as well as eliminating misalignment, it does create some other problems with respect to the structure of the device outside the unit cells, because n+ regions are co-incident with the p-well regions.

In a conventional MOSFET where the p-well and the N+ source regions are not self-aligned there is a dedicated masking step that will be used for forming the N+ source implant. In the embodiments described herein, in a self-aligned process, there is no dedicated masking step performing the N+ source implant. There is a dedicated masking step performing the p-well implant and followed by depositing the spacer, then etching the spacer followed by implantation for realizing the N+ source region. Everywhere there is a p-well region, there will be N+ source implant as well. It is not desirable to have N+ source implant at the periphery of the device. It is important to terminate the device with just the p-type implant. The various embodiments described herein introduce techniques in which one can get rid of the N+ source implants in the periphery of the device and replace it with some other regions.

The active region of the MOSFET is where the current conduction happens while the periphery region of the MOSFET is where the edge termination of the device is provided to block any voltage. The gate pad and gate bus regions are also considered to be part of the peripheral regions of the MOSFET, for the purposes of describing the innovations in this document. In an embodiment described herein, a combination of an appropriately located source trench and ion-implanted P+ plug region enables proper grounding of the p-well region in the main active MOSFET region and removal of a parasitic N+ source region formed in the periphery of the MOSFET.

In a conventional MOSFET where there is no self-alignment, one can put the source implant wherever needed and then create a region for grounding the p-well. In a self-aligned DMOSFET since the source implant is self-aligned to the p-well, one would have not only the p-well extending all the way to the periphery but also have the N+ source region extends all the way to the periphery.

A parasitic NPN transistor exists in the active region of the MOSFET unit cell, formed by the N+ source region which acts like the N+ emitter, the p-well region which forms the P-base and the N+ source ohmic contact. In the periphery of the device and also under the gate pad metallization, there is no N+ source ohmic contact, and as a result, the emitter, and base regions of the parasitic NPN transistor are not shorted in this region. The parasitic NPN transistor will not be activated under normal DC or switching operation of the MOSFET, but operating the device under extreme conditions can cause the triggering of the parasitic NPN transistor.

In the active region, by creating the source trench one has shorted the emitter and the base of this parasitic NPN transistor and ensured that in the active region of the device, this parasitic transistor will not turn ON. In the periphery of the device without a source trench, the parasitic NPN transistor exists even though it is shorted in the active region. It is possible that the parasitic NPN transistor may turn on in the peripheral region and it is not desirable.

In the embodiment herein, by creating a source trench in the periphery of the device and by providing a p-type implanted plug region, it is ensured that the parasitic NPN transistor is completely removed. Since the emitter of this transistor has been completely removed there is no chance for any kind of parasitic BJT structure. Typically, a separate masking step is carried out for masking the N+ source region from being formed at these locations, but in the embodiment herein, the source trench can be advantageously used for removing the parasitic N+ source regions and replacing them with a P+ plug region, which is self-aligned with the source trench and electrically connected to the p-well region.

The doping concentration of the P+ plug region to be placed in the device periphery can advantageously be made very high. In doing so, another parasitic device effect described here can be avoided. In a typical power MOSFET device structure, moderately doped P-well regions exist in the device periphery with or without a parasitic N+ Source region, as described above. If the N+ Source region is co-incident with the p-well region in the device periphery (i.e., the n+ source region is not deliberately masked from the peripheral region), this results in a partial compensation of the p-type electrical dose of the p-well region. In either case, the p-well regions in the device periphery can be extremely resistive from an electrical standpoint. During switching of the power MOSFET from off- to on-state or vice-versa, the extremely high rate of change of drain voltage (or dV/dt) can result in capacitive current flow through this resistive peripheral p-well regions, which are only collected by the Source ohmic contact in the active region of the MOSFET. In other words, the capacitive current caused by the high dV/dt during device switching has to traverse an extremely long distance from the device periphery to the Source ohmic contact in the active region. The high resistivity of p-well regions in prior art MOSFETs can result in a significant body bias effect, which has the result of lowering the device threshold voltage in those regions. So, these portions of the device can exhibit a false turn-on, which can result in device failure/destruction. The highly doped P+ plug regions in this embodiment can alleviate the aforementioned effect by reducing the amount of body bias developed in the peripheral regions of the MOSFET, which makes the MOSFET described in this embodiment more resilient to dV/dt induced failure. In other words, the MOSFET structure described in this embodiment will have a higher dV/dt rating than prior art MOSFETs. This reduces the switching losses and increases the circuit efficiency.

In an embodiment herein, a dedicated process step is utilized for masking the implantation of the N+ source region in the device periphery. The P+ plug region is formed first in this embodiment, while the source trench is created later on in the process at the ILD etch step.

In the embodiment herein, there is a source trench in the active region of the device but there is no source trench in the periphery of the device. A dedicated masking step is interspersed between the formation of the sidewall spacer after the p-well implant and before the N+ source implant to mask the N+ source implant from the peripheral regions of the MOSFET. The masking layer protects the periphery of the device from the source implanted region. A second deeper p-well region (P-Well#2) is formed using the same masking step used for the N+ source implant. P+ plug regions are formed in a later step in both the active regions of the device as well as the device periphery. A trench is later etched through the N+ source regions at discrete locations in the active region to contact the P+ plug regions, which get shorted to the N+ source region by the ohmic or silicide metallization.

In an embodiment herein, the source region implantation is masked from the periphery of the device. A dedicated process step is utilized for masking the implantation of the N+ source region in the device periphery as well as the N+ source region in the middle of the unit cell in the active region to enable ohmic contact to the p-well region.

In an embodiment herein, the polysilicon metallization has been segmented in the periphery of the device and is not one continuous layer as commonly seen. There is a dedicated masking step interspersed between formation of the sidewall spacer, after the p-well implant and before the implementation of the N+ source implant, to mask the N+ source region, from both the peripheral regions of the device as well as the selected areas in the active region.

In an embodiment herein segmenting the polysilicon metallization reduces the parasitic gate to body or gate to source capacitance which are parasitic capacitances. The islands of polysilicon are not disconnected but are connected at a position orthogonal to the plane of the drawing. Reducing the parasitic capacitance will enable the device to switch faster, which will increase the circuit efficiency by reducing the switching losses.

An embodiment shown in Fig. 10 is the unit cell and the device periphery of a cross-sectional structure of a SiC DMOSFET. The key regions of this device are a p-well region **203,** which is formed by ion- implantation or epitaxial re-growth of a p-type species such as aluminum or boron. There is an N+ source region **204,** N- drift layer **202,** and an N+ substrate **201.** In the ON state when a gate voltage is applied to the polysilicon gate **208** the current flows vertically from the drain **201,** through the inversion layer which is formed at the top of the p-well layer **203,** through the N+ source region **204,** and out through the source metallization **211.** In the OFF state or the blocking state, a voltage is supported across the p-well **203,** N-drift layer **202** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the junction gate field-effect transistor (JFET) region or the JFET gap and the thickness of the gate oxide **207.** Another feature is an ILD layer **209** which is used to insulate the source interconnect metallization **211** from the polysilicon gate **208.**

Source trench regions **205** are realized by dry etching through the N+ source layer at selected locations of the device, followed by a p-type ion-implantation step to realize P+ plug regions **206** under the source trench. At the very center of the unit cell, there is a P+ plug layer **206** which is grounded with the N+ source metallization. The purpose of the P+ plug in SiC DMOSFET is to ground the p-well region with the N+ source contact.

The formation of the source trench **205** device structure enables proper grounding of the p-well region in the main active MOSFET region and removal of a parasitic N+ source region **204** formed in the periphery of the MOSFET. When the N+ source region is formed in a self-aligned fashion with the p-well region, the formation of the source trench after the N+ source region formation removes parasitic N+ source regions from the device periphery of the chip and from under the gate pad region.

In the embodiment herein, combination of the source trench and the ion-implanted P+ plug region provides three important functions. First it provides proper grounding of the p-well region with the source ohmic contact in the active region of the device and second it helps in the removal of the parasitic N+ source region inadvertently formed in the periphery of the device. Third, the highly doped P+ plug region increases the dV/dt rating of the MOSFET. In the embodiment herein both of the above ensures the removal of the parasitic NPN transistor that would be otherwise formed in those regions.

While a parasitic NPN transistor also exists within the MOSFET unit cell, the N+ emitter (formed by the N+ source region) and the P-base (formed by the p-well region) are shorted by the N+ source ohmic contact. However, in the periphery of the device and also under the gate pad metallization, there is no N+ source ohmic contact, and as a result, the Emitter and Base regions of the parasitic NPN transistor are not shorted in this region. While this parasitic NPN transistor will not be activated under normal DC or switching operation of the MOSFET, operation of the device under extreme conditions like short-circuit or avalanche-mode results in the simultaneous presence of extremely high junction temperatures, high dV/dt and high current densities, which can cause the triggering of the parasitic NPN transistor. Typically, a separate masking step is carried out for masking the N+ source region from being formed at these locations. But in the embodiment herein, the source trench can be advantageously used for removing the parasitic N+ source regions and replacing them with a P+ plug region, which is self-aligned with the source trench and electrically connected to the p-well region.

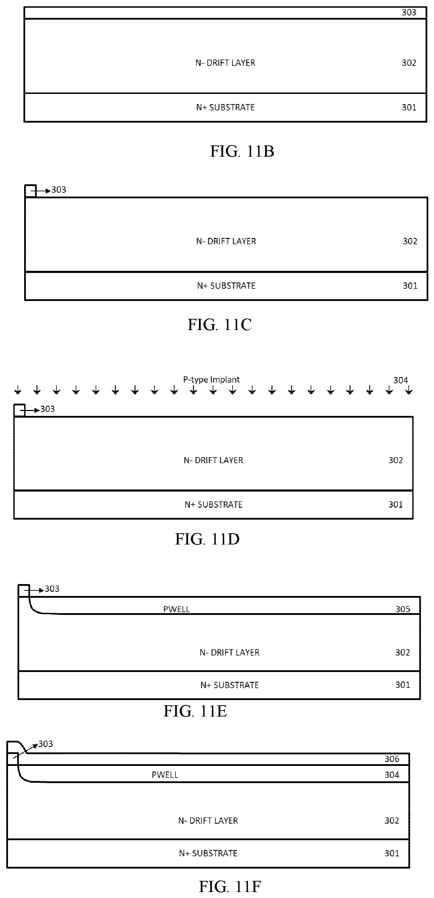

Fig. 11A to Fig. 11FF describes the process of manufacturing the structure shown in Fig. 10. The manufacturing process for a SiC DMOSFET is on a SiC substrate **301** and starts with using a 4H-SiC Si-face epi-wafer with suitable doping ($10^{14}$ - $10^{18}$ cm$^{-3}$) and thickness (1 $\mu$m to 300 $\mu$m) for the epilayer **302** shown in Fig. 11A. A blanket hard mask **303** comprising a chemical vapor deposition (CVD) deposited layer of silicon dioxide, silicon nitride, silicon oxynitride, or a metallic layer such as nickel, with thickness ranging from 50 nm to 5 $\mu$m is deposited in Fig. 11B and then patterned using photolithography followed by a dry etch using reactive ion etching (RIE) for example as shown in Fig. 11C. Then p-well region is first formed by ion-implantation or epitaxial growth using aluminum or boron as the p-type impurity. A p-type implantation **304** comprising boron or aluminum, at energies ranging from 10 keV to 800 keV, at implant doses ranging from $10^{12}$ cm$^{-2}$ to $10^{15}$ cm$^{-2}$ in Fig. 11D is performed to create a p-well **305** in Fig. 11E.

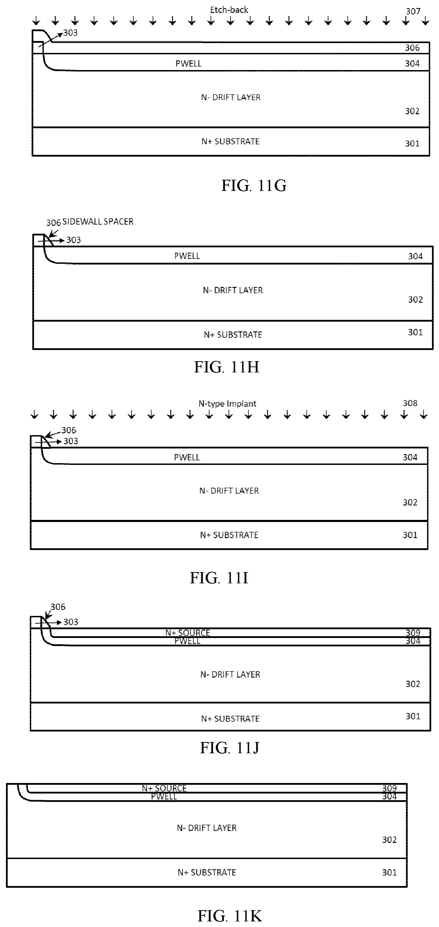

A second hard mask layer **306** is deposited by a CVD deposited layer of silicon dioxide, silicon nitride, silicon oxynitride, or a metallic layer such as nickel, with thickness ranging from 50 nm to 5 $\mu$m in Fig. 11F on top of the patterned first hard mask layer **303.** This is followed by an anisotropic etching **307** in Fig. 11G to form a sidewall spacer **306** as shown in Fig. 11H.

A n-type implant **308** is done in Fig. 11I for creating a N+ source region **309** in Fig. 11J. A N+ source region is formed by ion-implantation or by epitaxial re-growth by a n-type impurity such as nitrogen or phosphorus. Thus, the source region **309** is formed in a self-aligned fashion with the p-well region **304.** The first and second hard mask layers **303** and **306** respectively, are removed in Fig. 11K. While the aforementioned sequence of process steps constitutes one method to form a self-aligned p-well and N+ source region, other methods may be employed to achieve the same result. For example, the N+ source region **309** may first be formed after deposition and patterning of a first hard mask layer, followed by further etch back of the first hard mask layer to then form the p-well region **304.**

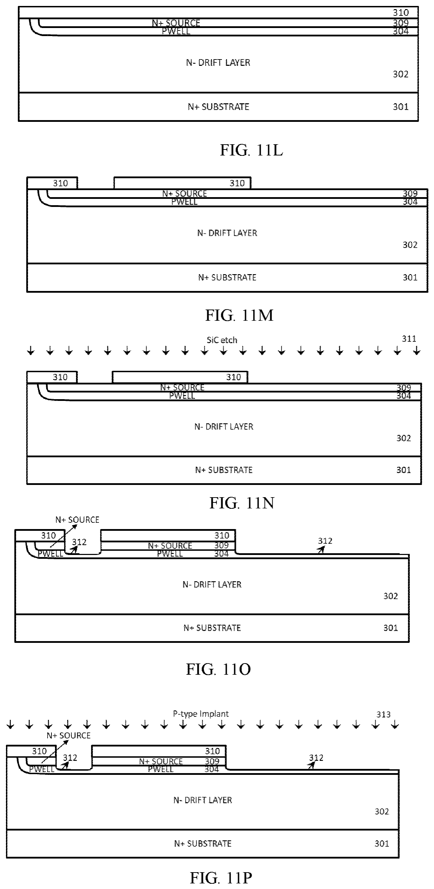

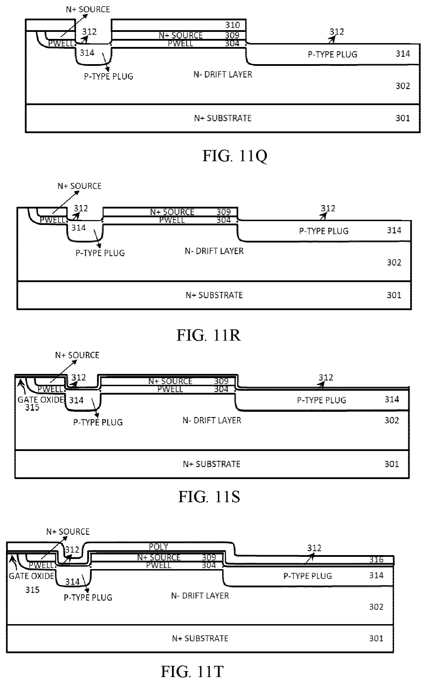

Another mask layer **310** is deposited by a CVD deposited layer of silicon dioxide, silicon nitride, silicon oxynitride, or a metallic layer such as nickel, with thickness ranging from 50 nm to 5 $\mu$m on the top in Fig. 11L. The mask layer **310** is patterned in Fig. 11M. The patterned mask **310** is used to etch into the substrate **311** in Fig. 11N using a dry etch method to create a recessed region within the SIC. The recessed region is the source trench **312** formed in the substrate by penetrating the source region in Fig. 11O. The entire N+ source region is removed by dry etching at these selected locations of the device. Using the same hard mask **310,** by implantation of a controlled dose of a p-type impurity **313** such as aluminum or boron in Fig. 11P a P+ plug layer is formed in Fig. 11Q. The depth of the P+ plug layer **314** may preferably exceed the depth of the N+ source implant and may even exceed the depth of the p-well region, in a particular implementation. A p-type implantation comprising boron or aluminum, at energies ranging from 10 keV to 800 keV, at implant doses ranging from $10^{13}$ cm$^{-2}$ to $10^{17}$ cm$^{-2}$ in Fig. 11D is performed to create a P+ plug region. The P+ plug region **314** is realized under the source trench **312,** which is electrically connected to the p-well region **304.** The mask layers are removed in Fig. 11R. The wafer is annealed for activating the implanted impurities.

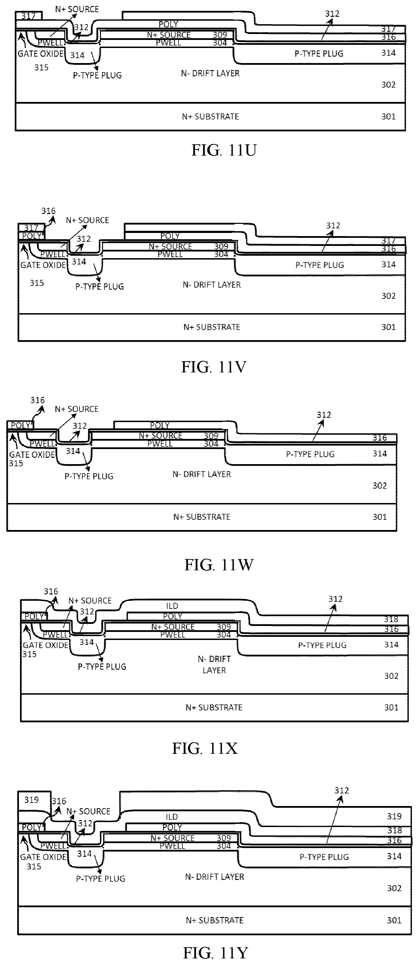

The oxide layer **315** which is the gate oxide is formed by thermal oxidation or using CVD of a dielectric layer such as silicon dioxide, silicon nitride, silicon oxynitride, etc. in Fig. 11S. The thickness of the gate oxide could range from 5 nm to 100 nm. Either dry or wet thermal oxidation could be used for oxide growth. Plasma-enhanced chemical vapor deposition (PECVD) or low-pressure chemical vapor deposition (LPCVD) could be used for gate oxide deposition. A polysilicon gate layer **316** is then deposited in Fig. 11T. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 600-900°C. A hard mask **317** is deposited by a CVD deposited layer of silicon dioxide, silicon nitride, silicon oxynitride, or a metallic layer such as nickel, with thickness ranging from 50 nm to 5 $\mu$m on the top on top and patterned as shown in Fig. 11U. The polysilicon layer **316** is etched by using the patterned mask layer **317** in Fig. 11V. The mask layer **317** is then removed in Fig. 11W. An ILD layer **318** comprising 50 nm - 1000 nm thick silicon dioxide, silicon nitride, silicon oxynitride layers or a stacked combination thereof is deposited on the wafer in Fig. 11X.

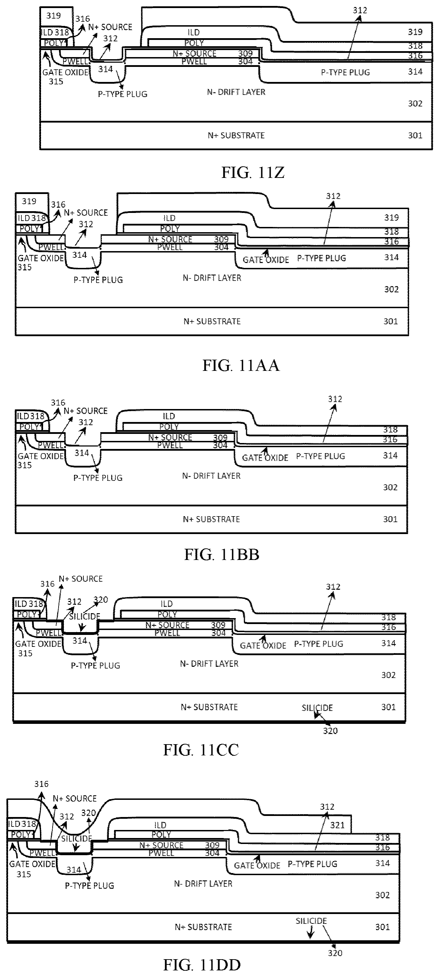

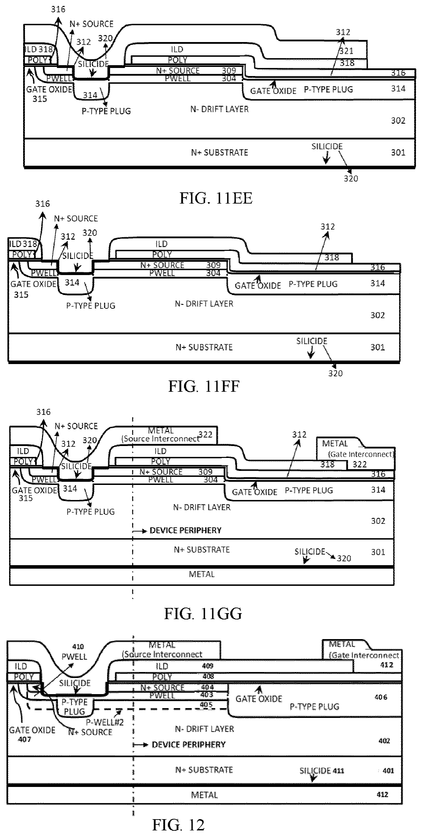

A hard mask **319** is deposited by a CVD deposited layer of silicon dioxide, silicon nitride, silicon oxynitride, or a metallic layer such as nickel, with thickness ranging from 50 nm to 5 $\mu$m on the top and patterned on top to define the ILD opening in Fig. 11Y. The ILD layer **318** is etched using the hard mask **319** as shown in Fig. 11Z. Further the gate oxide **315** is etched using the same mask **319** in Fig. 11AA. The mask **319** is then removed in Fig. 11BB. A nickel silicide region **320** is formed on the exposed SiC surface in Fig. 11CC. A mask layer **321** is formed by a CVD deposited layer of silicon dioxide, silicon nitride, silicon oxynitride, or a metallic layer such as nickel, with thickness ranging from 50 nm to 5 $\mu$m on the top and patterned in Fig. 11DD. The ILD layer **318** is etched using mask **321** in Fig. 11EE. The mask layer **321** is removed in Fig. 11FF. Interconnect metal layers **322** of either aluminum or silver or gold is deposited and patterned on the top and bottom of the substrate in. Fig. 11GG.

In the embodiment herein, the same final structure for forming the source trench region and P+ plug region may be alternatively realized using a slightly different approach. As in the above method, the p-well region, and the N+ source region is realized using a self-aligned process. However, in the embodiment herein, the P-plug layer may be formed first using deep boron or aluminum implantation as a buried layer that is placed under the N+ source region. The dry etching for the N+ source trench realization may be performed later on in the process. The N+ source trench may be realized preferably after the high-temperature annealing process in one example implementation.

An embodiment shown in Fig. 12 is the unit cell and the device periphery of a cross-sectional structure of a SiC DMOSFET. The key regions of this device are a p-well region **403,** which is formed by ion- implantation or epitaxial re-growth of a p-type species such as aluminum or boron. There is an N+ source region **404,** N- drift layer **402,** and an N+ substrate **401.** In the ON state when a gate voltage is applied to the polysilicon gate **407** the current flows vertically from the drain **401,** through the inversion layer which is formed at the top of the p-well layer **403,** through the N+ source region **404,** and out through the source metallization **412.** In the OFF state or the blocking state, a voltage is supported across the p-well **403,** N-drift layer **402** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **407.** Another feature is an ILD layer **409** which is used to insulate the source interconnect metallization **412** from the polysilicon gate

A dedicated masking step is interspersed between the formation of the sidewall spacer after the p-well implant and before the N+ source implant to mask the N+ source implant from the peripheral regions of the MOSFET. A second deeper p-well region (P-Well#2) **405** is formed using the same masking step used for the N+ source implant. P+ plug regions **406** are formed in a later step in both the active regions of the device as well as the device periphery. The P+ plug layer **406** is grounded with the N+ source metallization. The purpose of the P+ plug in SiC DMOSFET is to ground the p-well region with the N+ source contact.

A trench **410** is later etched through the N+ source regions at discrete locations in the active region to contact the P+ plug regions, which get shorted to the N+ source region by the ohmic silicide **411** metallization. The source trench **410** is etched into the SiC at selected regions using the same hard mask used for patterning the interlevel dielectric layer (ILD). In the embodiment herein, the source trench **410** serves two functions. First the source trench reveals the surface of the P+ plug layer that was previously buried under the N+ source region for subsequent contact with the ohmic silicide metal and second the source trench reveals the sidewalls of the N+ source region for subsequent contact with the ohmic silicide metal.

In the embodiment herein, a dedicated hard mask or photoresist layer is applied after the sidewall spacer is formed and before the N+ source implantation. This layer prevents the formation of the N+ source region in the device periphery and parasitic NPN structures in the device periphery are avoided

In the embodiment herein, a second p-well region (P-Well#2) **405** is placed under the N+ source region **404** and electrically connected to the main p-well region provides additional electrical dose under the N+ source implant, for preventing reach-through breakdown, especially after the source trench formation. The etching of the source trench may inadvertently etch part of the primary p-well region under the N+ source region, thereby locally reducing the p-well dose in this region, resulting in undesirable reach through breakdown at these locations.

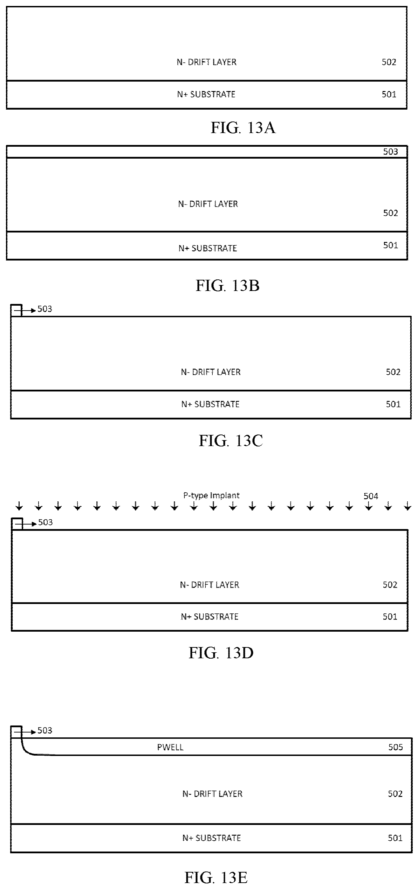

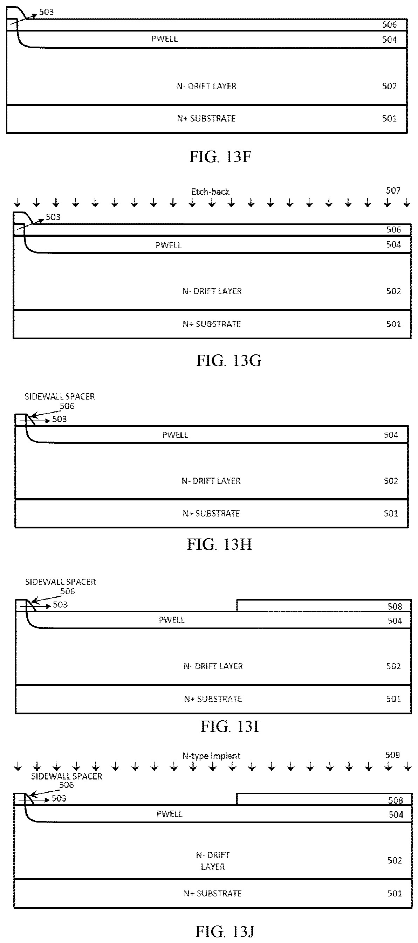

Fig. 13A to Fig. 13GG describes the process of manufacturing the structure shown in Fig. 12. The manufacturing process for a SiC DMOSFET is on a SiC substrate **501** and starts with using a 4H-SiC Si-face epi-wafer with suitable doping ($10^{14}$ - $10^{18}$ cm$^{-3}$) and thickness (1 $\mu$m to 300 $\mu$m) for the epilayer **502** shown in Fig. 13A. A blanket hard mask **503** comprising a CVD deposited layer of silicon dioxide, silicon nitride, silicon oxynitride, or a metallic layer such as nickel, with thickness ranging from 50 nm to 5 $\mu$m is deposited in Fig. 13B and then patterned using photolithography followed by a dry etch using RIE for example as shown in Fig. 13C. Then p-well region is first formed by ion-implantation or epitaxial growth using aluminum or boron as the p-type impurity. A p-type implantation **504** comprising boron or aluminum, at energies ranging from 10 keV to 800 keV, at implant doses ranging from $10^{12}$ cm$^{-2}$ to $10^{15}$ cm$^{-2}$ in Fig. 13D is performed to create a p-well **505** in Fig. 13E.

A second hard mask layer **506** is deposited by a CVD deposited layer of silicon dioxide, silicon nitride, silicon oxynitride, or a metallic layer such as nickel, with thickness ranging from 50 nm to 5 $\mu$m in Fig. 13F on top of the patterned first hard mask layer **503**. This is followed by an anisotropic etching **507** in Fig, 13G to form a sidewall spacer **506** as shown in Fig. 13H. A patterned mask layer **508** is deposited by a CVD deposited layer of silicon dioxide, silicon nitride, silicon oxynitride, or a metallic layer such as nickel, with thickness ranging from 50 nm to 5 $\mu$m on the top alongside the patterned mask layer with the sidewall spacer in Fig. 13I. The hard mask layer **508** patterned over the peripheral regions of the device.

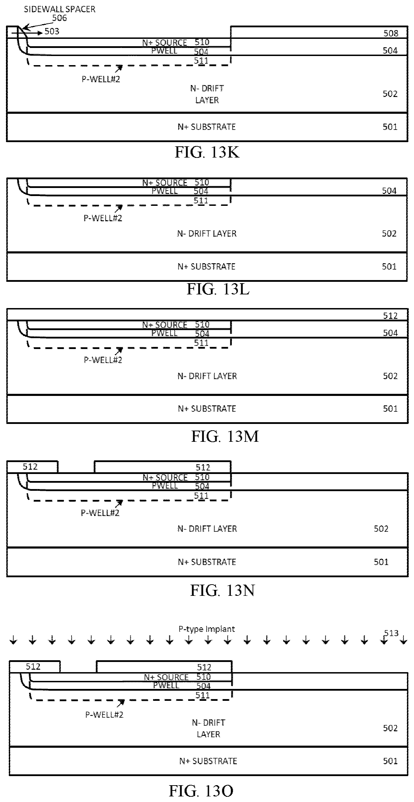

A n-type implant **509** is done in Fig. 13J for creating a N+ source region **510** in Fig. 13J. A N+ source region is formed by ion-implantation or by epitaxial re-growth by a n-type impurity such as nitrogen or phosphorus. The N+ source region **510** is formed in a self-aligned fashion with the p-well region **504**. The source region is formed in a self-aligned fashion with the p-well region, while it is masked from the peripheral regions of the device. A deep second p-well region (P-Well#2) **511** may be formed at the same time as the N+ source region in Fig. 13K. The buried P-well#2 region may be formed using aluminum or boron, and placed under the N+ source region in the active area of the device. The P-Well#2 region may be preferably formed using the p-type species boron which has a higher ion-implantation range as compared to aluminum in SiC. It may not be necessary to mask the p-well region#2 from the peripheral regions of the device.

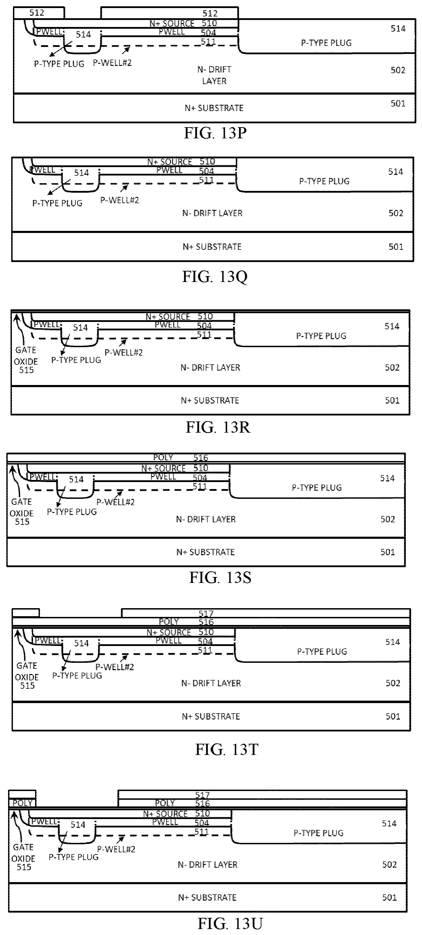

The first and second hard mask layers **503** and **506** respectively, are removed in Fig. 13L. Another mask layer **512** is deposited by a CVD deposited layer of silicon dioxide, silicon nitride, silicon oxynitride, or a metallic layer such as nickel, with thickness ranging from 50 nm to 5 $\mu$m on the top in Fig. 13M. The mask layer **512** is patterned in Fig. 13N. By implantation with a controlled dose of a p-type impurity **513** such as aluminum or boron in Fig. 13O a P+ plug region **514** buried under the N+ source region **510** is realized in Fig. 13P. The P+ plug region **514** is electrically connected to the p-well region **504** and the P-Well#2 region **511.** The P+ plug region may be formed deeper than the p-well and P-Well#2 regions. The mask layer **512** is then removed in Fig. 13Q and the implants are activated by high-temperature annealing.

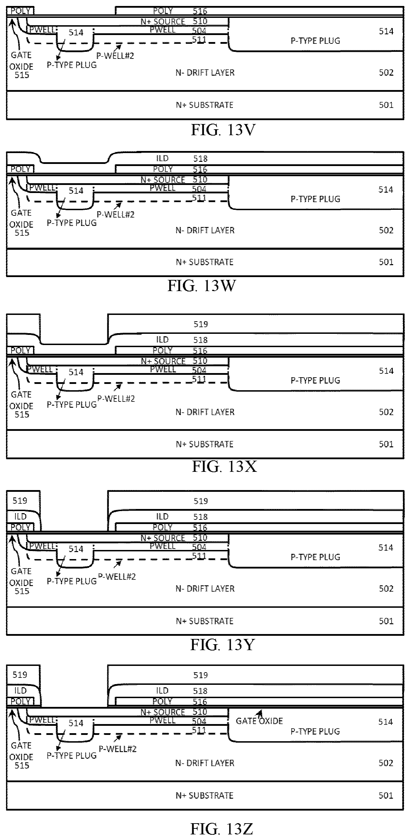

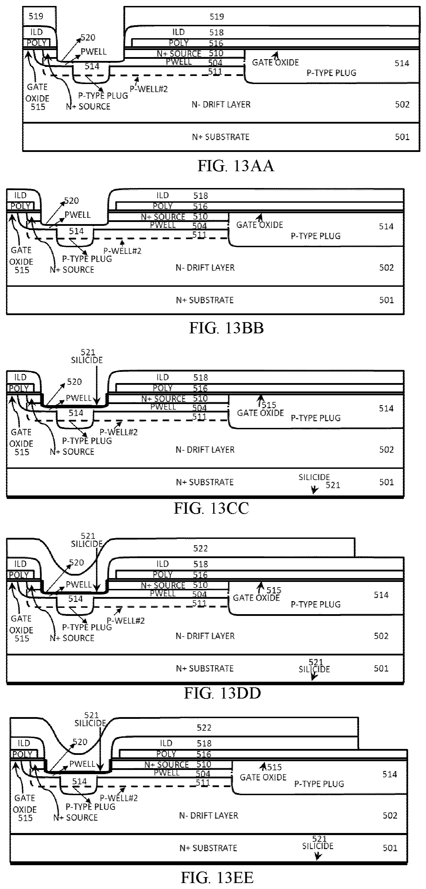

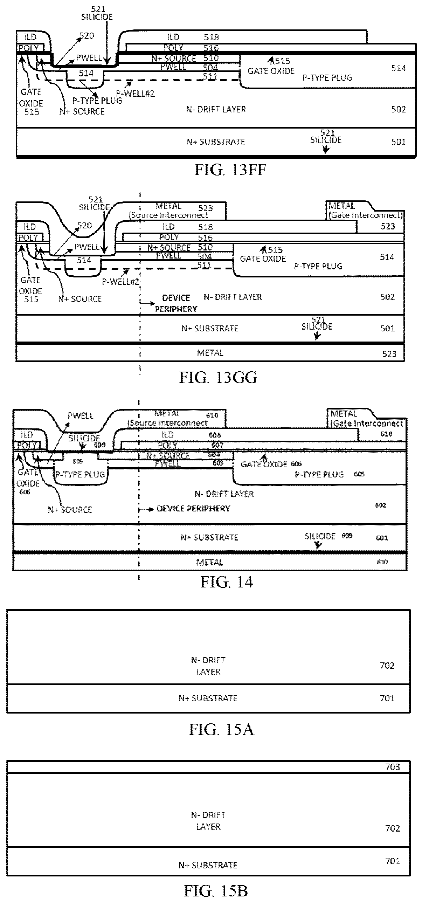

The oxide layer **515** which is the gate oxide is formed by thermal oxidation or using CVD of a dielectric layer such as silicon dioxide, silicon nitride, silicon oxynitride, etc. in Fig. 13R. The thickness of the gate oxide could range from 10 nm to 100 nm. Either dry or wet thermal oxidation could be used for oxide growth. PECVD or LPCVD could be used for gate oxide deposition. A polysilicon gate layer **516** is then deposited in Fig. 13S. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. A hard mask **517** is deposited by a CVD deposited layer of silicon dioxide, silicon nitride, silicon oxynitride, or a metallic layer such as nickel, with thickness ranging from 50 nm to 5 $\mu$m on the top on top and patterned as shown in Fig. 13T. The polysilicon layer **516** is etched by using the patterned mask layer **517** in Fig. 13U. The mask layer **517** is then removed in Fig. 13V. An ILD layer **518** comprising 50 nm - 1000 nm thick silicon dioxide, silicon nitride, silicon oxynitride layers or a stacked combination thereof is deposited on the wafer in Fig. 13W. A hard mask **519** is deposited by a CVD deposited layer of silicon dioxide, silicon nitride, silicon oxynitride, or a metallic layer such as nickel, with thickness ranging from 50 nm to 5 $\mu$m on the top and patterned on top to define the ILD opening in Fig. 13X. The ILD layer **518** is etched using the hard mask as shown in Fig. 13Y. Further the gate oxide **515** is etched using the same mask **519** in Fig. 13Z. The hard mask that is used for patterning the ILD layer **519** is used to realize the source trench region **520** by etching completely through the N+ source layer and into the P+ plug layer in Fig 13AA. The mask **519** is then removed in Fig. 13BB. A nickel silicide region **521** is formed on the exposed SiC surface in Fig. 13CC. A mask layer **522** is formed by a CVD deposited layer of silicon dioxide, silicon nitride, silicon oxynitride, or a metallic layer such as nickel, with thickness ranging from 50 nm to 5 $\mu$m on the top which is then patterned in Fig. 13DD. The ILD layer **518** is etched in Fig. 13EE. The mask layer **522** is removed in Fig. 13FF. Interconnect metal layers **523** of either aluminum or silver or gold is deposited and patterned on the top and bottom of the substrate in. Fig. 13GG. The ohmic contact to the N+ source regions are made through the etched sidewalls of the source trench regions in this embodiment, as opposed to the horizontal surfaces of the N+ source regions in conventional MOSFETs.

An embodiment shown in Fig. 14 is the unit cell and the device periphery of a cross-sectional structure of a SiC DMOSFET. The key regions of this device are a p-well region **603,** which is formed by ion- implantation or epitaxial re-growth of a p-type species such as aluminum or boron. There is an N+ source region **604,** N- drift layer **602,** and an N+ substrate **601.** In the ON state when a gate voltage is applied to the polysilicon gate **607** the current flows vertically from the drain **601,** through the inversion layer which is formed at the top of the p-well layer **603,** through the N+ source region **604,** and out through the source metallization **610.** In the OFF state or the blocking state, a voltage is supported across the p-well **603,** N-drift layer **602** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **606.** Another feature is an ILD layer **608** which is used to insulate the source interconnect metallization **610** from the polysilicon gate **607.** At the very center of the unit cell, there is a P+ plug layer **605** which is grounded with the N+ source metallization. The purpose of the P+ plug in SiC DMOSFET is to ground the p-well region with the N+ source contact.

In an embodiment herein, a dedicated masking step is interspersed between the formation of the sidewall spacer after the p-well implant and before the N+ source implant to mask the N+ source implant from the peripheral regions of the MOSFET. This also masks the N+ source implant from selected regions in the active area of the device, which enables ohmic contact to the p-well or P+ plug region. This embodiment obviates the need for a source trench that is present in earlier embodiments.

In the embodiment herein, a dedicated hard mask or photoresist layer is applied after the sidewall spacer is formed and before the N+ source implantation which prevents the formation of the N+ source region in the device periphery and parasitic NPN structures in the device periphery are avoided. The implantation of the N+ source region is avoided in selected areas in the active region, and this enables ohmic contact to the p-well or P+ plug regions without an intervening N+ source region.

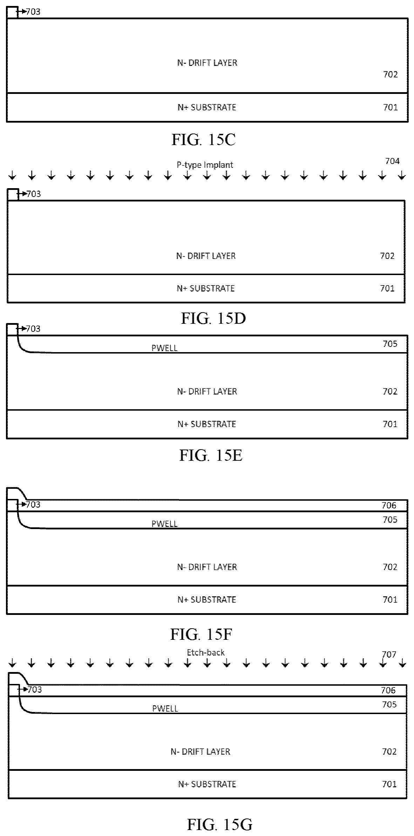

Fig. 15A to Fig. 15FF describes the process of manufacturing the structure shown in Fig. 14. The manufacturing process for a SiC DMOSFET is on a SiC substrate **701** and starts with using a 4H-SiC Si-face epi-wafer with suitable doping ($10^{14}$ - $10^{18}$ cm$^{-3}$) and thickness (1 $\mu$m to 300 $\mu$m) for the epilayer **702** shown in Fig. 15A. A blanket hard mask **703** comprising a CVD deposited layer of silicon dioxide, silicon nitride, silicon oxynitride, or a metallic layer such as nickel, with thickness ranging from 50 nm to 5 $\mu$m is deposited in Fig. 15B and then patterned using photolithography followed by a dry etch using RIE for example as shown in Fig. 15C. Then p-well region is first formed by ion-implantation or epitaxial growth using aluminum or boron as the p-type impurity. A p-type implantation **704** comprising boron or aluminum, at energies ranging from 10 keV to 800 keV, at implant doses ranging from $10^{12}$ cm$^{-2}$ to $10^{15}$ cm$^{-2}$ in Fig. 15D is performed to create a p-well **705** in Fig. 15E.

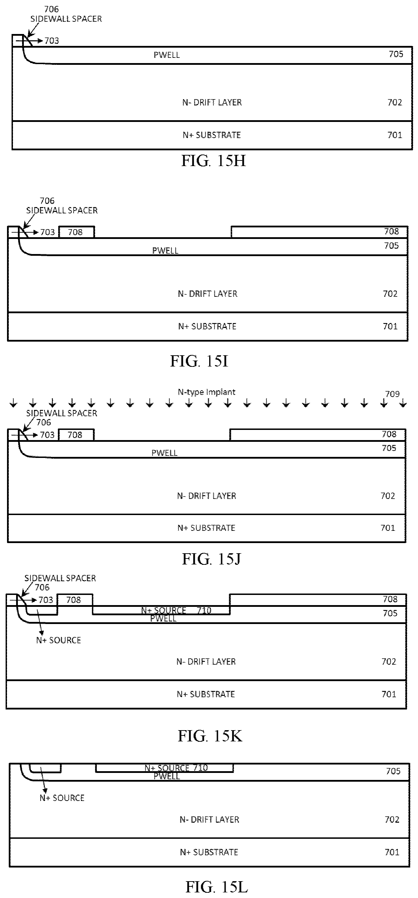

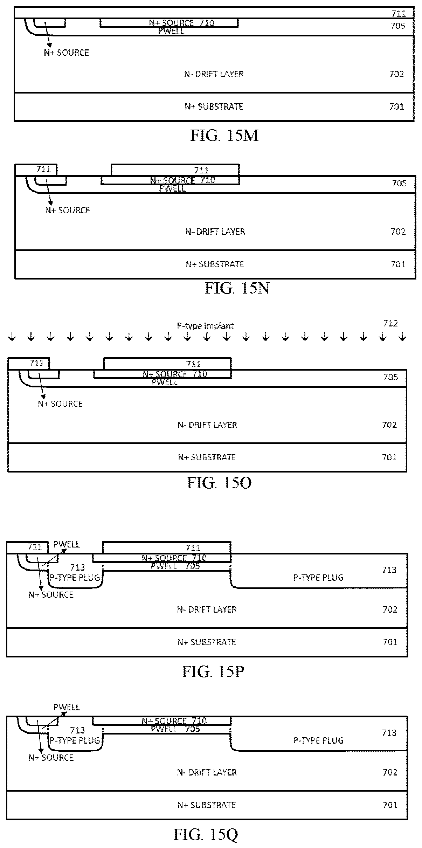

A second hard mask layer **706** is deposited by a CVD deposited layer of silicon dioxide, silicon nitride, silicon oxynitride, or a metallic layer such as nickel, with thickness ranging from 50 nm to 5 $\mu$m in Fig. 15F on top of the patterned first hard mask layer **703.** This is followed by an anisotropic etching **707** in Fig. 15G to form a sidewall spacer **706** as shown in Fig. 15H. A hard mask layer **708** is deposited by a CVD deposited layer of silicon dioxide, silicon nitride, silicon oxynitride, or a metallic layer such as nickel, with thickness ranging from 50 nm to 5 $\mu$m and patterned in Fig. 15I. The patterned mask layer is formed on the top alongside the patterned mask layer with the sidewall spacer **706.** A n-type implant **709** is done in Fig. 15J for creating a N+ source region **710** in Fig. 15K. A N+ source region is formed by ion-implantation or by epitaxial re-growth by a n-type impurity such as nitrogen or phosphorus. Thus, the source region **710** is formed in a self-aligned fashion with the p-well region **705** while it is masked from the peripheral regions of the device, as well as selected areas of the active region of the device, to enable contact with the source ohmic metallization. The first and second hard mask layers **703** and **708** respectively, are removed in Fig. 15L. Another mask layer **711** is deposited by a CVD deposited layer of silicon dioxide, silicon nitride, silicon oxynitride, or a metallic layer such as nickel, with thickness ranging from 50 nm to 5 $\mu$m on the top in Fig. 15M. The mask layer **711** is patterned in Fig. 15N.

Using the hard mask **711,** by implantation of a controlled dose of a p-type impurity **712** such as aluminum or boron in Fig. 15O a P+ plug region is realized in Fig. 15P. The depth of the P+ plug layer **713** may preferably exceed the depth of the N+ source implant and may even exceed the depth of the p-well region, in a particular implementation. The mask layer **711** is removed in Fig. 15Q. The wafer is annealed for activating the implanted impurities.

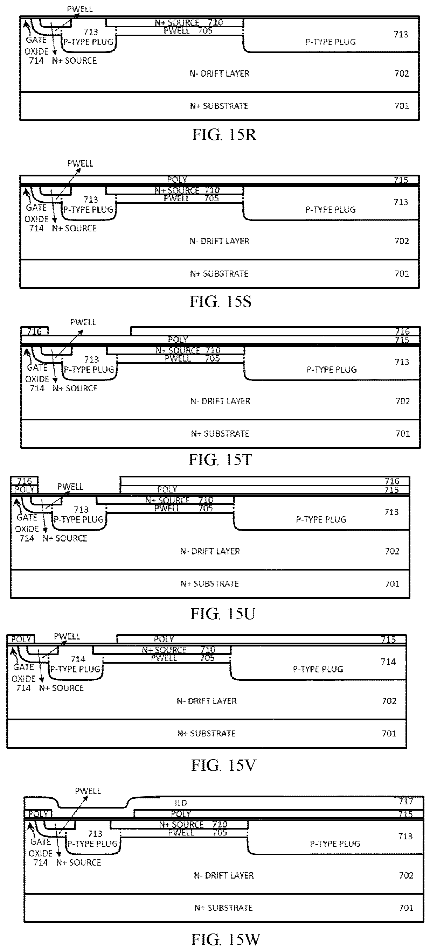

The oxide layer **714** which is the gate oxide is formed by thermal oxidation or using CVD of a dielectric layer such as silicon dioxide, silicon nitride, silicon oxynitride, etc. in Fig. 15R. The thickness of the gate oxide could range from 10 nm to 100 nm. Either dry or wet thermal oxidation could be used for oxide growth. PECVD or LPCVD could be used for gate oxide deposition. A polysilicon gate layer **715** is then deposited in Fig. 15S. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. A hard mask **716** is deposited by a CVD deposited layer of silicon dioxide, silicon nitride, silicon oxynitride, or a metallic layer such as nickel, with thickness ranging from 50 nm to 5 $\mu$m on the top on top and patterned as shown in Fig. 15T. The polysilicon layer **715** is etched by using the patterned mask layer **716** in Fig. 15U. The mask layer **716** is then removed in Fig. 15V. An ILD layer **717** comprising 50 nm - 1000 nm thick silicon dioxide, silicon nitride, silicon oxynitride layers or a stacked combination thereof is deposited on the wafer in Fig. 15W.

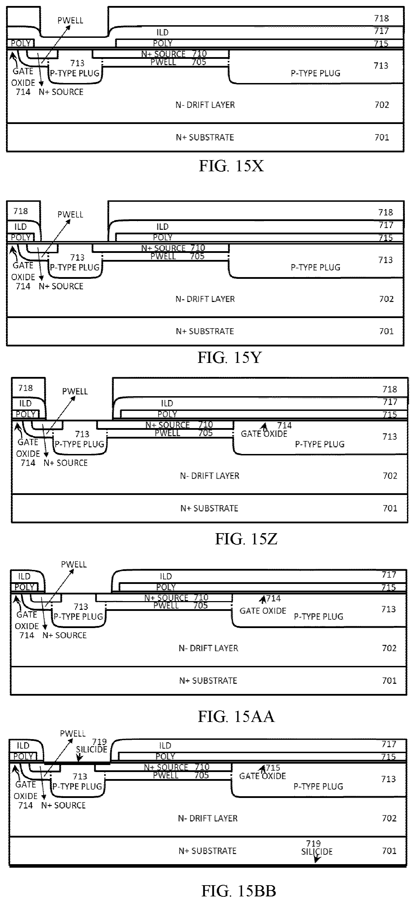

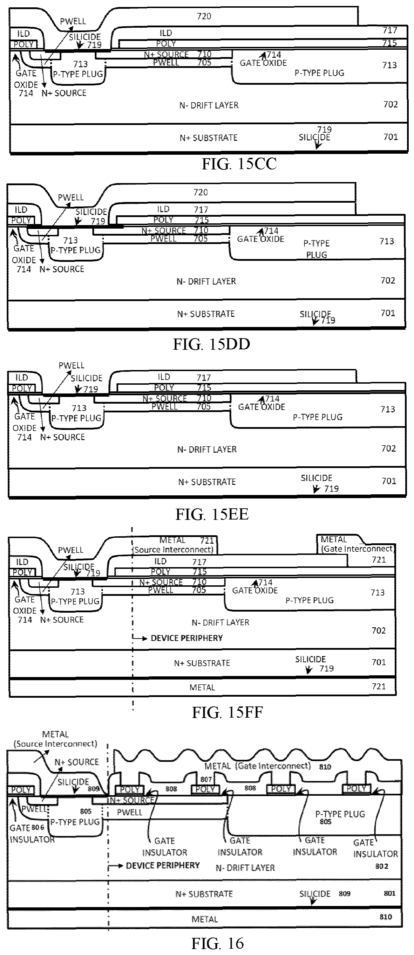

A hard mask **718** is deposited by a CVD deposited layer of silicon dioxide, silicon nitride, silicon oxynitride, or a metallic layer such as nickel, with thickness ranging from 50 nm to 5 $\mu$m on the top and patterned on top to define the ILD opening in Fig. 15X. The ILD layer **717** is etched using the hard mask as shown in Fig. 15Y. Further the gate oxide **714** is etched using the same mask **718** in Fig. 15Z. The mask **718** is then removed in Fig. 15AA. A nickel silicide region **719** is formed on the exposed SiC surface in Fig. 15BB. A mask layer **720** is formed by a CVD deposited layer of silicon dioxide, silicon nitride, silicon oxynitride, or a metallic layer such as nickel, with thickness ranging from 50 nm to 5 $\mu$m on the top which is then patterned in Fig. 15CC. The ILD layer **717** is etched in Fig. 15DD. The mask layer **720** is removed in Fig. 15EE. Interconnect metal layers **721** of either aluminum or silver or gold is deposited and patterned on the top and bottom of the substrate in Fig. 15FF.

An embodiment shown in Fig. 8 is the unit cell and the device periphery of a cross-sectional structure of a SiC DMOSFET. The key regions of this device are a p-well region **803,** which is formed by ion- implantation or epitaxial re-growth of a p-type species such as aluminum or boron. There is an N+ source region **804,** N- drift layer **802,** and an N+ substrate **801.** In the ON state when a gate voltage is applied to the polysilicon gate **807** the current flows vertically from the drain **801,** through the inversion layer which is formed at the top of the p-well layer **803,** through the N+ source region **804,** and out through the source metallization **810.** In the OFF state or the blocking state, a voltage is supported across the p-well **803,** N-drift layer **802** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **806.** Another feature is an ILD layer **808** which is used to insulate the source interconnect metallization **810** from the polysilicon gate **807.** At the very center of the unit cell, there is a P+ plug layer **805** which is grounded with the N+ source metallization. The purpose of the P+ plug in SiC DMOSFET is to ground the p-well region with the N+ source contact.

In an embodiment herein, a dedicated masking step is interspersed between the formation of the sidewall spacer after the p-well implant and before the N+ source implant to mask the N+ source implant from the peripheral regions of the MOSFET. This also masks the N+ source implant from selected regions in the active area of the device, which enables ohmic contact to the p-well or P+ plug region. This embodiment obviates the need for a source trench that is present in some earlier embodiments.

In the embodiment herein, a dedicated hard mask or photoresist layer is applied after the sidewall spacer is formed and before the N+ source implantation which prevents the formation of the N+ source region in the device periphery and parasitic NPN structures in the device periphery are avoided. The implantation of the N+ source region is avoided in selected areas in the active region, and this enables ohmic contact to the p-well or P+ plug regions without an intervening N+ source region.

In the embodiment herein, the polysilicon metallization in the peripheral regions of the device **807** are segmented and not a contiguous layer. In the embodiment herein, the formation of the segmented gate metallization in the periphery of the device instead of a contiguous gate bus could significantly decrease the gate-body capacitance of the MOSFET. This could result in a significant increase of the switching speed of the MOSFET.

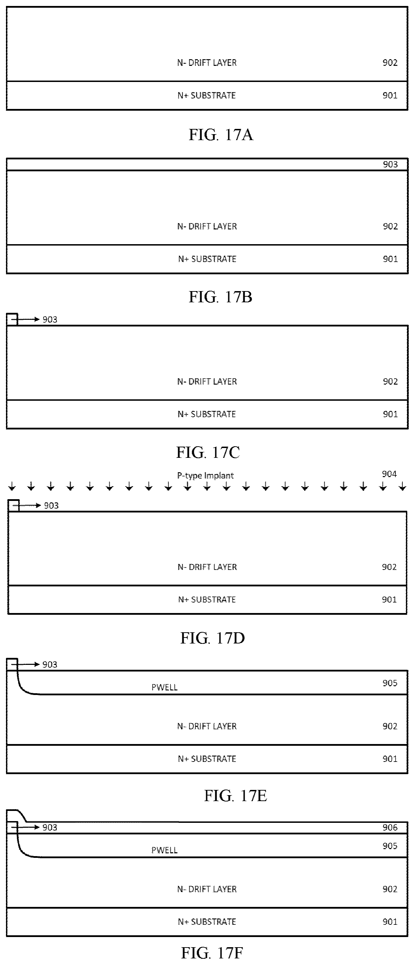

Fig. 17A to Fig. 17FF describes the process of manufacturing the structure shown in Fig. 8. The manufacturing process for a SiC DMOSFET is on a SiC substrate **901** and starts with using a 4H-SiC Si-face epi-wafer with suitable doping ($10^{14}$ - $10^{18}$ cm$^{-3}$) and thickness (1 $\mu$m to 300 $\mu$m) for the epilayer **902** shown in Fig. 17A. A blanket hard mask **903** comprising a CVD deposited layer of silicon dioxide, silicon nitride, silicon oxynitride, or a metallic layer such as nickel, with thickness ranging from 50 nm to 5 $\mu$m is deposited in Fig. 17B and then patterned using photolithography followed by a dry etch using RIE for example as shown in Fig. 17C. Then p-well region is first formed by ion-implantation or epitaxial growth using aluminum or boron as the p-type impurity. A p-type implantation **904** comprising boron or aluminum, at energies ranging from 10 keV to 800 keV, at implant doses ranging from $10^{12}$ cm$^{-2}$ to $10^{15}$ cm$^{-2}$ in Fig. 17D is performed to create a p-well **905** in Fig. 17E.

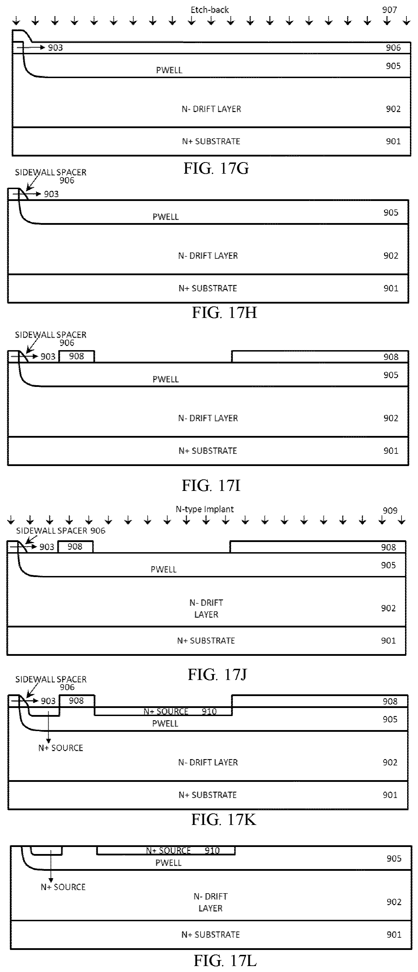

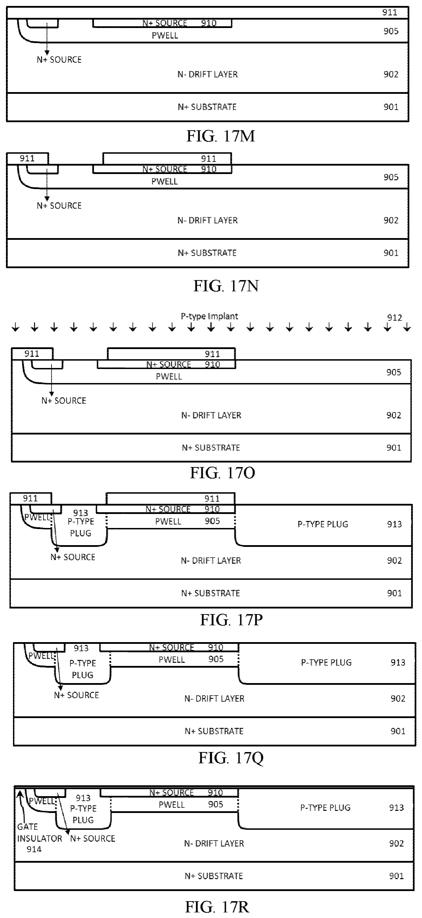

A second hard mask layer **906** is deposited by a CVD deposited layer of silicon dioxide, silicon nitride, silicon oxynitride, or a metallic layer such as nickel, with thickness ranging from 50 nm to 5 $\mu$m in Fig. 17F on top of the patterned first hard mask layer **903.** This is followed by an anisotropic etching **907** in Fig. 17G to form a sidewall spacer **906** as shown in Fig. 17H. A hard mask layer **908** is deposited by a CVD deposited layer of silicon dioxide, silicon nitride, silicon oxynitride, or a metallic layer such as nickel, with thickness ranging from 50 nm to 5 $\mu$m and patterned in Fig. 17I. The patterned mask layer **908** is formed on the top alongside the patterned mask layer with the sidewall spacer. A n-type implant **909** is done in Fig. 17J for creating a N+ source region **910** in Fig. 17K. A N+ source region is formed by ion-implantation or by epitaxial re-growth by a n-type impurity such as nitrogen or phosphorus. Thus, the source region **910** is formed in a self-aligned fashion with the p-well region **905** while it is masked from the peripheral regions of the device, as well as selected areas of the active region of the device, to enable contact with the source ohmic metallization. The first and second hard mask layers **903** and **908** respectively, are removed in Fig. 17L. Another mask layer **911** is deposited by a CVD deposited layer of silicon dioxide, silicon nitride, silicon oxynitride, or a metallic layer such as nickel, with thickness ranging from 50 nm to 5 $\mu$m on the top in Fig. 17M. The mask layer **911** is patterned in Fig. 17N.

Using the hard mask **911** and by implantation of a controlled dose of a p-type impurity **912** like aluminum or boron in Fig. 17O a P+ plug region **913** is realized in Fig. 17P. The mask layer **911** is removed in Fig. 17Q. The wafer is annealed for activating the implanted impurities.

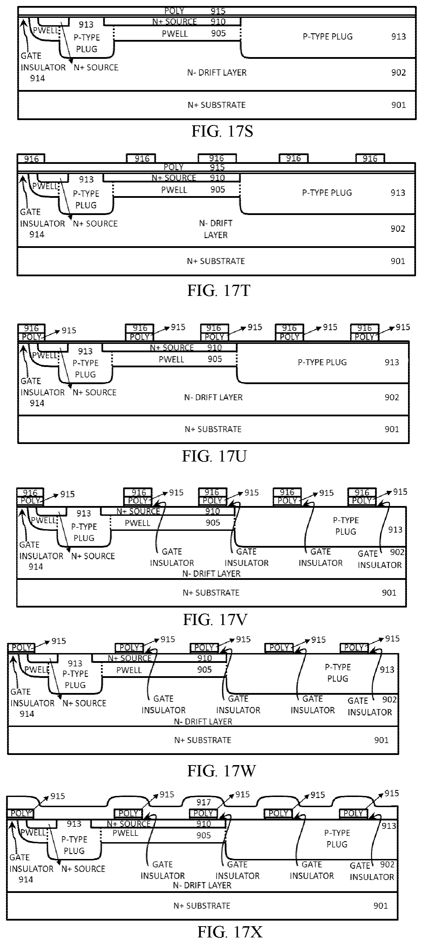

The oxide layer **914** which is the gate oxide is formed by thermal oxidation or using CVD of a dielectric layer such as silicon dioxide, silicon nitride, silicon oxynitride, etc. in Fig. 17R. The thickness of the gate oxide could range from 10 nm to 100 nm. Either dry or wet thermal oxidation could be used for oxide growth. PECVD or LPCVD could be used for gate oxide deposition. A polysilicon gate layer **915** is then deposited in Fig. 17S. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of $POCl_3$ followed by a drive-in step at temperatures ranging from 700-900°C. A hard mask **916** is deposited by a CVD deposited layer of silicon dioxide, silicon nitride, silicon oxynitride, or a metallic layer such as nickel, with thickness ranging from 50 nm to 5 $\mu$m on the top on top and patterned as shown in Fig. 17T. The polysilicon layer **915** is etched by using the patterned mask layer **916** in Fig. 17U. In the embodiment described herein, the masking step used to pattern the polysilicon gate metal, results in a partially segmented polysilicon pattern. While not apparent in the cross-sectional schematic, the disjointed gate fingers would be connected at a position orthogonal to the plane of the drawing. The gate insulator **914** is etched in Fig. 17V using the patterned mask **916.** The mask layer **916** is then removed in Fig. 17W. An ILD layer **917** comprising 50 nm - 1000 nm thick silicon dioxide, silicon nitride, silicon oxynitride layers or a stacked combination thereof is deposited on the wafer in Fig. 17X.

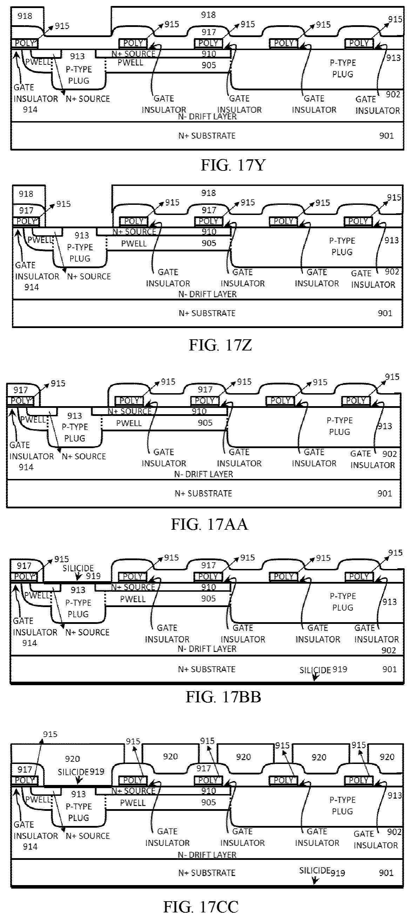

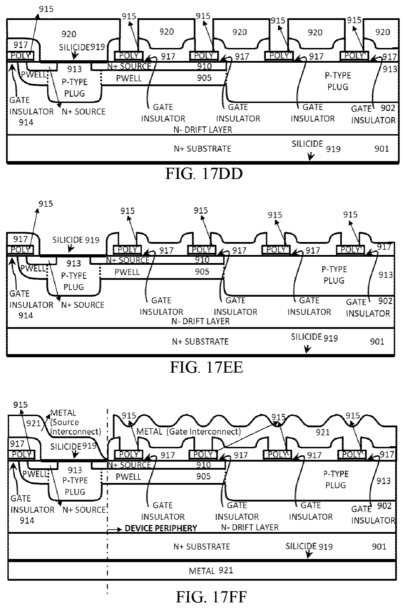

A hard mask **918** is deposited by a CVD deposited layer of silicon dioxide, silicon nitride, silicon oxynitride, or a metallic layer such as nickel, with thickness ranging from 50 nm to 5 $\mu$m on the top and patterned on top to define the ILD opening in Fig. 17Y. The ILD layer **917** is etched using the hard mask as shown in Fig. 17Z. The mask **918** is then removed in Fig. 17AA. A nickel silicide region **919** is formed on the exposed SiC surface in Fig. 17BB. A mask layer **920** is formed by a CVD deposited layer of silicon dioxide, silicon nitride, silicon oxynitride, or a metallic layer such as nickel, with thickness ranging from 50 nm to 5 $\mu$m on the top which is then patterned in Fig. 17CC. The ILD layer **917** is etched in Fig. 17DD. The mask layer **920** is removed in Fig. 17EE. Interconnect metal layers **921** of either aluminum or silver or gold is deposited and patterned on the top and bottom of the substrate in. Fig. 17FF.

Embodiments relate to SiC DMOSFET power devices where the p-well regions effectively shield the sensitive gate oxide from the high electric fields present in SiC especially during high drain bias or blocking mode operation.

An embodiment relates to using a P+-plug to ground the p-well region with the N+ source contact.

An embodiment relates to a p-well trench formed by dry etching into the p-well implanted region immediately preceding the source region formation, resulting in a portion of the MOS channel that is formed on the (0001) or horizontal face and another portion of the MOS channel that is formed on the (11-20/10-10) or vertical crystal plane of SiC which has the benefit of increasing the MOS channel mobility.

An embodiment relates to a much deeper vertical MOS channel formed by etching all the way through the p-well region. Subsequently, after the formation of the N+ Source region, a second p-well region (PW#2) is ion-implanted under and around the N+ source region in order to suppress reach-through breakdown.

An embodiment relates to the formation of the p-well trench which offers the flexibility to the device designer to either increase the effective channel length for a given ON resistance target, or reduce the ON resistance for a given chip size

SiC devices in power electronics feature fast switching times, high blocking voltage capabilities, and the ability to operate at high temperatures. These characteristics, along with recent advancements in manufacturing processes, suggest that SiC has the potential to revolutionize power electronics as a successor to traditional silicon-based (Si) devices. SiC is a wide band gap material (3.3 eV) and has a higher breakdown electric field ($3 \times 10^6$ V/cm to $5 \times 10^6$ V/cm) compared to Si (Si band gap is 1.1 eV and breakdown electric field for Si is $0.3 \times 10^6$ V/cm). SiC is a better thermal conductor (3.7 (W/cm-K) for SiC versus 1.6 (W/cm-K) for Si) which enables SiC devices to operate at extremely high-power levels and still dissipate the large amounts of excess heat generated. These material properties of SiC offer multiple advantages of using SiC instead of Si on power devices. In a comparison of SiC and Si semiconductor die with identical structures and dimensions, the SiC die exhibits a lower specific ON resistance and a higher breakdown voltage than the Si die.

The disclosed embodiments herein provide novel techniques for SiC DMOSFET design and fabrication to have a higher channel density, which can be advantageous for reducing the ON resistance of the device.

In a typical SiC planar MOSFET structure also known as the DMOSFET, the MOS channel is formed on the horizontal or 0001 crystal plane of SiC. The channel mobility or field effect mobility on the 0001 crystal plane of SiC tends to be lower as compared to the vertical side wall or what is called as the 11-20 or 10-10 crystal plane. When one makes a planar SiC DMOSFET, the ON resistance tends to be large and the DMOSFET is limited by the field effect channel mobility.

The channel mobility or field effect mobility on the 0001 crystal plane of SiC is in the range of 15 to 25 cm2/ V-sec as compared to silicon MOSFETs where it can be more than 350 cm2/ V-sec. One way to design lower resistance SiC MOSFETs is to find ways in which you can create very small channel lengths, so that this inversion layer mobility is active only in a smaller region of the current conduction path of this device, but this can lead to problems of short channel effects. Hence, reducing the channel alone does not solve the low channel mobility in the 0001 crystal plane because it introduces short channel effects, which results in poor reliability and poor robustness characteristics for this device. In an embodiment herein one way to combat this problem is by introducing trench MOSFETs in SiC. In a trench MOSFET, instead of forming the MOS channel on a horizontal or a 0001 crystal plane, the channels are now formed on the vertical side wall or on the so called A plane or M plane or also called as 10-10 or the 11-20 planes. Both of these planes have significantly higher channel mobility close to five times higher as compared to the horizontal plane resulting in 110 to 120 cm2/ V-sec for vertical channels.

A trench MOSFET can provide a higher channel density as compared to a planar MOSFET so one can increase the packing density. Since channel mobility is higher, it enables devices with small ON resistance. Even though a traditional trench MOSFET has an advantage over DMOSFET, the problem with a traditional trench MOSFET structure in SiC is that at the base of the trench there are high electric fields and a portion of a gate oxide in the trench suffers from high electric fields in the blocking mode of operation. This will become a failure point of a typical trench MOSFET structure and to overcome this issue it is necessary to shield the gate oxide at the base of the trench. P-type implantations used to shield gate oxide and approaches like a W-trench MOSFET are used to shield the gate oxide.

However, creating these shielding regions increases the ON resistance. While the trench MOSFET as compared to the DMOSFET enables higher channel mobilities hence reducing the ON resistance it creates high electric fields at the trench corners. To combat this, shielding regions are introduced, but this increases the ON resistance. Some benefits gained by reduced ON resistance from the trench MOSFET, are now lost due to shielding which is a trade off in designing traditional trench MOSFET.

In the embodiments herein, the device is neither pure DMOSFET nor is it a pure trench MOSFET. In this device the MOS channel is formed on both the 0001 plane as well as the vertical side wall or 11-20 (or 10-10) plane so it is a hybrid between a DMOSFET and a trench MOSFET.

In the embodiment herein, the device has a shorter overall channel length as compared to a pure DMOSFET but with the same effective channel mobility. By increasing the channel length in this way enables you to overcome some of the robustness and reliability problems associated with making short channel DMOSFETs. In the embodiments herein, the device has the trench which is completely surrounded or encompassed in a p-type implanted region. This provides a natural shielding to the high electric fields. Since the trench is completely formed inside a p-well there is no region where the trench is exposed to n-type epilayer which mitigates the issue of high electric fields at the trench corners.

In the embodiments herein, the structure of this device is distinguished by a trench which is etched into the p-well region and this trench is referred to as the p-well trench. In the embodiment first, the p-well region is formed and then the trench is etched into the p-well region, so all sides of this trench are encompassed in this p-well region. This trench also immediately precedes the formation of the N+ source region. With this process as described in this embodiment the device has a portion of the MOS channel which is formed on the 0001 phase and another portion of the channel is formed on the 11-20 or 10-10 plane.

The main steps to form a device described in the embodiment is forming the p-well region, by either ion implantation or epitaxial growth with aluminum or boron as the p-type impurity. Then the p-well trench is formed by controlled etching into the p-well region by using either reactive ion etching (RIE), or higher power inductively coupled plasma (ICP) source with an appropriate hard mask layer for forming this trench.

In the embodiment herein, this trench maybe formed with a sidewall angle between 70° and 90°. That is the approximate angle with which the trench is formed. The depth of this trench as an example may range between 0.1 $\mu$m to 0.5 $\mu$m. The depth of the p-well trench maybe adjusted to be smaller than the depth of the p-well region where the bottom of the p-well trench is completely enclosed within the p-well region.

In the embodiment herein, after forming the p-well trench, a N+ source region is formed by ion implantation or by epitaxial re-growth by using an impurity such as nitrogen or phosphorus. The N+ source is fully contained within the p-well region and N+ source does not extend beyond the p-well region. In the embodiments herein, one option is that the p-well trench region maybe formed using the same masking step as what may be used for forming the N+ source region even though it is not required. Next a P+ plug layer for grounding the p-well is formed by implantation of either aluminum or boron. The depth of the P+ plug layer may exceed the depth of the source implant layer such that it can both short the source implant with the ohmic layer that is put on top and also provides the grounding for the p-well region. The remainder of the process constitutes heat treatment of the wafers for electrical activation, the electric formation, gate metal formation, interlayer dielectric (ILD), patterning ILD, ohmic metallization, putting down a thick pad metallization.

In the embodiments herein, for forming the gate insulator either thermal oxidation or chemical vapor deposition (CVD) of a dielectric layer such as silicon dioxide, silicon nitride or oxynitride is used. In SiC, the oxidation rates are different for the 0001 plane as compared to the 11-20 or 10-10 plane which means oxidation rates are different for the horizontal side wall and the vertical side wall. This can lead to thicker gate oxide on the vertical side wall as compared to the horizontal side wall. In the embodiments herein, you can deposit a CVD silicon dioxide, and make sure that the thickness is the same on the horizontal and vertical side

The p-well trench is formed preceding the source region formation and after the p-well region formation in an embodiment with SiC DMOSFETs described herein. A portion of the MOS channel in the device is now formed parallel to the 0001 plane and another portion is formed parallel to the 11-20 plane. A MOSFET which is fabricated according to this embodiment as compared to a planar device for the same lateral footprint will have a higher channel density, hence enabling for a tighter packing. In addition to geometrically increasing the channel density the embodiment herein can also take advantage of the higher channel mobility of the vertical side wall.

In the embodiments herein devices have higher channel density and higher channel mobility and lower ON resistance. For a given ON resistance target you can increase the effective channel length. While comparing the device described in an embodiment to a typical planar DMOSFET, for the same ON resistance target, you can have a higher channel length for the device in the embodiment. Short channel effects can degrade the reliability and robustness characteristics and the longer channel length can alleviate short channel effects. Another way to use the device in this embodiment is for the same channel length as in a planar DMOSFET you can realize a smaller chip which means a lower cost device.

The device in this embodiment can have the same channel length as the planar DMOSFET but because of the higher channel mobility of 11-20 and 10-10 direction one can afford a longer channel in the vertical side wall and still have a shorter, horizontal channel. Due to higher channel mobility, the device in the embodiment will have a lower ON resistance. It allows you to then have a smaller chip size for the same ON resistance and design a device as in the embodiment which has a longer channel in the vertical and shorter on the horizontal, allowing to make a lower ON resistance MOSFET.

The embodiments described herein, can be distinguished from a prior art disclosed by Tega et al from Hitachi in a US patent application: US 2018/0331174 A1, published in November of 2018. The prior art structure described by Tega et al from Hitachi in the US patent describes a SiC MOSFET structure in which the MOS channel is formed on both the horizontal and vertical p-well surfaces and the p-well trench which creates this MOS channel on the vertical and horizontal side walls is not formed contiguously. The p-well trench is only formed at orthogonal locations in the 3D landscape. If it were formed contiguously a cross section anywhere in the device will show the same structure. But in the case of the prior art the cross section through those kinds of trenches shows a different cross section at each location since there are many regions in the device where there is no p-well trench. The p-well trench in the devices described in the embodiments herein are however contiguous in nature which is thus different from the prior art structure described by Tega et al from Hitachi.

The second difference is that the construction of the MOS channel in the prior art structure described by Tega et al from Hitachi is completely different when compared to what is described in the embodiments here. The MOS channel in the prior art is formed between an N+ source region and a separate N+ accumulation region. In the device in the embodiments described herein the p-well region is formed first followed by a trench into the p-well region, and then the source implant. However, in the prior art structure described by Tega et al from Hitachi the p-well region is formed followed by the source implant, an accumulation region, the heat treatment and then a p-well trench. The difference lies in how and when the MOS channel is formed during the process.

The third difference is that the process of trench creation for realizing MOS channel on the vertical SiC crystal planes is conducted after all implantation steps are completed in the prior art described by Tega et al from Hitachi. As a result, the N+ Source region is elevated as compared to the MOS channel formed on the vertical sidewall. In the device described in the embodiments herein the p-well trench is etched immediately following the p-well implantation and prior to the N+ source implantation which is formed on the recessed region created by the etching of the p-well trench.

In the structure proposed by Tega et all, along with a P+ plug region, N+ source region, and p-well region has N+ accumulation region and a P+ shielding region.

An embodiment described herein enables you to form an extremely long channel on the vertical side wall. The p-well trench can be formed significantly deeper so that the bottom of the p-well trench can extend beyond the p-well region.

In an embodiment herein, p-well region is formed followed by a deep p-well trench and source implantation. After the source implantation a second p-well region is formed. The second p-well region extends below the source region and has a cover around the corner to prevent any reliability issues of having a sharp edge.

In the embodiment herein, tilted implantation is used to extend the p-well region beyond the lateral extent of the p-well region and shield the gate oxide from any drain induced electric field. The structure in the embodiment provides a natural way to shield the drain potential from the channel region by extending the second p-well region beyond the source region

The process to form the device described in the embodiment includes forming a p-well region by ion implantation or epitaxial growth using aluminum or boron. This is followed by a p-well trench that is formed by control etching into the p-well region by RIE or ICP based etching. The p-well trench may be formed with a sidewall angle between 75° and 90°. The depth of the p-well trench region may range anywhere from 0.1 $\mu$m to 2 $\mu$m. A N+ Source region is then formed by ion-implantation or by epitaxial re-growth by a n-type impurity such as nitrogen or phosphorus. In the embodiment herein, since the bottom of the p-well trench may not be completely enclosed within the p-well region, a second p-well region is formed. The second p-well is formed with a sufficient depth under the N+ source region while making sure that the lateral extent of the p-well region is then now larger than the original p-well region.

There are two methods to form the second p-well as described in the embodiments here. In one case a dedicated hard mask layer may be deposited and patterned with a slightly larger extent than the original p-well region, and then the ion-implantation for PW#2 may be performed. In the second case tilted ion-implantation may be advantageously used for realizing PW#2. In an embodiment described here, the same hard mask may be used for creating the p-well trench, N+ source region and then the PW#2 region, whose lateral extent is made larger than the original PW region using tilted ion-implantation of a p-type impurity. The remainder of the process constitutes heat treatment of the wafers for electrical activation of the implanted impurities, gate insulator formation, gate electrode formation, inter-level dielectric formation, Source/Drain Ohmic metallization and finally the formation of pad or interconnect metals compatible with die probing and packaging. The gate insulator is formed either by thermal oxidation of the silicon carbide or by CVD of a dielectric layer such as silicon dioxide, silicon nitride, silicon oxynitride, etc.

The device described in the embodiment allows more freedom in the ON resistance versus robustness trade off that is often encountered in case of SiC power MOSFET. While longer channels allow you to have good short circuit performance and the ON resistance is high because of the lower channel mobility, an intrinsic property of SiC.

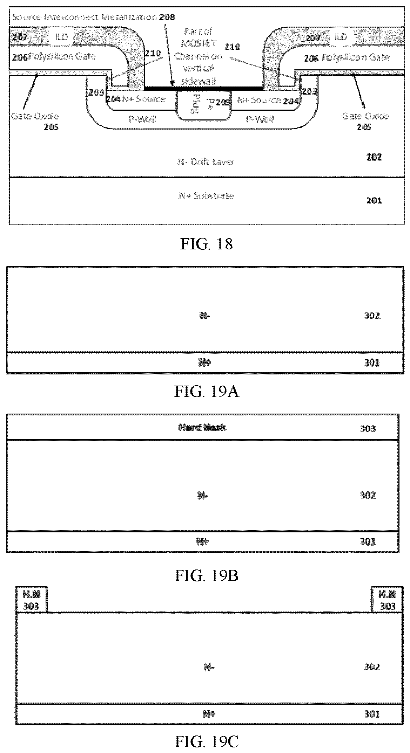

An embodiment shown in Fig. 18 is the unit cell of a cross-sectional structure of a SiC DMOSFET. The key regions of this device are a p-well region **203,** which is formed by ion-implantation or epitaxial re-growth of a p-type species such as aluminum or boron. There is an N+ source region **204,** N- drift layer **202,** and an N+ substrate **201.** In the ON state when a gate voltage is applied to the polysilicon gate **206,** the current flows vertically from the drain **201,** through the inversion layer which is formed at the top of the p-well layer **203,** through the N+ source region **204,** and out through the source metallization **208.** In the OFF state or the blocking state, a voltage is supported across the p-well **203,** N- drift layer **202** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **205.** Another feature is an ILD layer **207** which is used to insulate the source interconnect metallization **208** from the poly-silicon gate **206.** At the very center of the unit cell, there is a P+ plug layer **209** which is grounded with the N+ source metallization. The purpose of the P+ plug in SiC DMOSFET is to ground the p-well region with the N+ source contact.

The p-well region **203** is first formed by ion-implantation or epitaxial growth using aluminum or boron as the p-type impurity. Then, a p-well trench **210** is formed by controlled etching into the p-well region **203** by either RIE or ICP etching using an appropriately patterned hard mask layer. The p-well trench may be formed with a sidewall angle between 70° and 90°. The depth of the p-well trench region **210** may range from 0.1 $\mu$m to 0.5 $\mu$m. The depth of the p-well trench can be adjusted to be shallower than the depth of the p-well region. The bottom of the p-well trench may be enclosed within the p-well region. A N+ source region is then formed by ion-implantation or by epitaxial re-growth by a n-type impurity such as nitrogen or phosphorus. The p-well trench region may be preferably formed using the same masking step used for performing the ion-implantation necessary for forming the N+ source region **204.** A P+ plug layer **209** may be formed by implantation of a controlled dose of a p-type impurity such as aluminum or boron. The depth of the P+ plug layer may exceed the depth of the N+ source implant and may even exceed the depth of the p-well region, in a particular implementation. The remainder of the process constitutes heat treatment of the wafers for electrical activation of the implanted impurities, gate insulator formation, gate electrode formation, inter-level dielectric formation, source/drain ohmic metallization and finally the formation of pad or interconnect metals compatible with die probing and packaging. The gate insulator **205** is formed by thermal oxidation or using CVD of a dielectric layer such as silicon dioxide, silicon nitride, silicon oxynitride, etc.

In the embodiment herein, the trench is formed into the p-well region immediately preceding the formation of the N+ source region A portion of the MOS channel is formed parallel to the (0001) crystal plane, while another portion of the MOS channel is formed parallel to the (11-20) or (1-100) crystal plane of SiC. The DMOSFET fabricated according to this embodiment will have a higher channel density, which can be advantageous for reducing the ON resistance of the device. It is well-known to those in the field of the invention that MOS channels formed on vertical sidewalls, parallel to (11-20) or (10-10) crystal planes of 4H-SiC, can achieve much high field-effect mobility as compared to the MOS channels formed on the flat (0001) crystal planes. In an embodiment described here, in addition to increasing the channel density, the effective channel mobility for a DMOSFET fabricated according to this embodiment is expected to be higher than for a DMOSFET fabricated with its MOS channel always parallel to the (0001) crystal plane of 4H-SiC. This desirable feature can be exploited for increasing the effective channel length for a given ON resistance target or reducing the ON resistance for a given chip size, whichever may be of interest to the device designer.

The embodiment described in this application can be distinguished from the device disclosed by Tega et al. in US patent application: US 2018/0331174 A1 [henceforth referred to as Ref 1], even though that application describes a SiC MOSFET structure in which the MOS channel is formed on vertical and horizontal p-well surfaces:

(1) In Ref.1 the MOS channel on the vertical SiC crystal planes is not formed contiguously but only formed at discrete orthogonal locations in the active area. So, there are cross-sections through the Ref. 1 MOSFET that do not contain any MOS channel formation on the vertical SiC sidewall.

(2) The MOS channel construction in Ref.1 is completely different compared to that described in the embodiments herein. In Ref. 1, the MOS channel is formed between an N+ source region and a separate N+ accumulation region, which connects the MOS channel to the JFET region

(3) In Ref. 1, the process of trench creation for realizing MOS channel on the vertical SiC crystal planes is conducted after all implantation steps are completed. As a result, the N+ source region is elevated as compared to the MOS channel formed on the vertical sidewall. In the embodiment described herein, the p-well trench is etched immediately following the p-well implantation and prior to the N+ source Implantation which is formed on the recessed region created by the etching of the p-well trench.

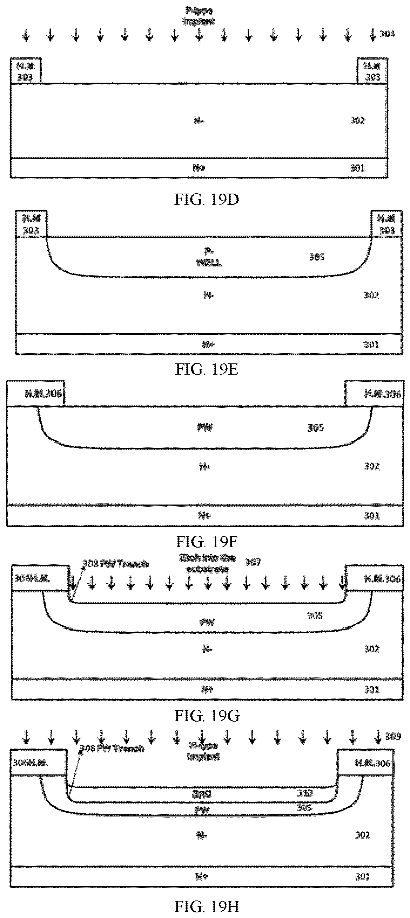

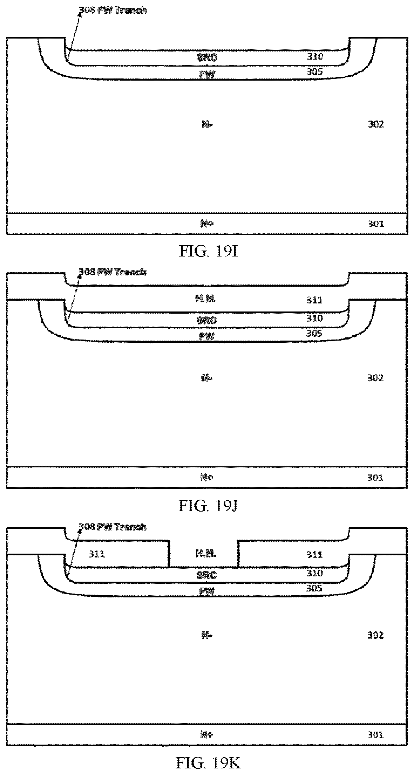

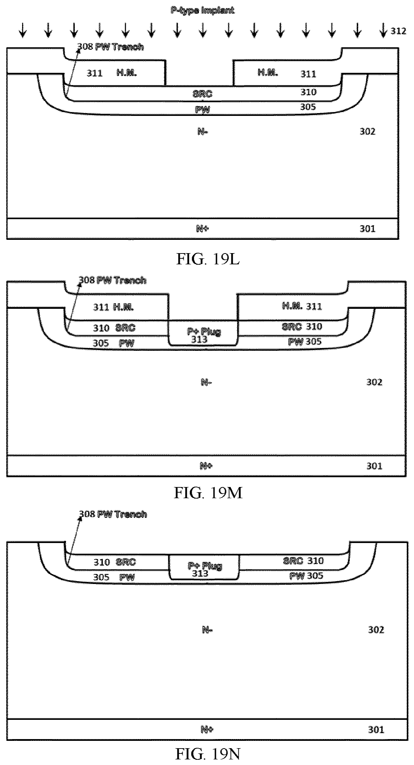

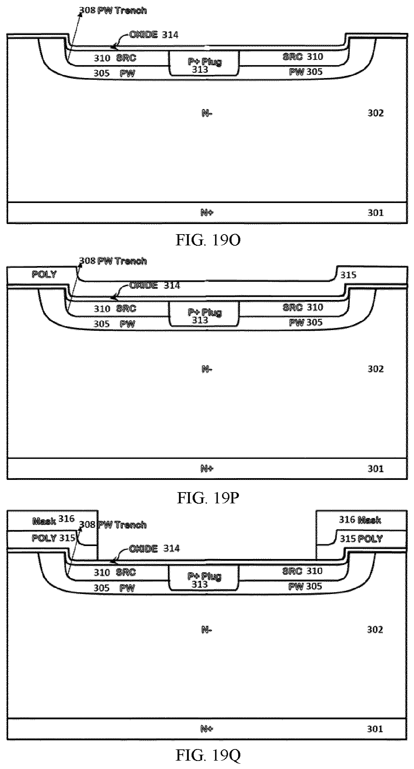

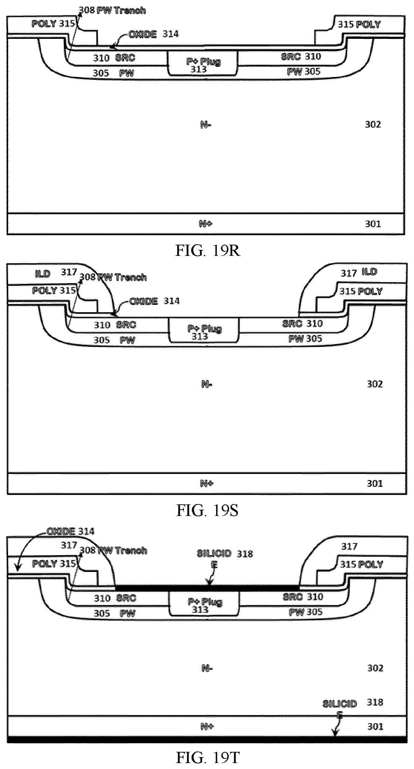

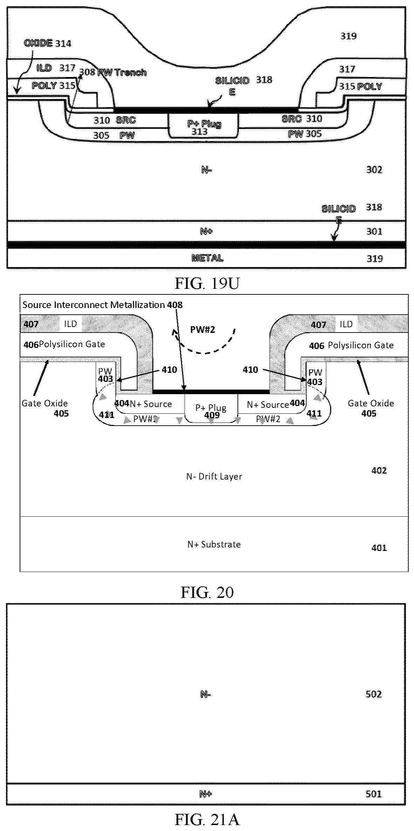

Fig. 19A to Fig. 19U describes the process of manufacturing the structure shown in Fig. 18. The manufacturing process for a SiC DMOSFET is on a SiC substrate **301** and starts with using a 4H-SiC Si-face epi-wafer with suitable doping ($10^{14}$ - $10^{18}$ cm$^{-3}$) and thickness (1 $\mu$m to 300 $\mu$m) for the epilayer **302** shown in Fig. 19A. A blanket hard mask **303** comprising a CVD deposited layer of silicon dioxide, silicon nitride, silicon oxynitride, or a metallic layer such as nickel, with thickness ranging from 50 nm to 5 $\mu$m is deposited in Fig. 19B and then patterned using photolithography followed by a dry etch using RIE for example as shown in Fig. 19C. Then p-well region is first formed by ion-implantation or epitaxial growth using aluminum or boron as the p-type impurity. A p-type implantation **304** comprising of boron or aluminum, at energies ranging from 10 keV to 800 keV, at implant doses ranging from $10^{12}$ cm$^{-2}$ to $10^{15}$ cm$^{-2}$ in Fig. 19D is performed to create a p-well **305** in Fig. 19E. The mask **303** is removed, and another hard mask layer **306** is deposited by a CVD deposited layer of silicon dioxide, silicon nitride, silicon oxynitride, or a metallic layer such as nickel, with thickness ranging from 50 nm to 5 $\mu$m and then patterned as in Fig. 19F. A p-well trench **308** is formed by controlled etching process **307** into the p-well region by RIE or ICP etching using the appropriately patterned hard mask layer **306** in Fig. 19G. The p-well trench **308** is formed with a sidewall angle between 70° and 90°. The depth of the p-well trench region ranges from 0.1 $\mu$m to 0.5 $\mu$m. The depth of the p-well trench may be adjusted to be shallower than the depth of the p-well region **305**. The bottom of the p-well trench **308** may be enclosed within the p-well region **305**. A n-type implant **309** is done for creating a N+ source region **310** in Fig. 19H. A N+ source region is formed by ion-implantation or by epitaxial re-growth by a n-type impurity such as nitrogen or phosphorus. The same hard mask layer **306** used for etching the p-well trench may be advantageously used for patterning the N+ source implant so the source implant is perfectly aligned under the p-well trench. The masking layer **306** is removed in Fig. 19I. Another hard mask layer **311** is deposited in Fig. 19J. The hard mask layer **311** is patterned in Fig. 19K. A P+ plug layer may be formed by implantation of a controlled dose of a p-type impurity **312** such as aluminum or boron in Fig. 19L. The depth of the P+ plug layer 313 may preferably exceed the depth of the N+ source implant and may even exceed the depth of the p-well region, in a particular implementation in Fig. 19M. This is followed by the removal of the hard mask **311** using either dry or wet etching techniques commonly practiced by those in the field in Fig. 19N. Then the oxide layer **314** which is the gate oxide is formed by thermal oxidation or using CVD of a dielectric layer such as silicon dioxide, silicon nitride, silicon oxynitride, etc. in Fig. 19O. The thickness of the gate oxide could range from 10 nm to 100 nm. Either dry or wet thermal oxidation could be used for oxide growth. Plasma-enhanced chemical vapor deposition (PECVD) or low-pressure chemical vapor deposition (LPCVD) could be used for gate oxide deposition. A polysilicon gate layer **315** is then deposited in Fig. 19P. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. A hard mask **316** is deposited on top and patterned as shown in Fig. 19Q. The polysilicon gate layer **315** is etched by using the patterned mask layer **316**. The mask layer **316** is then removed in Fig. 19R. An ILD layer **317** comprising of 50 nm - 1000 nm thick silicon dioxide, silicon nitride, silicon oxynitride layers or a stacked combination thereof is deposited on the wafer; a hard mask is deposited and patterned on top to define the ILD opening; the ILD layer **317** is patterned using the hard mask as shown in Fig. 19S. Further the gate oxide **314** is etched using the same mask. The mask is then removed and a nickel silicide region **318** is formed on the exposed SiC surface in Fig. 19T. Interconnect metal layers **319** of either aluminum or silver or gold is deposited and patterned on the top and bottom of the chip in Fig. 19U

An embodiment shown in Fig. 20 is the unit cell of a cross-sectional structure of a SiC DMOSFET. The key regions of this device are a p-well region **403,** which is formed by ion-implantation or epitaxial re-growth of a p-type species such as aluminum or boron. There is an N+ source region **404,** N- drift layer **402,** and an N+ substrate **401.** In the ON state when a gate voltage is applied to the polysilicon gate **406,** the current flows vertically from the drain **401,** through the inversion layer which is formed at the top of the p-well layer **403,** through the N+ source region **404,** and out through the source metallization **408.** In the OFF state or the blocking state, a voltage is supported across the p-well **403,** N- drift layer **402** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the JFET region or the JFET gap and the thickness of the gate oxide **405**. Another feature is an ILD layer **407** which is used to insulate the source interconnect metallization **408** from the poly-silicon gate **406**. At the very center of the unit cell, there is a P+ plug layer **409** which is grounded with the N+ source metallization. The purpose of the P+ plug in SiC DMOSFET is to ground the p-well region with the N+ source contact.

A p-well trench **410** is formed by dry etching into the p-well implanted region immediately preceding the source region **404** formation, resulting in a portion of the MOS channel that is formed on the (0001) or horizontal face and another portion of the MOS channel that is formed on the (11-20/10-10) or vertical crystal plane of SiC. However, in the embodiment shown in Fig. 20, a much deeper vertical MOS channel is formed by etching all the way through the p-well region. Subsequently, after the formation of the N+ source region, a second p-well region indicated as PW#2 **411** is ion-implanted under and around the N+ source region in order to suppress reach-through breakdown.

The p-well region **403** is first formed by ion-implantation or epitaxial growth using aluminum or boron as the p-type impurity. Then, a p-well trench **410** is formed by controlled etching into the p-well region by RIE or ICP etching using an appropriately patterned hard mask layer. The p-well trench **410** may be formed with a sidewall angle between 75° and 90°. The depth of the p-well trench region may range from 0.5 $\mu$m to 2 $\mu$m. Compared to the device shown in Fig. 18 the device in Fig. 20 has the depth of the p-well trench which may be adjusted to be of the same depth or even slightly deeper than the p-well region. The bottom of the p-well trench in the embodiment shown in Fig. 20 may not be completely enclosed within the p-well region. A N+ source region is then formed by ion-implantation or by epitaxial re-growth by a n-type impurity such as nitrogen or phosphorus. A second p-well region (PW#2) **411** is then formed to a sufficient depth under the N+ source region, such that the lateral extent of the PW#2 region is larger than that of the original p-well region. Two methods for forming the PW#2 **411** regions are identified. (1) A dedicated hard mask layer may be deposited and patterned with a slightly larger extent than the original p-well region, and then the ion-implantation for PW#2 may be performed. (2) Tilted ion-implantation may be advantageously used for realizing PW#2. In the embodiment here, the same hard mask may be used for creating the trench, N+ source region and then the PW#2 region, whose lateral extent is made larger than the original p-well region **403** using tilted ion-implantation of a p-type impurity. The remainder of the process constitutes heat treatment of the wafers for electrical activation of the implanted impurities, gate insulator formation, gate electrode formation, inter-level dielectric formation, source/drain ohmic metallization and finally the formation of pad or interconnect metals compatible with die probing and packaging. The gate insulator **405** is formed either by thermal oxidation of the silicon carbide or by CVD of a dielectric layer such as silicon dioxide, silicon nitride, silicon oxynitride, etc.

The device described in this embodiment in Fig. 20 is an enhancement to the device described in the embodiment in Fig. 18 and has several additional functions and advantages. The vertical portion of the MOS channel of the embodiment in Fig. 20 can be made much larger than the device shown in Fig. 18, due to a deeper p-well trench **410** for the MOSFET in Fig. 20. A larger percentage of the MOS channel can be realized on the higher channel mobility capable vertical sidewall as compared to the horizontal surface. For example, for a total channel length of 1 $\mu$m, 0.25 $\mu$m of the MOS channel can be realized on the horizontal surface and 0.75 $\mu$m of the MOS channel can be realized on the vertical sidewall. Thus, the effective channel mobility of the device described in embodiment shown in Fig. 20 can be larger than the device described in embodiment shown in Fig. 18, for the same MOS channel length. Hence for the same effective channel mobility, a longer channel MOSFET can be fabricated using embodiment in Fig. 20 as compared to the MOSFET fabricated using embodiment in Fig. 18. A longer channel MOSFET offers higher device robustness, including lower drain saturation current, higher short-circuit robustness, lower Vth roll-off with drain voltage, immunity from drain induced barrier lowering (DIBL) effects.

In the embodiment in Fig. 20 a larger extent for the PW#2 **411** as compared to the original p-well **403** is necessary and beneficial for reducing the channel length of the horizontal portion of the MOS channel. By forming a PW#2 with a larger lateral extent than the original p-well, the drain potential during the high-voltage blocking condition is effectively shielded from the original p-well region by the PW#2 region. This enables a significantly reduced lateral extent (electrical dose) for the original p-well region that extends beyond the p-well trench, without risk of reach-through breakdown. A reduced lateral extent for the p-well region beyond the p-well trench leads to a smaller portion of the MOSFET channel formed on the horizontal surface.

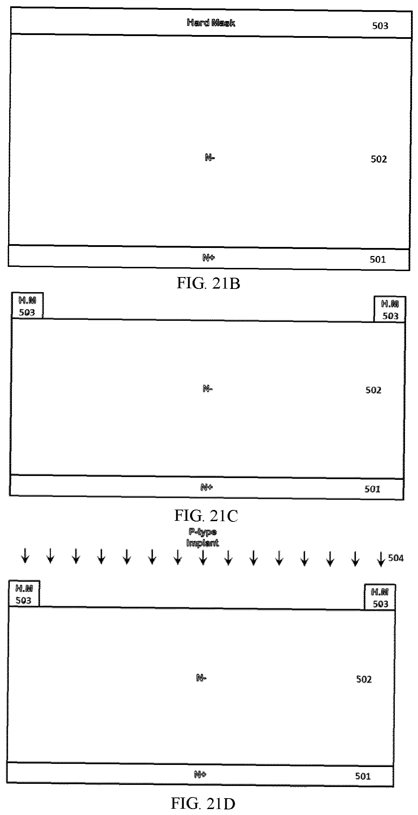

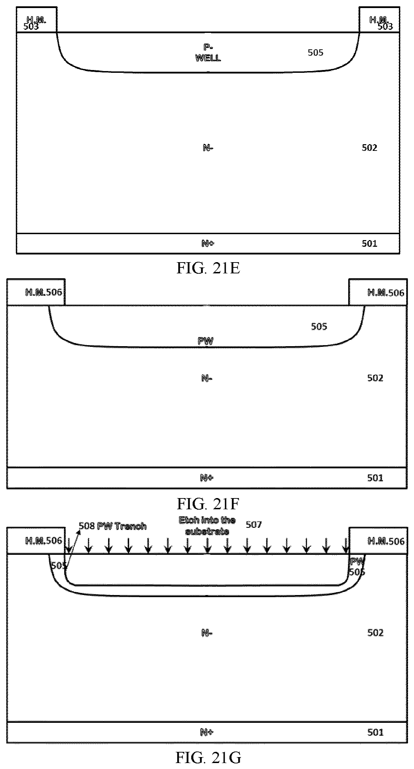

Fig. 21A to Fig. 21V describes the process of manufacturing the structure shown in Fig. 20. The manufacturing process for a SiC DMOSFET is on a SiC substrate **501** and starts with using a 4H-SiC Si-face epi-wafer with suitable doping ($10^{14}$ - $10^{18}$ cm$^{-3}$) and thickness (1 $\mu$m to 300 $\mu$m) for the epilayer **502** shown in Fig. 21A. A blanket hard mask **503** comprising a CVD deposited layer of silicon dioxide, silicon nitride, silicon oxynitride, or a metallic layer such as nickel, with thickness ranging from 50 nm to 5 $\mu$m is deposited in Fig. 21B and then patterned using photolithography followed by a dry etch using a RIE for example as shown in Fig. 21C. Then p-well region is first formed by ion-implantation or epitaxial growth using aluminum or boron as the p-type impurity. A p-type implantation **504** comprising of boron or aluminum, at energies ranging from 10 keV to 800 keV, at implant doses ranging from $10^{12}$ cm$^{-2}$ to $10^{15}$ cm$^{-2}$ in Fig. 21D is performed to create a p-well **505** in Fig. 21E. The mask **503** is removed, and another hard mask layer **506** is deposited by a CVD deposited layer of silicon dioxide, silicon nitride, silicon oxynitride, or a metallic layer such as nickel, with thickness ranging from 50 nm to 5 $\mu$m

and then patterned as in Fig. 21F. A deep p-well trench **508** is formed by controlled etching process **507** into the p-well region by RIE or ICP etching using the appropriately patterned hard mask layer **506** in Fig. 21G. The p-well trench **508** may be formed with a sidewall angle between 75° and 90°. The depth of the p-well trench region for example may range from 0.5 $\mu$m to 2 $\mu$m. The depth of the p-well trench **508** may be adjusted to be of the same depth or even slightly deeper than the p-well region. The bottom of the p-well trench may not be completed enclosed within the p-well region.

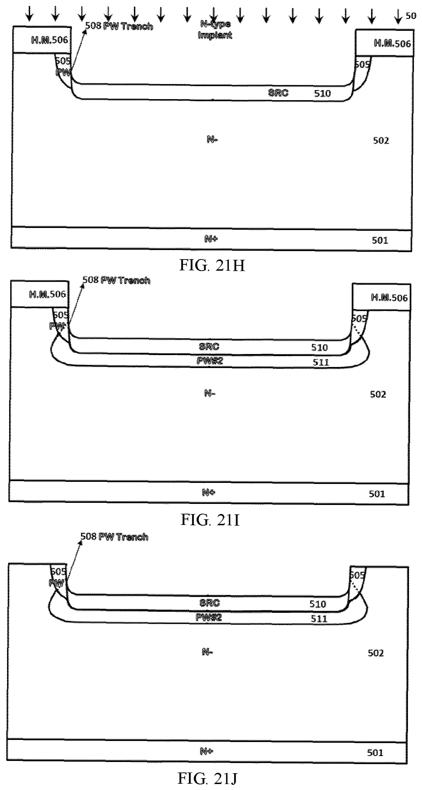

A N-type implant **509** is done for creating a N+ source region **510** in Fig. 21H. A N+ source region is formed by ion-implantation or by epitaxial re-growth by a n-type impurity such as nitrogen or phosphorus. A second p-well region (PW#2) **511** is then formed to a sufficient depth under the N+ source region, such that the lateral extent of the PW#2 region is larger than that of the original p-well region in Fig. 21I. Two methods for forming the PW#2 region **511** are identified. (1) A dedicated hard mask layer may be deposited and patterned with a slightly larger extent than the original p-well region, and then the ion-implantation for PW#2 may be performed. (2) Tilted ion-implantation may be advantageously used for realizing PW#2. In this implementation, the same hard mask **506** may be used for creating the p-well trench **508**, N+ source region **510** and then the PW#2 region **511,** whose lateral extent is made larger than the original p-well region using tilted ion-implantation of a p-type impurity.

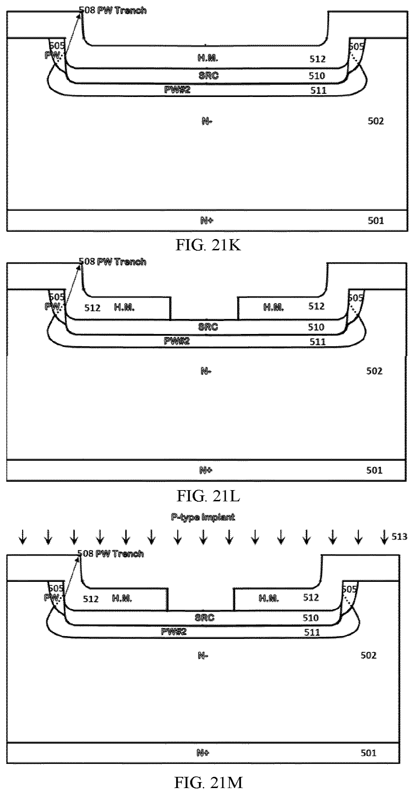

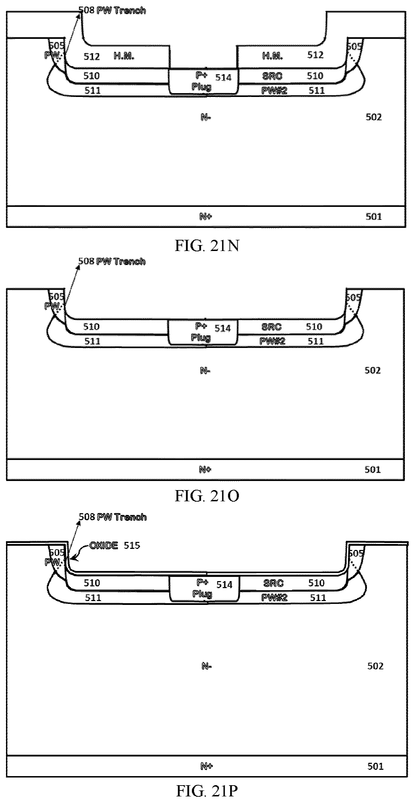

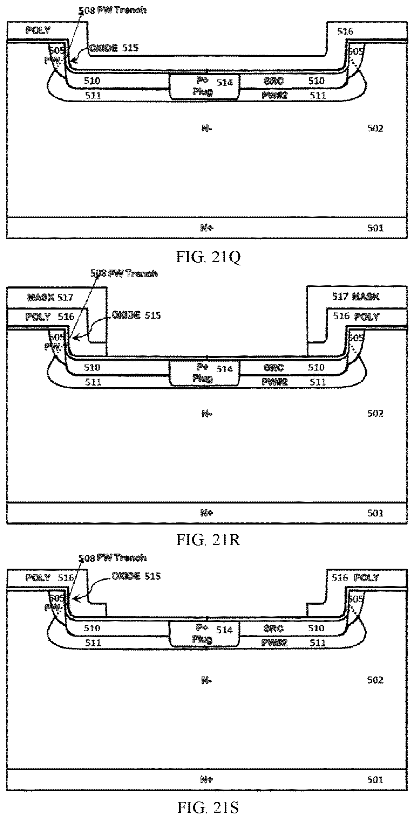

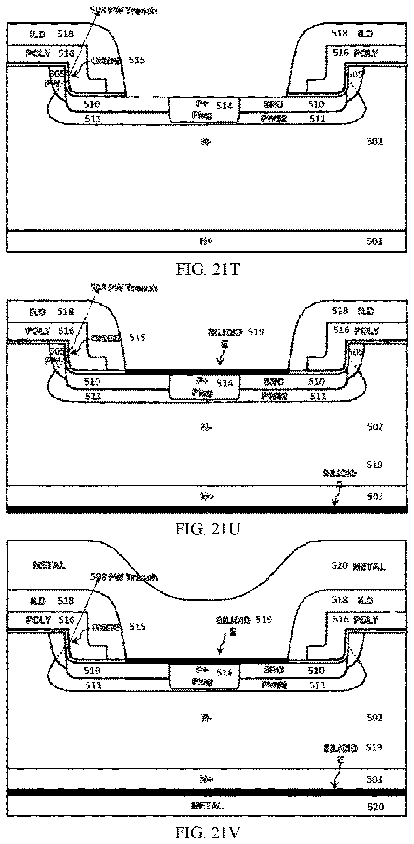

The masking layer **506** is removed in Fig. 21J. Another hard mask layer **512** is deposited in Fig. 21K. The hard mask layer **512** is patterned in Fig. 21L. A P+ plug layer may be formed by implantation of a controlled dose of a p-type impurity **513** such as aluminum or boron in Fig. 21M. The depth of the P+ plug layer **514** may preferably exceed the depth of the N+ source implant and may even exceed the depth of the p-well region, in a particular implementation in Fig. 21N. This is followed by the removal of the hard mask **512** using either dry or wet etching techniques commonly practiced by those in the field in Fig. 21O. Then the oxide layer **515** which is the gate oxide is formed by thermal oxidation or using CVD of a dielectric layer such as silicon dioxide, silicon nitride, silicon oxynitride, etc. in Fig. 21P. The thickness of the gate oxide could range from 10 nm to 100 nm. Either dry or wet thermal oxidation could be used for oxide growth. PECVD or LPCVD could be used for gate oxide deposition. A polysilicon gate layer **516** is then deposited in Fig. 21Q. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. A hard mask **517** is deposited and patterned as shown in Fig. 21R. The polysilicon gate layer **516** is etched by using the patterned mask layer **517.** The mask layer **517** is then removed in Fig. 21S. An ILD layer **518** comprising of 50 nm - 1000 nm thick silicon dioxide, silicon nitride, silicon oxynitride layers or a stacked combination thereof is deposited on the wafer; a hard mask is deposited and patterned on top to define the ILD opening; the ILD layer **518** is patterned using the hard mask as shown in Fig. 21T. Further the gate oxide **515** is etched using the same mask. The mask is then removed and a nickel silicide region **519** is formed on the exposed SiC surface in Fig. 21U. Interconnect metal layers **520** of either aluminum, silver or gold is deposited and patterned on the top and bottom of the chip in Fig. 21V.

An embodiment described herein relates to design and manufacturing of a short-channel SiC MOSFET.

An embodiment described herein relates to minimizing the DIBL effect of the high voltage, short-channel SiC MOSFETs.

An embodiment described herein relates to design and manufacturing MOS channels with sub-micron channel lengths.

The embodiments described herein achieve a device with both low enough ON resistance as well as high enough short circuit withstand time.

The embodiments described herein relate to increasing the doping concentration of the channel locally in certain regions of the channel. The non-uniformly doped channels for SiC MOSFET provide better tradeoff between ON resistance, threshold voltage and short circuit withstand time.

In the embodiments described herein relate to increasing the doping concentration in the channel locally such that they do not increase the threshold voltage too much, but at the same time reduce the DIBL effect to achieve a better trade off.

In an embodiment described herein a p-type shielding layer called the p-shield is formed within the p-well region. The p-shield always originates within the p-well region, but it can extend beyond the vertical extent of the p-well region.

In an embodiment described herein the bottom of the p-shield region can extend beneath the p-well.

In an embodiment described herein there can be multiple p-shield regions. The doping concentrations in the different p-shield region can be different from each other.

The embodiment described herein relates to a device where a p-shield region is formed buried within the p-well structure. The p-shield region always originates within the p-well region, but can extend beyond the vertical extent of the p-well region.

In an embodiment herein, device structures can have multiple p-shield regions. In these cases, their doping concentration profiles of the different p-shield regions do not necessarily have to be the same and can be different from each other.

In the race to achieve a lower ON stage resistance in planar gate SiC MOSFET, especially with high breakdown voltage ratings, it's a common practice to make the channel lengths as short as possible because this reduces a great part of the conduction loss that is associated with SiC channels. The MOS mobility in SiC MOS structures is significantly smaller as compared to those found in silicon MOSFETS and as a result to achieve a low enough ON resistance, one needs to make the channel lengths quite short and sometimes in the sub-micron range.

As the channel lengths become shorter, short channel effects become a problem in a SiC power MOSFET causing the drain induced barrier lowering effect, also called the DIBL effect which is responsible for a lot of reliability issues in SiC MOSFETs.

One associated problem is a roll off of the threshold voltage at high drain bias where the designed device achieves a certain desired threshold voltage only at very low drain bias. But, as the drain bias approaches it's blocking value, the threshold voltage gets reduced substantially which is undesirable since the channel could inadvertently turn on.

Also, a device suffering the DIBL effect has extremely large saturation currents under high drain bias. which results in excessive power dissipation under short circuit load conditions. This results in a low short circuit withstand time. While limited MOS channel mobility of SiC MOSFETS can be overcome with short channel lengths, it is associated with problems due to DIBL effects.

One approach to mitigating this problem is to increase the doping concentration in the channel region which uniformly increases the threshold voltage of the device. While this approach can reduce the saturation drain current, this also increases the ON resistance of the device.

The embodiments described herein can help achieve a device with both low enough ON resistance as well as high enough short circuit withstand time. While the conventional approach is to just uniformly increase the doping concentration in the channel region, the embodiments described herein do not increase the doping concentration of the other channel uniformly but increases it locally in certain regions of the channel. The non-uniformly doped channels for SiC MOSFET provide better tradeoff between ON resistance, threshold voltage and short circuit withstand time.

In the embodiments herein the doping concentration is increased such that they do not increase the threshold voltage too much, but at the same time reduce the DIBL effect and hence achieving a better trade off.

In an embodiment herein a p-type shielding layer called the p-shield is formed within the p-well region. The p-shield always originates within the p-well region, but in certain examples of this embodiment, it can extend beyond the vertical extent of the p-well region.

In an embodiment herein the bottom of the p-shield region can be extended further down and can reach beneath the p-well. In an embodiment herein there can be multiple p-shield regions. The doping concentrations in the different p-shield region can be different from each other.

In an embodiment herein a p-type shielding layer called the p-shield is formed buried within the p-well region. The p-shield always originates within the p-well region, but in certain examples of this embodiment, it can extend beyond the vertical extent of the p-well region.

In an embodiment herein the bottom of the p-shield region can be extended further down and can reach beneath the p-well. In an embodiment herein there can be multiple p-shield regions buried in the p-well region. The doping concentrations in the different p-shield region can be different from each other.

A p-shield region is formed buried within the p-well structure re-enforces" the doping of the p-well region locally and provides better shielding of the MOSFET channel at the surface, while minimizing the DIBL effect. In the embodiment described herein since the p-shield is not directly connected to the channel, the p-shield does not change the $V_{TH}$.

An embodiment shown in Fig. 23A is the half unit cell of a cross-sectional structure of a SiC DMOSFET. The key regions of this device are a p-well region **203,** which is formed by ion- implantation or epitaxial re-growth of a p-type species such as aluminum or boron. There is an N+ source region **205,** N- drift layer **202,** and an N+ substrate **201.** In the ON state when a gate voltage is applied to the polysilicon gate **207** the current flows vertically from the drain **201,** through the inversion layer which is formed at the top of the p-well layer **203,** through the N+ source region **205,** and out through the source metallization **210.** In the OFF state or the blocking state, a voltage is supported across the p-well **203,** N- drift layer **202** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the junction gate field-effect transistor (JFET) region or the JFET gap and the thickness of the gate oxide **206.** Another feature is an ILD layer **208** which is used to insulate the source interconnect metallization **210** from the polysilicon gate **207.**

In the embodiments herein a p-type shielding layer which is called p-shield **204a** is formed within the p-well region. The p-shield can be located inside the p-well such that its lateral location of the point whose doping concentration is the highest as compared to the average background doping concentration of the p-well is positioned within the boundary of the p-well. The p-shield region always originates within the p-well region. Points A and B are given as the reference points for describing how the doping profile of the implanted p-shield region looks like.

The embodiment shown in Fig. 23B is similar to that of Fig. 23A except that the bottom of the p-shield region is extended further down into the p-well and can reach outside the p-well region.

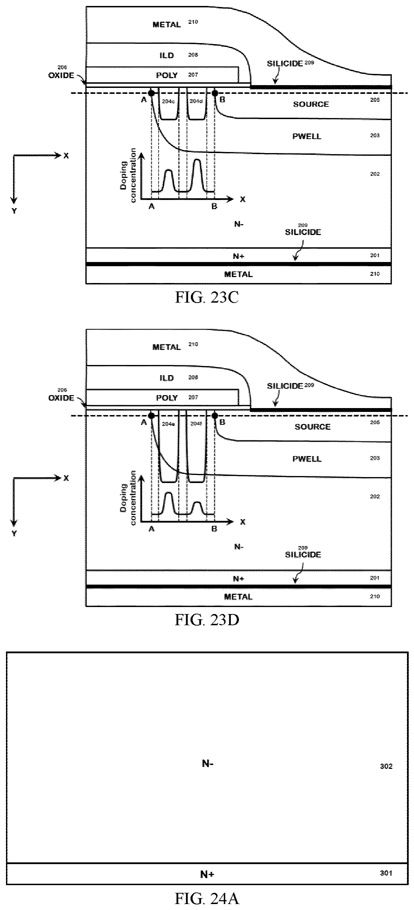

In an embodiment shown in Fig. 23C and Fig. 23D the devices are similar to Fig. 23A. The devices in Fig. 23C and Fig. 23D exemplify the case where there are multiple p-shield regions. In these cases, their doping concentration profiles of the different p-shield regions do not necessarily have to be the same and can be different from each other.

In case of biasing the drain with high voltage, the p-shield that is formed in the middle of the channel can help in mitigating the expansion of the drain bias-induced depletion region, which eliminates the DIBL effect. In addition to the mitigation of the DIBL effect, the p-shield region also provides a simple way for controlling the $V_{TH}$ of the MOSFET, which enables improving the short circuit time ($t_{SC}$). The p-shield enables a local increase of the doping concentration of the p-well at critical locations in the device structure, as opposed to an uniform increase of the p-well doping concentration. A better trade-off with respect to lower Vth, ON resistance and better immunity to short-channel effects is obtained by methods described in the embodiment. In the case, where the depth of the p-shield region is greater than the p-well region, i.e., the p-shield extends beyond the p-well region in the vertical direction, the p-shield can also provide better shielding of the electric field to the channel region which further mitigates the DIBL effect in the channel. The device structure with multiple p-shield regions can be designed with different doping concentrations in the different p-shield regions. In an embodiment described herein, a higher doping concentration can be applied to the p-shield region/s close to the edge of the p-well (POINT A), while the p-shield regions closer to POINT B can be made with lower doping concentrations. This structure will have the benefit of a lower gate threshold voltage as well as excellent immunity to short-channel effects, for a given channel length.

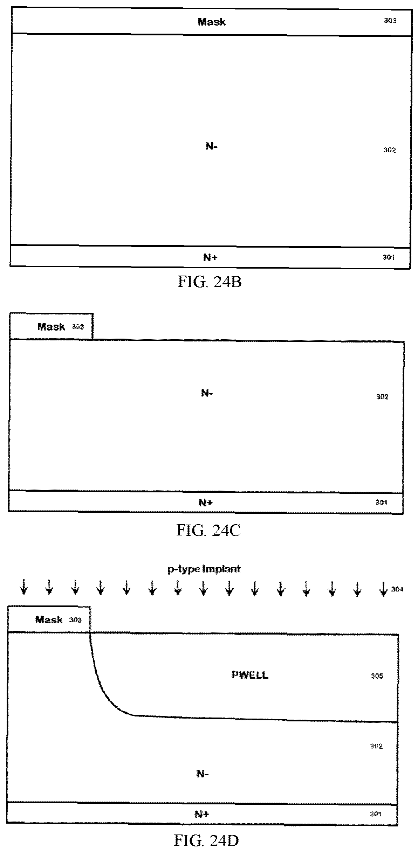

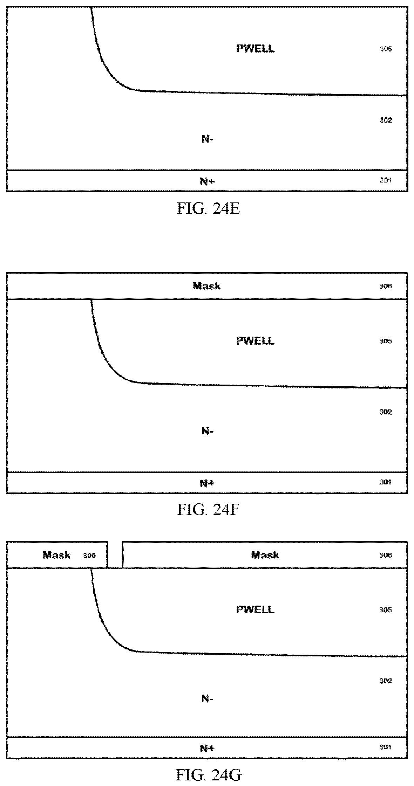

Fig. 24A to Fig. 24U describes the process of manufacturing the structure shown in Fig. 23A. The manufacturing process for a SiC DMOSFET is on a SiC substrate **301** and starts with using a 4H-SiC Si-face epi-wafer with suitable doping ($10^{14}$ - $10^{18}$ cm$^{-3}$) and thickness (1 $\mu$m to 300 $\mu$m) for the epilayer **302** shown in Fig. 24A. A blanket hard mask **303** comprising a chemical vapor deposition (CVD) deposited layer of silicon dioxide, silicon nitride, silicon oxynitride, or a metallic layer such as nickel, with thickness ranging from 50 nm to 5 $\mu$m is deposited in Fig. 24B and then patterned using photolithography followed by a dry etch using reactive ion etching (RIE) for example as shown in Fig. 24C. The p-well region is first formed by ion-implantation or epitaxial growth using aluminum or boron as the p-type impurity. A p-type implantation **304** comprising boron or aluminum, at energies ranging from 10 keV to 1000 keV, at implant doses ranging from $10^{12}$ cm$^{-2}$ to $10^{15}$ cm$^{-2}$ is performed to create a p-well **305** in Fig. 24D. The patterned mask layer **303** is removed in Fig. 24E.

A hard mask layer **306** is deposited by a CVD deposited layer of silicon dioxide, silicon nitride, silicon oxynitride, or a metallic layer such as nickel, with thickness ranging from 50 nm to 5 $\mu$m in Fig. 24F. The mask layer **306** is patterned using photolithography followed by a dry etch using RIE for example in Fig. 24G.

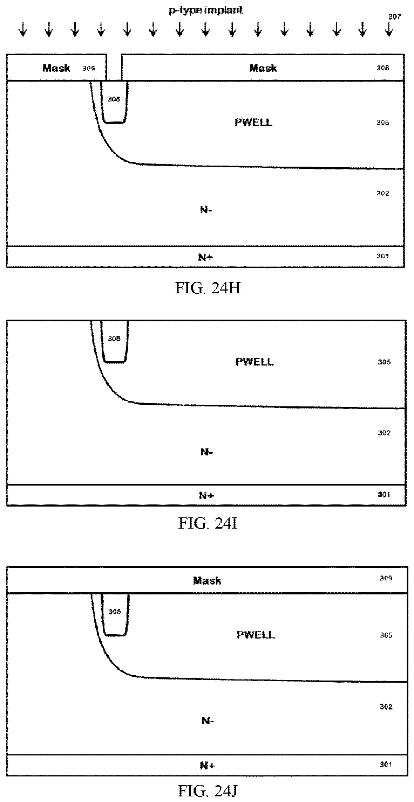

A p-type implant **307** is done as shown in Fig. 24H for creating a p-type region inside the p-well called p-shield **308**. The p-shield region **308** can be formed using aluminum or boron as the p-type impurity. The doping concentration in the p-shield region may be in the range of 1E16 cm-3 to 1E21 cm-3. The patterned mask layer **306** is removed in Fig. 24I.

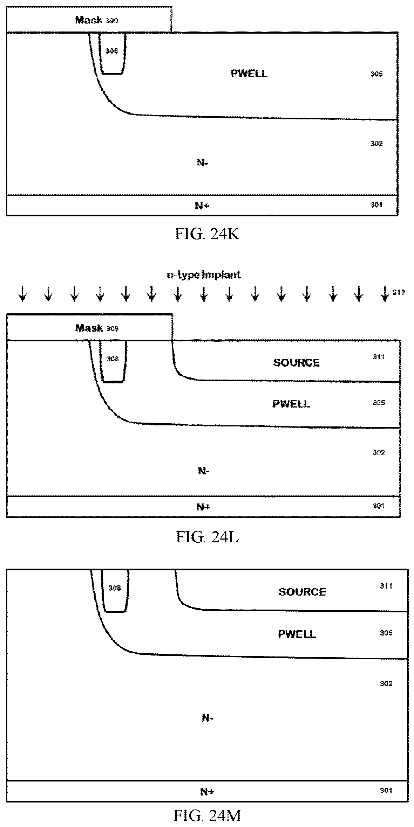

A blanket hard mask **309** comprising a chemical vapor deposition (CVD) deposited layer of silicon dioxide, silicon nitride, silicon oxynitride, or a metallic layer such as nickel, with thickness ranging from 50 nm to 5 $\mu$m is deposited in Fig. 24J and then patterned using photolithography followed by a dry etch using RIE for example as shown in Fig. 24K.

A N+ source region **311** is formed by ion-implantation or by epitaxial re-growth by a n-type impurity such as nitrogen or phosphorus **310** in Fig. 24L. The patterned mask layer **309** is removed in Fig. 24M.

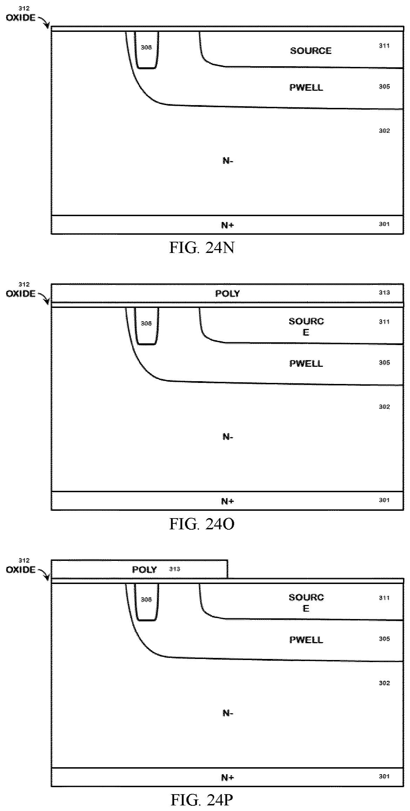

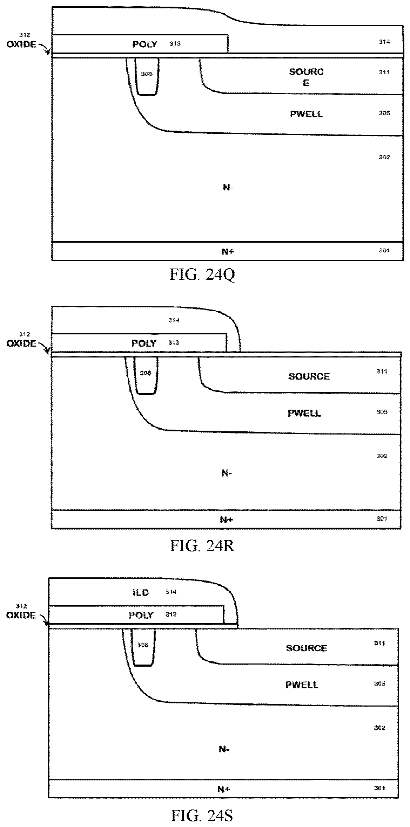

The oxide layer **312** which is the gate oxide is formed by thermal oxidation or using CVD of a dielectric layer such as silicon dioxide, silicon nitride, silicon oxynitride, etc. in Fig. 24N. The thickness of the gate oxide could range from 10 nm to 100 nm. Either dry or wet thermal oxidation could be used for oxide growth. Plasma-enhanced chemical vapor deposition (PECVD) or low-pressure chemical vapor deposition (LPCVD) could be used for gate oxide deposition. A polysilicon gate layer **313** is then deposited in Fig. 24O. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. The polysilicon layer **313** is patterned in Fig. 24P. An ILD layer **314** comprising 50 nm - 1000 nm thick silicon dioxide, silicon nitride, silicon oxynitride layers or a stacked combination thereof is deposited on the wafer in Fig. 24Q. The ILD layer **314** is patterned in Fig. 24R. The gate oxide **312** is patterned in Fig. 24S.

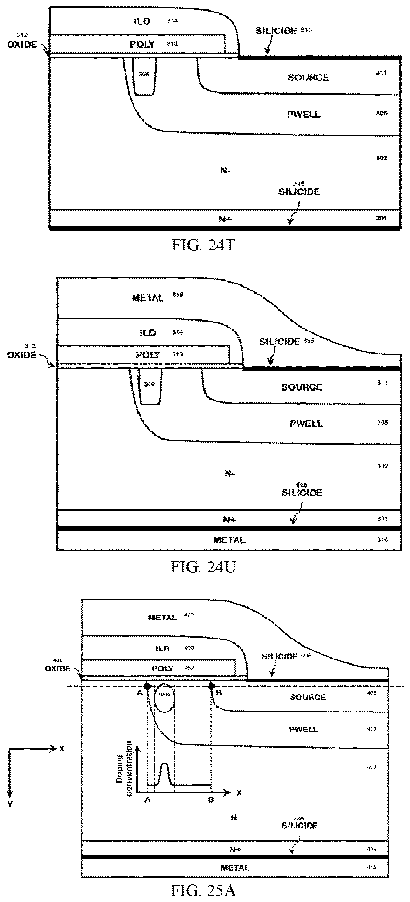

Nickel silicide regions **315** are formed on the exposed SiC surface in Fig. 24T. Interconnect metal layers **316** of either aluminum or silver or gold is deposited and patterned on the top and bottom of the substrate in. Fig. 24U.

An embodiment shown in Fig. 25A is the half unit cell of a cross-sectional structure of a SiC DMOSFET. The key regions of this device are a p-well region **403,** which is formed by ion- implantation or epitaxial re-growth of a p-type species such as aluminum or boron. There is an N+ source region **405,** N- drift layer **402,** and an N+ substrate **401.** In the ON state when a gate voltage is applied to the polysilicon gate **407** the current flows vertically from the drain **401,** through the inversion layer which is formed at the top of the p-well layer **403,** through the N+ source region **405,** and out through the source metallization **410.** In the OFF state or the blocking state, a voltage is supported across the p-well **403,** N- drift layer **402** junction and there is a PN junction which is formed between the p-well and the N- drift layer. The voltage applied to the structure is supported across this PN junction in the reverse bias. There are several key features in a power MOSFET, which include the pitch of the unit cell, which is the repeat unit for the MOSFET, the channel length, which is the portion of the p-well in which the inversion channel is formed, the distance between two successive p-wells, which is referred to as the junction gate field-effect transistor region (JFET region) or the JFET gap and the thickness of the gate oxide **406.** Another feature is an ILD layer **408** which is used to insulate the source interconnect metallization **410** from the polysilicon gate **407.**

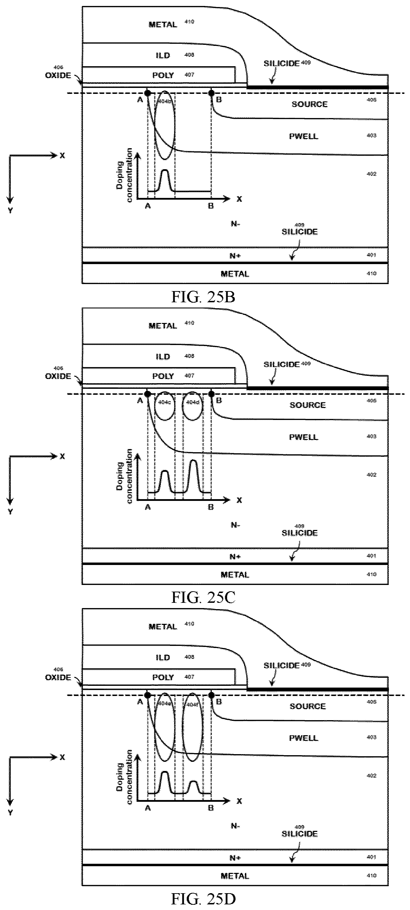

A p-shield region **404a** is formed buried within the p-well structure. In other words, the p-shield is formed beneath the SiC surface, where the MOSFET channel is located. The p-shield region always originates within the p-well region as seen in Fig. 25A, but may in certain examples of this embodiment extend beyond the vertical extent of the p-well region as shown in Fig. 25B.

The embodiment shown in Fig. 25B is similar to that of Fig. 25A except that the bottom of the p-shield region is extended further down into the p-well and can reach outside the p-well region.

Device structures shown in Fig. 25C and Fig. 25D are also similar to the device in Fig. 25A, but they exemplify the case where there are multiple p-shield regions. In these cases, their doping concentration profiles of the different p-shield regions do not necessarily have to be the same and can be different from each other. Points A and B in each of these figures are given as the reference points for describing how the doping profile of the implanted p-shield region looks like.

The p-shield in Fig. 25A to Fig. 25D "re-enforces" the doping of the p-well region locally and provides better shielding of the MOSFET channel at the surface, while minimizing the DIBL effect. Since the p-shield is not directly connected to the channel, the p-shield in this case does not change the threshold voltage. The device shown in Fig. 25A provides the same kind of field shielding for mitigating the DIBL but does not require the change of the threshold voltage value where it is inevitable for the device of Fig. 23A.

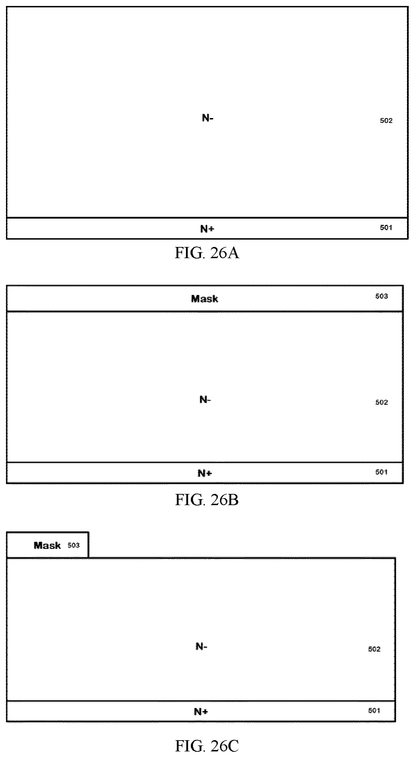

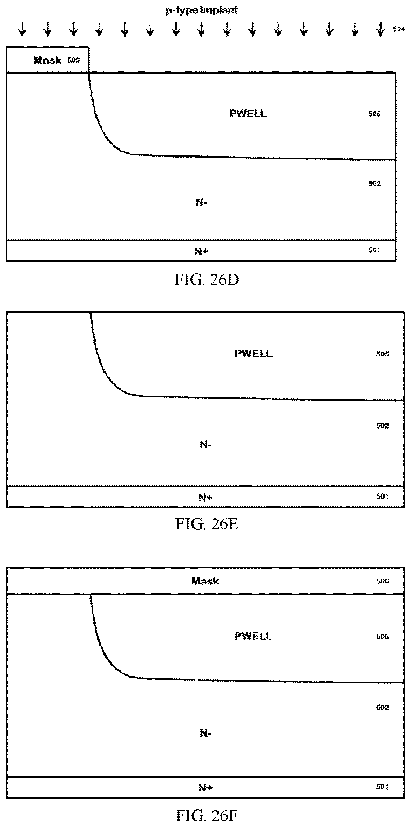

Fig. 26A to Fig. 26U describes the process of manufacturing the structure shown in Fig. 25A. The manufacturing process for a SiC DMOSFET is on a SiC substrate **501** and starts with using a 4H-SiC Si-face epi-wafer with suitable doping ($10^{14}$ - $10^{18}$ cm$^{-3}$) and thickness (1 $\mu$m to 300 $\mu$m) for the epilayer **502** shown in Fig. 26A. A blanket hard mask **503** comprising a chemical vapor deposition (CVD) deposited layer of silicon dioxide, silicon nitride, silicon oxynitride, or a metallic layer such as nickel, with thickness ranging from 50 nm to 5 $\mu$m is deposited in Fig. 26B and then patterned using photolithography followed by a dry etch using reactive ion etching (RIE) for example as shown in Fig. 26C. Then p-well region is first formed by ion-implantation or epitaxial growth using aluminum or boron as the p-type impurity. A p-type implantation **504** comprising boron or aluminum, at energies ranging from 10 keV to 1000 keV, at implant doses ranging from $10^{12}$ cm$^{-2}$ to $10^{15}$ cm$^{-2}$ is performed to create a p-well **505** in Fig. 26D. The patterned mask layer **503** is removed in Fig. 26E.

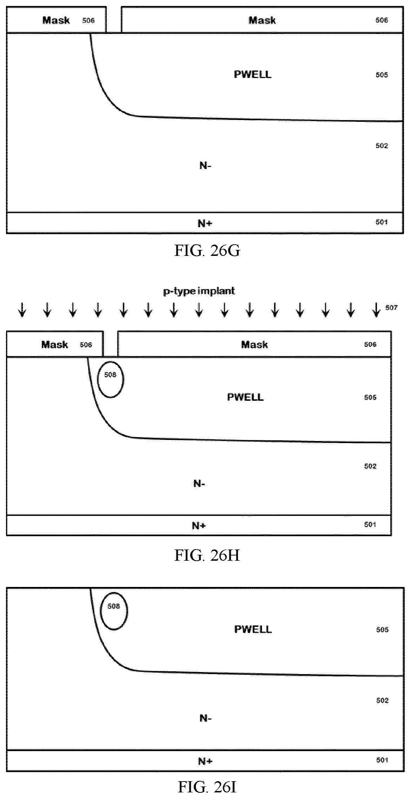

A hard mask layer **506** is deposited by a CVD deposited layer of silicon dioxide, silicon nitride, silicon oxynitride, or a metallic layer such as nickel, with thickness ranging from 50 nm to 5 $\mu$m in Fig. 26F. The mask layer **506** is patterned using photolithography followed by a dry etch using RIE for example in Fig. 26G.

A p-type implant **507** is done in Fig. 26H for creating a p-type region inside the p-well called p-shield **508.** The p-shield region **508** can be formed using aluminum or boron as the p-type impurity. A p-shield region is formed buried within the p-well structure. In other words, the p-shield is formed beneath the SiC surface, where the MOSFET channel is located. The p-shield region always originates within the p-well region. The location of the p-shield region, which is controlled by careful adjustment of the implant energies used for realizing the p-shield region.

The p-shield region may be created by a p-type ion-implantation step comprising boron or aluminum, at energies ranging from 25 keV to 800 keV, at implant doses ranging from $10^{12}$ cm$^{-2}$ to $10^{15}$ cm$^{-2}$. The patterned mask layer **506** is removed in Fig. 26I.

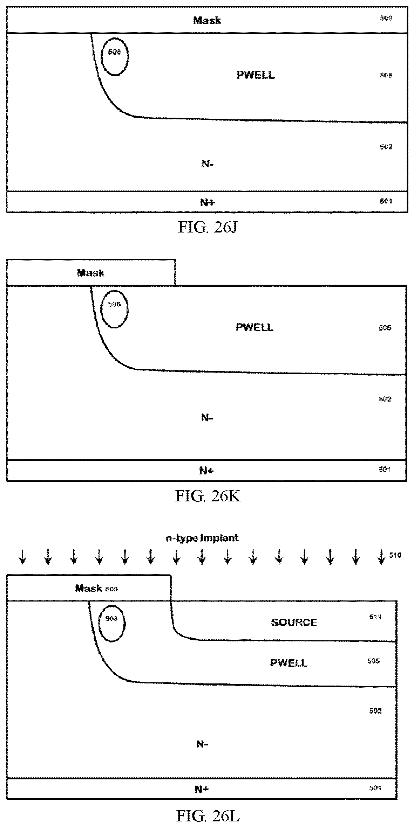

A blanket hard mask **509** comprising a chemical vapor deposition (CVD) deposited layer of silicon dioxide, silicon nitride, silicon oxynitride, or a metallic layer such as nickel, with thickness ranging from 50 nm to 5 $\mu$m is deposited in Fig. 26J and then patterned using photolithography followed by a dry etch using RIE for example as shown in Fig. 26K.

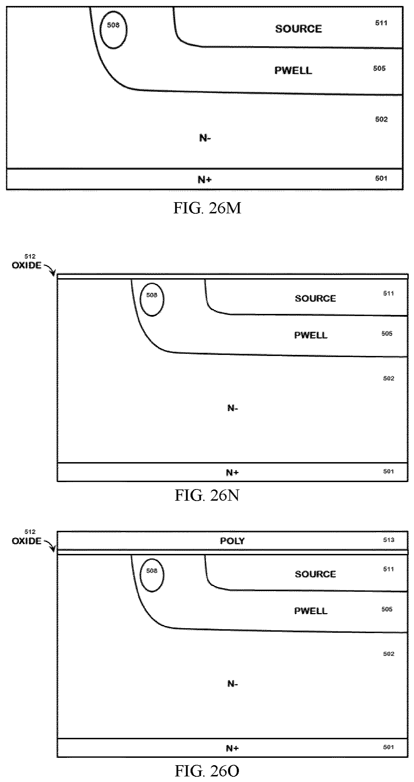

A N+ source region **511** is formed by ion-implantation or by epitaxial re-growth by a n-type impurity such as nitrogen or phosphorus **510** in Fig. 26L. The patterned mask layer **509** is removed in Fig. 26M.

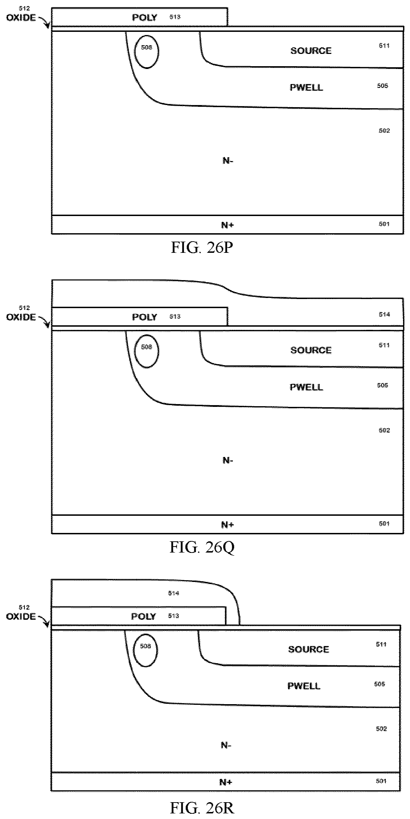

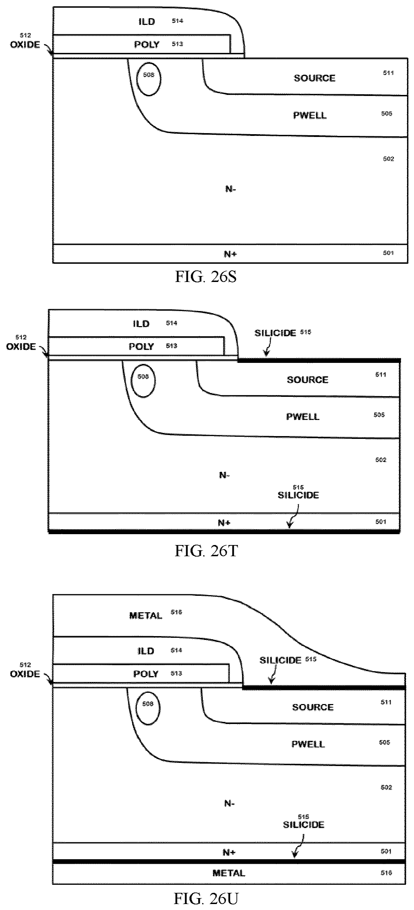

The oxide layer **512** which is the gate oxide is formed by thermal oxidation or using CVD of a dielectric layer such as silicon dioxide, silicon nitride, silicon oxynitride, etc. in Fig. 26N. The thickness of the gate oxide could range from 10 nm to 100 nm. Either dry or wet thermal oxidation could be used for oxide growth. Plasma-enhanced chemical vapor deposition (PECVD) or low-pressure chemical vapor deposition (LPCVD) could be used for gate oxide deposition. A polysilicon gate layer **513** is then deposited in Fig. 26O. The polysilicon layer may be deposited using PECVD or LPCVD. The polysilicon layer may be degenerately doped using boron or phosphorus, either in-situ or in a subsequent step. In-situ doping may be performed by the addition of PH3 precursor to the polysilicon deposition chemistry. Post-deposition doping of polysilicon may be performed by depositing a layer of POCl$_3$ followed by a drive-in step at temperatures ranging from 700-900°C. The polysilicon layer **513** is patterned in Fig. 26P. An ILD layer **514** comprising 50 nm - 1000 nm thick silicon dioxide, silicon nitride, silicon oxynitride layers or a stacked combination thereof is deposited on the wafer in Fig. 26Q. The ILD layer **514** is patterned in Fig. 26R. The gate oxide **512** is patterned in Fig. 26S.

Nickel silicide regions **515** are formed on the exposed SiC surface in Fig. 26T. Interconnect metal layers **516** of either aluminum or silver or gold is deposited and patterned on the top and bottom of the substrate in. Fig. 26U.

The embodiments described herein relate to SiC transistors

The device described in an embodiment herein has a buried N+ region, which is located in between that P+ islands. The buried N+ region is formed in a way that it is physically separated from the wafer surface because it does not contact the Schottky layer. There is a portion of the N- drift layer in contact with the Schottky surface. The physical separation of the N+ region from the wafer surface is a critical feature of this embodiment since SiC devices at the Schottky metal have the N- doping concentration, not the N+ doping concentration. The silicon carbide surfaces in contact with a Schottky metal has the N- doping concentration which is critical for reducing the strength of the electric field at the Schottky metal interface with the SiC. In an embodiment described herein, the vertical extent of the buried N+ region is lower than the bottom of the P+ region and covers the bottom of the P+ region. The spacing between the P+ islands are narrower and the depth of the P+ islands is deeper when compared to prior art MPS diodes. The presence of the N+ region allows the spacing between the P+ islands to be narrower. The P+ islands shield the electric field that develops during the high voltage operation from the Schottky interface. In the embodiments herein the P+ regions interspersed with the N+ regions are designed such as to achieve a certain level of charge balance between the P+ islands and N+ regions which provides the benefit of further reducing the ON resistance of this device and also keeping a low electric field.

In an embodiment herein, the bottom of the N+ region is higher than the bottom of the P+ region. The bottom of the P+ region is in contact with the N- drift layer which is a trade off as this will enable lower leakage currents but higher ON resistance. Better ON resistance can be achieved in an embodiment of the device where the N+ region located in between the P+ islands is buried while lower leakage currents can be achieved in an embodiment of the device where the N+ region does not enclose the bottom of the P+ islands completely. In an embodiment described herein, both buried N+ region located in between the P+ islands and N+ region that do not enclose the bottom of the P+ islands completely can exist on the same device.

In an embodiment described herein the N+ region is formed of several sub N regions while the P+ is formed of many sub P regions such that the doping concentration in each of these different layers or slices could be different. In an embodiment herein either the final slice of the N+ region is underneath the P+ islands and covers around the P+ islands completely or the bottom of the N+ slice is higher than the bottom of the P+ region. The doping concentration of N+ types sub regions farther away from the silicon carbide surface could be progressively higher which may have a benefit of lower conduction losses. In another implementation the doping concentration of the p-type sub regions farther away from the SiC surface could be made progressively lower which may enable better blocking characteristics. The varying doping concentration described in the embodiments herein allows freedom to appropriately tune the device design towards a lower leakage currents, better conduction losses, lowered resistance etc. Better trade off can be achieved with layered and differently doped N+ and P+ regions as opposed to just having one P+ layer and one N+ layer and this can be achieved by using multiple ion implantation steps or multiple epi growth.

In an embodiment herein the N+ region which is interspersed between a set of multiple P+ wells are formed in such a way that it is physically separated from the wafer surface and extends all the way into the N- drift region. The physical separation of the N+ region from a SiC wafer surface in the embodiments herein distinguishes it from other similar inventions.

In an embodiment herein, a part of the SiC wafer which is in contact with a Schottky metal (METAL 1) and is an n-type semiconductor has the same doping concentration of the N-drift since the doping concentration of the n-type SiC semiconductor which is in direct contact with the Schottky metal (METAL 1) is critical for reducing the strength of the electric field at the wafer surface, during the high-voltage blocking mode of operation of the SiC MPS diode.

The device of embodiment shown in Fig. 28A is the cross-sectional schematic of the SiC MPS diode. The key regions of this device are an N+ substrate **201** at the bottom which gives mechanical support of the wafer and is ~350 μm-thick. An N- drift region **202** which is usually an epi layer and is on top of the N+ substrate. There are multiple P+ wells **204** that are formed as linear stripes or more complex circular or hexagonal patterns. The device has a first metal layer **205** denoted as METAL 1, which is the Schottky metal to an n-type SiC semiconductor region and forms Schottky contact to its underlying n-type regions. The device has a second metal layer **206** denoted as METAL 2 on the front side of the wafer which is in contact with the METAL 1. METAL 2 is often called "power metal" and is usually in Aluminum. There is a silicide layer **207** under the bottom of the N+ substrate. There is a third metal layer **208** denoted as METAL 3 under the back side of the wafer which is in contact with the silicide layer.

The device shown in Fig. 28A has a N+ region **203** which is interspersed between a set of multiple P+ wells **204.** The N+ region **203** is formed in such a way that it is physically separated from the wafer surface and extends all the way into the N- drift region **202**. The physical separation of the N+ region from a SiC wafer surface is a critical feature of the embodiment described herein and distinguishes it from other similar inventions. A part of the SiC wafer which is in contact with a Schottky metal **205** denoted as METAL 1 and is an n-type semiconductor has the same doping concentration of the N- drift **202**. In the embodiment described herein, the doping concentration of the n-type SiC semiconductor which is in direct contact with the Schottky metal **205** labeled METAL 1 is critical for reducing the strength of the electric field at the wafer surface, during the high-voltage blocking mode of operation of the SiC MPS diode. The vertical extent of the N+ region **203** is lower than the bottom of the P+ region **204.** The buried N+ region completely surrounds the P+ region which provides Schottky-injected majority carriers a more conductive travel path and reduces the total forward conduction loss.

The embodiment described in the device herein, uses a different kind of Schottky metal for the METAL 1 layer when compared to the METAL 1 of the prior art. The choice of METAL 1 **205** of the device described in Fig. 28A is made so that the barrier height of its Schottky contact is lower than that of the prior art. Due to the smaller Schottky barrier height, the injection of the majority carrier over the Schottky barrier becomes more efficient and this reflects as a lower Knee Voltage ($V_{Knee}$) in the forward I-V characteristics as shown in Fig. 28B. The new devices with lower $V_{Knee}$ (marked as #2 and #3) have lower forward conduction loss than their counterpart (marked as #1). The lower Schottky barrier height, leads to higher reverse leakage current as shown in the reverse I-V curves - marked as #2 and #3. The amount of the leakage current can be kept under control in the embodiment described here by fine tuning the barrier height which is dependent on various design elements including but not limited to the annealing temperature of the Schottky contact, the pitch of the device, depth and doping of the P+ region, the doping and depth of the N+ region, and the doping of the N- drift region.

Another distinct feature of the embodiment described here is that the N+ substrate of the new device is thinner (which is usually $100 \sim 200$ $\mu m$) than its counterpart (which is usually $\sim 350$ $\mu m$). The thinned N+ substrate directly impacts on the forward I-V characteristics that the linear region of the forward I-V curves where $V_F > V_{Knee}$ becomes steeper because the thinned substrate contributes less series resistance to the total amount of the forward conduction loss. As shown in Fig. 28B, the diode with the lower $V_{Knee}$ and thinned substrate (marked #3) must have less conduction loss than another diode with the exact lower $V_{Knee}$ and thick substrate (marked #2). In the embodiment here the Differential On-Resistance ($R_{ON, Diff}$) which is the inverse of the slope of the linear segment of the forward I-V curve is significantly reduced by thinning the N+ substrate. The lower $V_{Knee}$ and $R_{ON, Diff}$ of the diode in the embodiment herein enables significant reduction of the forward conduction loss while maintaining the reverse leakage low enough for suitable needs in the market.

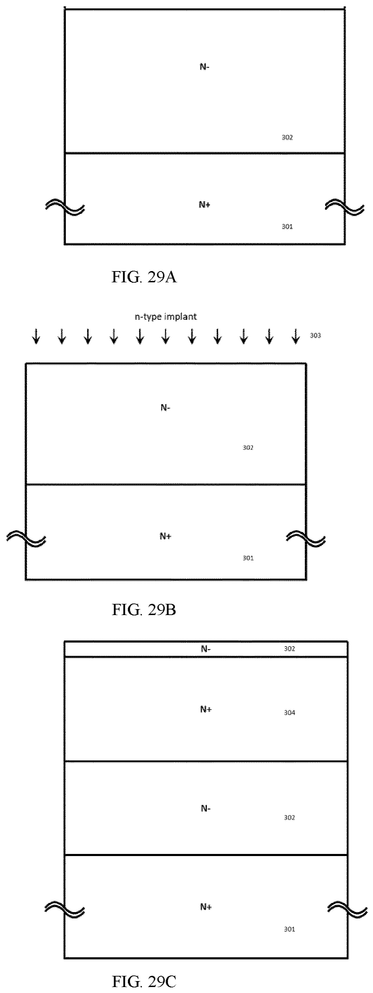

Fig. 29A to Fig. 29L describes the process of manufacturing the structure shown in Fig. 28A. The manufacturing process of the device includes preparing a SiC wafer in Fig. 29A which consists of a highly conductive N+ substrate **301** and an N- drift region **302,** where the N- drift region is typically epi-grown. The N- drift region **302** is designed in such a way that the doping concentration and thickness of the N- drift region are primarily selected based on the required blocking performance. When the SiC wafer is prepared, an ion implantation step with an n-type species **303** such as nitrogen and/or phosphorus is performed onto the active region of the device in Fig. 29B forming an N+ region within the N- drift region. The edge termination which is not shown needs to be masked during the n-type ion implantation step. It is important to note that the n-type ion implantation step **303** needs to be performed in such a fashion that the N+ region **304** is completely buried inside the N- drift region in Fig. 29C. The ion implantation step should form the N+ region **304** where the top of the N+ region is physically off from the wafer surface.

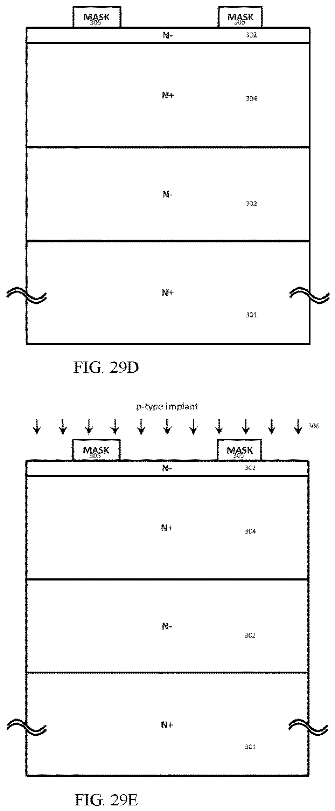

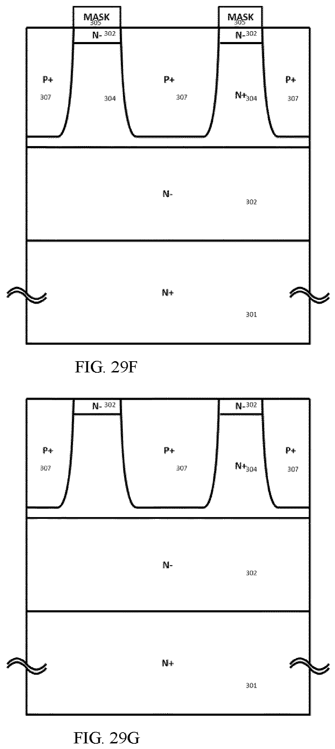

A patterned mask **305,** which is preferably a hard mask made of such as an oxide, a nitride, a polysilicon layer, or a combination of these, is formed on the wafer surface in Fig. 29D. The patterned mask must be thick enough to completely block any high energy impurities during the subsequent ion implant step. A p-type ion implantation step with a p-type impurity **306** such as aluminum and/or boron is performed in Fig. 29E to form a set of multiple P+ wells **307** in Fig. 29F. The bottoms of the set of multiple P+ wells **307** are formed such that they are above the bottom of the N+ region **304.** In the embodiments herein, the depth of the set of multiple P+ wells are less than the depth of the N+ region. The set of multiple P+ wells leads to a P+ region as a whole in Fig. 29F. The edge termination region which is not shown may be formed by the p-type ion implantation step. The patterned mask **305** is removed by dry or wet etching process in Fig. 29G. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

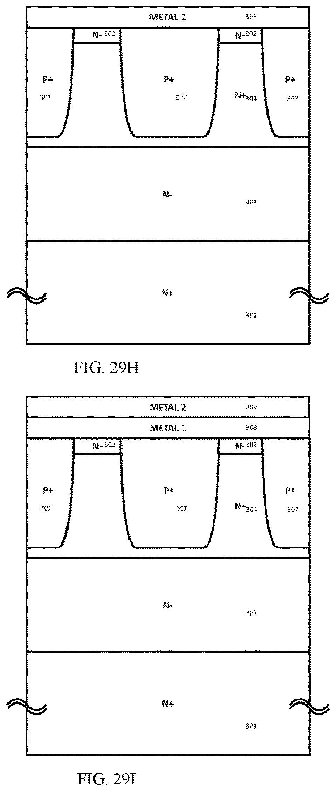

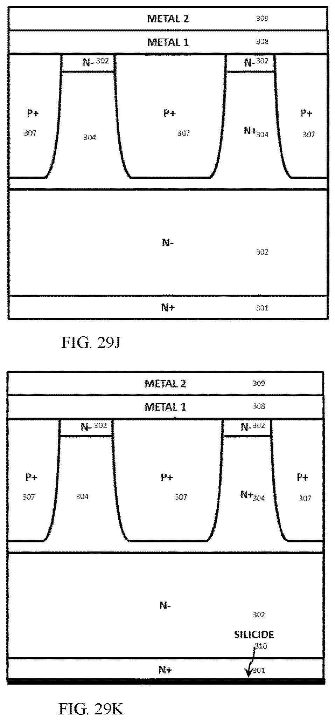

The Schottky contact is formed on the wafer surface by depositing a Schottky metal **308** marked as METAL 1 directly on the wafer surface in Fig. 29H. The deposited Schottky metal layer is then patterned by using dry etching, wet etching, or lift-off process and annealed at a certain temperature for a certain amount of time by using a furnace or RTA (Rapid Thermal Anneal). The thermal budget of the annealing step after the Schottky metal deposition needs to be carefully designed and controlled because it directly affects the barrier height of the Schottky contact. A first pad metal **309** marked as METAL 2 is then deposited on top of the wafer in Fig. 29I and patterned by dry etching, wet etching, or lift-off. The first pad metal can be of Aluminum/Aluminum-based alloy. The wafer is then thinned from its back side until its thickness reaches to a target thickness of $100 \sim 200$ $\mu m$ in Fig. 29J. The thickness may be further reduced in the future when the wafer thinning technology improves and provides the target thickness less than the aforementioned $100 \sim 200$ $\mu m$. The wafer thinning can be accomplished by Chemical Mechanical Polishing (CMP), wet etching, dry etching, or a combination of the aforementioned grinding techniques with a proper protective coating at the front side of the wafer.

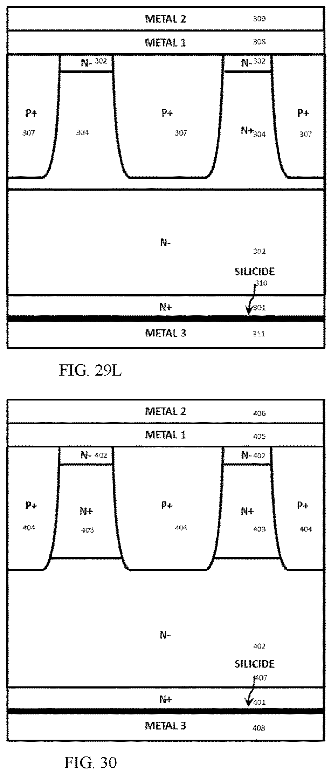

A silicide region **310** on the back side of the wafer is then formed in Fig. 29K. The silicide region is required to form a good ohmic contact on the back side of the wafer. The silicide region is formed by depositing ohmic metal stack and annealing the wafer by using a laser annealing technique as an example. A second pad metal **311** marked as METAL 3 is formed on the back side of the wafer in Fig. 29L. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of three n-type epi-grown layers in Fig. 29C with different doping concentrations and thicknesses and the N+ substrate at the bottom of the SiC wafer. The three n-type epi-grown layers should be formed in such a way that an N- layer **302** is meeting a device side of the wafer and an N+ layer **304** is positioned right underneath the N- layer, where the N+ layer is on top of a second N- layer also labeled **302** which serves as a drift region and the second N- layer is positioned on top of the N+ substrate **301.**

When the SiC wafer with the aforementioned epi structure is prepared, a patterned mask **305,** which is preferably a hard mask made of such as an oxide, a nitride, a polysilicon layer, or a combination of these, is formed on the wafer surface in Fig. 29D. The patterned mask must be thick enough to completely block any high energy impurities during the subsequent ion implant step. A p-type ion implantation step with a p-type impurity **306** such as aluminum and/or boron is performed in Fig. 29E to form a set of multiple P+ wells **307** in Fig. 29F. The bottoms of the set of multiple P+ wells **307** are formed such that they are above the bottom of the N+ region **304.** In the embodiments herein, the depth of the set of multiple P+ wells are less than the depth of the N+ region. The set of multiple P+ wells lead to a P+ region as a whole in Fig. 29F. The edge termination region which is not shown may be formed by the p-type ion implantation step. The patterned mask **305** is removed by dry or wet etching process in Fig. 29G. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal 308 marked as METAL 1 directly on the wafer surface in Fig. 29H. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **309** marked as METAL 2 is then deposited on top of the wafer in Fig. 29I and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 29J. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **310** on the back side of the wafer is then formed in Fig. 29K. The silicide region is required to form a good ohmic contact on the back side of the wafer. The silicide region is formed by depositing ohmic metal stack and annealing the wafer by using a laser annealing technique as an example. A second pad metal **311** marked as METAL 3 is formed on the back side of the wafer in Fig. 29L. The second pad metal can be of Aluminum or Aluminum-based alloy. After the second pad metal step is finished, a protective coating process step may be followed on top of the wafer to form a moisture barrier.

As seen in the embodiment shown in Fig. 28A the P+ region **204** of the SiC MPS diode of this invention is formed in such a way that the set of multiple P+ wells are spaced narrower in lateral direction and extend vertically deeper into the N- drift region **202** when compared to the case of the prior art. The P+ region of this invention, in conjunction with the aforementioned N+ region, is designed to provide a robust shielding to the Schottky barrier formed on the wafer surface. In contrast, the device of the prior art is vulnerable to the high stress of the electric field at its Schottky contact which easily results in temporary/permanent degradation of the Schottky contact leading to the high leakage current and/or irreversible destruction of the device. The device in the prior art has the N- drift region as the sole conduction path only, and it is clear that the majority carriers flowing through the JFET-like region between the P+ wells near the wafer surface will suffer in the carrier transport and increase the total forward conduction loss.

Fig. 28C compares key dimensions of the device structure of this invention. Regardless of the types of the devices, the lateral spacing between two adjacent P+ wells are defined to be W1 and the vertical depth of the P+ wells measured from the surface of the SiC wafer is defined to be D1. It should be noted that the ratio of W1 over D1 (or W1/D1) for the device of this invention is less than 3.0 (or W1/D1 < 3.0).

The device of embodiment shown in Fig. 30 is the cross-sectional schematic of the SiC MPS diode. The key regions of this device are an N+ substrate **401** at the bottom which gives mechanical support of the wafer and is ~350 $\mu$m-thick. An N- drift region **402** which is usually an epi layer and is on top of the N+ substrate. There are multiple P+ wells **404** that are formed as linear stripes or more complex circular or hexagonal patterns. The device has a first metal layer **405** denoted as METAL 1, which is the Schottky metal to an n-type SiC semiconductor region and forms Schottky contact to its underlying n-type regions. The device has a second metal layer **406** denoted as METAL 2 on the front side of the wafer which is in contact with the METAL 1. METAL 2 is often called "power metal" and is usually in Aluminum. There is a silicide layer **407** under the bottom of the N+ substrate. There is a third metal layer **408** denoted as METAL 3 under the back side of the wafer which is in contact with the silicide layer.

The device shown in Fig. 30 has a N+ region **403** which is interspersed between a set of multiple P+ wells **404.** The N+ region **403** is formed in such a way to extend near the vicinity of the P+ region **404** but not completely cover the bottom of the P+ region. The physical separation of the N+ region from a SiC wafer surface is a critical feature of the embodiment described herein and distinguishes it from other similar inventions. A part of the SiC wafer which is in contact with a Schottky metal **405** denoted as METAL 1 and is an n-type semiconductor has the same doping concentration of the N- drift **402.** In the embodiment described herein, the doping concentration of the n-type SiC semiconductor which is in direct contact with the Schottky metal **405** labeled METAL 1 is critical for reducing the strength of the electric field at the wafer surface, during the high-voltage blocking mode of operation of the SiC MPS diode. The vertical extent of the N+ region **403** is above the bottom of the P+ region **404.** The buried N+ region does not completely cover the bottom of the P+ region.

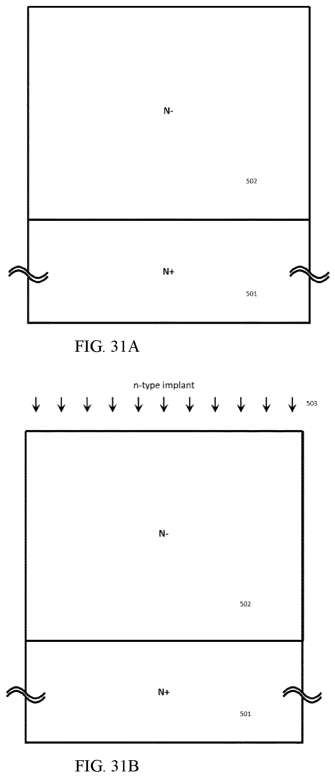

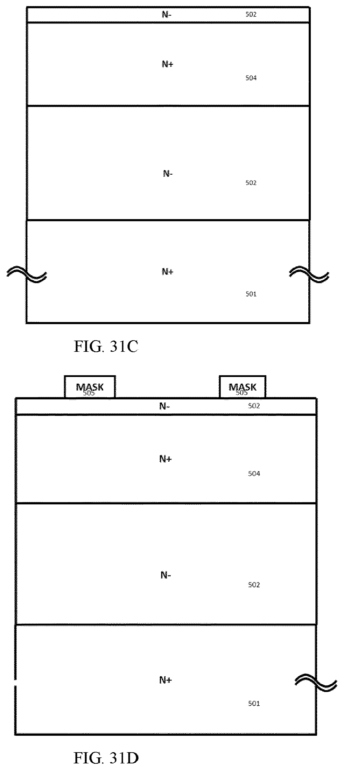

Fig. 31A to Fig. 31L describes the process of manufacturing the structure shown in Fig. 30. The manufacturing process of the device includes preparing a SiC wafer in Fig. 31A which consists of a highly conductive N+ substrate **501** and an N- drift region **502,** where the N- drift region is typically epi-grown. The N- drift region **502** is designed in such a way that the doping concentration and thickness of the N- drift region are primarily selected based on the required blocking performance. When the SiC wafer is prepared, an ion implantation step with an n-type species **503** such as nitrogen and/or phosphorus is performed onto the active region of the device in Fig. 31B forming an N+ region within the N- drift region. The edge termination which is not shown needs to be masked during the n-type ion implantation step. It is important to note that the n-type ion implantation step **503** needs to be performed in such a fashion that the N+ region **504** is completely buried inside the N- drift region in Fig. 31C. The ion implantation step should form the N+ region **504** where the top of the N+ region is physically off from the wafer surface.

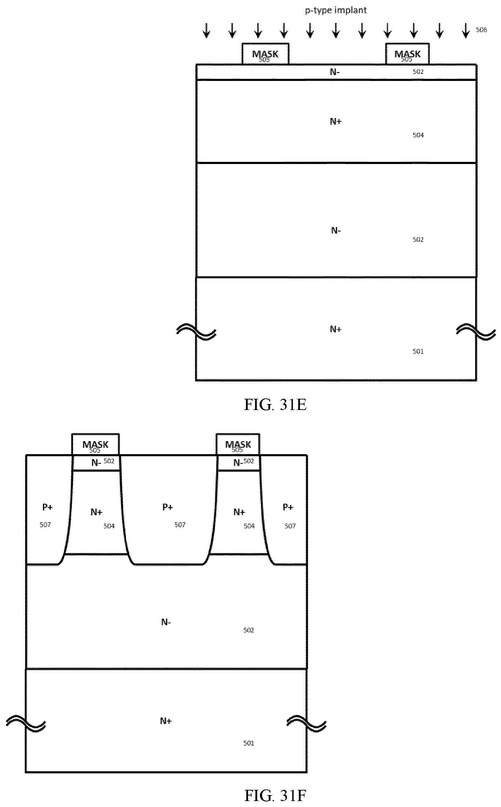

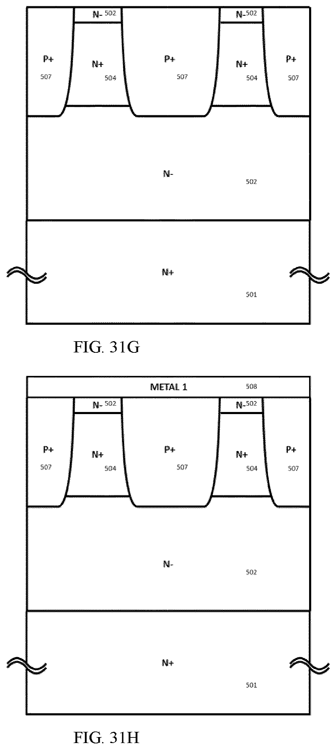

A patterned mask **505,** which is preferably a hard mask made of such as an oxide, a nitride, a polysilicon layer, or a combination of these, is formed on the wafer surface in Fig. 31D. The patterned mask must be thick enough to completely block any high energy impurities during the subsequent ion implant step. A p-type ion implantation step with a p-type impurity **506** such as aluminum and/or boron is performed in Fig. 31E to form a set of multiple P+ wells **507** in Fig. 31F. The bottoms of the set of multiple P+ wells **507** are formed such that they are below the bottom of the N+ region **504.** In the embodiments herein, the depth of the set of multiple P+ wells are greater than the depth of the N+ region. The set of multiple P+ wells lead to a P+ region as a whole in Fig. 31F. The edge termination region which is not shown may be formed by the p-type ion implantation step. The patterned mask **505** is removed by dry or wet etching process in Fig. 31G. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

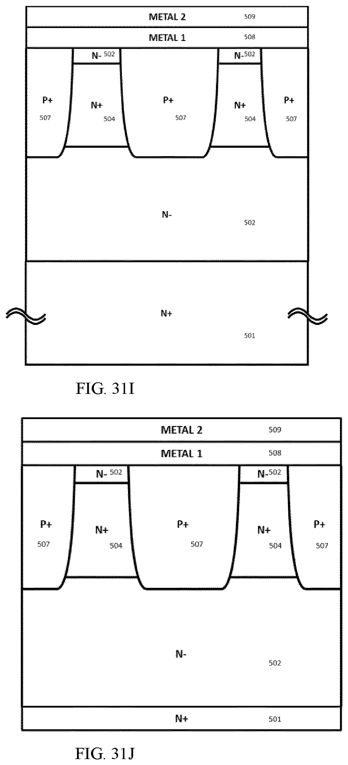

The Schottky contact is formed on the wafer surface by depositing a Schottky metal **508** marked as METAL 1 directly on the wafer surface in Fig. 31H. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **509** marked as METAL 2 is then deposited on top of the wafer in Fig. 31I and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 31J. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

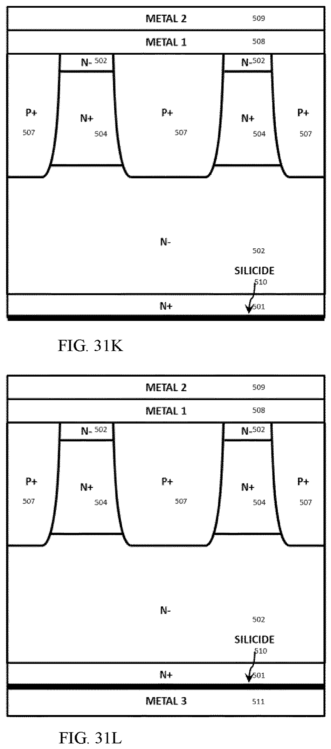

A silicide region **510** on the back side of the wafer is then formed in Fig. 31K. The silicide region is required to form a good ohmic contact on the back side of the wafer. The silicide region is formed by depositing ohmic metal stack and annealing the wafer by using a laser annealing technique as an example. A second pad metal **511** marked as METAL 3 is formed on the back side of the wafer in Fig. 31L. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of three n-type epi-grown layers in Fig. 31C with different doping concentrations and thicknesses and the N+ substrate at the bottom of the SiC wafer. The three n-type epi-grown layers should be formed in such a way that an N- layer **502** is meeting a device side of the wafer and an N+ layer **504** is positioned right underneath the N- layer, where the N+ layer is on top of a second N- layer also labeled **502** which serves as a drift region and the second N- layer is positioned on top of the N+ substrate **501.**

When the SiC wafer with the aforementioned epi structure is prepared, a patterned mask 505, which is preferably a hard mask made of such as an oxide, a nitride, a polysilicon layer, or a combination of these, is formed on the wafer surface in Fig. 31D. The patterned mask must be thick enough to completely block any high energy impurities during the subsequent ion implant step. A p-type ion implantation step with a p-type impurity **506** such as aluminum and/or boron is performed in Fig. 31E to form a set of multiple P+ wells **507** in Fig. 31F. The bottoms of the set of multiple P+ wells **507** are formed such that they are below the bottom of the N+ region **504.** In the embodiments herein, the depth of the set of multiple P+ wells are greater than the depth of the N+ region. The set of multiple P+ wells lead to a P+ region as a whole in Fig. 31F. The edge termination region which is not shown may be formed by the p-type ion implantation step. The patterned mask **505** is removed by dry or wet etching process in Fig. 31G. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **508** marked as METAL 1 directly on the wafer surface in Fig. 31H. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **509** marked as METAL 2 is then deposited on top of the wafer in Fig. 31I and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 31J. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **510** on the back side of the wafer is then formed in Fig. 31K. The silicide region is required to form a good ohmic contact on the back side of the wafer. The silicide region is formed by depositing ohmic metal stack and annealing the wafer by using a laser annealing technique as an example. A second pad metal **511** marked as METAL 3 is formed on the back side of the wafer in Fig. 31L. The second pad metal can be of Aluminum or Aluminum-based alloy. After the second pad metal step is finished, a protective coating process step may be followed on top of the wafer to form a moisture barrier.

The embodiment shown in Fig. 30 affords lower leakage current and better blocking performance than embodiment shown in Fig. 28A, by further reducing the electrical field at the Schottky metal interface, but may trade-off a higher on-state voltage drop as compared to the embodiment shown in Fig. 28A.

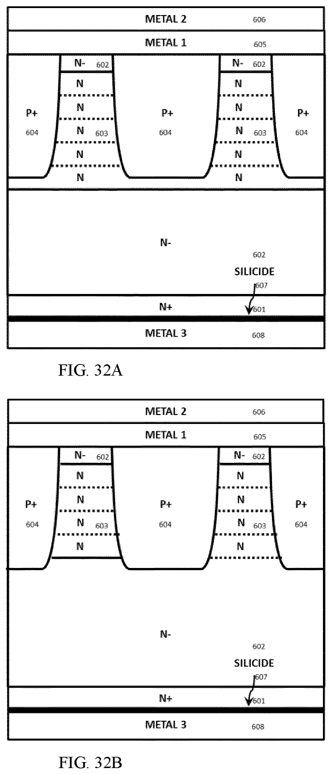

The devices of embodiments shown in Fig. 32A to Fig. 32F are the cross-sectional schematic of the SiC MPS diode. The key regions of these devices are an N+ substrate **601** at the bottom which gives mechanical support of the wafer and is ~350 $\mu$m-thick. An N- drift region **602** which is usually an epi layer and is on top of the N+ substrate. The device has a first metal layer **605** denoted as METAL 1, which is the Schottky metal to an n-type SiC semiconductor region and forms Schottky contact to its underlying n-type regions. The device has a second metal layer **606** denoted as METAL 2 on the front side of the wafer which is in contact with the METAL 1. METAL 2 is often called "power metal" and is usually in Aluminum. There is a silicide layer **607** under the bottom of the N+ substrate. There is a third metal layer **608** denoted as METAL 3 under the back side of the wafer which is in contact with the silicide layer. The devices of embodiments in Fig. 32A to Fig. 32F differs from the ones shown in embodiments Fig. 28A and Fig. 30 because the N+ region in the previous embodiments is replaced by a set of multiple N sub-regions **603** arranged in layers. The thickness and doping concentration in each of these sub-regions may be different. Similarly, the P+ region of devices in embodiments of Fig. 28A and Fig. 30 is replaced by a set of multiple layered P sub-regions. The doping concentration in each slice may be preferably designed.

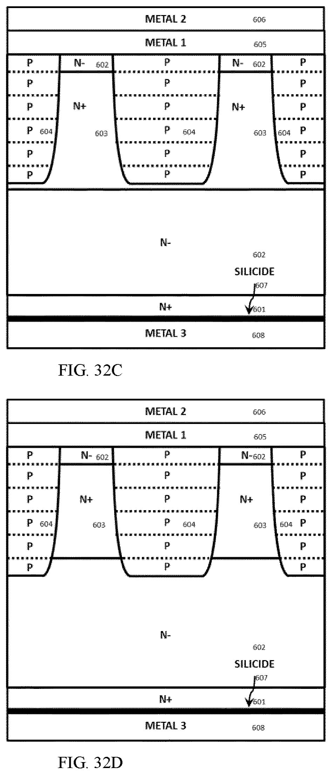

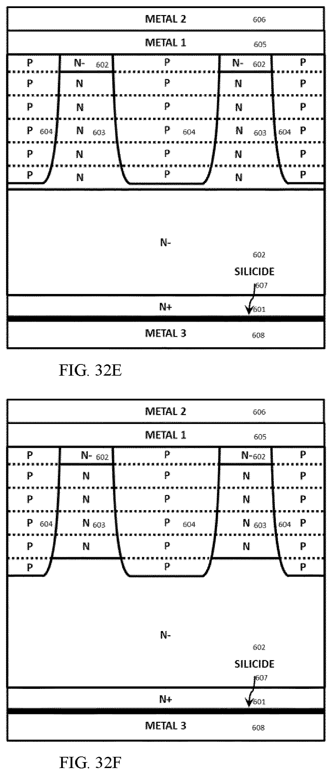

The devices in embodiments shown in Fig. 32A to Fig. 32F have the N+ region **603** which is interspersed between a set of multiple P+ wells **604.** There are several potential examples of the embodiment shown in Fig. 32A to Fig. 32F including a device with a set of multiple n-type sub-layers with different thicknesses and doping concentrations but a set of multiple p-type wells which are of the same kind as in Fig. 32A and Fig. 32B, a device with a set of multiple p-type sub-layers with different thicknesses and doping concentrations but a single n-type layer serving as the N+ region as in Fig. 32C and Fig. 32D, a device with a set of multiple n-type sub-layers and a set of multiple p-type sub-layers with different thicknesses and doping concentrations as in Fig. 32E and Fig. 32F. Devices in Fig. 32A, Fig. 32C and Fig. 32E have the N+ region **603** surrounding and under the P+ wells **604,** and devices in Fig. 32B, Fig. 32D and Fig. 32F have the N+ region **603** placed in between the P+ wells but not surrounding the P+ wells **604.** The physical separation of the N+ region from a SiC wafer surface is a critical feature of the embodiment described herein and distinguishes it from other similar inventions. A part of the SiC wafer which is in contact with a Schottky metal **605** denoted as METAL 1 and is an n-type semiconductor has the same doping concentration of the N- drift **602.** In the embodiment described herein, the doping concentration of the n-type SiC semiconductor which is in direct contact with the Schottky metal **605** labeled METAL 1 is critical for reducing the strength of the electric field at the wafer surface, during the high-voltage blocking mode of operation of the SiC MPS diode.

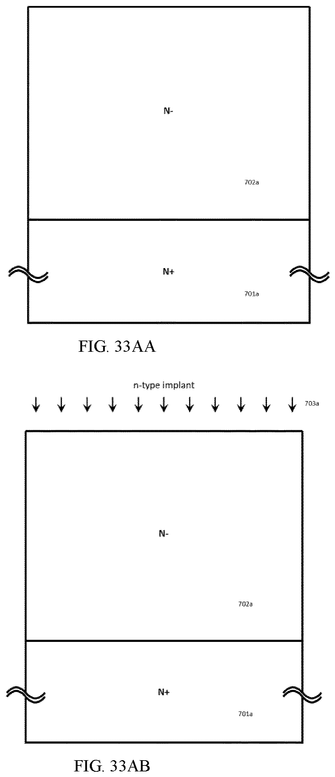

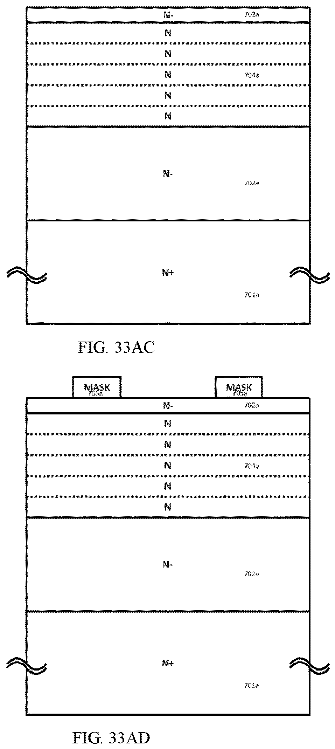

Fig. 33AA to Fig. 33AL describes the process of manufacturing the structure shown in Fig. 32A. The manufacturing process of the device includes preparing a SiC wafer in Fig. 33AA which consists of a highly conductive N+ substrate **701a** and an N- drift region **702a,** where the N- drift region is typically epi-grown. The N- drift region **702a** is designed in such a way that the doping concentration and thickness of the N- drift region are primarily selected based on the required blocking performance. When the SiC wafer is prepared, a set of multiple ion implantation steps with an n-type species **703a** such as nitrogen and/or phosphorus is performed onto the active region of the device in Fig. 33AB. The set of multiple ion implantation steps with the n-type species forms a set of sub n-type regions **704a** in Fig. 33AC where each sub region is defined by the dotted line in the schematic for indicating the top and bottom of the sub region and all sub regions are interconnected. The interconnected sub regions consist of the N+ region as a whole. The edge termination which is not shown needs to be masked during the set of n-type ion implantation steps. It is important to note that the n-type ion implantation steps **703a** needs to be performed in such a fashion that the N+ region **704a** is completely buried inside the N-drift region in Fig. 33AC. The ion implantation steps should form the N+ region **704a** where the top of the N+ region is physically off from the wafer surface.

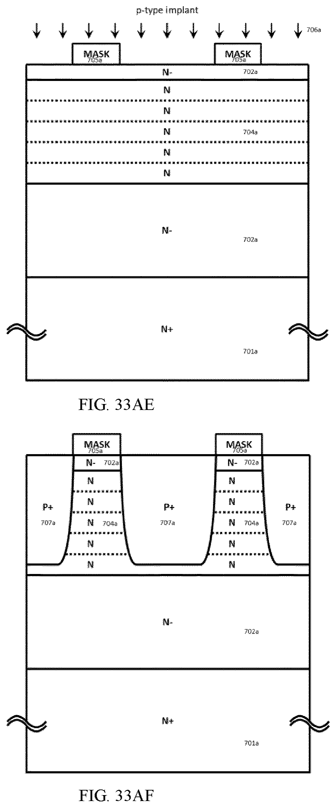

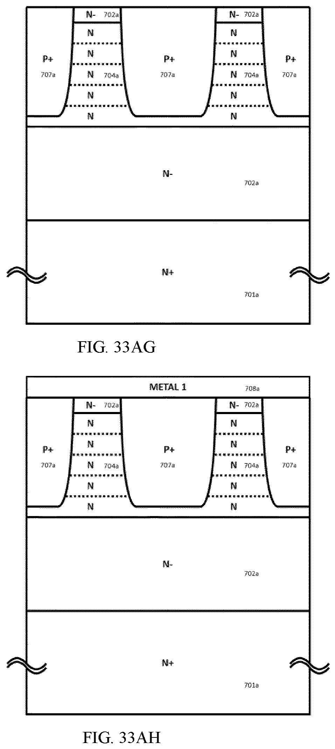

A patterned mask **705a,** which is preferably a hard mask made of such as an oxide, a nitride, a polysilicon layer, or a combination of these, is formed on the wafer surface in Fig. 33AD. The patterned mask must be thick enough to completely block any high energy impurities during the subsequent ion implant step. A p-type ion implantation step with a p-type impurity **706a** such as aluminum and/or boron is performed in Fig. 33AE to form a set of multiple P+ wells **707a** in Fig. 33AF. The bottoms of the set of multiple P+ wells **707a** are formed such that they are above the bottom of the N+ region **704a.** In the embodiments herein, the depth of the set of multiple P+ wells are less than the depth of the N+ region. The set of multiple P+ wells lead to a P+ region as a whole in Fig. 33AF. The edge termination region which is not shown may be formed by the p-type ion implantation step. The patterned mask **705a** is removed by dry or wet etching process in Fig. 33AG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

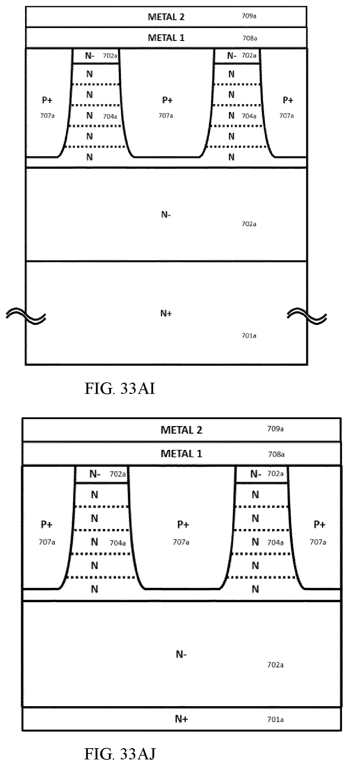

The Schottky contact is formed on the wafer surface by depositing a Schottky metal **708a** marked as METAL 1 directly on the wafer surface in Fig. 33AH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709a** marked as METAL 2 is then deposited on top of the wafer in Fig. 33AI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33AJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

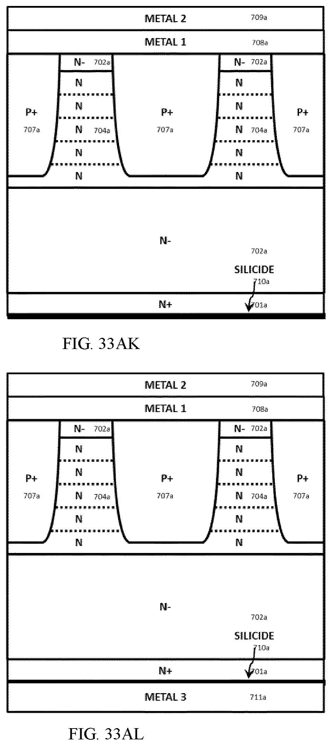

A silicide region **710a** on the back side of the wafer is then formed in Fig. 33AK. The silicide region is required to form a good ohmic contact on the back side of the wafer. The silicide region is formed by depositing ohmic metal stack and annealing the wafer by using a laser annealing technique as an example. A second pad metal **711a** marked as METAL 3 is formed on the back side of the wafer in Fig. 33AL. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of multiple n-type epi-grown layers in Fig. 33AC with different doping concentrations and thicknesses and the N+ substrate at the bottom of the SiC wafer. On top of the N+ substrate **701a,** an N- drift layer **702a** can be epi-grown for serving as a drift/blocking layer. On top of the N- drift layer, a number of n-type epilayers can be grown to form an N+ region **704a** as a whole which consists of a set of sub n-type regions where each sub region is defined by different doping concentration and thickness and all sub regions are interconnected. On top of the buried N+ region, an N- layer can be formed which reaches to the surface of the SIC wafer **702a.**

When the SiC wafer with the aforementioned epi structure is prepared, a patterned mask **705a,** which is preferably a hard mask made of such as an oxide, a nitride, a polysilicon layer, or a combination of these, is formed on the wafer surface in Fig. 33AD. The patterned mask must be thick enough to completely block any high energy impurities during the subsequent ion implant step. A p-type ion implantation step with a p-type impurity **706a** such as aluminum and/or boron is performed in Fig. 33AE to form a set of multiple P+ wells **707a** in Fig. 33AF. The bottoms of the set of multiple P+ wells **707a** are formed such that they are above the bottom of the N+ region **704a.** In the embodiments herein, the depth of the set of multiple P+ wells are less than the depth of the N+ region. The set of multiple P+ wells lead to a P+ region as a whole in Fig. 33AF. The edge termination region which is not shown may be formed by the p-type ion implantation step. The patterned mask **705a** is removed by dry or wet etching process in Fig. 33AG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **708a** marked as METAL 1 directly on the wafer surface in Fig. 33AH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709a** marked as METAL 2 is then deposited on top of the wafer in Fig. 33AI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33AJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **710a** on the back side of the wafer is then formed in Fig. 33AK. The silicide region is required to form a good ohmic contact on the back side of the wafer. The silicide region is formed by depositing ohmic metal stack and annealing the wafer by using a laser annealing technique as an example. A second pad metal **711a** marked as METAL 3 is formed on the back side of the wafer in Fig. 33AL. The second pad metal can be of Aluminum or Aluminum-based alloy. After the second pad metal step is finished, a protective coating process step may be followed on top of the wafer to form a moisture barrier.

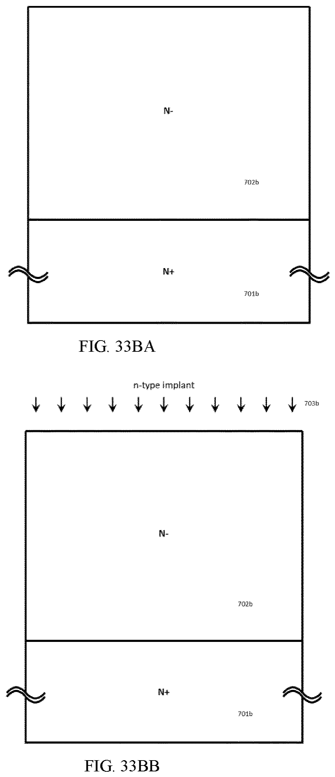

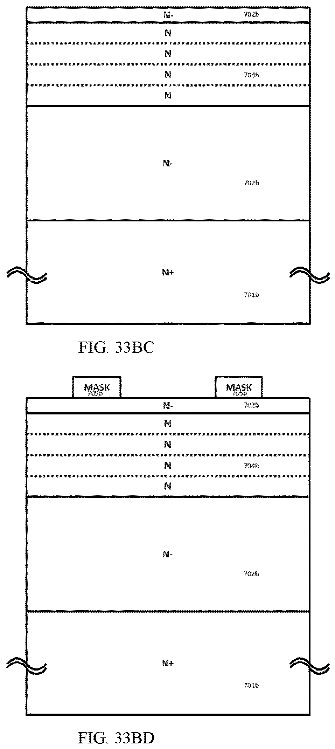

Fig. 33BA to Fig. 33BL describes the process of manufacturing the structure shown in Fig. 32B. The manufacturing process of the device includes preparing a SiC wafer in Fig. 33BA which consists of a highly conductive N+ substrate **701b** and an N- drift region **702b,** where the N- drift region is typically epi-grown. The N- drift region **702b** is designed in such a way that the doping concentration and thickness of the N- drift region are primarily selected based on the required blocking performance. When the SiC wafer is prepared, a set of multiple ion implantation steps with an n-type species **703b** such as nitrogen and/or phosphorus is performed onto the active region of the device in Fig. 33BB. The set of multiple ion implantation steps with the n-type species forms a set of sub n-type regions **704b** in Fig. 33BC where each sub region is defined by the dotted line in the schematic for indicating the top and bottom of the sub region and all sub regions are interconnected. The interconnected sub regions consist of the N+ region as a whole. The edge termination which is not shown needs to be masked during the set of n-type ion implantation steps. It is important to note that the n-type ion implantation steps **703b** needs to be performed in such a fashion that the N+ region **704b** is completely buried inside the N- drift region in Fig. 33BC. The ion implantation steps should form the N+ region **704b** where the top of the N+ region is physically off from the wafer surface.

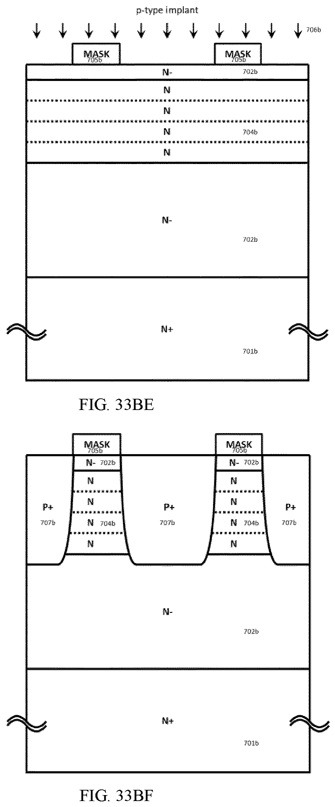

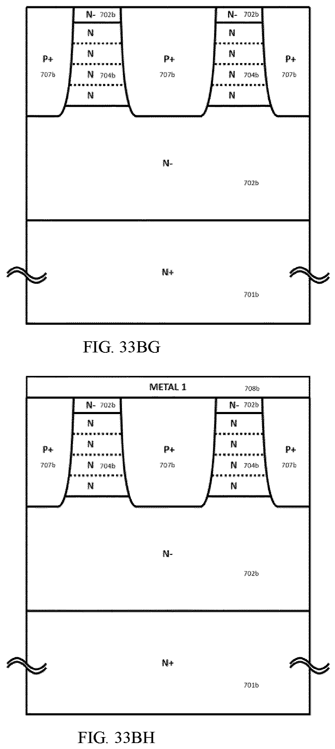

A patterned mask **705b,** which is preferably a hard mask made of such as an oxide, a nitride, a polysilicon layer, or a combination of these, is formed on the wafer surface in Fig. 33BD. The patterned mask must be thick enough to completely block any high energy impurities during the subsequent ion implant step. A p-type ion implantation step with a p-type impurity **706b** such as aluminum and/or boron is performed in Fig. 33BE to form a set of multiple P+ wells **707b** in Fig. 33BF. The bottoms of the set of multiple P+ wells **707b** are formed such that they are below the bottom of the N+ region **704b.** In the embodiments herein, the depth of the set of multiple P+ wells are greater than the depth of the N+ region. The set of multiple P+ wells lead to a P+ region as a whole in Fig. 33BF. The edge termination region which is not shown may be formed by the p-type ion implantation step. The patterned mask **705b** is removed by dry or wet etching process in Fig. 33BG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

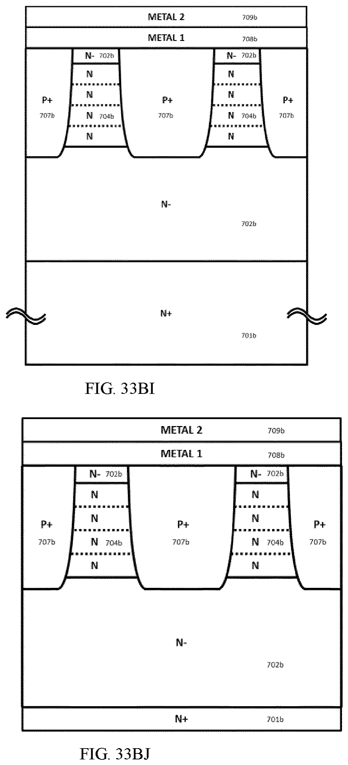

The Schottky contact is formed on the wafer surface by depositing a Schottky metal **708b** marked as METAL 1 directly on the wafer surface in Fig. 33BH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709b** marked as METAL 2 is then deposited on top of the wafer in Fig. 33BI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33BJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

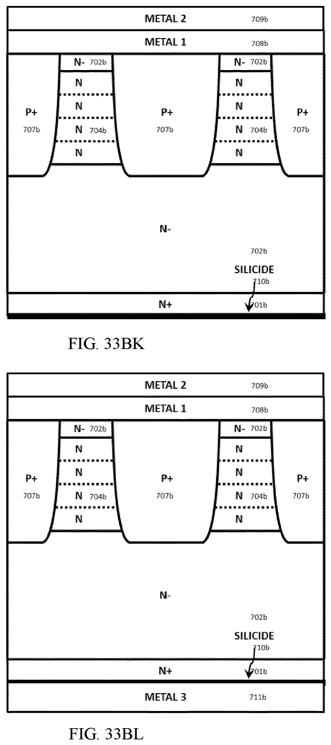

A silicide region **710b** on the back side of the wafer is then formed in Fig. 33BK. The silicide region is required to form a good ohmic contact on the back side of the wafer. The silicide region is formed by depositing ohmic metal stack and annealing the wafer by using a laser annealing technique as an example. A second pad metal **711b** marked as METAL 3 is formed on the back side of the wafer in Fig. 33BL. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of multiple n-type epi-grown layers in Fig. 33BC with different doping concentrations and thicknesses and the N+ substrate at the bottom of the SiC wafer. On top of the N+ substrate **701b,** an N- drift layer **702b** can be epi-grown for serving as a drift/blocking layer. On top of the N- drift layer, a number of n-type epilayers can be grown to form an N+ region **704b** as a whole which consists of a set of sub n-type regions where each sub region is defined by different doping concentration and thickness and all sub regions are interconnected. On top of the buried N+ region, an N- layer can be formed which reaches to the surface of the SIC wafer **702b.**

When the SiC wafer with the aforementioned epi structure is prepared, a patterned mask **705b,** which is preferably a hard mask made of such as an oxide, a nitride, a polysilicon layer, or a combination of these, is formed on the wafer surface in Fig. 33BD. The patterned mask must be thick enough to completely block any high energy impurities during the subsequent ion implant step. A p-type ion implantation step with a p-type impurity **706b** such as aluminum and/or boron is performed in Fig. 33BE to form a set of multiple P+ wells **707b** in Fig. 33BF. The bottoms of the set of multiple P+ wells **707b** are formed such that they are below the bottom of the N+ region **704b.** In the embodiments herein, the depth of the set of multiple P+ wells are greater than the depth of the N+ region. The set of multiple P+ wells lead to a P+ region as a whole in Fig. 33BF. The edge termination region which is not shown may be formed by the p-type ion implantation step. The patterned mask **705b** is removed by dry or wet etching process in Fig. 33BG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **708b** marked as METAL 1 directly on the wafer surface in Fig. 33BH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709b** marked as METAL 2 is then deposited on top of the wafer in Fig. 33BI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33BJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **710b** on the back side of the wafer is then formed in Fig. 33BK. The silicide region is required to form a good ohmic contact on the back side of the wafer. The silicide region is formed by depositing ohmic metal stack and annealing the wafer by using a laser annealing technique as an example. A second pad metal **711b** marked as METAL 3 is formed on the back side of the wafer in Fig. 33BL. The second pad metal can be of Aluminum or Aluminum-based alloy. After the second pad metal step is finished, a protective coating process step may be followed on top of the wafer to form a moisture barrier.

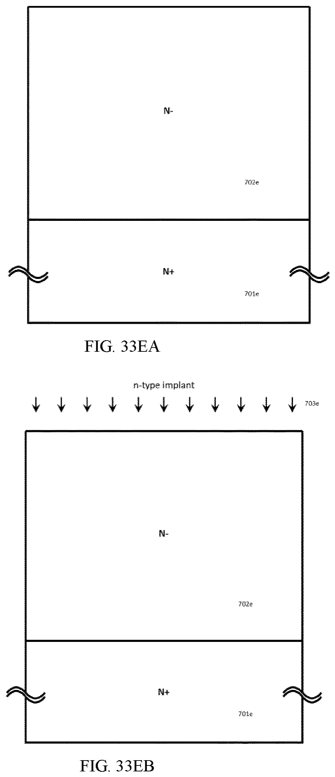

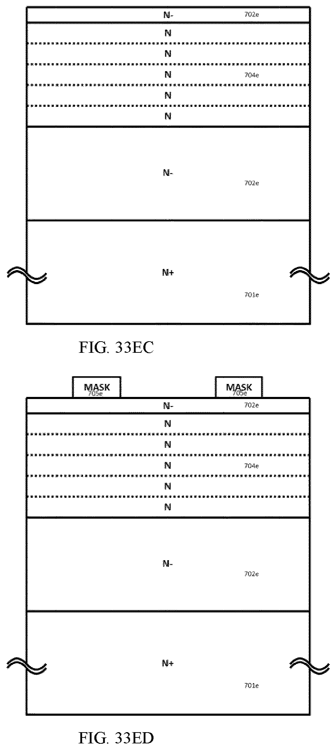

Fig. 33EA to Fig. 33EL describes the process of manufacturing the structure shown in Fig. 32E. The manufacturing process of the device includes preparing a SiC wafer in Fig. 33EA which consists of a highly conductive N+ substrate **701e** and an N- drift region **702e,** where the N- drift region is typically epi-grown. The N- drift region **702e** is designed in such a way that the doping concentration and thickness of the N- drift region are primarily selected based on the required blocking performance. When the SiC wafer is prepared, a set of multiple ion implantation steps with an n-type species **703e** such as nitrogen and/or phosphorus is performed onto the active region of the device in Fig. 33EB. The set of multiple ion implantation steps with the n-type species forms a set of sub n-type regions **704e** in Fig. 33EC where each sub region is defined by the dotted line in the schematic for indicating the top and bottom of the sub region and all sub regions are interconnected. The interconnected sub regions consist of the N+ region as a whole. The edge termination which is not shown needs to be masked during the set of n-type ion implantation steps. It is important to note that the n-type ion implantation steps **703e** needs to be performed in such a fashion that the N+ region **704e** is completely buried inside the N- drift region in Fig. 33EC. The ion implantation steps should form the N+ region **704e** where the top of the N+ region is physically off from the wafer surface.

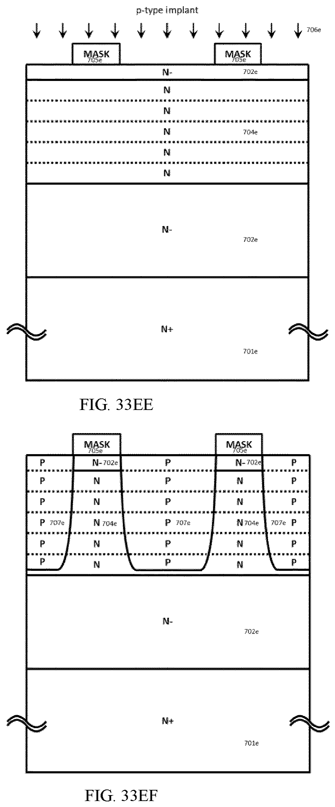

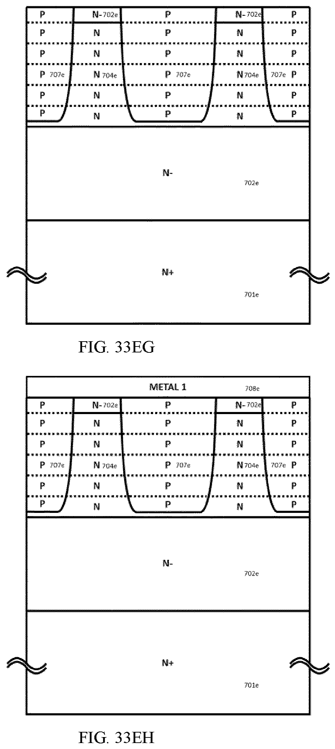

A patterned mask **705e,** which is preferably a hard mask made of such as an oxide, a nitride, a polysilicon layer, or a combination of these, is formed on the wafer surface in Fig. 33ED. The patterned mask must be thick enough to completely block any high energy impurities during the subsequent ion implant step. A set of multiple ion implantation steps with a p-type impurity **706e** such as aluminum and/or boron is performed in Fig. 33EE to form a set of multiple P+ wells **707e** in Fig. 33EF. The set of multiple ion implantation steps with the p-type species forms a set of sub p-type regions **707e** in Fig. 33EF where each sub region is defined by the dotted line in the schematic for indicating the top and bottom of the sub region and all sub regions are interconnected. The P+ region **707e** is formed by multiple P sub-regions. The bottoms of the set of multiple P+ wells **707e** are formed such that they are above the bottom of the N+ region **704e.** In the embodiments herein, the depth of the set of multiple P+ wells are less than the depth of the N+ region. The set of multiple P+ wells lead to a P+ region as a whole in Fig. 33EF. The edge termination region which is not shown may be formed by the p-type ion implantation step. The patterned mask **705e** is removed by dry or wet etching process in Fig. 33EG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

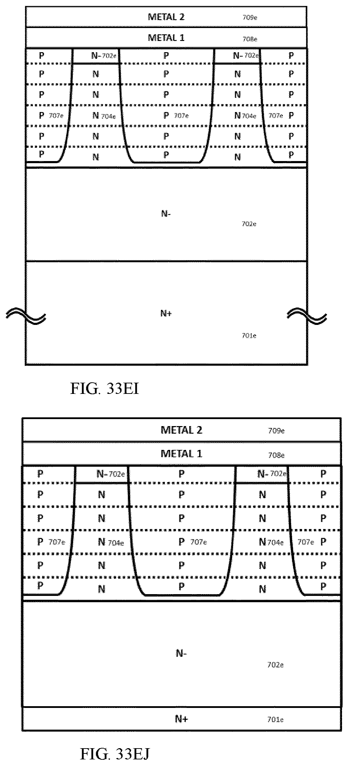

The Schottky contact is formed on the wafer surface by depositing a Schottky metal **708e** marked as METAL 1 directly on the wafer surface in Fig. 5FEH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709e** marked as METAL 2 is then deposited on top of the wafer in Fig. 33EI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33EJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

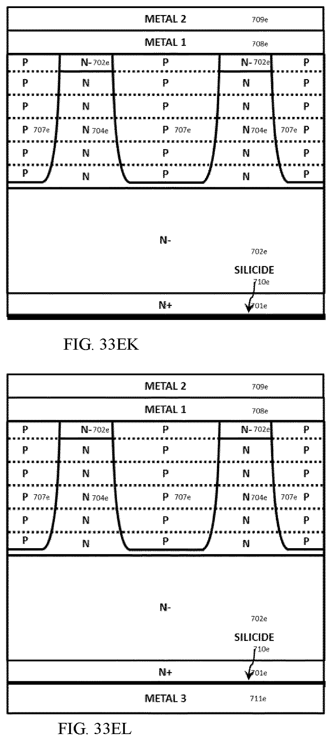

A silicide region **710e** on the back side of the wafer is then formed in Fig. 33EK. The silicide region is required to form a good ohmic contact on the back side of the wafer. The silicide region is formed by depositing ohmic metal stack and annealing the wafer by using a laser annealing technique as an example. A second pad metal **711e** marked as METAL 3 is formed on the back side of the wafer in Fig. 33EL. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of multiple n-type epi-grown layers in Fig. 33EC with different doping concentrations and thicknesses and the N+ substrate at the bottom of the SiC wafer. On top of the N+ substrate **701e**, an N- drift layer **702e** can be epi-grown for serving as a drift/blocking layer. On top of the N- drift layer, a number of n-type epilayers can be grown to form an N+ region **704e** as a whole which consists of a set of sub n-type regions where each sub region is defined by different doping concentration and thickness and all sub regions are interconnected. On top of the buried N+ region, an N- layer can be formed which reaches to the surface of the SIC wafer **702e.**

When the SiC wafer with the aforementioned epi structure is prepared, a patterned mask **705e,** which is preferably a hard mask made of such as an oxide, a nitride, a polysilicon layer, or a combination of these, is formed on the wafer surface in Fig. 33ED. The patterned mask must be thick enough to completely block any high energy impurities during the subsequent ion implant step. A set of multiple ion implantation steps with a p-type impurity **706e** such as aluminum and/or boron is performed in Fig. 33EE to form a set of multiple P+ wells **707e** in Fig. 33EF. The set of multiple ion implantation steps with the p-type species forms a set of sub p-type regions **707e** in Fig. 33EF where each sub region is defined by the dotted line in the schematic for indicating the top and bottom of the sub region and all sub regions are interconnected. The P+ region **707e** is formed by multiple P sub-regions. The bottoms of the set of multiple P+ wells **707e** are formed such that they are above the bottom of the N+ region **704e.** In the embodiments herein, the depth of the set of multiple P+ wells is less than the depth of the N+ region. The set of multiple P+ wells leads to a P+ region as a whole in Fig. 33EF. The edge termination region which is not shown may be formed by the p-type ion implantation step. The patterned mask **705e** is removed by dry or wet etching process in Fig. 33EG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **708e** marked as METAL 1 directly on the wafer surface in Fig. 33EH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709e** marked as METAL 2 is then deposited on top of the wafer in Fig. 33EI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33EJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **710e** on the back side of the wafer is then formed in Fig. 33EK. The silicide region is required to form a good ohmic contact on the back side of the wafer. The silicide region is formed by depositing ohmic metal stack and annealing the wafer by using a laser annealing technique as an example. A second pad metal **711e** marked as METAL 3 is formed on the back side of the wafer in Fig. 33EL. The second pad metal can be of Aluminum or Aluminum-based alloy. After the second pad metal step is finished, a protective coating process step may be followed on top of the wafer to form a moisture barrier.

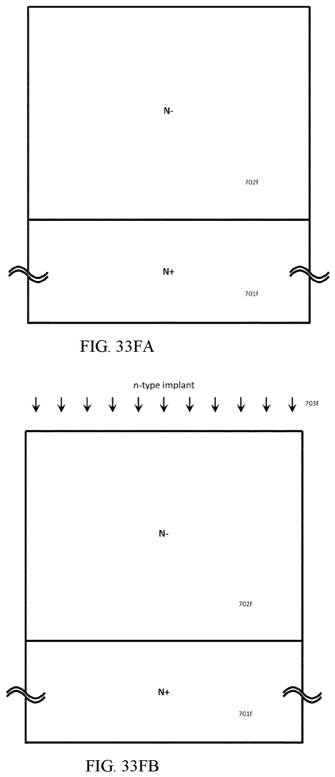

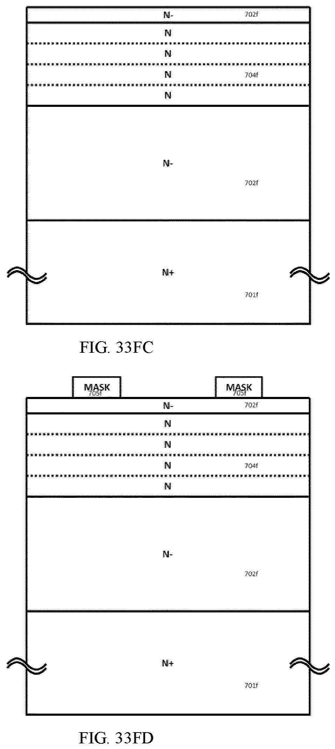

Fig. 33FA to Fig. 33FL describes the process of manufacturing the structure shown in Fig. 32F. The manufacturing process of the device includes preparing a SiC wafer in Fig. 33FA which consists of a highly conductive N+ substrate **701f** and an N- drift region **702f,** where the N- drift region is typically epi-grown. The N- drift region **702f** is designed in such a way that the doping concentration and thickness of the N- drift region are primarily selected based on the required blocking performance. When the SiC wafer is prepared, a set of multiple ion implantation steps with an n-type species **703f** such as nitrogen and/or phosphorus is performed onto the active region of the device in Fig. 33FB. The set of multiple ion implantation steps with the n-type species forms a set of sub n-type regions **704f** in Fig. 33FC where each sub region is defined by the dotted line in the schematic for indicating the top and bottom of the sub region and all sub regions are interconnected. The interconnected sub regions consist of the N+ region as a whole. The edge termination which is not shown needs to be masked during the set of n-type ion implantation steps. It is important to note that the n-type ion implantation steps **703f** needs to be performed in such a fashion that the N+ region **704f** is completely buried inside the N- drift region in Fig. 33FC. The ion implantation steps should form the N+ region 704f where the top of the N+ region is physically off from the wafer surface.

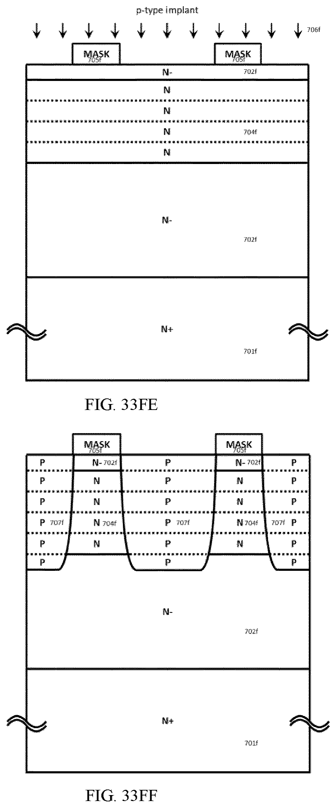

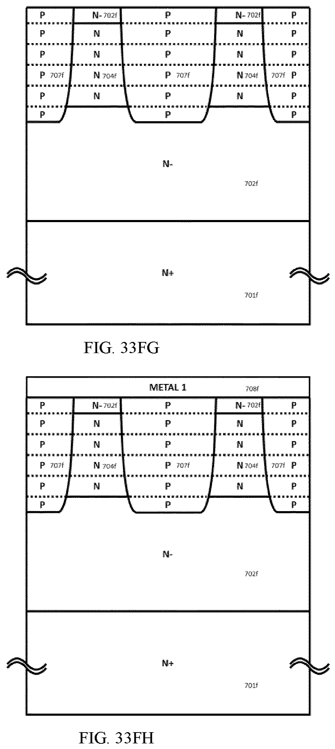

A patterned mask **705f,** which is preferably a hard mask made of such as an oxide, a nitride, a polysilicon layer, or a combination of these, is formed on the wafer surface in Fig. 33FD. The patterned mask must be thick enough to completely block any high energy impurities during the subsequent ion implant step. A set of multiple ion implantation steps with a p-type impurity **706f** such as aluminum and/or boron is performed in Fig. 33FE to form a set of multiple P+ wells **707f** in Fig. 33FF. The set of multiple ion implantation steps with the p-type species forms a set of sub p-type regions **707f** in Fig. 33FF where each sub region is defined by the dotted line in the schematic for indicating the top and bottom of the sub region and all sub regions are interconnected. The P+ region **707f** is formed by multiple P sub-regions. The bottoms of the set of multiple P+ wells **707f** are formed such that they are below the bottom of the N+ region **704f.** In the embodiments herein, the depth of the set of multiple P+ wells is greater than the depth of the N+ region. The set of multiple P+ wells leads to a P+ region as a whole in Fig. 33FF. The edge termination region which is not shown may be formed by the p-type ion implantation step. The patterned mask **705f** is removed by dry or wet etching process in Fig. 33FG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

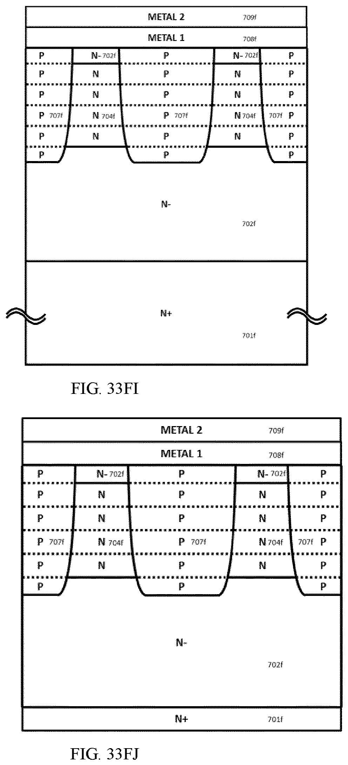

The Schottky contact is formed on the wafer surface by depositing a Schottky metal **708f** marked as METAL 1 directly on the wafer surface in Fig. 33FH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709f** marked as METAL 2 is then deposited on top of the wafer in Fig. 33FI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33FJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

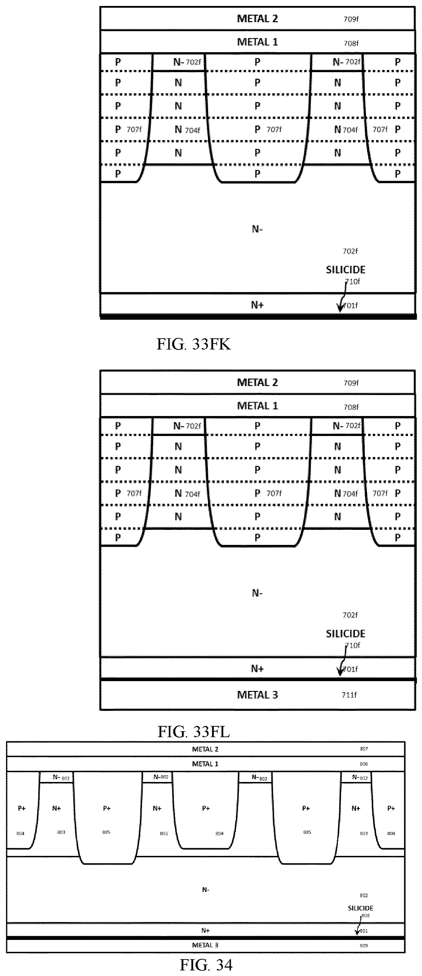

A silicide region **710f** on the back side of the wafer is then formed in Fig. 33FK. The silicide region is required to form a good ohmic contact on the back side of the wafer. The silicide region is formed by depositing ohmic metal stack and annealing the wafer by using a laser annealing technique as an example. A second pad metal **711f** marked as METAL 3 is formed on the back side of the wafer in Fig. 33FL. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of multiple n-type epi-grown layers in Fig. 33FC with different doping concentrations and thicknesses and the N+ substrate at the bottom of the SiC wafer. On top of the N+ substrate **701f,** an N-drift layer **702f** can be epi-grown for serving as a drift/blocking layer. On top of the N- drift layer, a number of n-type epilayers can be grown to form an N+ region **704f** as a whole which consists of a set of sub n-type regions where each sub region is defined by different doping concentration and thickness and all sub regions are interconnected. On top of the buried N+ region, an N- layer can be formed which reaches to the surface of the SiC wafer **702f.**

When the SiC wafer with the aforementioned epi structure is prepared, a patterned mask **705f,** which is preferably a hard mask made of such as an oxide, a nitride, a polysilicon layer, or a combination of these, is formed on the wafer surface in Fig. 33FD. The patterned mask must be thick enough to completely block any high energy impurities during the subsequent ion implant step. A set of multiple ion implantation steps with a p-type impurity **706f** such as aluminum and/or boron is performed in Fig. 33FE to form a set of multiple P+ wells **707f** in Fig. 33FF. The set of multiple ion implantation steps with the p-type species forms a set of sub p-type regions **707f** in Fig. 33FF where each sub region is defined by the dotted line in the schematic for indicating the top and bottom of the sub region and all sub regions are interconnected. The P+ region **707f** is formed by multiple P sub-regions. The bottoms of the set of multiple P+ wells **707f** are formed such that they are below the bottom of the N+ region **704f.** In the embodiments herein, the depth of the set of multiple P+ wells is greater than the depth of the N+ region. The set of multiple P+ wells leads to a P+ region as a whole in Fig. 33FF. The edge termination region which is not shown may be formed by the p-type ion implantation step. The patterned mask **705f** is removed by dry or wet etching process in Fig. 33FG. This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **708f** marked as METAL 1 directly on the wafer surface in Fig. 33FH. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **709f** marked as METAL 2 is then deposited on top of the wafer in Fig. 33FI and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 33FJ. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **710f** on the back side of the wafer is then formed in Fig. 33FK. The silicide region is required to form a good ohmic contact on the back side of the wafer. The silicide region is formed by depositing ohmic metal stack and annealing the wafer by using a laser annealing technique as an example. A second pad metal **711f** marked as METAL 3 is formed on the back side of the wafer in Fig. 33FL. The second pad metal can be of Aluminum or Aluminum-based alloy. After the second pad metal step is finished, a protective coating process step may be followed on top of the wafer to form a moisture barrier.

The advantage of the device structures shown in embodiments of Fig. 32A to Fig. 32F over those in Fig. 28A and Fig. 30 is that the doping concentration of the sub-regions can be appropriately fine-tuned to realize more optimum trade-off between the reverse leakage current and on-state voltage drop. In one implementation, the doping concentration in the n-type sub-regions farther away from the SiC surface can be made progressively higher, which may benefit from lower conduction losses. In another implementation, the doping concentration in the p-type sub-regions farther away from the SiC surface can be made progressively lower, which may enable better blocking characteristics.

In the device of shown in Fig. 34 is the cross-sectional schematic of the SiC MPS diode. The key regions of this device are an N+ substrate **801** at the bottom which gives mechanical support of the wafer and is ~350 $\mu$m-thick. An N- drift region **802** which is usually an epi layer and is on top of the N+ substrate. There are two different types of P+ wells depending on their depths which are in comparison to the depth of the N+ layer. The P+ wells **804** whose depths are less than the depth of the N+ layer **803** is called a first P+ wells while other P+ wells **805** whose depths are greater than the depth of the N+ layer **803** is called a second P+ wells. The N+ layer **803** is formed in such a way to completely surround the first P+ wells **804** and allow the second P+ wells **805** to completely penetrate the N+ layer which exposes the bottom of the second P+ wells **805** to the N- drift region **802.** The device has a first metal layer **806** denoted as METAL 1, which is the Schottky metal to an n-type SiC semiconductor region and forms Schottky contact to its underlying n-type regions. The device has a second metal layer **807** denoted as METAL 2 on the front side of the wafer which is in contact with the METAL 1. METAL 2 is often called "power metal" and is usually in Aluminum. There is a silicide layer **808** under the bottom of the N+ substrate. There is a third metal layer **809** denoted as METAL 3 under the back side of the wafer which is in contact with the silicide layer.

The device shown in Fig. 34 has a N+ region **803** which is interspersed between a set of two different types of P+ wells depending on their depths which are in comparison to the depth of the N+ layer. The P+ wells **804** whose depths are less than the depth of the N+ layer **803** is called a first P+ wells while other P+ wells **805** whose depths are greater than the depth of the N+ layer **803** is called a second P+ wells. The N+ layer **803** is formed in such a way to completely surround the first P+ wells **804** and allow the second P+ wells **805** to completely penetrate the N+ layer which exposes the bottom of the second P+ wells **805** to the N- drift region **802**. The physical separation of the N+ region from a SiC wafer surface is a critical feature of the embodiment described herein and distinguishes it from other similar inventions. A part of the SiC wafer which is in contact with a Schottky metal **806** denoted as METAL 1 and is an n-type semiconductor has the same doping concentration of the N- drift **802**. In the embodiment described herein, the doping concentration of the n-type SiC semiconductor which is in direct contact with the Schottky metal **806** labeled METAL 1 is critical for reducing the strength of the electric field at the wafer surface, during the high-voltage blocking mode of operation of the SiC MPS diode.

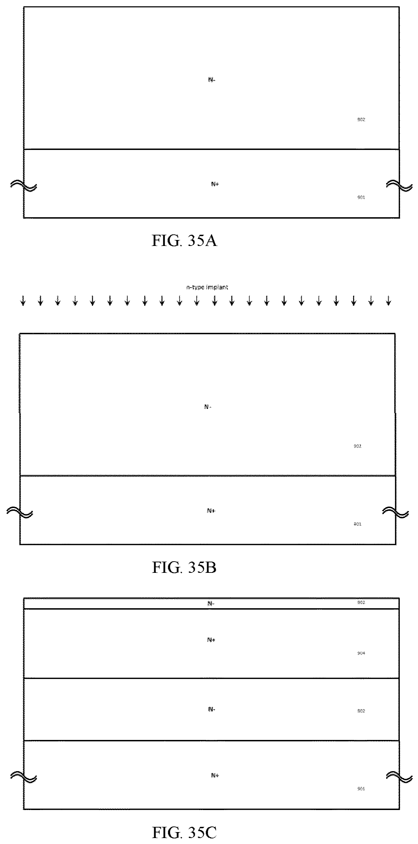

Fig. 35A to Fig. 35P describes the process of manufacturing the structure shown in Fig. 34. The manufacturing process of the device includes preparing a SiC wafer in Fig. 35A which consists of a highly conductive N+ substrate **901** and an N- drift region **902**, where the N- drift region is typically epi-grown. The N- drift region **902** is designed in such a way that the doping concentration and thickness of the N- drift region are primarily selected based on the required blocking performance. When the SiC wafer is prepared, an ion implantation step with an n-type species **903** such as nitrogen and/or phosphorus is performed onto the active region of the device in Fig. 35B forming an N+ region within the N- drift region. The edge termination which is not shown needs to be masked during the n-type ion implantation step. It is important to note that the n-type ion implantation step **903** needs to be performed in such a fashion that the N+ region **904** is completely buried inside the N- drift region in Fig. 35C. The ion implantation step should form the N+ region **904** where the top of the N+ region is physically off from the wafer surface.

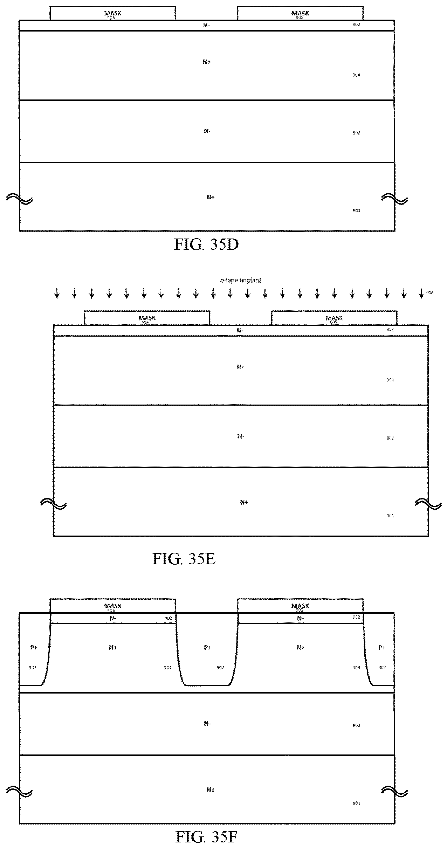

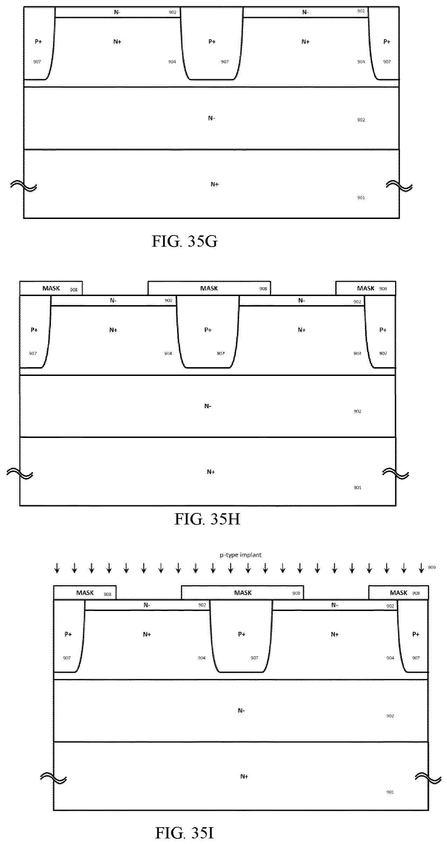

A first patterned mask **905**, which is preferably a hard mask made of such as an oxide, a nitride, a polysilicon layer, or a combination of these, is formed on the wafer surface in Fig. 35D. The first patterned mask must be thick enough to completely block any high energy impurities during the subsequent ion implant step. A first p-type ion implantation step with a p-type impurity **906** such as aluminum and/or boron is performed in Fig. 35E to form a first set of multiple P+ wells **907** in Fig. 35F. The depths of the first set of multiple P+ wells **907** are formed such that they are completely surrounded by the N+ region **904.** In the embodiments herein, the depth of the first set of multiple P+ wells is less than the depth of the N+ region. The first patterned mask **909** is removed by dry or wet etching process in Fig. 35G.

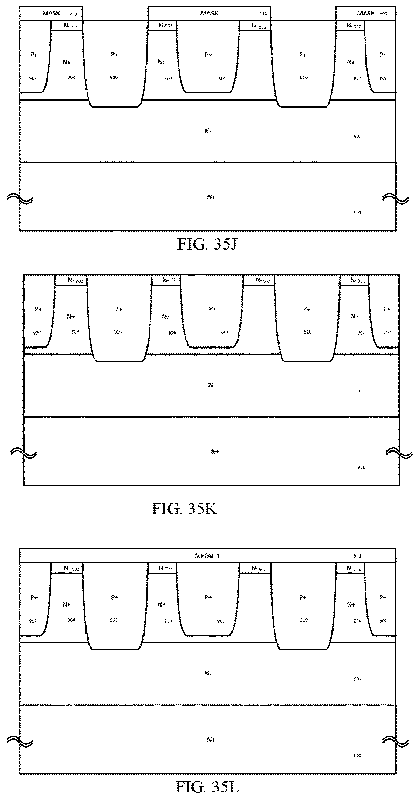

After the first patterned mask is removed, a second patterned mask **908,** which preferably is a hard mask made of such as an oxide, a nitride, a polysilicon layer, or a combination of these, is formed on the wafer surface in Fig. 35H. The second patterned **908** mask must be thick enough to completely block any high energy impurities during the subsequent ion implant step. A second p-type ion implantation step **909** with a p-type impurity such as aluminum and/or boron is performed in Fig. 35I in such a way to form a second multiple P+ wells where the bottom of the second set of multiple P+ wells **910** is below the bottom of the N+ region **904** in Fig. 35J. The first set of multiple P+ wells and the second set of multiple P+ wells lead to a P+ region as a whole. The edge termination region which is not shown may be formed by the first p-type ion implantation step and/or the second p-type ion implantation step. The second patterned mask **908** is removed by dry or wet etching process in Fig. 35K.

This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

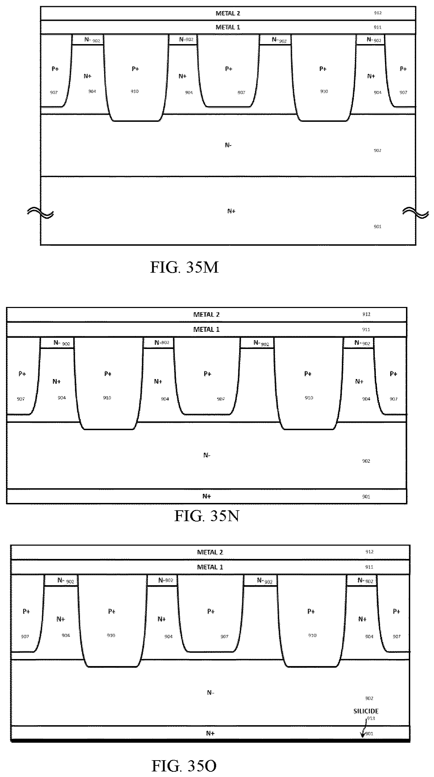

The Schottky contact is formed on the wafer surface by depositing a Schottky metal **911** marked as METAL 1 directly on the wafer surface in Fig. 35L. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **912** marked as METAL 2 is then deposited on top of the wafer in Fig. 35M and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 35N. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

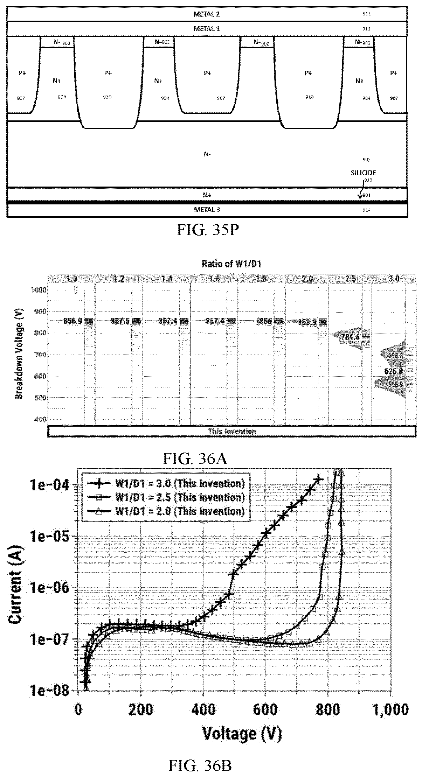

A silicide region **913** on the back side of the wafer is then formed in Fig. 35O. The silicide region is required to form a good ohmic contact on the back side of the wafer. The silicide region is formed by depositing ohmic metal stack and annealing the wafer by using a laser annealing technique as an example. A second pad metal **914** marked as METAL 3 is formed on the back side of the wafer in Fig. 35P. The second pad metal can be of Aluminum or Aluminum-based alloy. After the second pad metal step is finished, a protective coating process step may be followed on top of the wafer to form a moisture barrier.

Another method to fabricate this embodiment is to use a SiC wafer with multiple n-type epi-grown layers to start with. In this case, the SiC wafer consists of three n-type epi-grown layers in Fig. 35C with different doping concentrations and thicknesses and the N+ substrate at the bottom of the SiC wafer. The three n-type epi-grown layers should be formed in such a way that an N- layer **902** is meeting a device side of the wafer and an N+ layer **904** is positioned right underneath the N- layer, where the N+ layer is on top of a second N- layer also labeled **902** which serves as a drift region and the second N- layer is positioned on top of the N+ substrate **901.**

When the SiC wafer with the aforementioned epi structure is prepared, a first patterned mask **905,** which is preferably a hard mask made of such as an oxide, a nitride, a polysilicon layer, or a combination of these, is formed on the wafer surface in Fig. 35D. The first patterned mask must be thick enough to completely block any high energy impurities during the subsequent ion implant step. A first p-type ion implantation step with a p-type impurity **906** such as aluminum and/or boron is performed in Fig. 35E to form a first set of multiple P+ wells **907** in Fig. 35F. The depths of the first set of multiple P+ wells **907** are formed such that they are completely surrounded by the N+ region **904.** In the embodiments herein, the depth of the first set of multiple P+ wells is less than the depth of the N+ region. The first patterned mask **909** is removed by dry or wet etching process in Fig. 35G.

After the first patterned mask is removed, a second patterned mask **908,** which preferably is a hard mask made of such as an oxide, a nitride, a polysilicon layer, or a combination of these, is formed on the wafer surface in Fig. 35H. The second patterned **908** mask must be thick enough to completely block any high energy impurities during the subsequent ion implant step. A second p-type ion implantation step **909** with a p-type impurity such as aluminum and/or boron is performed in Fig. 35I in such a way to form a second multiple P+ wells where the bottom of the second set of multiple P+ wells **910** is below the bottom of the N+ region **904** in Fig. 35J. The first set of multiple P+ wells and the second set of multiple P+ wells lead to a P+ region as a whole. The edge termination region which is not shown may be formed by the first p-type ion implantation step and/or the second p-type ion implantation step. The second patterned mask **908** is removed by dry or wet etching process in Fig. 35K.

This is followed by a process step to electrically activate all the implanted impurity species by coating the wafer with a suitable coating material such as a carbon cap and annealing at high temperature such as 1700°C. The active region is then defined by forming a field oxide layer on the entire wafer surface and clearing out a part of the field oxide where the conduction current needs to flow for on-state operation of the device.

The Schottky contact is formed on the wafer surface by depositing a Schottky metal **911** marked as METAL 1 directly on the wafer surface in Fig. 35L. The deposited Schottky metal layer is then patterned by using dry etching, wet etching, or lift-off process and annealed at a certain temperature for a certain amount of time by using a furnace or RTA. The thermal budget of the annealing step after the Schottky metal deposition needs to be carefully designed and controlled because it directly affects the barrier height of the Schottky contact. A first pad metal **912** marked as METAL 2 is then deposited on top of the wafer in Fig. 35M and patterned by dry etching, wet etching, or lift-off. The first pad metal can be of Aluminum/Aluminum-based alloy. The wafer is then thinned from its back side until its thickness reaches to a target thickness of 100 ~ 200 $\mu$m in Fig. 35N. The thickness may be further reduced in the future when the wafer thinning technology improves and provides the target thickness less than the aforementioned 100 ~ 200 $\mu$m. The wafer thinning can be accomplished by CMP, wet etching, dry etching, or a combination of the aforementioned grinding techniques with a proper protective coating at the front side of the wafer.

A silicide region **913** on the back side of the wafer is then formed in Fig. 35O. The silicide region is required to form a good ohmic contact on the back side of the wafer. The silicide region is formed by depositing ohmic metal stack and annealing the wafer by using a laser annealing technique as an example. A second pad metal **914** marked as METAL 3 is formed on the back side of the wafer in Fig. 35P. The second pad metal can be of Aluminum or Aluminum-based alloy. After the second pad metal step is finished, a protective coating process step may be followed on top of the wafer to form a moisture barrier.

The device of embodiment shown in Fig. 34 combines the desirable features of the devices shown in embodiments described in Fig. 28A and Fig. 30. In the embodiment described in Fig. 34 the first P+ wells that are formed deeper than the N+ layer may serve to inject minority carriers into the N+ drift layer under surge current conditions and the second P+ wells that are completely enclosed by the N+ layer reduce the spreading resistance of the diode current as it spreads vertically from the region in-between the p-type wells to the N- drift layer. The device of embodiment is constructed with both first and second type P+ wells to exploit both aforementioned benefits of the first and second P+ wells, respectively. The proportion of the first and second type P+ wells may be appropriately adjusted to yield a diode that is either tuned for lower conduction losses or one that is designed for withstanding higher surge currents.

Fig. 36A shows blocking performances of the devices of this invention with varying ratio of W1/D1 that ranges from 1.0 to 3.0 and blocking performance of the device of the prior art with a fixed ratio of W1/D1 which is equal to 3.0. Fig. 36A shows the statistical distribution of the measured blocking voltages of the devices described the various embodiments herein. With a targeted breakdown voltage for these devices at 650 V, the median value of each distribution is highlighted. A leakage current of 10 $\mu$A is used as a criteria to measure the blocking voltages and the blocking voltages are greater than the target of 650 V. The measured blocking voltages of the devices of this invention whose ratio of W1/D1 is varied from 1.0 to 2.5 are greater than 650 V. The case when the ratio of W1/D1 equals to 3.0, however, shows its blocking voltage distribution spreads out from 500 V to 730 V where a large portion of the distribution is below the targeted 650 V.

Fig. 36B shows the blocking I-V curves of the devices of this invention with varying ratio of W1/D1 (i.e., 2.0, 2.5 and 3.0). Fig. 36B shows that all the devices with the exception of the device of this invention where the radio of W1/D1 equals to 3.0 block at 650 V with their leakage current kept less than 10 μA which is used as the blocking criterion as mentioned earlier. At 650 V, the device of this invention with the ratio of W1/D1 that equals to 3.0 shows high leakage current of 22 μA which is above 10 μA. Due to the high leakage current density of the device of this invention with the ratio of W1/D1 of 3.0 at the targeted rated voltage of 650 V, the device of this invention with the ratio of W1/D1 of 3.0 is not adequate for the use. Based on the discussion on the blocking performance, it is clear that the ratio of W1/D1 of the devices of this invention should be less than 3.0 to meet the targeted blocking voltage of 650 V.

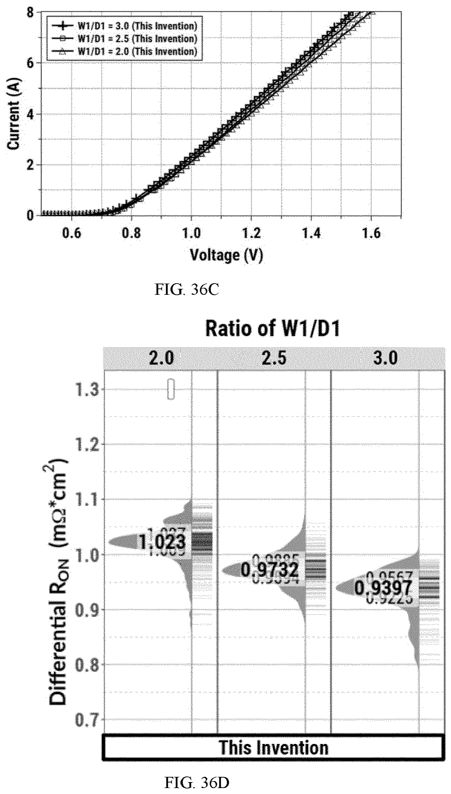

Fig. 36C is the forward I-V curves of the devices of this invention with varying ratio of W1/D1 that ranges from 2.0 to 3.0. Fig. 36C shows that increasing the ratio of W1/D1 from 2.0 to 3.0 decreases the forward conduction loss. The device of this invention of the ratio of W1/D1 of 3.0 shows the best forward conduction performance, however due to the aforementioned poor blocking performance of the device, the device is not suitable for the use of 650 V applications.

Fig. 36D shows the performance of differential specific on-resistances of the devices of this invention with varying ratio of W1/D1 that ranges from 2.0 to 3.0. Fig. 36D shows the statistical distribution of the measured differential specific on-resistances of the devices of this invention. The median value of each distribution is highlighted in bold. Clearly, the differential specific on-resistance drops as the ratio of W1/D1 increases. This trend agrees with the observation made on the forward I-V curves in Fig. 36C. Even though the device of this invention of the ratio of W1/D1 of 3.0 shows the best forward conduction performance, the device should not be considered to be appropriate due to its poor blocking performance as mentioned earlier.

The devices of this invention show improvement in both the forward and blocking performance is only valid when the ratio of W1/D1 is less than 3.0.

Other embodiments are also within the scope of the following claims.

**Power DMOSFETs**

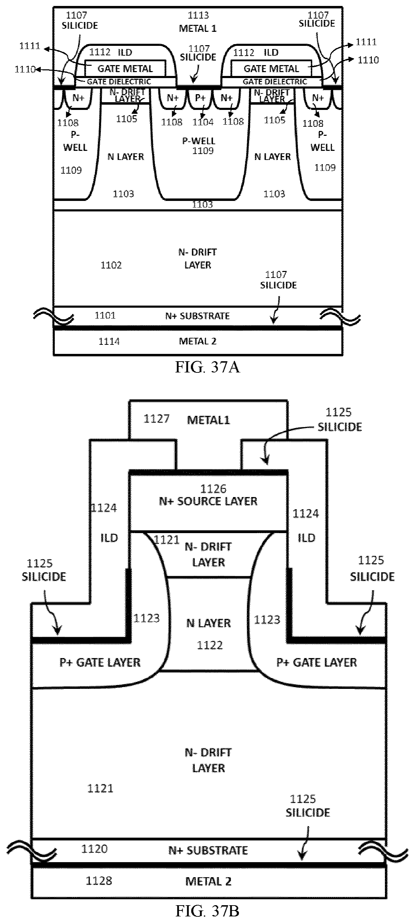

A cross-sectional schematic of a power MOSFET structure comprising N layer is shown in FIG. 37A according to an embodiment. Fig. 37A shows a cross-sectional device structure of a double-implanted MOSFET or DMOSFET. The DMOSFET structure comprises a N+ substrate **1101,** N-Drift (or Voltage Blocking) Region **1102,** p-well Region **1109,** N+ source **1108** and P+ Body (or p-well contact) regions **1104.** A silicide layer **1107** is formed on the N+ and P+ regions to form the source ohmic contact. The gate dielectric **1110** and gate metal layers **1111** are successively formed on the SiC surface **1107,** which together constitute the metal-oxide-semiconductor (MOS) structure. An inter-level dielectric or ILD layer **1112** separates the Gate metal 1 **111** from the metal 1 layer **1113** which contacts the interspersed Source ohmic contact regions.

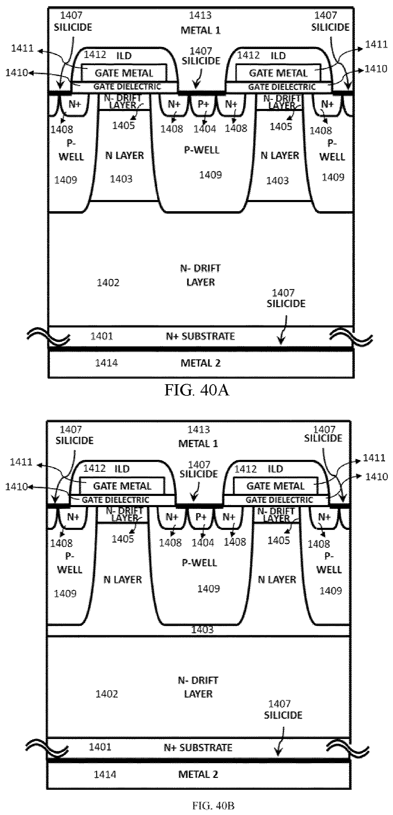

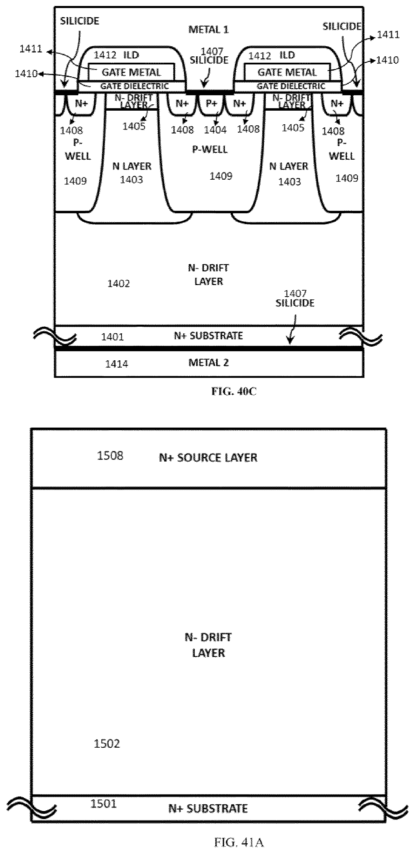

An additional n-type layer **1103** is formed that is not in contact with the gate dielectric layer **1110.** In other words, the additional n-type layer **1103** is formed such that in vertical direction, it is completely enclosed by the N-drift layer **1105.** The doping concentration of the n-type layer **1103** should be higher than that of the N-drift layer **1105.** The doping concentration of the n-type layer **1103** could be in the range of 1E15 cm-3 to 1E19 cm-3. Except for the gate dielectric layer **1110** in DMOSFET, the design of this n-type layer follows identical considerations. In this embodiment, the vertical extent of this n-type layer **1103** is greater than the p-well region **1109,** but the n-type layer **1103** could also be designed such that its vertical extent is smaller than the vertical extent of the p-well region. Figs. 40A to 40C show the vertical extent of n-type layer **1103** with respect to the vertical extent of the p-well region **1109.** In an embodiment, according to Fig. 40A, the n-type layer **1103** vertical extent is smaller than the vertical extent of the p-well region **1109.** In another embodiment, according to Fig. 40B, the vertical extent of n-type layer **1103** is greater than the vertical extent of the p-well region **1109.** In another embodiment, according to Fig. 40C, the n-type layer **1103** vertical extent is greater than the vertical extent of the p-well region **1109** but lateral extent is smaller and is non-continuous or interrupted i.e., having gaps.

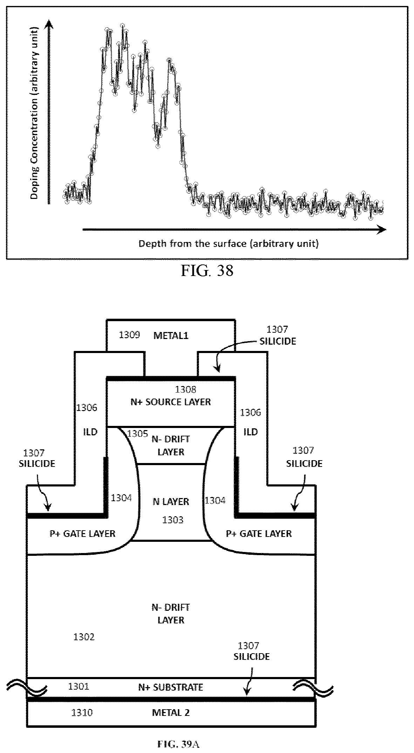

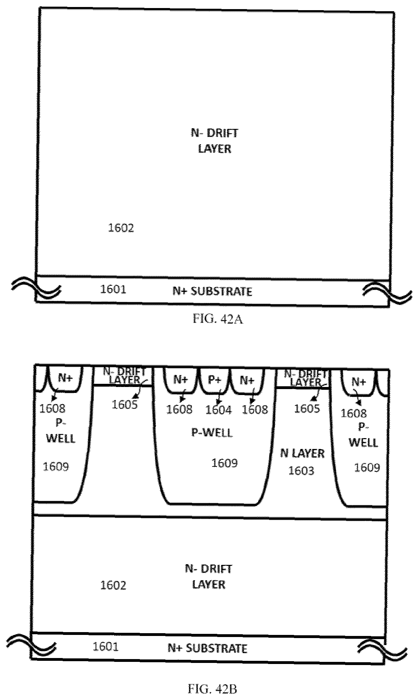

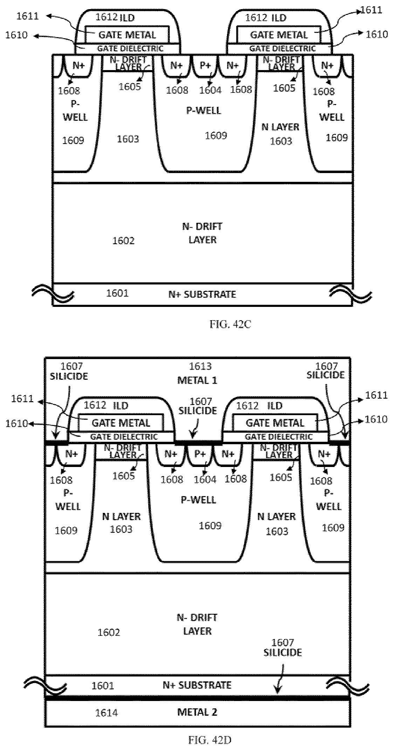

**Method of fabrication of Power DMOSFETs:** Figs. 42A to 42D depicts the process steps for fabrication of Power DMOSFET. As depicted in Fig. 42A, the starting silicon carbide wafer comprises a N-drift layer **1602** formed on top of a N+ substrate **1601.** As depicted in Fig. 42B, the N-Layer **1603** can be formed either by ion-implantation or by epitaxial growth. If the N-layer **1603** is formed using epitaxial growth, this needs to be followed by the growth of an additional n-type layer **1603** with the same doping concentration as the N-drift layer **1602.** In case of ion-implantation, the n-type layer **1603** may be formed using either Nitrogen or Phosphorus as the n-type implanted species. The implant energy may be in the range of 50 keV to 4 MeV and the implanted dose may be in the range of 1E10 cm-2 to 1E14 cm-2. An example of the n-type **1603** formed using ion-implantation is shown in Fig. 38. Notice that the n-type layer **1603** is completely buried within the N-drift layer **1602.** Following this, appropriate ion-implantation steps may be utilized to realize the p-well **1609,** N+ source **1608** and P+ regions **1604.** Fig. 42C and 42D shows the remainder of the steps for the DMOSFET fabrication which include post-implantation annealing, gate dielectric **1610** and gate metal **1611** formation, silicide **1607** formation for ohmic contacts, ILD layer **1612** and final pad metal layer deposition **1613.**

The incorporation of the additional n-type layer into the DMOSFET structures enables a better trade-off between reducing the on-state resistance of the device and maintaining a low electric field in the gate dielectric layer. The DMOSFET device structure can result in high electric field concentration at the corner of the P-well region, which results in a high electric field in the gate oxide layer, especially during high drain bias (blocking mode) operation. The high critical electric fields for breakdown in 4H-SiC ($\approx$ 3 MV/cm) results in a very high (> 5 MV/cm) electric field in the gate oxide. Fowler-Nordheim tunneling currents are observed at such high electric fields in the gate oxide, which can result in trapped charge in the gate oxide, which leads to poor device reliability. Similar n-type layers (called current spreading layers) are typically utilized in other DMOSFET structures reported in the literature, but the distinguishing feature of this invention is that the N-layer is completely buried within the N-drift layer. This device structure enables a higher reduction of the electric field in the gate dielectric layer without compromising the on-state resistance. As it will be apparent to those in the field of the invention, the proposed approach to realize additional n-type doping between the P-well regions (also called the JFET region) may be used in combination with other design features such as JFET width reduction for electric field reduction. The maximum electric fields in the gate dielectric layer may be reduced below 3 MV/cm and for some implementations even below 2.5 MV/cm using the teachings of this invention, which presages significantly higher device reliability.

## Vertical JFETs

A cross-sectional schematic of a vertical JFET structure is shown in Fig. 37B according to an embodiment. Fig. 37B shows a cross-sectional schematic of a vertical JFET. The JFET comprises a N+ substrate **1120,** N- Drift (or Voltage Blocking) Region **1121,** P+ gate Region **1123,** N+ source **1126,** ohmic contact and pad metallization layers. An inter-level dielectric or ILD layer **1124** separates the Gate Metal from the metal 1 layer **1127** which contacts the interspersed Source ohmic contact regions.

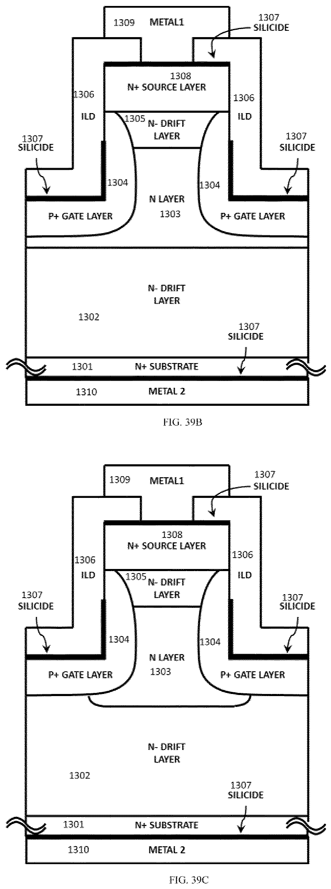

In this application, an additional n-type layer **1122** is formed that is not in contact with the N+ source layer **1126.** In other words, the additional n-type layer **1122** is formed such that in a vertical direction, it is completely enclosed by the N-drift layer **1121.** The doping concentration of the n-type layer **1122** should be higher than that of the N-drift layer **1121.** The doping concentration of the n-type layer could be in the range of 1E15 cm-3 to 1E19 cm-3. Except for the N+ source layer **1126** in vertical JFET, the design of this n-type layer follows identical considerations. In this embodiment, the vertical extent of this n-type layer **1112** is smaller the P+ gate region **1123,** but the n-type layer **1112** could also be designed such that its vertical extent is larger than the vertical extent of the P+ gate region **1123.** Figs. 39A to 39C show the vertical extent of n-type layer with respect to the vertical extent of the P+ gate region. In an embodiment according to Fig. 39A the n-type layer **1303** vertical extent is smaller than the vertical extent of the P+ gate region **1304.** In another embodiment, according to Fig. 39B, the n-type layer **1303** vertical extent is greater than the vertical extent of the P+ gate region **1304.** In another embodiment, according to Fig. 39C, the n-type layer **1303** vertical extent is greater than the vertical extent of the P+ gate region **1304** but lateral extent is smaller and is non-continuous or interrupted i.e., having gaps.

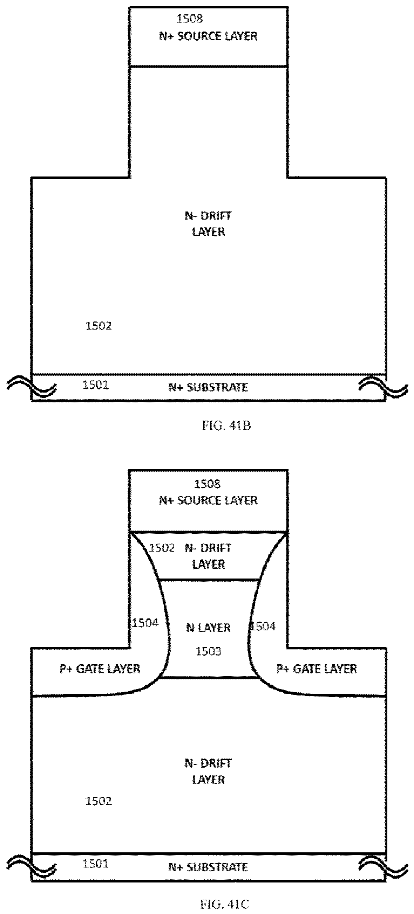

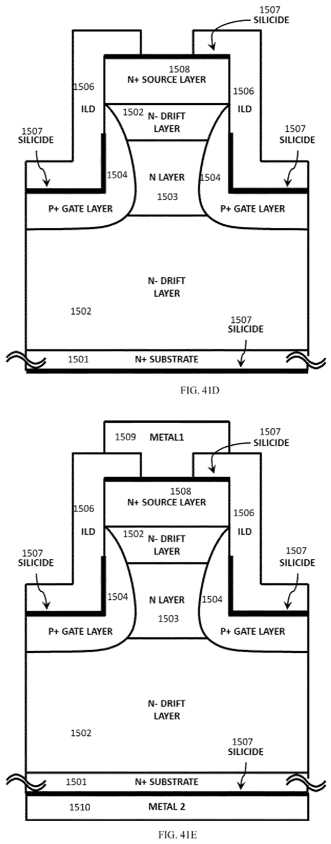

**Method of fabrication of Vertical JFETs:** Figs. 41A to 41E depicts the process steps for fabrication of Vertical JFET. As depicted in Figs. 41A and 41B, the starting silicon carbide wafer comprises a N-drift layer **1502** formed on top of a N+ substrate **1501.** As depicted in Figs. 41C to 41E, the n-type Layer **1503** can be formed either by ion-implantation or by epitaxial growth. If the n-type layer **1503** is formed using epitaxial growth, this needs to be followed by the growth of an additional n-type layer with the same doping concentration as the N-drift layer **1502.** In case of ion-implantation, the n-type layer **1503** may be formed using either Nitrogen or Phosphorus as the n-type implanted species. The implant energy for the n-type layer **1503** may be in the range of 50 keV to 4 MeV and the implanted dose may be in the range of 1E10 cm-2 to 1E14 cm-2. Appropriate ion-implantation steps may be utilized to realize the P+ gate **1504,** N+ source regions **1508.** The N+ source region **1508** may also be formed using epitaxial growth, as part of the starting wafer. The remainder of the steps for the JFET fabrication include post-implantation annealing, silicide formation **1507** for gate and source ohmic contacts, ILD layer **1506** formation and final pad metal layer **1509** deposition.

The incorporation of the additional n-type layer into the JFET structure enables a better trade-off between reducing the on-resistance of the device and maintaining a high enough gate threshold voltage close to zero volts, in case of a normally-ON JFET device. The n-type layer is strategically placed in the so-called channel region of the JFET, and we will refer to this doping concentration as Nch or the channel doping concentration.

For the design of normally-on and normally-off type JFET, a simplified one-sided N-channel p-n JFET is considered. The channel width between the P+ gates is $W_{ch}$, and the induced depletion region width for the one-sided p+n junction is d when the drain-to-source voltage is zero. Based on these assumptions, the depletion width is given by Equation (1).

$$d = \frac{2\varepsilon_{sic}\varepsilon_o(V_{bi}-V_{GS})}{eN_{ch}} \qquad\qquad \text{Equation (1)}$$

where VGS is the gate-to-source voltage (a negative voltage for a reverse-biased PN junction), Vbi is the built-in potential barrier, and Nch is the channel doping concentration. So called pinch-off condition is reached when the channel is fully depleted (d=$W_{ch}$) and we can write Equation (2).

$$W_{ch} = \left(\frac{2\varepsilon_{sic}\varepsilon_o V_{po}}{eN_{ch}}\right)^{\frac{1}{2}}$$ 

Equation (2)

where Vpo is the internal pinch-off voltage. This voltage is not the gate-to-source voltage to obtain the pinch-off condition. From the above equations, the pinch-off voltage (threshold voltage) is defined by Equation (3) and Equation (4).

$$V_{bi} - V_{p(th)} = V_{po} \rightarrow V_{p(th)} = V_{bi} - V_{po}$$ 

Equation (3)

$$V_{th} = V_{bi} - \frac{eN_{ch}W_{ch}^2}{2\varepsilon_{sic}\varepsilon_o}$$ 

Equation (4)

For 4H-SiC material, the built-in potential is approximately 2.5 V at room temperature. The highest threshold voltage in the forward direction is given by the built-in potential of the gate-to-source junction in the absence of bipolar injection. The lowest threshold voltage in the reverse direction is given by $V_{po} >= V_{bi}$. Equation (4) is the basis for designing the channel of the JFET. For a channel width, $W_{ch}$, and threshold voltage, Vth, the channel doping ($N_{ch}$) has to be chosen according to Equation (4). The above analysis assumes a uniform JFET channel. In case of a non-uniform JFET channel that is typically realized in practice as shown in Fig. 37B, the n-type channel doping can be designed in a non-uniform manner. The highest doping in this layer can be advantageously realized, where the JFET channel is at its narrowest, with a lower doping in other regions of the JFET channel. Ion-implantation enables the realization of such arbitrary doping profiles.

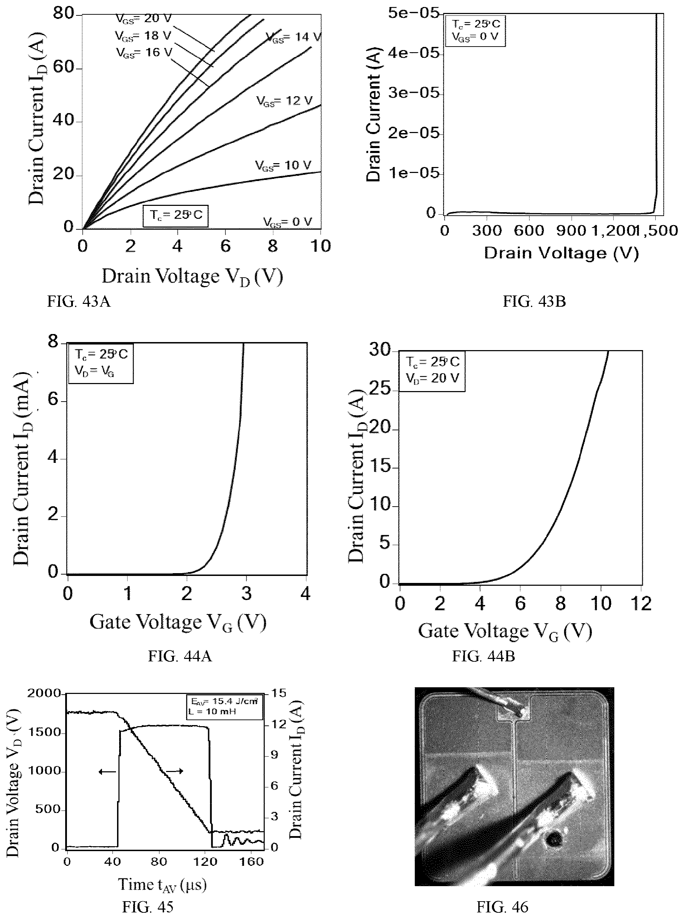

Fig. 43A and Fig. 43B show the output and breakdown I-V characteristics of 1200 V SiC DMOSFETs fabricated using the teachings of this invention. A specific on-resistance of 2.9 mΩ-cm2, gate threshold voltage of 3.0 V and breakdown voltages in the 1400 V - 1500 V range are achieved.

Fig. 44A and Fig. 44B show the transfer (ID v/s VGS) characteristics of 1200 V SiC MOSFETs fabricated using the teachings of this invention are shown. The devices feature a gate threshold voltage of 2.9 V, a sub-threshold slope of 150 mV/decade and a transconductance of 9.2 S measured at a drain current of 20 A.

Fig. 45 shows a single-pulse avalanche energy of 1.05 J is measured for a 1200 V SiC MOSFET fabricated using the teachings of this invention. This corresponds to an energy density of 15.4 J/cm2, when normalized to the total chip size (Avalanche Energy/Chip Size).

Fig. 46 is a photograph showing a SiC DMOSFET fabricated using the teachings of these inventions and tested for single-pulse avalanche energy test.

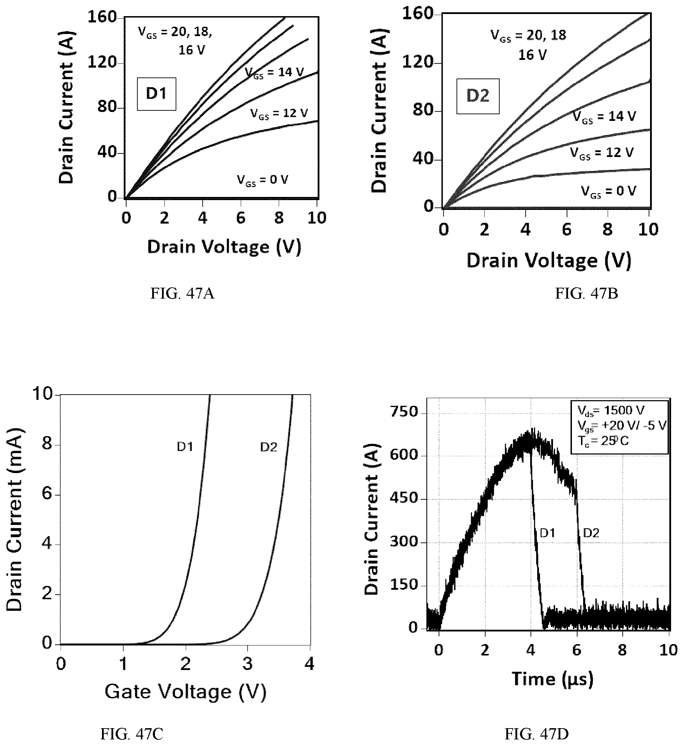

Fig. 47A and Fig. 47B are output characteristics of two 3.3 kV SiC MOSFETs fabricated using the teachings of this invention are shown. The Fig. 15a device features a gate threshold voltage of 2.5 V, while the Fig. 15b device features a gate threshold voltage of 3.8 V. The higher gate threshold voltage is achieved by employing the novel non-uniformly doped channel concept introduced in this invention. A 156% increase of gate threshold voltage is achieved for only a 11% increase of on-resistance (Vgs = 20 V), by using the device design concepts introduced in this invention.

Fig. 47C is the transfer characteristics of two 3.3 kV SiC MOSFETs fabricated using the teachings of these inventions.

Fig. 47D is a short-circuit test measured for two 3.3 kV SiC MOSFETs fabricated using the teachings of this invention.

Embodiments relate to silicon carbide (SiC) DMOSFET power devices having increased third quadrant cross over current.

An embodiment relates to tuning the turn-on voltage of one or more body diode regions of the DMOSFET.

An embodiment relates to reducing injection of minority carriers during conduction of the one or more body diode regions.

An embodiment relates to tuning source contact resistance of the one or more body diode regions of the DMOSFET.

An embodiment relates to mitigate basal plane dislocation (BPD).

An embodiment relates to formation of a first conductivity type second source region between a silicide layer and a second conductivity type well region of the DMOSFET.

An embodiment relates to formation of a first metal region in direct contact with a second conductivity type well contact region.

An embodiment relates to connecting one or more Schottky diode regions in series with the one or more body diode regions of the DMOSFET.

An embodiment relates to formation of the second conductivity type well contact region that meanders and comprises a periodic spacing between the first conductivity type source region and the second conductivity type well contact region.

An embodiment relates to formation of the second conductivity type well contact region that meanders and enables the second conductivity type well region to be contact in with a source metal only through the second conductivity type well contact region.

An embodiment relates to a power DMOSFET device structure designed to handle significant power level includes an intrinsic anti-parallel p-n junction diode, formed between the body and well regions, respectively. The anti-parallel p-n junction diode within the power DMOSFET structure conducts during third quadrant operation of the power DMOSFET. The third quadrant operation occurs when source terminal is biased positively with respect to drain terminal, a situation that is commonly encountered when power MOSFETs are utilized in motor control related power conversion applications. To circumvent performance and reliability issues related to slower switching speed of the p-n diode and conversion of the basal plane dislocations into stacking faults, respectively, a Schottky diode is either externally or internally connected in an anti-parallel with the intrinsic p-n body diode of the DMOSFET. In this scenario, there exists a specific cross-over current, above which the current still flows mainly through the p-n diode, despite the connection of the Schottky diode.

An embodiment relates to a Silicon Carbide (SiC) double-implantation metal oxide semiconductor field effect transistor (DMOSFET) with increased cross over current. The magnitude of the cross over current of the DMOSFET is increased by at least one of increasing built-in potential (e.g., turn-on voltage) of the one or more body diode regions of the DMOSFET and reducing injection of minority carriers during conduction of the one or more body diode regions. In an embodiment, the SiC DMOSFET is a n-type planar gate DMOSFET. In another embodiment, the SiC DMOSFET is a p-type planar gate DMOSFET. In yet another embodiment, the SiC DMOSFET is a n-type trench gate DMOSFET. In yet another embodiment, the SiC DMOSFET is a p-type trench gate DMOSFET. The magnitude of the cross over current is increased by performing below embodiments. The below embodiments are described specifically with respect to the n-type planar gate DMOSFET.

In one embodiment, each unit cell of the DMOSFET comprises a second N+ source region between a silicide layer and a p-well region to impact the turn-on voltage of the one or more body diode regions of the DMOSFET.

In another embodiment, each unit cell of the DMOSFET comprises a first metal region in direct contact with a P+ region to connect one or more Schottky diode regions in series with the one or more body diode regions of the DMOSFET to impact the turn-on voltage of the one or more body diode regions of the DMOSFET.

In yet another embodiment, each unit cell of the DMOSFET comprises the P+ region that meanders and comprises a periodic spacing between a N+ source region and the P+ region to form periodic contacts to a first pad metal (e.g., a source metal) via the silicide layer between interlayer dielectric bumps (ILD) to impact the differential on-resistance of the one or more body diode regions of the DMOSFET.

In yet another embodiment, each unit cell of the DMOSFET comprises the P+ region that meanders and enables the P-well region to be in contact with the silicide layer (i.e., the first pad metal) only through the meandering P+ region to impact the differential on-resistance of the one or more body diode regions of the DMOSFET.

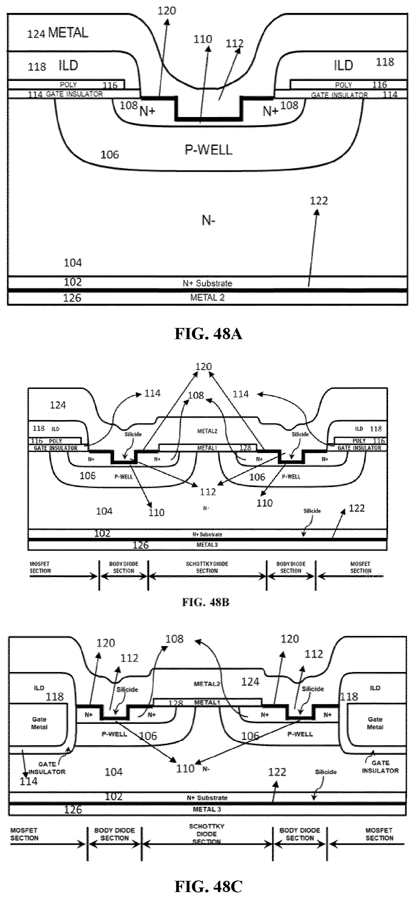

**FIG. 48A** illustrates an embodiment of a cross sectional structure of a unit cell of a double-implantation metal oxide semiconductor field-effect transistor (DMOSFET) comprising a first conductivity type second source region within a first conductivity type first source region. The DMOSFET (shown in FIG. 48A) is a n-type planar gate DMOSFET. In an embodiment, the DMOSFET is a p-type planar gate DMOSFET. The DMOSFET (shown in FIG. 48A) comprises a silicon carbide (SiC) substrate. The SiC substrate comprises a N+ substrate 102 and a N- drift layer 104. The DMOSFET also comprises a P-well region 106, a first N+ source region 108 (i.e., the first conductivity type first source region) and a second N+ source region 110 (i.e., the first conductivity type second source region). The first N+ source region 108 is formed within the P-well region 106. The second N+ source region 110 is formed within each first N+ source region 108 by etching the SiC substrate to remove a portion of the SiC substrate and form a recessed SiC trench 112. In an embodiment, the second N+ source region 110 is a depletion region when the DMOSFET is operated in the third quadrant. The recessed SiC trench 112 leaves the remnant thin first N+ source region 108 as the second N+ source region 110. The second N+ source region 110 comprises a thickness less than a thickness of the first N+ source region 108 which enables the second N+ source region 110 to get depleted easily compared to the first N+ source region 108. The second N+ source region 110 may comprise the thickness ranging from 1% to 90% lower than the thickness of the first N+ source region 108. In an embodiment, the second N+ source region 110 comprises a doping concentration less than a doping concentration of the first N+ source region 108. The second N+ source region 110 may comprise the doping concentration ranging from 1% to 90% lower than the doping concentration of the first N+ source region 108.

The DMOSFET also comprises a gate insulator 114, a polysilicon layer 116 and an interlayer dielectric (ILD) 118 on both sides of top surface of the SiC substrate. The DMOSFET further comprises a first silicide layer 120 on top of the recessed SiC trench 112 and a second silicide layer 122 on bottom side/back side of the SiC substrate to form ohmic contacts for a source terminal and a drain terminal respectively. The DMOSFET further comprises a first pad metal 124 (e.g., a source metal) and a second pad metal 126 (e.g., a drain metal) on top of the first silicide layer 120 and bottom of the second silicide layer 122 respectively.

During third quadrant operation of the n-type planar gate DMOSFET (i.e., when the source terminal is positively biased with respect to the drain terminal), an intrinsic p-n junction between the second N+ source region 110 and the p-well region 106 is reverse biased as electric potential of the first pad metal 124 is low when compared to electric potential of the second pad metal 126. The second N+ source region 110 starts depleting during the third quadrant operation. The first pad metal 124 (e.g., the source metal) is directly short circuited (e.g., connected) with the P-well region 106, when the second N+ source region 110 is completely depleted. The second N+ source region 110 enables one or more body diode regions of the DMOSFET to have an increased turn-on voltage and the one or more body diode regions turn on only when the second N+ source region 110 is completely depleted. The increased turn-on voltage is due to intrinsic bandgap of the SiC. As the complete depletion of the second N+ source region 110 depends on at least one of the thickness and the doping concentration of the second N+ source region 110, the turn-on voltage of the second N+ source region 110 also depends on the thickness and the doping concentration of the second N+ source region 110. The turn-on voltage of the one or more body diode regions is tuned by controlling/adjusting the thickness and the doping concentration of the second N+ source region 110 to a target thickness and a target doping concentration respectively. In an embodiment, the target thickness ranges from 1 nm to 1 $\mu$m. In another embodiment, the target doping concentration ranges from $10^{15}$ cm$^{-3}$ to $10^{21}$ cm$^{-3}$. The target thickness and the target doping concentration of the second N+ source region 110 is achieved by monitoring and controlling precisely the etching performed onto the SiC substrate.

FIG. 48B illustrates an embodiment of a cross sectional structure of one or more unit cells of the DMOSFET, comprising one or more unit cells of an integrated Schottky diode, each DMOSFET unit cell comprising the first conductivity type second source region within the first conductivity type first source region. The DMOSFET (shown in FIG. 48B) is a n-type planar gate SiC DMOSFET. The DMOSFET shown in FIG. 48B operates in a similar way to FIG. 48A. In addition to FIG. 48A, the DMOSFET (shown in FIG. 48B) comprises a metal region 128 (e.g., a Schottky metal region 128) in direct contact with the N- drift layer 104 and bridges adjacent P-well regions 106 (i.e., bridges the adjacent unit cells) of the one or more P-well regions 106. The DMOSFET comprises each second N+ source region 110 between the respective silicide SiC trench 112 and the respective P-well region 106.

FIG. 48C illustrates an embodiment of a cross sectional structure of one or more unit cells of a trench gate MOSFET, comprising one or more unit cells of the integrated Schottky diode, each MOSFET unit cell comprising the first conductivity type second source region within the first conductivity type first source region. The trench gate MOSFET shown in FIG. 48C is a n-type trench gate SiC MOSFET. In an embodiment, the trench gate MOSFET is a p-type trench gate SiC MOSFET. The trench gate MOSFET shown in FIG. 48C operates in a similar way to planar gate DMOSFET shown in FIG. 48A and FIG. 48B. The main difference between the trench gate MOSFET and the planar gate DMOSFET is that the trench gate MOSFET comprises one or more trench gate structures instead of one or more planar gate structures. The one or more trench gate structures of the trench gate MOSFET comprises sidewalls that are exposed to the first N+ source region 108 and the one or more P-well regions 106. The bottom of the one or more trench gate structures is in vicinity of the bottom of the one or more P-well regions 106. In an embodiment, the bottom of the one or more trench gate structures is adjusted appropriately depending on electrical properties of the MOSFET device. Each trench gate structure of the trench gate MOSFET comprises the gate insulator 114 as liner along the sidewall and the bottom of the respective trench gate structure. Each trench gate structure comprises the polysilicon layer 116 that fills the gate-insulator lined trenches and serves as gate electrode. The trench gate MOSFET further comprises the interlayer dielectric (ILD) 118 over each polysilicon layer 116 to open short circuitry between the first pad metal 124 (e.g., the source metal) and the gate electrode.

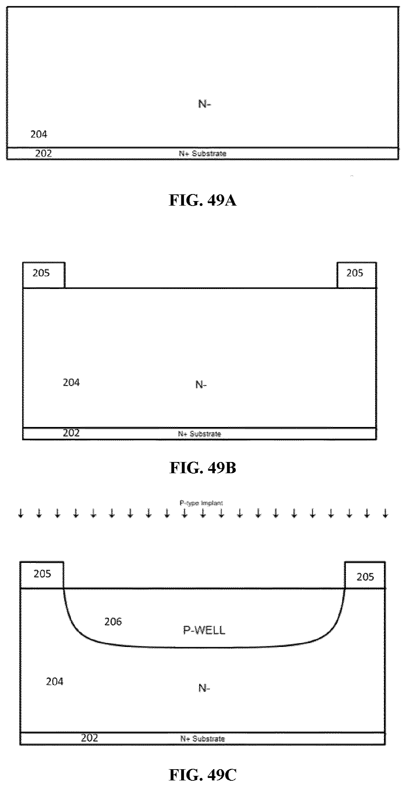

FIG. 49A to 49T illustrate an embodiment of a process of manufacturing the DMOSFET structure shown in FIG. 48A. The process of manufacturing the DMOSFET structure (shown in FIG. 48A) comprises preparing a Silicon Carbide (SiC) substrate having a N+ substrate 202 and a N- drift layer 204 as shown in FIG. 49A. The N- drift layer 204 of the SiC substrate is epi-grown and prepared such that a doping concentration and a thickness of the N- drift layer 204 are selected primarily based on blocking voltage and forward conduction loss. The N+ substrate 202 is highly conductive when compared to the N- drift layer 204 and the N+ substrate 202 is in direct contact with the N- drift layer 204. A first patterned hard mask layer 205 is formed on top of the SiC substrate as shown in FIG. 49B. The first patterned hard mask layer 205 is thick enough for completely blocking high energy impurities during implantation. In an embodiment, the first patterned hard mask layer 205 is a hard mask of at least one of oxide, nitride, and a polysilicon.

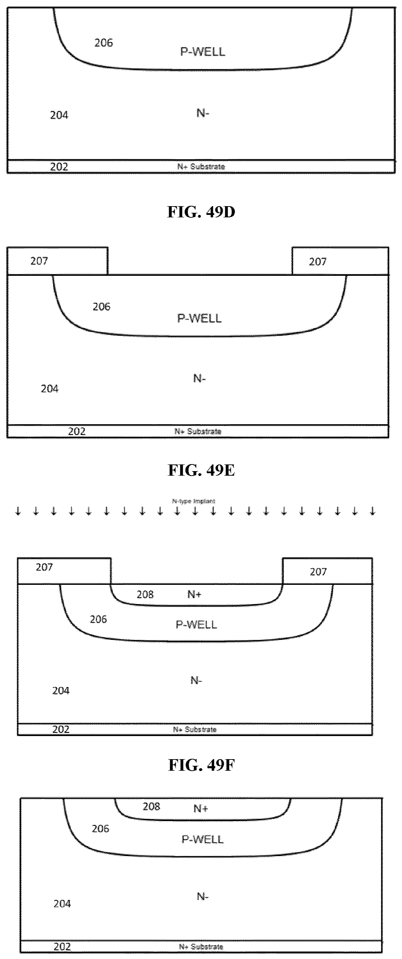

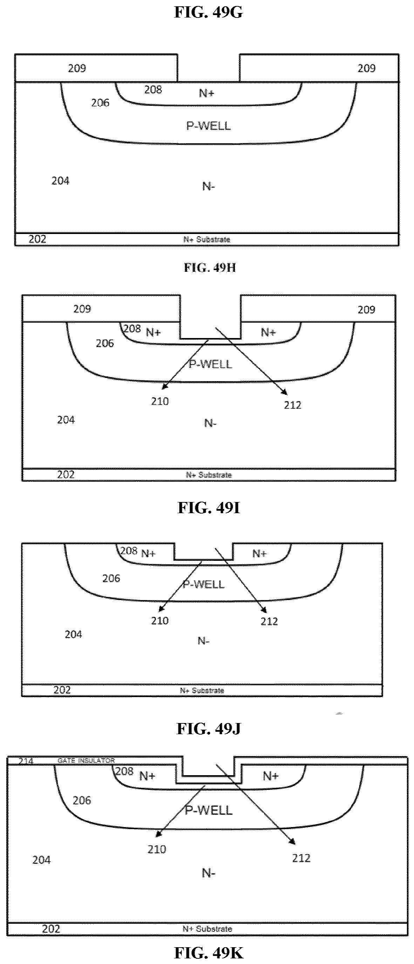

A first p-type ion implantation is formed in FIG. 49C through the first patterned hard mask layer 205 to form a p-well region 206. In an embodiment, the first p-type ion implantation is performed with one or more p-type impurities (e.g., aluminum, boron, etc.). In another embodiment, first p-type ion implantation may comprise a screen oxide layer. The first patterned hard mask layer 205 is then removed, after the first p-type ion implantation, by at least one of dry etching and wet etching process as shown in FIG. 49D. A second patterned hard mask layer 207 is then formed on the top of the SiC substrate as shown in FIG. 49E for subsequent ion implantation. The second patterned hard mask layer 207 is a photoresist based material and thick enough for preventing any unwanted high energy impurity particles penetrating the second patterned hard mask layer 207. A first n-type ion implantation is performed through the second patterned hard mask layer 207 to form a first N+ source region 208 within the p-well region 206 as shown in FIG. 49F. In an embodiment, the first n-type ion implantation is performed with one or more n-type impurities (e.g., nitrogen, phosphorous etc.). The second patterned hard mask layer 207 is then removed after the first n-type ion implantation by at least one of dry etching and wet etching process as shown in FIG. 49G.

A third patterned hard mask layer 209 is formed on top of the SiC substrate as shown in FIG. 49H. An etching is performed onto the SiC substrate through the third patterned hard mask layer 209. The SiC etching performed consumes a central portion of each first N+ source region 208 and forms a recessed SiC trench region 212 per each first N+ source region 208. The recessed SiC trench region 212 does not fully penetrates the first N+ source region 208 in vertical direction and leaves a remnant of the first N+ source region 208 to form a second N+ source region 210 under the bottom of the recessed SiC trench region 212 as shown in FIG. 49I. The SiC etching is controlled accurately and precisely considering plausible loss of the Sic Substrate, during at least one of thermal activation annealing, sacrificial oxidation, and dry oxidation for one of a gate oxide formation and a silicide layer formation for ohmic contacts, when target SiC trench depth is reached. The target SiC trench depth leaves at least one of a target thickness and a target doping concentration of the second N+ source region 210 under the bottom of the recessed SiC trench region 212. In an embodiment, the target thickness ranges from 1 nm to 1 $\mu$m. In another embodiment, the target doping concentration ranges from $10^{15}$ cm$^{-3}$ to $10^{21}$ cm$^{-3}$.

The third patterned hard mask layer 209 is then removed as shown in FIG. 49J by at least one of a dry etching and a wet etching process once the target SiC trench depth is reached. The SiC substrate undergoes thermal activation annealing with a carbon-based protection coating at a predefined temperature. In an embodiment, the predefined temperature is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate once the thermal activation annealing is completed. The SiC substrate then undergoes a sacrificial oxide growth and subsequently the sacrificial oxide removal. An active region of the DMOSFET is then patterned by forming and patterning field oxide layer on the SiC substrate.

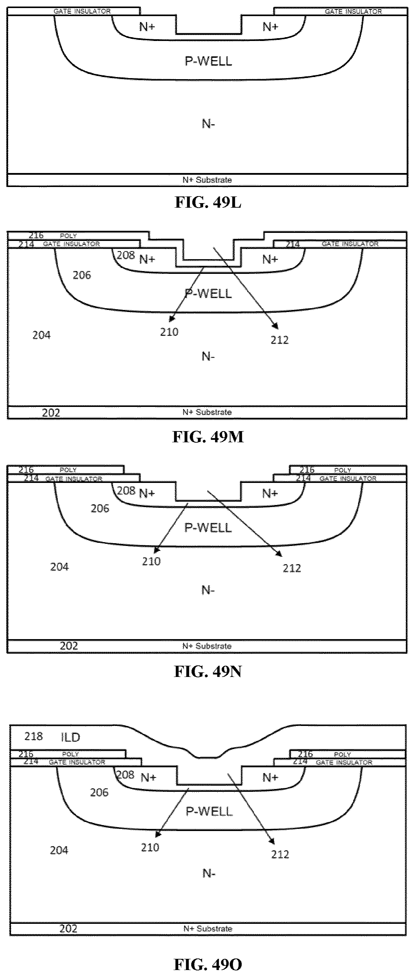

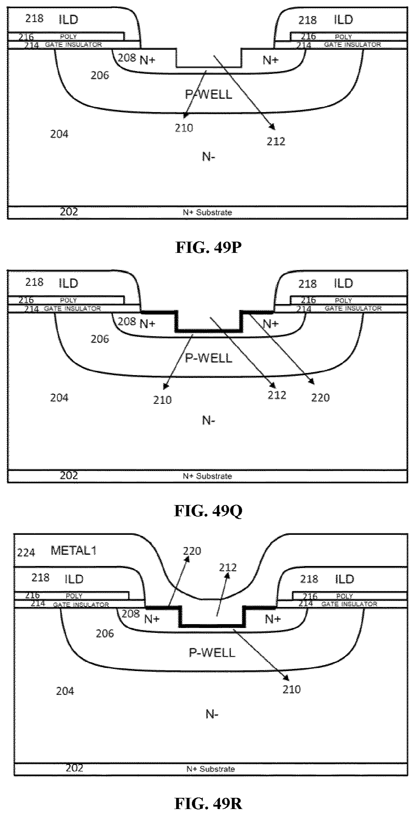

A gate insulator 214 is then deposited/formed on top of the SiC substrate as shown in FIG. 49K. The gate insulator 214 is then patterned as shown in FIG. 49L. A polysilicon layer 216 is then formed on top of the SiC substrate as shown in FIG. 49M. The polysilicon layer 216 is then patterned as shown in FIG. 49N. The contacts for the polysilicon layer are kept open before pad metal deposition for forming a gate pad region and the gate bus region(s). An interlayer dielectric (ILD) 218 is then formed on top of the SiC substrate as shown in FIG. 49O. The interlayer dielectric (ILD) 218 is then patterned for exposing the portions of the SiC substrate via the openings of the ILD 218 as shown in FIG. 49P. A first silicide layer 220 is then formed on the exposed portions on top of the SiC substrate for forming a first Ohmic contact (e.g., a source terminal contact) as shown in FIG. 49Q. In an embodiment, the first silicide layer 220 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 224 is then formed on top of the first silicide layer 220 of the SiC substrate as shown in FIG. 49R.

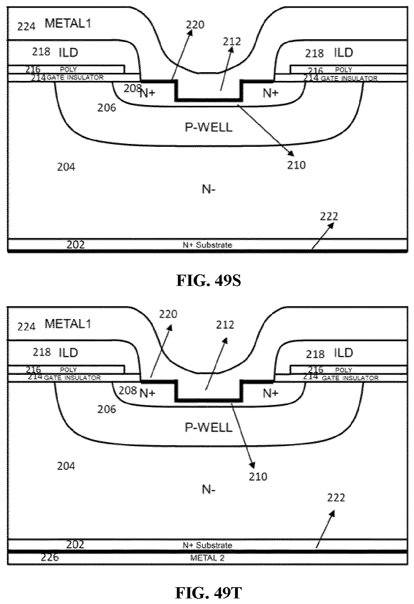

A second silicide layer 222 is then formed on bottom of the SiC substrate for forming a second Ohmic contact as shown in FIG. 49S. In an embodiment, the second silicide layer 222 is then formed on back of the SiC substrate for forming the second Ohmic contact (e.g., a drain terminal contact). In an embodiment, the second silicide layer 222 is also the nickel-based silicide layer. A second pad metal 226 is then formed on bottom of the second silicide layer 222 of the SiC substrate as shown in FIG. 49T. In an embodiment, the second pad metal formation is performed by at least one of e-beam and sputtering.

A fourth patterned hard mask layer 211 is then formed on the SiC substrate once the first Ohmic contact and the second Ohmic contact are formed on topside and bottom side/back side of the SiC substrate respectively. The fourth patterned hard mask layer 211 is formed for selectively removing the exposed portions of the ILD layer 218 and forming a metal region (i.e., a Schottky metal region 228) shown in FIG. 48B. The fourth patterned hard mask layer 211 is used for both etching the portion of the ILD layer 218 and lifting off the Schottky metal region 228 when Schottky metal is deposited. The Schottky metal region 228 is in direct contact with the N- drift layer 204 and bridge two adjacent P-well regions 206 (i.e., bridges the adjacent unit cells). The Schottky metal region 228 is then annealed with a predefined thermal budget for forming a Schottky metal contact between the Schottky metal region 228 and the portion of the N- drift layer 204 exposed at the top surface of the SiC substrate. In an embodiment, the predefined thermal budget ranges from 55°C to 1100°C. In Fig. 48B the first pad metal and the second pad metal formation are performed once the Schottky metal region 228 formation is completed.

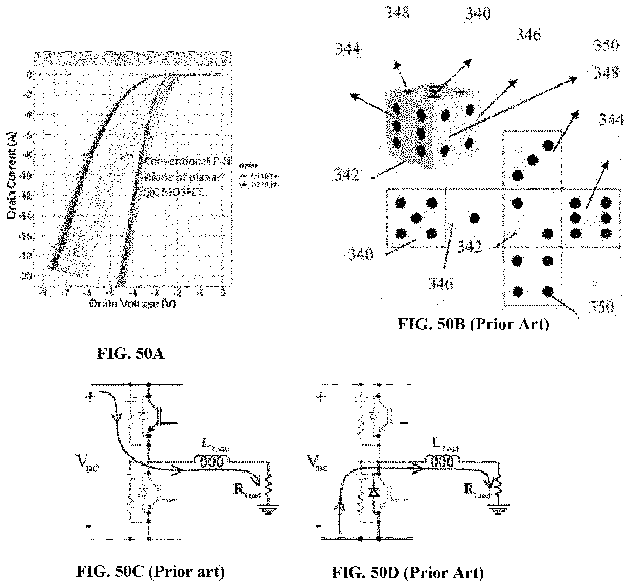

FIG. 50A illustrates an embodiment of a voltage-current characteristic of a SiC DMOSFET with conventional p-n junction vs the SiC DMOSFET with deactivated p-n junction (i.e., the first conductivity type second source region). The voltage-current characteristic shown in FIG. 50A depicts that at a drain current -16A, the SiC planar DMOSFET with conventional p-n junction shows a voltage drop of ≈-4v and the SiC DMOSFET with deactivated p-n junction (i.e., the first conductivity type second source region) shows a voltage drop of ≈-7V. The SiC DMOSFET comprise the p-n junction with increased built-in potential and increased differential on-resistance when the SiC DMOSFET comprises the first conductivity type second source region 110.

FIG. 50B is a perspective view that illustrates an embodiment of sides of the DMOSFET in relation to a dice. The DMOSFET may comprise a structure similar to the dice as shown in FIG. 50B. The DMOSFET comprises at least the topside 340, the bottom side 342, a front side 344, the back side 346, a left side 348 and a right side 350. The topside 340 of the DMOSFET refers to an outer side/top of the DMOSFET. The topside 340 comprises the source terminal. The bottom side 342 refers to a base of the DMOSFET. In an embodiment, the bottom side 342 of the DMOSFET comprises the drain terminal. The back side 346 of the DMOSFET is hidden in FIG. 50B and is located adjacent to the topside 340 and the bottom side 342. In another embodiment, the back side 346 of the DMOSFET comprises the drain terminal. The front side 344 and the right side 350 of the DMOSFET is visible in FIG. 50B, whereas the left side 348 and the back side 346 of the DMOSFET is hidden in FIG. 50B.

"FIG. 50C and 50D shows the operation of the anti-parallel diode in a half-bridge inverter feeding an inductive load. The left picture (i.e., FIG. 50C) shows the state when the upper switch feeds the inductor. However, when that switch turns off, inductor's current continues its path through the anti-parallel diode of the bottom switch (right picture i.e., FIG. 50D)." [source: Re: Why are diodes connected anti-parallel across the MOSFET or IGBT in Inverter Module? Heydari, Gholamali, published on Research gate, July 25, 2013].

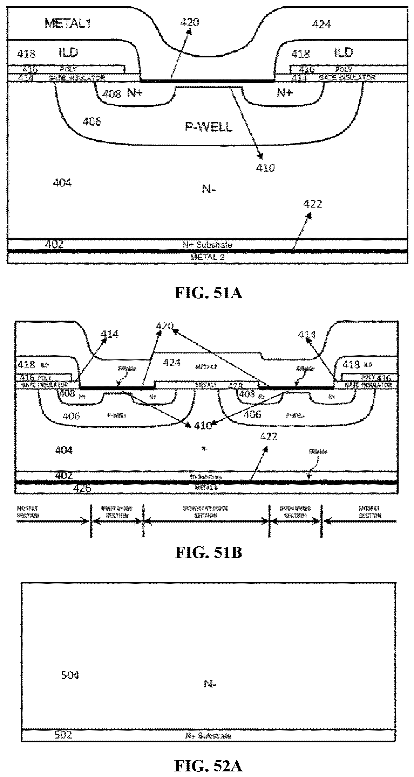

FIG. 51A illustrates an embodiment of a cross sectional structure of a unit cell of a double-implantation metal oxide semiconductor field-effect transistor (DMOSFET) comprising a first conductivity type second source region within a first conductivity type first source region. The DMOSFET (shown in FIG. 51A) is a n-type planar gate DMOSFET. In an embodiment, the DMOSFET is a p-type planar gate DMOSFET. In another embodiment, the DMOSFET is one of a n-type trench gate DMOSFET and a p-type trench gate DMOSFET. The DMOSFET (shown in FIG. 51A) comprises a Silicon Carbide (SiC) substrate. The SiC substrate comprises a N+ substrate 402 and a N- drift layer 404. The DMOSFET also comprises a P-well region 406, a first N+ source region 408 (i.e., the first conductivity type first source region) and a second N+ source region 410 (i.e., the first conductivity type second source region). The first N+ source region 408 is formed within the P-well region 406. The second N+ source region 410 is formed within the first N+ source region 408 by performing a n-type implantation with controlled dosage and energy level. In an embodiment, the second N+ source region 410 is a depletion region during third quadrant MOSFET operation. The second N+ source region 410 comprises a thickness and a doping concentration which is significantly less than a thickness and a doping concentration of the first N+ source region 408 respectively which enables the second N+ source region 410 to get depleted easily compared to the first N+ source region 408. In an embodiment, the second N+ source region 410 comprises the thickness ranging from 1% to 90% lower than the thickness of the first N+ source region 408. In another embodiment, the second N+ source region 410 comprises the doping concentration ranging from 1% to 90% lower than the doping concentration of the first N+ source region 408.

The DMOSFET also comprises a gate insulator 414, a polysilicon layer 416 and an interlayer dielectric (ILD) 418 on both sides of top surface of the SiC substrate. The DMOSFET further comprises a first silicide layer 420 on top of the SiC substrate and a second silicide layer 422 on bottom side/back side of the SiC substrate to form ohmic contacts for a source terminal and a drain terminal respectively. The DMOSFET further comprises a first pad metal 424 (e.g., a source metal) and a second pad metal 426 (e.g., a drain metal) on top of the first silicide layer 420 and bottom of the second silicide layer 422 respectively.

During third quadrant operation of the DMOSFET (i.e., when the source terminal is positively biased with respect to the drain terminal), an intrinsic p-n junction between the second N+ source region 410 and the p-well region 406 is reverse biased as electric potential of the first pad metal 424 is low when compared to electric potential of the second pad metal 426. The second N+ source region 410 starts depleting during the third quadrant operation. The first pad metal 424 (e.g., the source metal) is directly short circuited (i.e., connected) with the P-well region 406, when the second N+ source region 410 is completely depleted. The second N+ source region 410 enables one or more body diode regions of the DMOSFET to have an increased turn-on voltage and the one or more body diode regions turn on only when the second N+ source region 410 is completely depleted. The increased turn-on voltage is due to intrinsic bandgap of the SiC. As the complete depletion of the second N+ source region 410 depends on at least one of a thickness and a doping concentration of the second N+ source region 410, the turn-on voltage of the one or more body diode regions also depends on the thickness and the doping concentration of the second N+ source region 410. The turn-on voltage of the one or more body diode regions is tuned by controlling/adjusting the thickness and the doping concentration of the second N+ source region 410 to a target thickness and a target doping concentration respectively. In an embodiment, the target thickness ranges from 1 nm to 1 $\mu$m. In another embodiment, the target doping concentration ranges from $10^{15}$ cm$^{-3}$ to $10^{21}$ cm$^{-3}$. The target thickness and the target doping concentration of the second N+ source region 410 is achieved by monitoring and controlling the dosage and the energy level of the n-type implantation.

FIG. 51B illustrates an embodiment of a cross sectional structure of one or more unit cells of the DMOSFET, comprising one or more unit cells of an integrated Schottky diode, each DMOSFET unit cell comprising the first conductivity type second source region within the first conductivity type first source region. The DMOSFET (shown in FIG. 51B) is a n-type planar gate DMOSFET. The DMOSFET shown in FIG. 51B operates in a similar way to FIG. 51A. In addition to FIG. 51A, the DMOSFET (shown in FIG. 51B) comprises a metal region (i.e., a Schottky metal region 428) and one or more P-well regions 406. The Schottky metal region 428 is in direct contact with the N- drift layer 404 and bridges the adjacent P-well regions 406 (i.e., bridges the adjacent unit cells) of the one or more P-well regions 406. The DMOSFET comprises each second N+ source region 410 between the first silicide layer 420 and the respective P-well region 406.

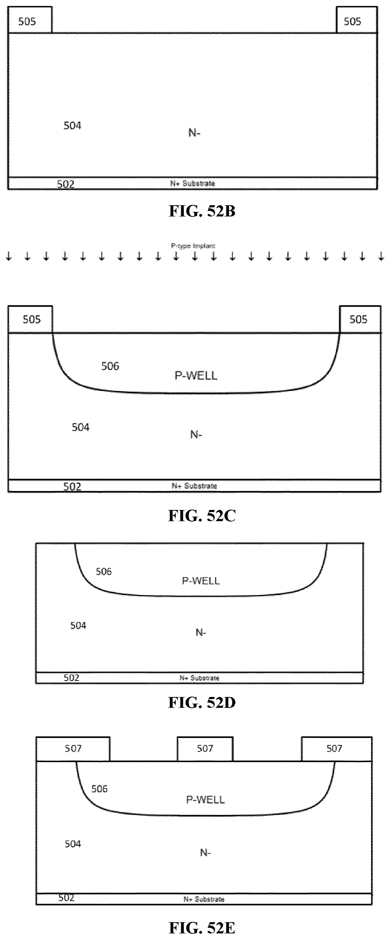

**FIG. 52A to 52T** illustrate an embodiment of a process of manufacturing the DMOSFET structure shown in FIG. 51A. The process of manufacturing the DMOSFET structure (shown in FIG. 52A) comprises preparing a Silicon Carbide (SiC) substrate having a N+ substrate 502 and a N- drift layer 504 as shown in FIG. 52A. The N- drift layer 504 of the SiC substrate is epi-grown and prepared such that a doping concentration and a thickness of the N- drift layer 504 are selected primarily based on blocking voltage and forward conduction loss. The N+ substrate 502 is highly conductive when compared to the N- drift layer 504 and the N+ substrate 502 is in direct contact with the N- drift layer 504. A first patterned hard mask layer 505 is formed on top of the SiC substrate as shown in FIG. 52B. The first patterned hard mask layer 505 is thick enough for completely blocking high energy impurities during implantation. In an embodiment, the first patterned hard mask layer 505 is a hard mask of at least one of oxide, nitride, and a polysilicon.

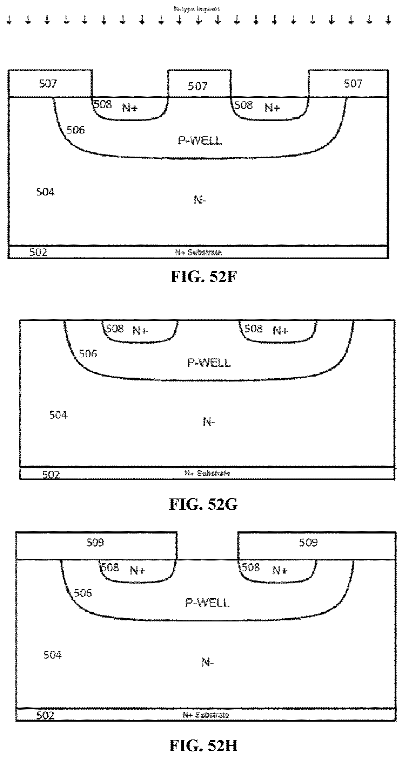

A first p-type ion implantation is formed in FIG. 52C through the first patterned hard mask layer 505 to form a p-well region 506. In an embodiment, the first p-type ion implantation is performed with one or more p-type impurities (e.g., aluminum, boron, etc.). In another embodiment, first p-type ion implantation may comprise a screen oxide layer. The first patterned hard mask layer 505 is then removed, after the first p-type ion implantation, by at least one of dry etching process and wet etching process as shown in FIG. 52D. A second patterned hard mask layer 507 is then formed on the top of the SiC substrate as shown in FIG. 52E for subsequent ion implantation. The second patterned hard mask layer 507 is a photoresist based material and thick enough for preventing any unwanted high energy impurities particles penetrating the second patterned hard mask layer 507. A first n-type ion implantation is formed through the second patterned hard mask layer 507 to form a first N+ source region 508 (i.e., the first conductivity type first source region) within the p-well region 506 as shown in FIG. 52F. In an embodiment, the first n-type ion implantation is performed with one or more n-type impurities (e.g., nitrogen, phosphorous etc.). The second patterned hard mask layer 507 is then removed after the first n-type ion implantation by at least one of dry etching and wet etching process as shown in FIG. 52G.

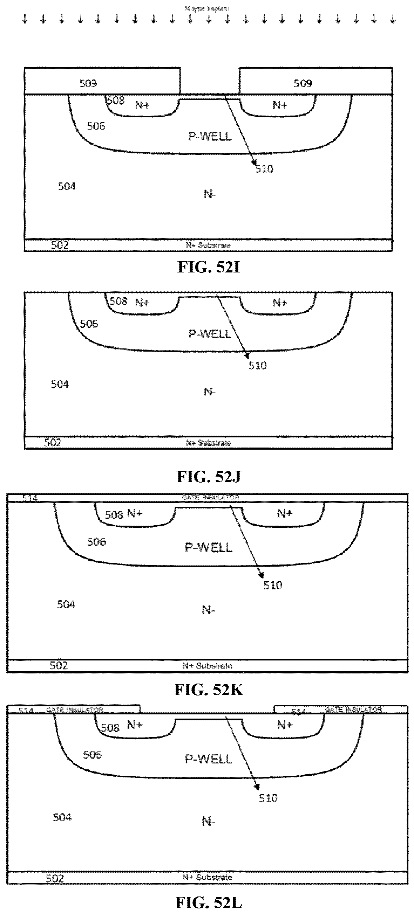

A third patterned hard mask layer 509 is then formed on top of the SiC substrate as shown in FIG. 52H. A second n-type implantation is performed through the third patterned hard mask layer 509 to form a second N+ source region 510 within the first N+ source region 508 within each p-well region 506 as shown in FIG. 52I. The dosage and energy level of the second n-type implantation is controlled accurately and precisely to form the second N+ source region 510 having a target thickness and a target doping concentration. The target thickness may range from 1 nm to 1 $\mu$m. The target doping concentration may range from $10^{15}$ cm$^{-3}$ to $10^{21}$ cm$^{-3}$. In an embodiment, a doping concentration, and a thickness of the second N+ source region 510 is less than a doping concentration and a thickness of the first N+ source region 508 respectively. In one embodiment, the doping concentration of the second N+ source region 510 is 1% to 90% lower than the doping concentration of the first N+ source region 508. In another embodiment, the thickness of the second N+ source region 510 is 1% to 90% lower than the thickness of the first N+ source region 508.

The third patterned hard mask layer 509 is then removed as shown in FIG. 52J by at least one of a dry etching and a wet etching process once the second N+ source region 510 having the target thickness and the target doping concentration is achieved. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

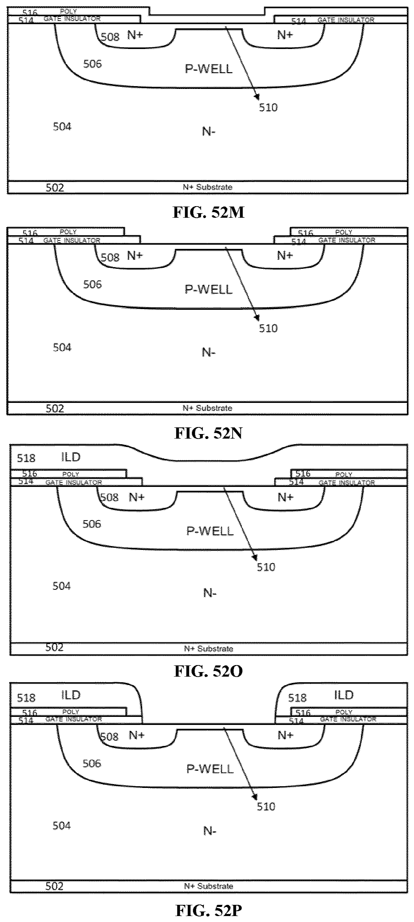

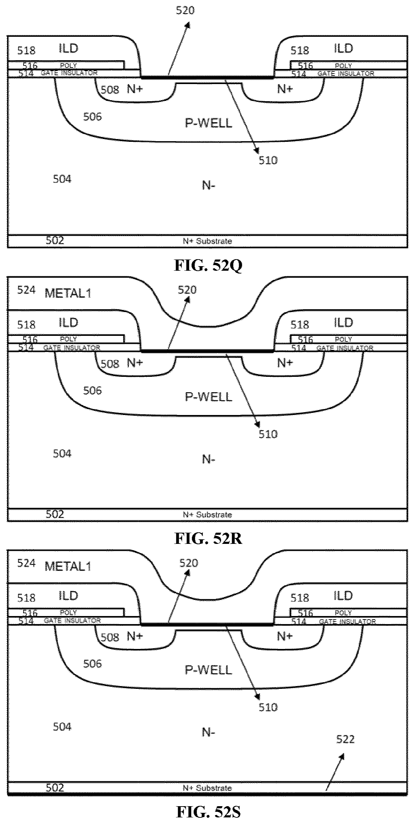

A gate insulator 514 is then formed on top of the SiC substrate as shown in FIG. 52K. The gate insulator is then patterned as shown in FIG. 52L. A polysilicon layer 516 is then formed on top of the SiC substrate as shown in FIG. 52M. The polysilicon layer 516 is then patterned as shown in FIG. 52N. Contacts for the polysilicon layer are kept open for pad metal deposition for forming a gate pad region and one or more gate bus regions. An interlayer dielectric (ILD) 518 is then formed on top of the SiC substrate as shown in FIG. 52O. The interlayer dielectric (ILD) 518 is then patterned for exposing the portions of the SiC substrate via the openings of the ILD 518 as shown in FIG. 52P. A first silicide layer 520 is then formed on the exposed portions of top of the SiC substrate for forming a first Ohmic contact (e.g., a source terminal contact) as shown in FIG. 52Q. In an embodiment, the first silicide layer 520 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 524 is then formed on top of the first silicide layer 520 of the SiC substrate as shown in FIG. 52R.

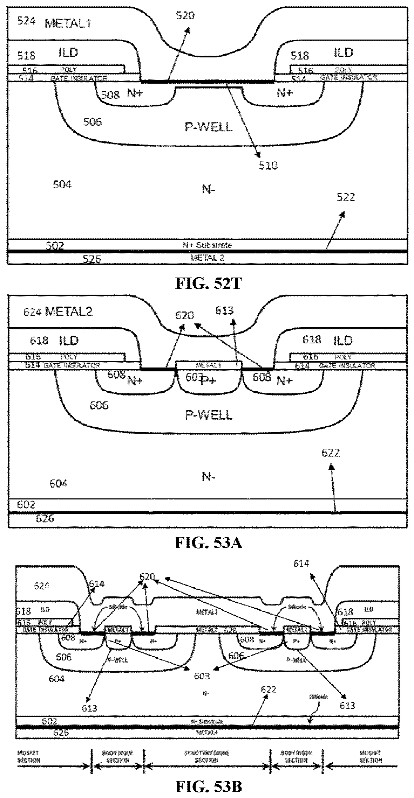

A second silicide layer 522 is then formed on bottom of the SiC substrate for forming a second Ohmic contact (e.g., a drain terminal contact) as shown in FIG. 52S. In an embodiment, the second silicide layer 522 is then formed on back of the SiC substrate for forming the second Ohmic contact (e.g., the drain terminal contact). In an embodiment, the second silicide layer 522 is also the nickel-based silicide layer. A second pad metal 526 is then formed on bottom of the second silicide layer 522 of the SiC substrate as shown in FIG. 52T. In an embodiment, the second pad metal formation is performed by at least one of e-beam and sputtering.

A fourth patterned hard mask layer 511 is then formed on the SiC substrate once the first Ohmic contact and the second Ohmic contact are formed on top and bottom side/back side of the SiC substrate respectively. The fourth patterned hard mask layer 511 is formed for selectively removing the exposed portions of the ILD layer 518 and forming a metal region 528 (i.e., a Schottky metal region 528) shown in FIG. 51B. The fourth patterned hard mask layer 511 is used for both etching the portion of the ILD layer 518 and lifting off the Schottky metal region 528 when Schottky metal is deposited. The Schottky metal region 528 is in direct contact with the top of the N- drift layer 504 and bridge two adjacent P-well regions 506 (e.g., bridges the adjacent unit cells). The Schottky metal region 528 is then annealed with a predefined thermal budget for forming a Schottky metal contact between the second Schottky metal region 528 and the portion of the N- drift layer 504 exposed at the top surface of the SiC substrate. In an embodiment, the predefined thermal budget ranges from 55°C to 1100°C. In fig. 51B the first pad metal and the second pad metal formation are performed once the Schottky metal region 528 formation is completed.

FIG. 53A illustrates an embodiment of a cross sectional structure of a unit cell of a double-implantation metal oxide semiconductor field effect transistor (DMOSFET) comprising a first metal region in direct contact with a second conductivity type well contact region. The DMOSFET (shown in FIG. 53A) is a n-type planar gate SiC DMOSFET. In an embodiment, the DMOSFET is a p-type planar gate DMOSFET. In another embodiment, the DMOSFET is a p-type trench gate DMOSFET. In yet another embodiment, the DMOSFET is a n-type trench gate DMOSFET. The DMOSFET (shown in FIG. 53A) comprises a Silicon Carbide (SiC) substrate. The SiC substrate comprises a N+ substrate 602 and a N- drift layer 604. The DMOSFET also comprises a P-well region 606, a first N+ source region 608 and a P+ region 603 (i.e., the second conductivity type well contact region). The first N+ source region 608 is formed within the P-well region 606. The P+ region 603 (i.e., the second conductivity type well contact region) is formed within the P-well region 606 by performing a p-type implantation. The second conductivity type well contact region specifically refers to the P+ region 603. The first metal region 613 (e.g., a first Schottky metal region 613) is then formed in direct contact with the P+ region 603 to connect one or more Schottky diode regions in series with one or more body diode regions of the DMOSFET. The first Schottky metal region 613 comprises a target work function. In an embodiment, the target work function of the first Schottky metal region 613 ranges from 3.5 electron volts to 6 electron volts. The work function of the first Schottky metal region 613 and the series connection of the Schottky diode regions with the body diode regions allows the one or more body diode regions to turn-on only when significant number of carriers from the first Schottky metal region 613 is thermionically injected over Schottky barrier during third quadrant operation of the DMOSFET. Since the one or more Schottky diode regions are connected in series with the one or more body diode regions, the one or more Schottky diode regions consumes the voltage of the one or more body diode regions and the one or more Schottky diode regions turn on first before the one or more body diode regions. Any additional applied voltage that is greater than turn-on voltage of the one or more Schottky diode regions contributes to turn-on the one or more body diode regions. Due to the series connection of the one or more Schottky diode regions with the body diode regions, the body diode regions consume additional turn-on voltage compared to typical turn-on voltage. The one or more body diode regions get turn-on only when the first Schottky metal region 613 turn on with a forward voltage which corresponds at least to the barrier height of a first Schottky contact region for starting the on-set of the carrier injection over the Schottky barrier (i.e., when the first Schottky metal region 613 comprises the target work function). The forward voltage initiates the carrier injection to turn-on the Schottky diode regions. Any additional forward voltage that is greater than the turn-on voltage of the Schottky diode regions contributes to turn-on the body diode regions. The turn-on voltage of the body diode regions is tuned by at least one of controlling a Schottky barrier height and selecting a Schottky metal with an appropriate work function utilized in forming the first Schottky metal region 613. The turn-on voltage of the body diode regions is also tuned by adjusting thermal budget for annealing the first Schottky contact region once the first Schottky metal region 613 is formed on top of the SiC substrate. The predefined thermal budget may range from 55°C to 1100°C. In an embodiment, the DMOSFET comprises a second metal region 628 (e.g., a second Schottky metal region 628) directly on top of the N- drift layer 604 and bridge adjacent P-well regions 606 of the one or more P-well regions 606 (i.e., bridges the adjacent unit cells) shown in FIG. 53B. The work function of the first Schottky metal region 613 is less than a work function of the second Schottky metal region 628.

FIG. 53B illustrates an embodiment of a cross sectional structure of one or more unit cells of the DMOSFET, comprising one or more unit cells of an integrated Schottky diode, each DMOSFET unit cell comprising the first metal region in direct contact with the respective second conductivity type well contact region. The DMOSFET (shown in FIG. 53B) is a n-type planar gate SiC DMOSFET. The DMOSFET shown in FIG. 53B operates in a similar way to FIG. 53A. In addition to FIG. 53A, the DMOSFET (shown in FIG. 53B) comprises the second Schottky metal region 628 and one or more P-well regions 606. The second Schottky metal region 628 is in direct contact with the N- drift layer 604 and bridges the adjacent P-well regions 606 (i.e., the adjacent unit cells) of the one or more P-well regions 606. The work function of the first Schottky metal region 613 is less than the work function of the second Schottky metal region 628.

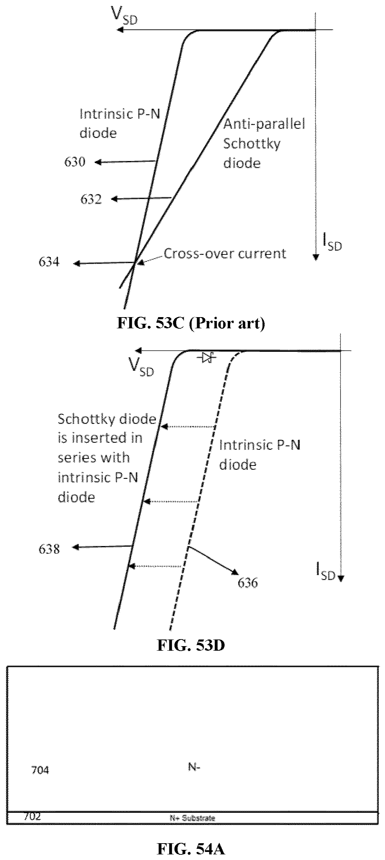

**FIG. 53C** illustrates an embodiment of a third quadrant current conduction through an intrinsic p-n junction diode region vs a Schottky diode region connected in parallel to DMOSFET. The third quadrant current of the body diode region is indicated as 630 in FIG. 53C. The third quadrant current of the anti-parallel Schottky diode region is indicated as 632 in FIG. 53C. At a certain point, the third quadrant current passing through the body diode region intersects with the third quadrant current passing through the Schottky diode region which is indicated as 634 in FIG. 53C. Above this point, the third quadrant current is bipolar in nature which results in performance and reliability issues.

**FIG. 53D** illustrates an embodiment of a third quadrant current conduction through the DMOSFET after connecting the one or more Schottky diode regions in series with the one or more body diode regions of the DMOSFET. The third quadrant current of the body diode region is indicated as 636 in FIG. 53D. Due to the existence of the one or more Schottky diode regions in series connection with the one or more body diode regions, the magnitude of the third quadrant current is shifted by the additional current required for the one or more Schottky diode regions to turn-on first. The shift in the magnitude of the third quadrant current ((i.e.) the increased third quadrant current), after connecting the one or more Schottky diode regions in series with the one or more body diode regions, is indicated as 638 in FIG. 53D. It is evident from FIG. 53C and FIG. 53D, the magnitude of the third quadrant current is increased when the one or more Schottky Diode regions is connected in series with the one or more body diode regions of the DMOSFET.

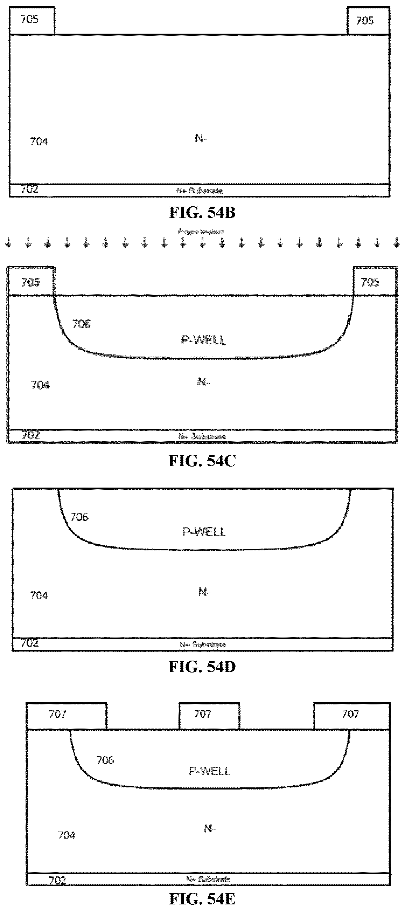

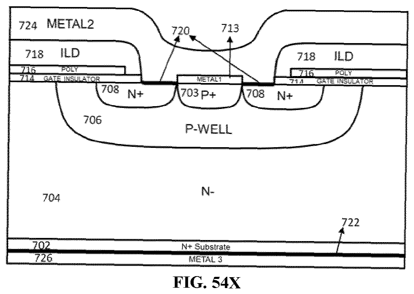

**FIG. 54A to 54X** illustrate an embodiment of a process of manufacturing the DMOSFET structure shown in FIG. 53A. The process of manufacturing the DMOSFET structure (shown in FIG. 54A) comprises preparing a Silicon Carbide (SiC) substrate having a N+ substrate 702 and a N- drift layer 704 as shown in FIG. 54A. The N- drift layer 704 of the SiC substrate is epi-grown and prepared such that a doping concentration and a thickness of the N- drift layer 704 are selected primarily based on blocking voltage and forward conduction loss. The N+ substrate 702 is highly conductive when compared to the N- drift layer 704 and the N+ substrate 702 is in direct contact with the N- drift layer 704. A first patterned hard mask layer 705 is formed on top of the SiC substrate as shown in FIG. 54B. The first patterned hard mask layer 705 is thick enough for completely blocking high energy impurities during implantation. In an embodiment, the first patterned hard mask layer 705 is a hard mask of at least one of oxide, nitride, and polysilicon.

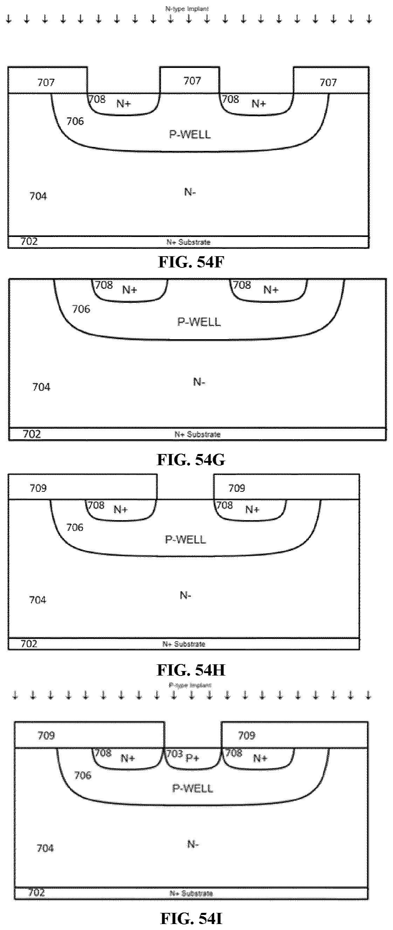

A first p-type ion implantation is formed in FIG. 54C through the first patterned hard mask layer 705 to form a p-well region 706. In an embodiment, the first p-type ion implantation is performed with one or more p-type impurities (e.g., aluminum, boron, etc.). In another embodiment, first p-type ion implantation may comprise a screen oxide layer. The first patterned hard mask layer 705 is then removed, after the first p-type ion implantation, by at least one of dry etching process and wet etching process as shown in FIG. 54D. A second patterned hard mask layer 707 is then formed on the top of the SiC substrate as shown in FIG. 54E for subsequent ion implantation. The second patterned hard mask layer 707 is a photoresist based material and thick enough for preventing any unwanted high energy impurities particles penetrating the second patterned hard mask layer 707. A first n-type ion implantation is formed through the second patterned hard mask layer 707 to form a N+ source region 708 within the p-well region 706 as shown in FIG. 54F. In an embodiment, the first n-type ion implantation is performed with one or more n-type impurities (e.g., nitrogen, phosphorous etc.). The second patterned hard mask layer 707 is then removed after the first n-type ion implantation by at least one of dry etching and wet etching process as shown in FIG. 54G.

A third patterned hard mask layer 709 is then formed on top of the SiC substrate as shown in FIG. 54H. A second p-type implantation is performed through the third patterned hard mask layer 709 to form a P+ region 703 within the p-well region 706 as shown in FIG. 54I.

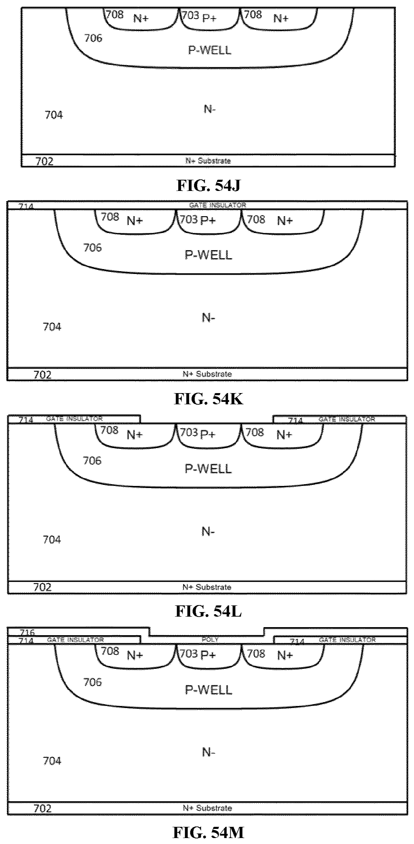

The third patterned hard mask layer 709 is then removed as shown in FIG. 54J by at least one of a dry etching and a wet etching process once the P+ region 703 is formed. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

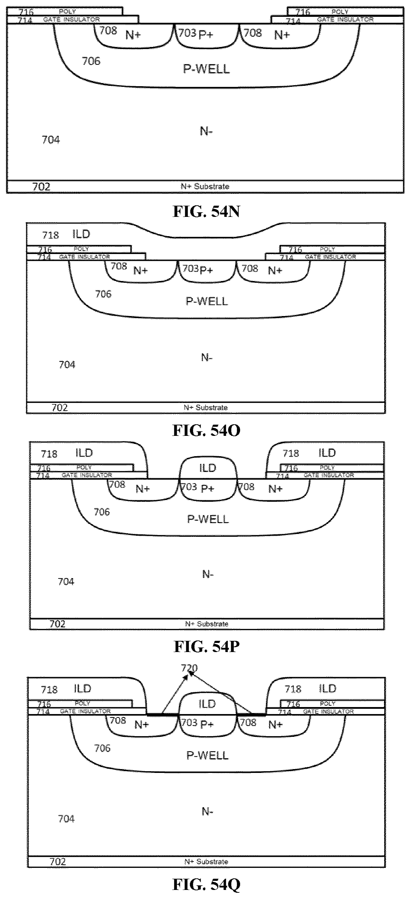

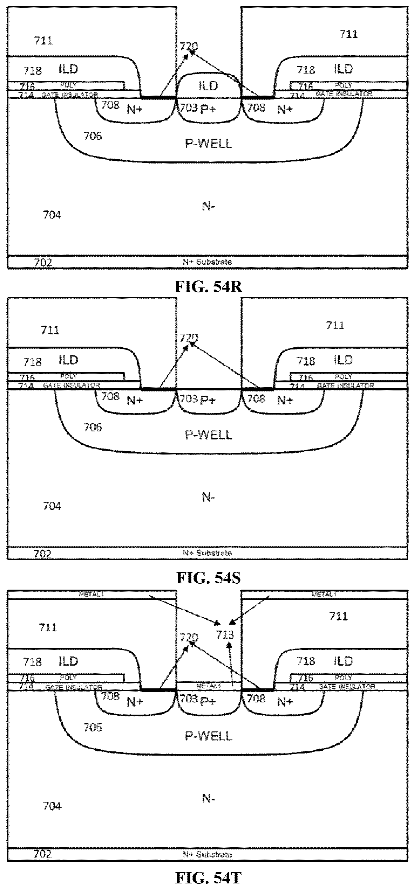

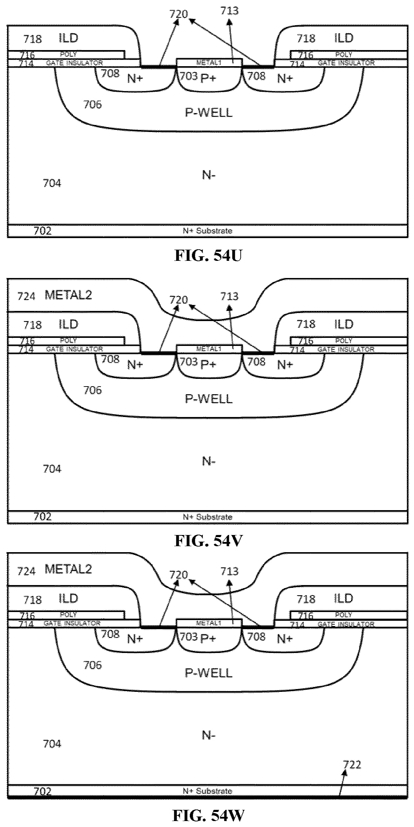

A gate insulator 714 is then formed on top of the SiC substrate as shown in FIG. 54K. The gate insulator is then patterned as shown in FIG. 54L. A polysilicon layer 716 is then formed on top of the SiC substrate as shown in FIG. 54M. The polysilicon layer 716 is then patterned as shown in FIG. 54N. Contacts for the polysilicon layer are kept open for pad metal deposition for forming a gate pad region and one or more gate bus regions. An interlayer dielectric (ILD) 718 is then formed on top of the SiC substrate as shown in FIG. 54O. The interlayer dielectric (ILD) 718 is then patterned for exposing the portions of the SiC substrate via the openings of the ILD 718 as shown in FIG. 54P. A first silicide layer 720 is then formed on the exposed portions of top of the SiC substrate for forming a first Ohmic contact as shown in FIG. 54Q. In an embodiment, the first silicide layer 720 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A fourth patterned hard mask layer 711 is formed on top of the SiC substrate as shown in FIG. 54R. An ILD etching is formed on the SiC substrate through the fourth patterned hard mask layer 711 to selectively remove the exposed portions of the ILD layer 718 as shown in FIG. 54S. A first metal is deposited on top of the SiC substrate through the fourth patterned hard mask layer 711 as shown in FIG. 54T. The first metal is lifted off and annealed to form a first metal region 713 (e.g., the first Schottky metal region 713) to be in direct contact with the P+ region 703 as shown in FIG. 54U. The first Schottky metal region 713 comprises a target work function. In an embodiment, the target work function may range from 3.5 electron volts to 6 electron volts. The first Schottky metal region 713 is then annealed with a predefined thermal budget for forming a first Schottky contact region between the first Schottky metal region 713 and the top of each P+ region 703. In an embodiment, the predefined thermal budget ranges from 55°C to 1100°C. The thermal budget for forming the first Schottky contact region is precisely designed and controlled as it directly impacts electrical properties of the first Schottky contact regions. A first pad metal 724 is formed on top of the SiC substrate as shown in FIG. 54V.

A second silicide layer 722 is then formed on bottom of the SiC substrate for forming a second Ohmic contact as shown in FIG. 54W. In an embodiment, the second silicide layer 722 is then formed on back of the SiC substrate for forming the second Ohmic contact (e.g., a drain terminal contact). In an embodiment, the second silicide layer 722 is the nickel-based silicide layer. A second pad metal 726 is then formed on bottom of the second silicide layer 722 of the SiC substrate. In an embodiment, the second pad metal formation is performed by at least one of e-beam and sputtering.

A fifth patterned hard mask layer 715 is then formed on the SiC substrate once the first Ohmic contact and the second Ohmic contact are formed on topside and bottom side/back side of the SiC substrate respectively. The fifth patterned hard mask layer 715 is formed for selectively removing the exposed portions of the ILD layer 718 and depositing a second metal region 728 (i.e., a second Schottky metal region 728) (shown in FIG. 52B) on top of the SiC substrate. The fifth patterned hard mask layer 715 is used for both etching the portion of the ILD layer 718 and lifting off the second Schottky metal region 728 when second Schottky metal is deposited. The second Schottky metal region 728 is in direct contact with the N- drift layer 704 and bridge two adjacent P-well regions 706 (i.e., bridges the adjacent unit cells). The second Schottky metal region 728 is then annealed with a predefined thermal budget for forming a second Schottky metal contact between the second Schottky metal region 728 and the portion of the N- drift layer 704 exposed at the top surface of the SiC substrate. In an embodiment, the predefined thermal budget ranges from 55°C to 1100°C. In fig. 53B the first pad metal and the second pad metal formation are performed once the second Schottky metal region 728 formation is completed.

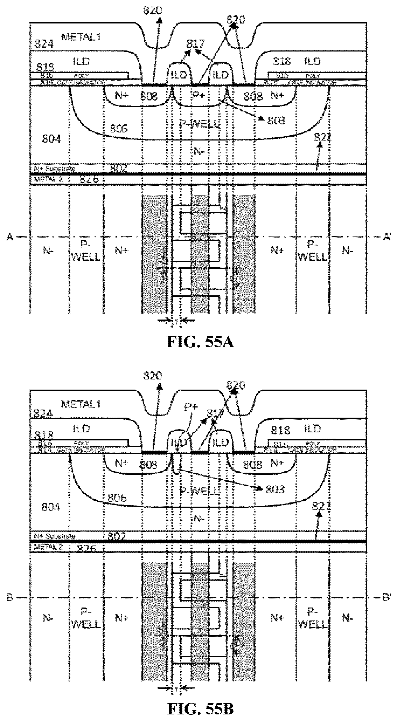

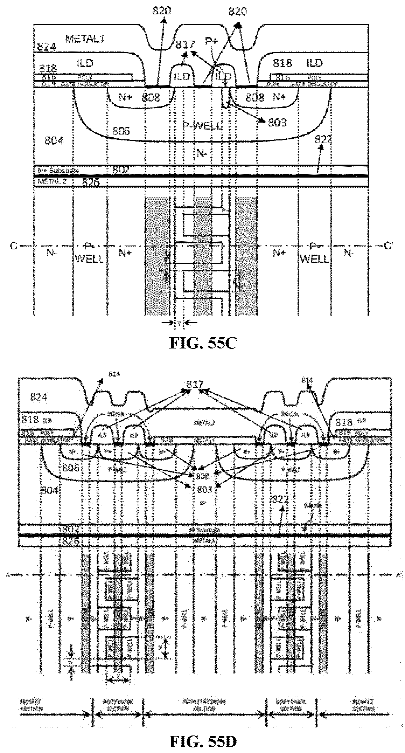

FIG. 55A, 55B & 55C illustrate an embodiment of cross-sectional structures of a unit cell of a DMOSFET comprising a second conductivity type well contact region that meanders at three different locations respectively. The DMOSFET shown in FIG. 55A, 55B and 55C is a n-type planar gate SiC DMOSFET. In an embodiment, the DMOSFET is a p-type planar gate DMOSFET. In another embodiment, the DMOSFET is a n-type trench gate DMOSFET. In yet another embodiment, the DMOSFET is a p-type trench gate DMOSFET. The DMOSFET (shown in FIG. 55A, 55B and 55C) comprises a Silicon Carbide (SiC) substrate. The SiC substrate comprises a N+ substrate 802 and a N- drift layer 804. The DMOSFET also comprises a P-well region 806, a N+ source region 808 and a P+ region 803 (i.e., the second conductivity type well contact region). The N+ source region 808 (i.e., a first conductivity type source region) is formed within the P-well region 806. The P+ region 803 is meandering within the P-well region 806 by performing a p-type implantation at respective locations. The P+ region 803 comprise a periodic spacing with the successive P+ region 803 (i.e., non-contiguous). Further the lateral extent of the P+ region 803 varies with a non-zero value in a direction orthogonal to the unit cell. The meandering P+ region 803 periodically forms ohmic contacts to a first pad metal 824 (e.g., a source metal) via a first silicide layer 820 between two interlayer dielectric (ILD) bumps 817 located between metal oxide semiconductor gate stack and the first pad metal 824. The meandering P+ region 803 follows Zigzag path, where corners of the zigzag path is right angled. The Zigzag path of the meandering P+ region 803 comprises dimensions $\alpha$, $\beta$, and $\gamma$. The meandering P+ region 803 comprise a target size and are a target spacing between adjacent junction points located between the meandering P+ region 803. Contact resistance to the first pad metal 824 (e.g., the source metal) varies when the P+ region 803 under the ILD bumps 817 do not have direct contact with the first pad metal 824 and when the P+ region 803 have direct contact with the first pad metal 824 through the first silicide layer 820. The portions of the meandering P+ region 803 which are directly under the ILD bumps 817 functions as networks of distributed ballast resistors and provides an additional source resistance to the source contact resistance. The additional contact resistance provided directly impacts the differential on-resistance of one or more body diode regions of the DMOSFET. The impacted differential-on resistance of the body diode regions suppresses increase of forward conduction current of the one or more body diode regions. The limited forward conduction current mitigates basal plane dislocation (BPD). Since the source contact resistance is dependent on the sizing, the spacing between adjacent junction points located between the meandering P+ region 803, and the silicide region between the adjacent ILD bumps 817, the source contact resistance is tuned by sizing the P+ region 803 to a target size and controlling the spacing to a target spacing. In an embodiment, the target size ranges from 10 nm to 10 $\mu$m. In another embodiment, the target spacing ranges from 10 nm to 10 $\mu$m. Say for a first instance, when width ($\alpha$) of the meandering P+ region 803 is reduced, the resistance of each ballast resistor network is increased which degrades the differential on-resistance of the one or more body diode regions. The reduction of the width ($\alpha$), also shrinks the area where the Ohmic contacts are formed, degrades the differential on-resistance of the one or more body diode regions. Say for a second instance, when the periodic spacing ($\gamma$) between the meandering P+ region 803 is increased, the resistance of each ballast resistor network is increased which degrades the differential on-resistance of the one or more body diode regions. Say for a third instance, when spacing ($\beta$) between two adjacent junction points between the meandering featured P+ region 803, and the straight silicide region between two adjacent ILD bumps 817 is increased, the resistance of each ballast resistor network is increased which degrades the differential on-resistance of the one or more body diode regions.

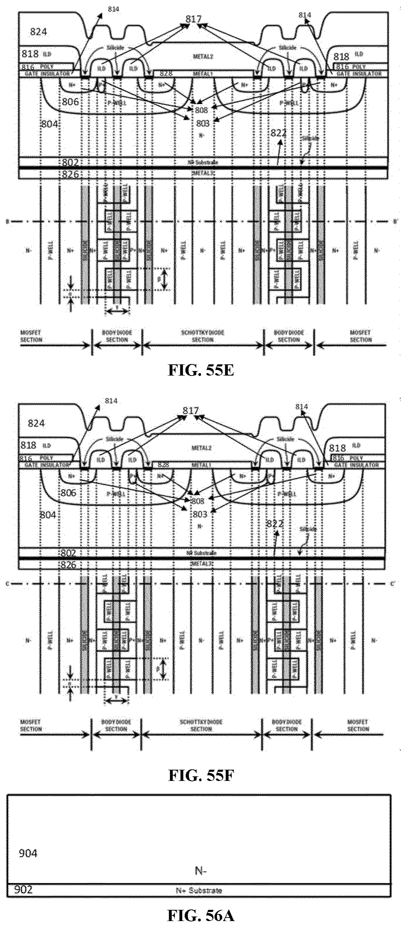

**FIG. 55D, 55E & 55F** illustrate an embodiment of cross-sectional structures of one or more unit cells of a diode integrated DMOSFET, each DMOSFET unit cell comprising the second conductivity type well contact region that meanders at three different locations respectively. The DMOSFET (shown in FIG. 55D, 55E & 55F) is a n-type planar gate SiC DMOSFET. The DMOSFET shown in FIG. 55D, 55E & 55F operates in a similar way to FIG. 55A, 55B & 55C. In addition to FIG. 55A, 55B & 55C, the DMOSFET (shown in FIG. 55D, 55E & 55F) comprises a metal region (i.e., a Schottky metal region 828) in direct contact with the N- drift layer 804 and bridges adjacent P-well regions 806 of the one or more P-well regions 806 (i.e., bridges the adjacent unit cells). The DMOSFET comprises the P+ region 803 that meanders within each P-well region 806.

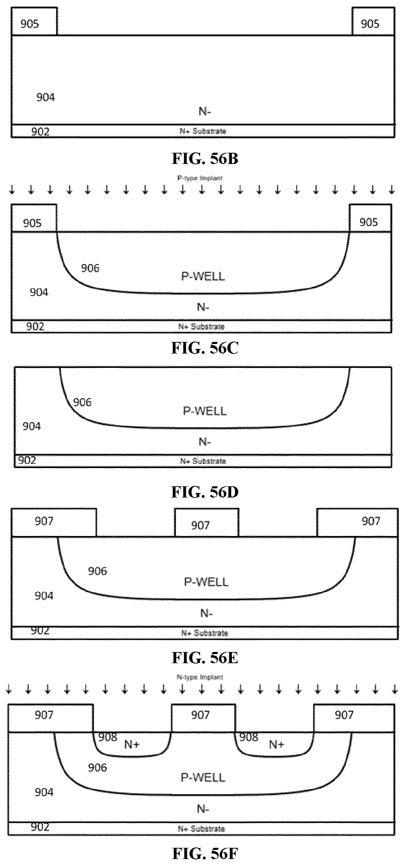

**FIG. 56A to 56T** illustrate an embodiment of a process of manufacturing the DMOSFET structure shown in FIG. 55A. The process of manufacturing the DMOSFET structure (shown in FIG. 56A) comprises preparing a Silicon Carbide (SiC) substrate having a N+ substrate 902 and a N- drift layer 904 as shown in FIG. 56A. The N- drift layer 904 of the SiC substrate is epi-grown and prepared such that a doping concentration and a thickness of the N- drift layer 904 are selected primarily based on blocking voltage and forward conduction loss. The N+ substrate 902 is highly conductive when compared to the N- drift layer 904 and the N+ substrate 902 is directly located under the N- drift layer 904. A first patterned hard mask layer 905 is formed on top of the SiC substrate as shown in FIG. 56B. The first patterned hard mask layer 905 is thick enough for completely blocking high energy impurities during implantation. In an embodiment, the first patterned hard mask layer 905 is a hard mask of at least one of oxide, nitride, and a polysilicon layer.

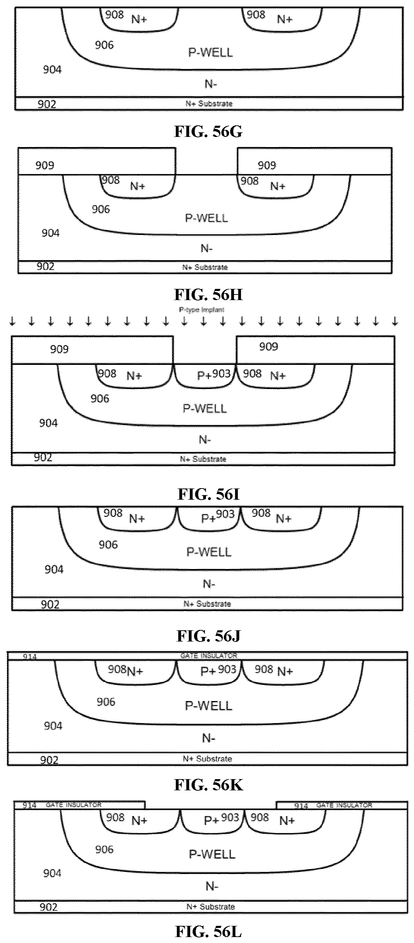

A first p-type ion implantation is formed in FIG. 56C through the first patterned hard mask layer 905 to form a p-well region 906. In an embodiment, the first p-type ion implantation is performed with one or more p-type impurities (e.g., aluminum, boron, etc.). In another embodiment, first p-type ion implantation may comprise a screen oxide layer. The first patterned hard mask layer 905 is then removed, after the first p-type ion implantation, by at least one of dry etching process and wet etching process as shown in FIG. 56D. A second patterned hard mask layer 907 is then formed on the top of the SiC substrate as shown in FIG. 56E for subsequent ion implantation. The second patterned hard mask layer 907 is a photoresist based material and thick enough for preventing any unwanted high energy impurities particles penetrating the second patterned hard mask layer 907. A first n-type ion implantation is formed through the second patterned hard mask layer 907 to form a N+ source region 908 within the p-well region 906 as shown in FIG. 56F. In an embodiment, the first n-type ion implantation is performed with one or more n-type impurities (e.g., nitrogen, phosphorous etc.). The second patterned hard mask layer 907 is then removed after the first n-type ion implantation by at least one of dry etching and wet etching process as shown in FIG. 56G.

A third patterned hard mask layer 909 is then formed on top of the SiC substrate as shown in FIG. 56H. A second p-type implantation is performed through the third patterned hard mask layer 909 to form a P+ region 903, at a first location within the p-well region 906 as shown in FIG. 56I.

The third patterned hard mask layer 909 is then removed as shown in FIG. 56J by at least one of a dry etching and a wet etching process once the P+ region 903 is formed. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

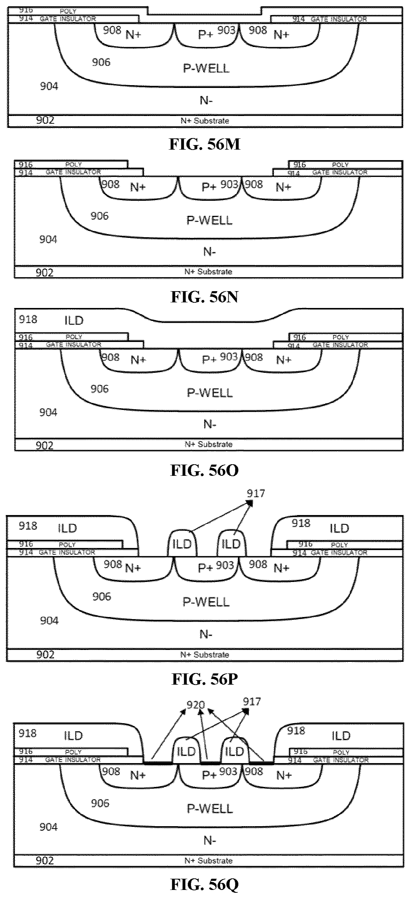

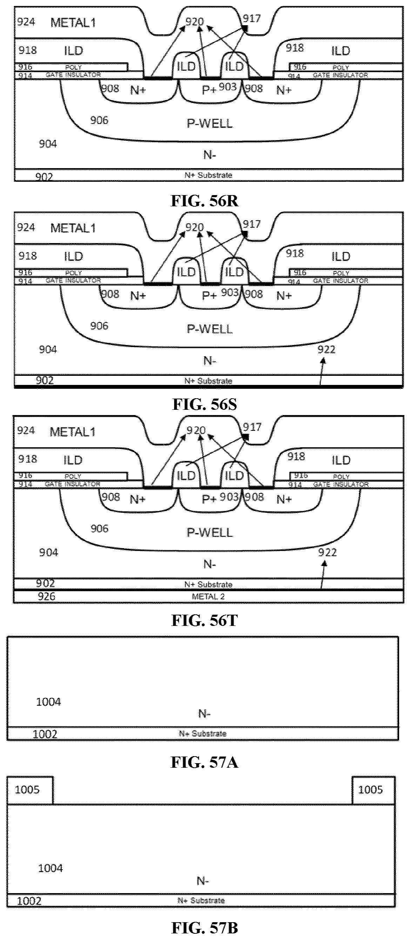

A gate insulator 914 is then formed on top of the SiC substrate as shown in FIG. 56K. The gate insulator 914 is then patterned as shown in FIG. 56L. A polysilicon layer 916 is then formed on top of the SiC substrate as shown in FIG. 56M. The polysilicon layer 916 is then patterned as shown in FIG. 56N. Contacts for the polysilicon layer are kept open for pad metal deposition for forming a gate pad region and one or more gate bus regions. An interlayer dielectric (ILD) 918 is then formed on top of the SiC substrate as shown in FIG. 56O. The interlayer dielectric (ILD) 918 is then patterned for exposing the portions of the SiC substrate via the openings of the ILD 918 and leaving one or more ILD bumps 917 as shown in FIG. 56P. A first silicide layer 920 is then formed between the one or more ILD bumps 917 on the exposed portions of top of the SiC substrate for forming a first Ohmic contact as shown in FIG. 56Q. In an embodiment, the first silicide layer 920 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 924 is formed on top of the SiC substrate as shown in FIG. 56R. The P+ region 903, formed at the first location, covers both portions of the first silicide layer 920 between the adjacent ILD bumps 917 and the portions under the ILD bumps 917.

A second silicide layer 922 is then formed on bottom of the SiC substrate for forming a second Ohmic contact as shown in FIG. 56S. In an embodiment, the second silicide layer 922 is then formed on back of the SiC substrate for forming the second Ohmic contact. In an embodiment, the second silicide layer 922 is also the nickel-based silicide layer. A second pad metal 926 is then formed on bottom of the second silicide layer 922 of the SiC substrate as shown in FIG. 56T. In an embodiment, the second pad metal formation is performed by at least one of e-beam and sputtering.

A fourth patterned hard mask layer 911 is then formed on the SiC substrate once the first Ohmic contact and the second Ohmic contact are formed on topside and bottom side/back side of the SiC substrate respectively. The fourth patterned hard mask layer 911 is formed for selectively removing the exposed portions of the ILD layer 918 and depositing a metal region (i.e., a Schottky metal region 928) (shown in FIG. 55D, 55E & 55F) on top of the SiC substrate. The fourth patterned hard mask layer 911 is used for both etching the portion of the ILD layer 918 and lifting off the Schottky metal region 928 when Schottky metal is deposited. The Schottky metal region 928 is in direct contact with the N- drift layer 904 and bridge two adjacent P-well regions 906 (i.e., bridges the adjacent unit cells). The Schottky metal region 928 is then annealed with a predefined thermal budget for forming a Schottky metal contact between the Schottky metal region 928 and the portion of the N- drift layer 904 exposed at the top surface of the SiC substrate. In an embodiment, the predefined thermal budget ranges from 55°C to 1100°C. In fig. 55D, 55E & 55F, the first pad metal and the second pad metal formation are performed once the Schottky metal region 928 formation is completed.

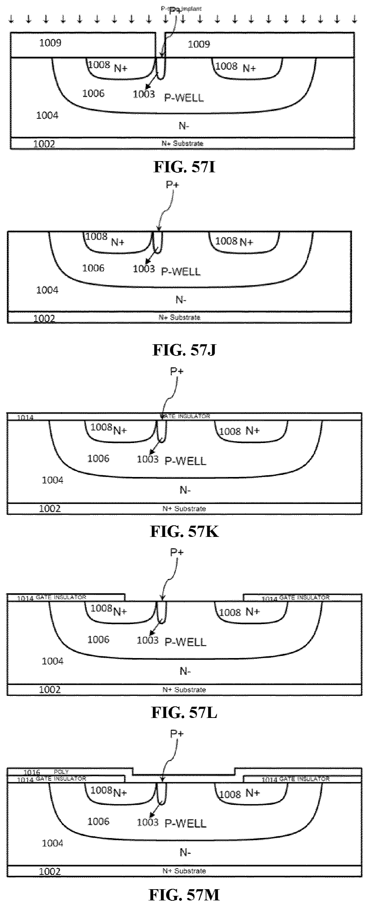

FIG. 57A to 57T illustrate an embodiment of a process of manufacturing the DMOSFET structure shown in FIG. 55B. The process of manufacturing the DMOSFET structure (shown in FIG. 57A) comprises preparing a silicon carbide (SiC) substrate having a N+ substrate 1002 and a N- drift layer 1004 as shown in FIG. 57A. The N- drift layer 1004 of the SiC substrate is epi-grown and prepared such that a doping concentration and a thickness of the N- drift layer 1004 are selected primarily based on blocking voltage and forward conduction loss. The N+ substrate 1002 is highly conductive when compared to the N- drift layer 1004 and the N+ substrate 1002 is in direct contact with the N- drift layer 1004. A first patterned hard mask layer 1005 is formed on top of the SiC substrate as shown in FIG. 57B. The first patterned hard mask layer 1005 is thick enough for completely blocking high energy impurities during implantation. In an embodiment, the first patterned hard mask layer 1005 is a hard mask of at least one of oxide, nitride, and a polysilicon layer.

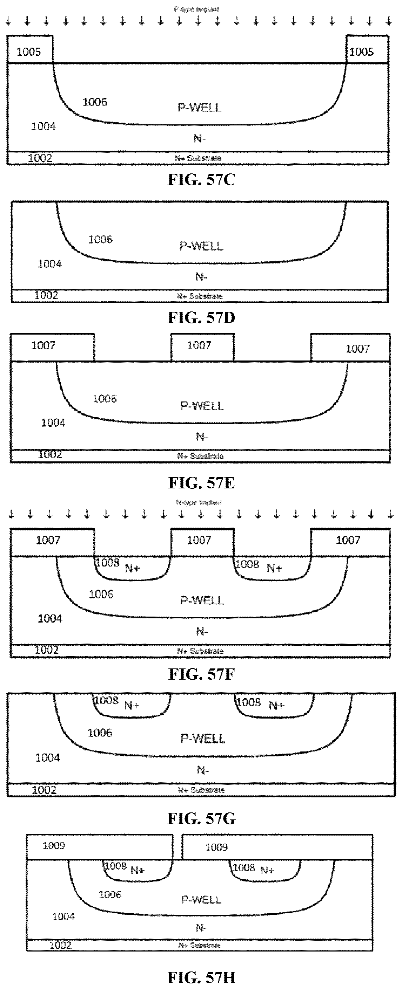

A first p-type ion implantation is formed in FIG. 57C through the first patterned hard mask layer 1005 to form a p-well region 1006. In an embodiment, the first p-type ion implantation is performed with one or more p-type impurities (e.g., aluminum, boron, etc.). In another embodiment, first p-type ion implantation may comprise a screen oxide layer. The first patterned hard mask layer 1005 is then removed, after the first p-type ion implantation, by at least one of dry etching process and wet etching process as shown in FIG. 57D. A second patterned hard mask layer 1007 is then formed on the top of the SiC substrate as shown in FIG. 57E for subsequent ion implantation. The second patterned hard mask layer 1007 is a photoresist based material and thick enough for preventing any unwanted high energy impurities particles penetrating the second patterned hard mask layer 1007. A first n-type ion implantation is formed through the second patterned hard mask layer 1007 to form a N+ source region 1008 within the p-well region 1006 as shown in FIG. 57F. In an embodiment, the first n-type ion implantation is performed with one or more n-type impurities (e.g., nitrogen, phosphorous etc.). The second patterned hard mask layer 1007 is then removed after the first n-type ion implantation by at least one of dry etching and wet etching process as shown in FIG. 57G.

A third patterned hard mask layer 1009 is then formed on top of the SiC substrate as shown in FIG. 57H. A second p-type implantation is performed through the third patterned hard mask layer 1009 to form a P+ region 1003, at a second location, within the p-well region 1006 as shown in FIG. 57I.

The third patterned hard mask layer 1009 is then removed as shown in FIG. 57J by at least one of a dry etching and a wet etching process once the P+ region 1003 is formed at the second location. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

A gate insulator 1014 is then formed on top of the SiC substrate as shown in FIG. 57K. The gate insulator 1014 is then patterned as shown in FIG. 57L. A polysilicon layer 1016 is then formed on top of the SiC substrate as shown in FIG.

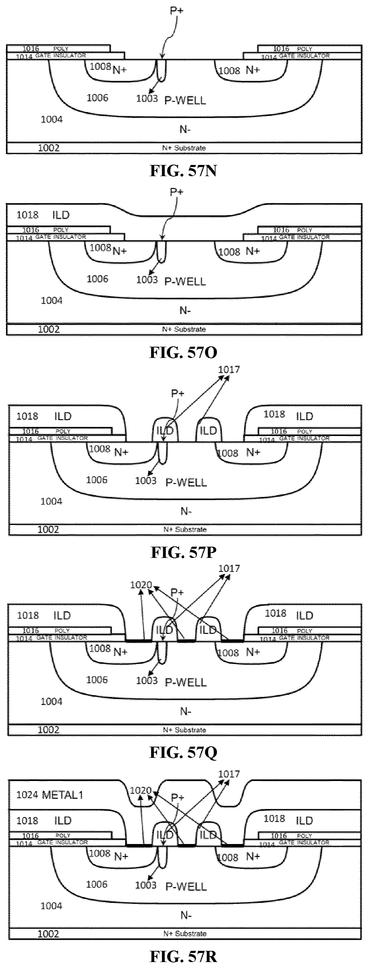

57M. The polysilicon layer 1016 is then patterned as shown in FIG. 57N. Contacts for the polysilicon layer are kept open for pad metal deposition for forming a gate pad region and one or more gate bus regions. An interlayer dielectric (ILD) 1018 is then formed on top of the SiC substrate as shown in FIG. 57O. The interlayer dielectric (ILD) 1018 is then patterned for exposing the portions of the SiC substrate via the openings of the ILD 1018 and leaving one or more ILD bumps 1017 on top of the SiC substrate as shown in FIG. 57P. A first silicide layer 1020 is then formed between the one or more ILD bumps 1017 on the exposed portions of top of the SiC substrate for forming a first Ohmic contact as shown in FIG. 57Q. In an embodiment, the first silicide layer 1020 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 1024 is formed on top of the SiC substrate as shown in FIG. 57R. The P+ region 1003, formed at the second location, is under the one or more ILD bumps 1017 and do not form any direct contact with the first silicide layer 1020.

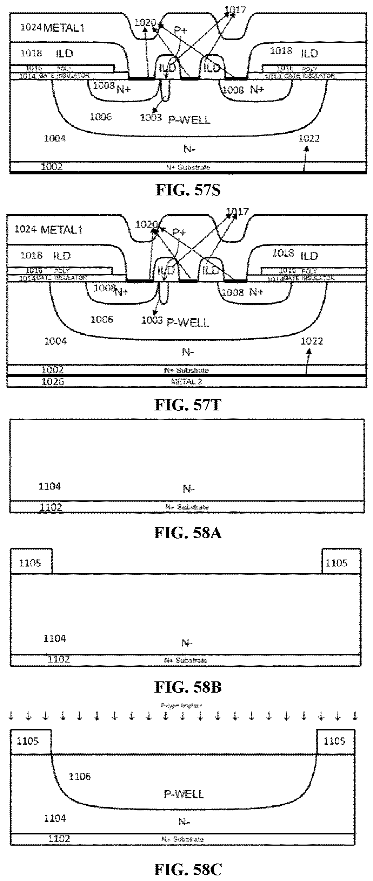

A second silicide layer 1022 is then formed on bottom of the SiC substrate for forming a second Ohmic contact as shown in FIG. 57S. In an embodiment, the second silicide layer 1022 is then formed on back of the SiC substrate for forming the second Ohmic contact. In an embodiment, the second silicide layer 1022 is also the nickel-based silicide layer. A second pad metal 1026 is then formed on bottom of the second silicide layer 1022 of the SiC substrate as shown in FIG. 57T. In an embodiment, the second pad metal formation is performed by at least one of e-beam and sputtering.

A fourth patterned hard mask layer 1011 is then formed on the SiC substrate once the first Ohmic contact and the second Ohmic contact are formed on topside and bottom side /back side of the SiC substrate respectively. The fourth patterned hard mask layer 1011 is formed for selectively removing the exposed portions of the ILD layer 1018 and depositing a metal region 1028 (e.g., a Schottky metal region 1028) (shown in FIG. 55D, 55E & 55F) on top of the SiC substrate. The fourth patterned hard mask layer 1011 is used for both etching the portion of the ILD layer 1018 and lifting off the Schottky metal region 1028 when Schottky metal is deposited. The Schottky metal region 1028 is in direct contact with the N- drift layer 1004 and bridge two adjacent P-well regions 1006 (i.e., bridges the adjacent unit cells). The Schottky metal region 1028 is then annealed with a predefined thermal budget for forming a Schottky metal contact between the Schottky metal region 1028 and the portion of the N- drift layer 1004 exposed at the top surface of the SiC substrate. In an embodiment, the predefined thermal budget ranges from 55°C to 1100°C. In fig. 55D, 55E & 55F, the first pad metal and the second pad metal formation are performed once the Schottky metal region 1028 formation is completed.

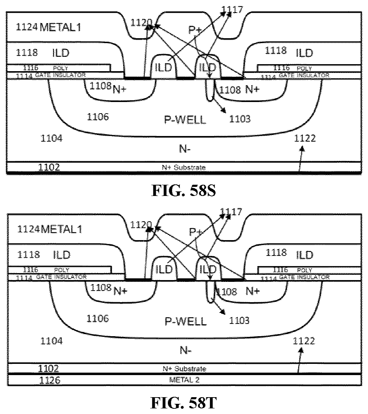

FIG. 58A to 58T illustrate an embodiment of a process of manufacturing the DMOSFET structure shown in FIG. 55C. The process of manufacturing the DMOSFET structure (shown in FIG. 58A) comprises preparing a silicon carbide (SiC) substrate having a N+ substrate 1102 and a N- drift layer 1104 as shown in FIG. 58A. The N- drift layer 1104 of the SiC substrate is epi-grown and prepared such that a doping concentration and a thickness of the N- drift layer 1104 are selected primarily based on blocking voltage and forward conduction loss. The N+ substrate 1102 is highly conductive when compared to the N- drift layer 1104 and the N+ substrate 1102 is in direct contact with the N- drift layer 1104. A first patterned hard mask layer 1105 is formed on top of the SiC substrate as shown in FIG. 58B. The first patterned hard mask layer 1105 is thick enough for completely blocking high energy impurities during implantation. In an embodiment, the first patterned hard mask layer 1105 is a hard mask of at least one of oxide, nitride, and a polysilicon layer.

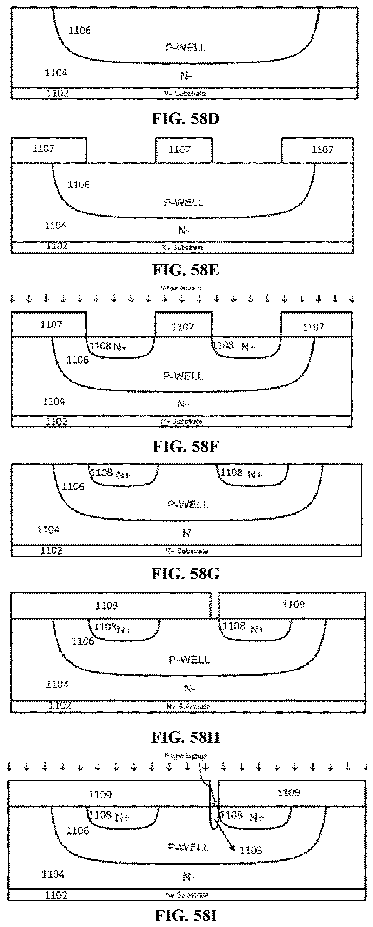

A first p-type ion implantation is formed in FIG. 58C through the first patterned hard mask layer 1105 to form a p-well region 1106. In an embodiment, the first p-type ion implantation is performed with one or more p-type impurities (e.g., aluminum, boron, etc.). In another embodiment, first p-type ion implantation may comprise a screen oxide layer. The first patterned hard mask layer 1105 is then removed, after the first p-type ion implantation, by at least one of dry etching process and wet etching process as shown in FIG. 58D. A second patterned hard mask layer 1107 is then formed on the top of the SiC substrate as shown in FIG. 58E for subsequent ion implantation. The second patterned hard mask layer 1107 is a photoresist based material and thick enough for preventing any unwanted high energy impurities particles penetrating the second patterned hard mask layer 1107. A first n-type ion implantation is formed through the second patterned hard mask layer 1107 to form a first N+ source region 1108 within the p-well region 1106 as shown in FIG. 58F. In an embodiment, the first n-type ion implantation is performed with one or more n-type impurities (e.g., nitrogen, phosphorous etc.). The second patterned hard mask layer 1107 is then removed after the first n-type ion implantation by at least one of dry etching and wet etching process as shown in FIG. 58G.

A third patterned hard mask layer 1109 is then formed on top of the SiC substrate as shown in FIG. 58H. A second p-type implantation is performed through the third patterned hard mask layer 1109 to form a P+ region 1103, at a third location, within the p-well region 1106 as shown in FIG. 58I.

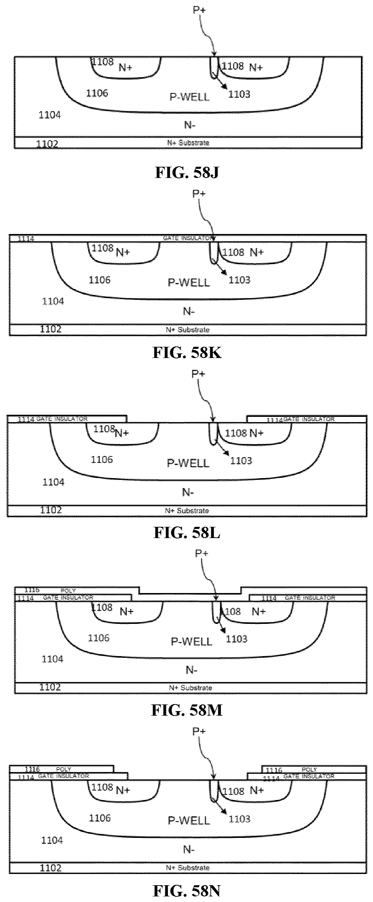

The third patterned hard mask layer 1109 is then removed as shown in FIG. 58J by at least one of a dry etching and a wet etching process once the P+ region 1103 is formed at the second location. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

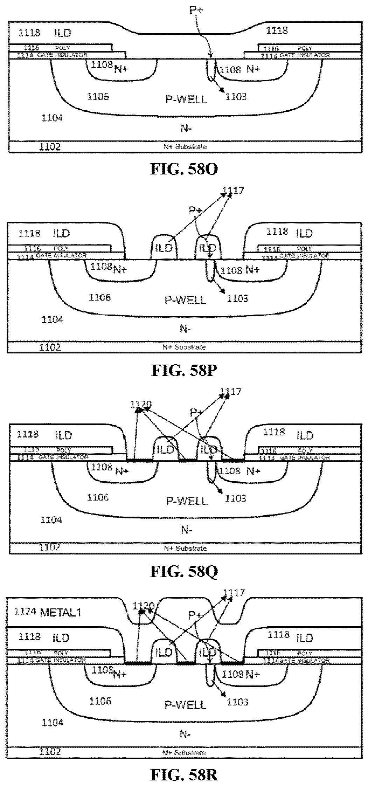

A gate insulator 1114 is then formed on top of the SiC substrate as shown in FIG. 58K. The gate insulator 1114 is then patterned as shown in FIG. 58L. A polysilicon layer 1116 is then formed on top of the SiC substrate as shown in FIG. 58M. The polysilicon layer 1116 is then patterned as shown in FIG. 58N. Contacts for the polysilicon layer are kept open for pad metal deposition for forming a gate pad region and one or more gate bus regions. An interlayer dielectric (ILD) 1118 is then formed on top of the SiC substrate as shown in FIG. 58O. The interlayer dielectric (ILD) 1118 is then patterned for exposing the portions of the SiC substrate via the openings of the ILD 1118 and leaving one or more ILD bumps 1117 on top of the SiC substrate as shown in FIG. 58P. A first silicide layer 1120 is then formed between the one or more ILD bumps 1117 on the exposed portions of top of the SiC substrate for forming one or more first Ohmic contacts as shown in FIG. 58Q. In an embodiment, the first silicide layer 1120 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 1124 is formed on top of the SiC substrate as shown in FIG. 58R. The P+ region 1103, formed at the third location, is under the one or more ILD bumps 1117 and do not form any direct contact with the first silicide layer 1120.

A second silicide layer 1122 is then formed on bottom of the SiC substrate for forming a second Ohmic contact as shown in FIG. 58S. In an embodiment, the second silicide layer 1122 is then formed on back of the SiC substrate for forming the second Ohmic contact. In an embodiment, the second silicide layer 1122 is also the nickel-based silicide layer. A second pad metal 1126 is then formed on bottom of the second silicide layer 1122 of the SiC substrate. In an embodiment, the second pad metal formation is performed by at least one of e-beam and sputtering.

A fourth patterned hard mask layer 1111 is then formed on the SiC substrate once the first Ohmic contact and the second Ohmic contact are formed on topside and bottom side/back side of the SiC substrate respectively. The fourth patterned hard mask layer 1111 is formed for selectively removing the exposed portions of the ILD layer 1118 and depositing a metal region 1128 (i.e., a Schottky metal region 1128) shown in FIG. 55D, 55E & 55F on top of the SiC substrate. The fourth patterned hard mask layer 1111 is used for both etching the portion of the ILD layer 1118 and lifting off the Schottky metal region 1128 when Schottky metal is deposited. The Schottky metal region 1128 is in direct contact with the top of the N- drift layer 1104 and bridge two adjacent P-well regions 1106 (i.e., bridges the adjacent unit cells). The Schottky metal region 1128 is then annealed with a predefined thermal budget for forming a Schottky metal contact between the Schottky metal region 1128 and the portion of the N- drift layer 1104 exposed at the top surface of the SiC substrate. In an embodiment, the predefined thermal budget ranges from 55°C to 1100°C. In fig. 55D, 55E & 55F, the first pad metal and the second pad metal formation are performed once the Schottky metal region 1128 formation is completed.

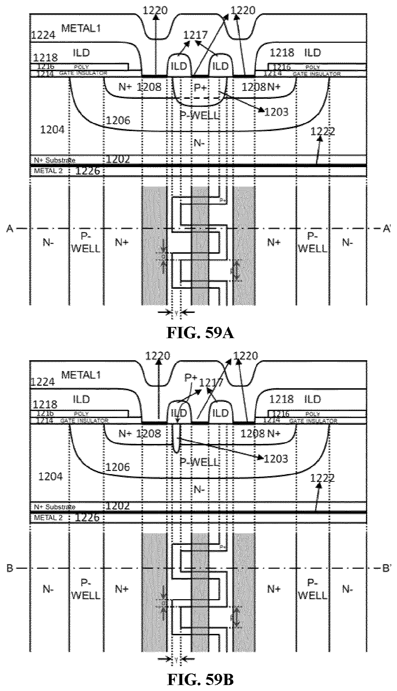

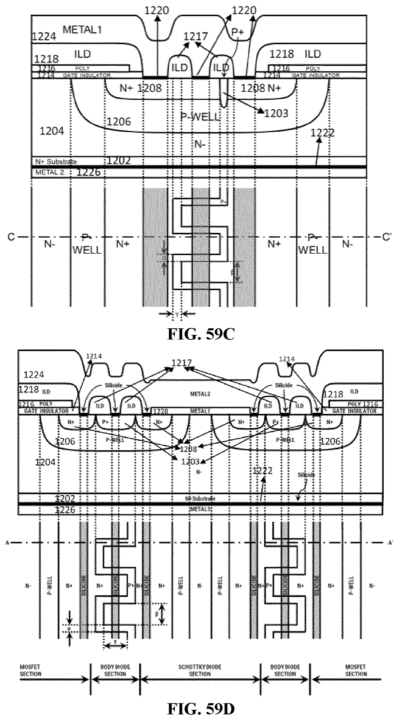

FIG. 59A, 59B & 59C illustrate an embodiment of cross sectional structures of a unit cell of a double-implantation metal oxide semiconductor field effect transistor (DMOSFET) comprising a second conductivity type well contact region that meanders at three different locations respectively, allowing a second conductivity type well region to be in contact with a source metal only through the second conductivity type well contact region. The DMOSFET shown in FIG. 59A, 59B and 59C is a n-type planar gate SiC DMOSFET. In an embodiment, the DMOSFET is a p-type planar gate DMOSFET. The DMOSFET (shown in FIG. 59A, 59B and 59C) comprises a Silicon Carbide (SiC) substrate. The SiC substrate comprises a N+ substrate 1202 and a N- drift layer 1204. The DMOSFET also comprises a P-well region 1206, a N+ source region 1208 and a P+ region 1203 (i.e., the second conductivity type well contact region). The N+ source regions 1208 is formed within the P-well region 1206. The P+ region 1203 is meandering within the P-well region 1206 by performing a p-type implantation. The P+ region 1203 comprise a periodic spacing with the successive P+ region 1203 (i.e., non-contiguous). Further the lateral extent of the P+ region 1203 varies with a non-zero value in a direction orthogonal to the unit cell. The meandering P+ region 1203 periodically forms ohmic contacts to a first pad metal 1224 (e.g., the source metal) via a first silicide layer 1220 between two interlayer dielectric (ILD) bumps 1217 located between metal oxide semiconductor gate stack and the first pad metal 1224. The P-well region 1206 contacts with the first pad metal 1224 (e.g., the source metal) only through the meandering P+ region 1203. The P-well region 1206 do not have a direct contact with the first pad metal 1224. The meandering P+ region 1203 follows Zigzag path, where corners of the zigzag path is right angled. The Zigzag path of the meandering P+ region 1203 comprises dimensions $\alpha$, $\beta$, and $\gamma$. The meandering P+ region 1203 comprise a target size and a target spacing between adjacent junction points located between the meandering P+ region 803. Contact resistance to the first pad metal 1224 (e.g., the source metal) varies when the P+ region 1203 under the ILD bumps 1217 do not have direct contact with the first pad metal 1224 and when the P+ region 1203 have direct contact with the first pad metal 1224 through the first silicide layer 1220. The portions of the meandering P+ region 1203 which are directly under the ILD bumps 1217 functions as networks of distributed ballast resistors and provides an additional source resistance to the source contact resistance. The additional contact resistance provided directly impacts the differential on-resistance of one or more body diode regions of the DMOSFET. Since, the p-well region 1206 contacts the first pad metal 1224 only through the meandering P+ region 1203, flow of carriers is confined within the meandering P+ region 1203. The confined flow of carriers increases source contact resistance of each ballast resistor network and further impacts differential on-resistance of the one or more body diode regions of the DMOSFET. Since the source contact resistance is dependent on the sizing, the spacing between adjacent junction points located between the meandering P+ region 1203, and the silicide region between the adjacent ILD bumps 1217, the source contact resistance is tuned by sizing the P+ region 1203 to a target size and controlling the spacing to a target spacing. In an embodiment, the target size ranges from 10 nm to 10 $\mu$m. In another embodiment, the target spacing ranges from 10 nm to 10 $\mu$m. Say for a first instance, when width ($\alpha$) of the meandering P+ region is reduced, the resistance of each ballast resistor network is increased which degrades the differential on-resistance of the body diode regions. The reduction of the width ($\alpha$) also shrinks the area where the Ohmic contacts are formed so degrades the differential on-resistance of the body diode regions. Say for a second instance, when spacing ($\gamma$) between the meandering P+ region is increased, the resistance of each ballast resistor network is increased which degrades the differential on-resistance of the body diode regions. Say for a third instance, when spacing ($\beta$) between two adjacent junction points between the meandering featured P+ region 1203, and the straight silicide region between two adjacent ILD bumps 1217 is increased, the resistance of each ballast resistor network is increased which degrades the differential on-resistance of the one or more body diode regions.

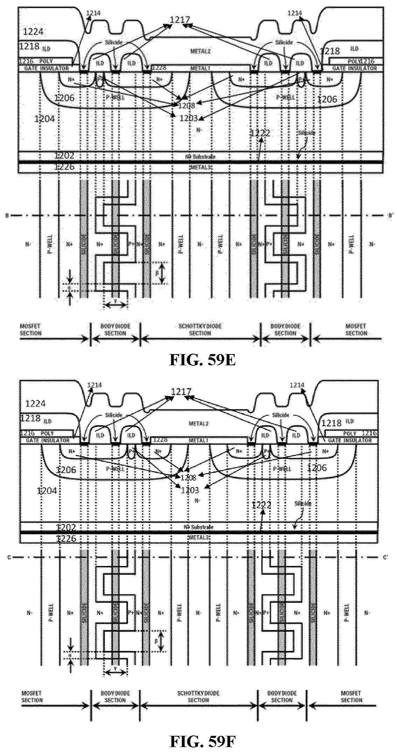

**FIG. 59D, 59E & 59F** illustrate an embodiment of cross sectional structures of one or more unit cells of a diode integrated DMOSFET, each DMOSFET unit cell comprising the second conductivity type well contact region that meanders at three different locations respectively, allowing the second conductivity type well region to be in contact with the source metal only through the second conductivity type well contact region. The DMOSFET (shown in FIG. 59D, 59E & 59F) is a n-type planar gate SiC DMOSFET. The DMOSFET shown in FIG. 59D, 59E & 59F operates in a similar way to FIG. 59A, 59B & 59C. In addition to FIG. 59A, 59B & 59C, the DMOSFET (shown in FIG. 59D, 59E & 59F) comprises a metal region 1228 (e.g., a Schottky metal region 1228) in direct contact with the N- drift layer 1204 and bridges adjacent P-well regions 1206 of the one or more P-well regions 1206 (i.e., bridges the adjacent unit cells).

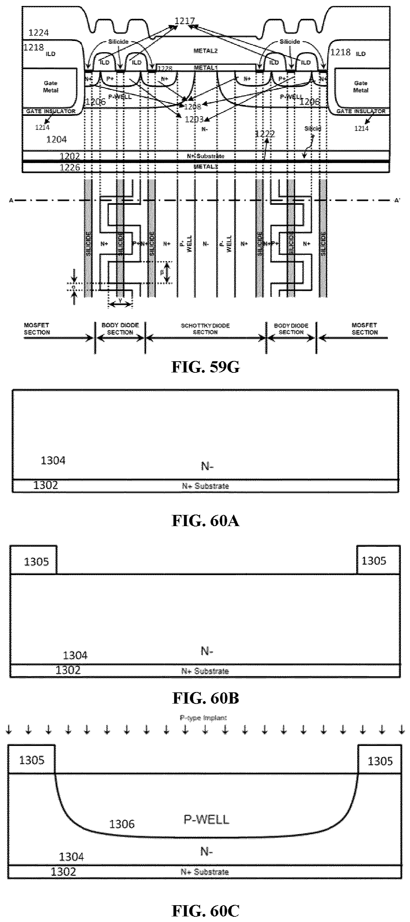

**FIG. 59G** illustrate an embodiment of a cross sectional structure of one or more unit cells of a diode integrated trench gate MOSFET, comprising one or more unit cells of an integrated Schottky diode, each MOSFET unit cell comprising the second conductivity type well contact region at the first location, allowing the second conductivity type well region to be in contact with the source metal only through the second conductivity type well contact region. The trench gate MOSFET shown in FIG. 59G is a n-type trench gate SiC MOSFET. In an embodiment, the trench gate MOSFET is a p-type trench gate SiC MOSFET. The trench gate MOSFET shown in FIG. 59G operates in a similar way to planar gate MOSFET shown in FIG. 59A and FIG. 59D. The main difference between the trench gate MOSFET and the planar gate DMOSFET is that the trench gate MOSFET comprises one or more trench gate structures instead of one or more planar gate structures. The one or more trench gate structures of the trench gate MOSFET comprises sidewalls that are exposed to the first N+ source region 1208 and the one or more P-well regions 1206. The bottom of the one or more trench gate structures is in vicinity of the bottom of the one or more P-well regions 1206. In an embodiment, the bottom of the one or more trench gate structures is adjusted appropriately depending on electrical properties of the MOSFET device. Each trench gate structure of the trench gate MOSFET comprises a gate insulator as liner along the sidewall and the bottom of the respective trench gate structure. The trench gate MOSFET also comprises the polysilicon layer that fills each gate-insulator lined trenches and serves as gate electrode. The trench gate MOSFET further comprises the interlayer dielectric (ILD) 1218 over each polysilicon layer to open short circuitry between the first pad metal 1224 (e.g., the source metal) and the gate electrode.

**FIG. 60A to 60T** illustrate an embodiment of a process of manufacturing the DMOSFET structure shown in FIG. 59A. The process of manufacturing the DMOSFET structure (shown in FIG. 60A) comprises preparing a silicon carbide (SiC) substrate having a N+ substrate 1302 and a N- drift layer 1304 as shown in FIG. 60A. The N- drift layer 1304 of the SiC substrate is epi-grown and prepared such that a doping concentration and a thickness of the N- drift layer 1304 are selected primarily based on blocking voltage and forward conduction loss. The N+ substrate 1302 is highly conductive when compared to the N- drift layer 1304 and the N+ substrate 1302 is directly located under the N- drift layer 1304. A first patterned hard mask layer 1305 is formed on top of the SiC substrate as shown in FIG. 60B. The first patterned hard mask layer 1305 is thick enough for completely blocking high energy impurities during implantation. In an embodiment, the first patterned hard mask layer 1305 is a hard mask of at least one of oxide, nitride, and a polysilicon layer.

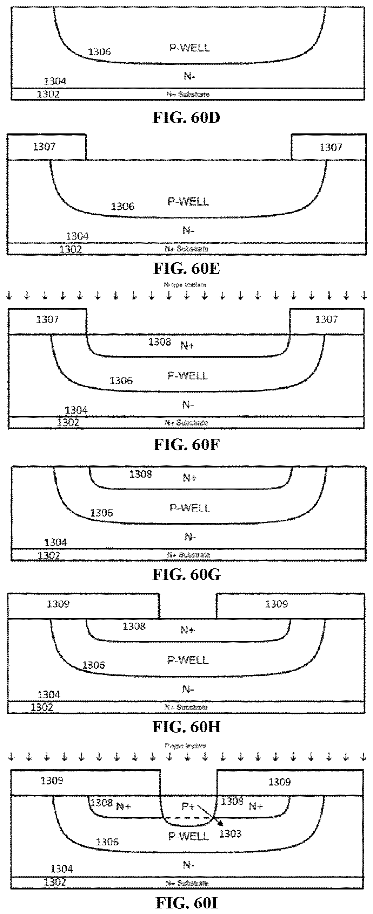

A first p-type ion implantation is formed in FIG. 60C through the first patterned hard mask layer 1305 to form a p-well region 1306. In an embodiment, the first p-type ion implantation is performed with one or more p-type impurities (e.g., aluminum, boron, etc.). In another embodiment, first p-type ion implantation may comprise a screen oxide layer. The first patterned hard mask layer 1305 is then removed, after the first p-type ion implantation, by at least one of dry etching process and wet etching process as shown in FIG. 60D. A second patterned hard mask layer 1307 is then formed on the top of the SiC substrate as shown in FIG. 60E for subsequent ion implantation. The second patterned hard mask layer 1307 is a photoresist based material and thick enough for preventing any unwanted high energy impurities particles penetrating the second patterned hard mask layer 1307. A first n-type ion implantation is formed through the second patterned hard mask layer 1307 to form a N+ source region 1308 within the p-well region 1306 as shown in FIG. 60F. In an embodiment, the first n-type ion implantation is performed with one or more n-type impurities (e.g., nitrogen, phosphorous etc.). The second patterned hard mask layer 1307 is then removed after the first n-type ion implantation by at least one of dry etching and wet etching process as shown in FIG. 60G.

A third patterned hard mask layer 1309 is then formed on top of the SiC substrate as shown in FIG. 60H. A second p-type implantation is performed through the third patterned hard mask layer 1309 to form a P+ region 1303, at a first location, within the p-well region 1306 as shown in FIG. 60I. The P+ region 1303 formed at the first location allows the P-well region 1306 to be in contact with a first pad metal 1324 (e.g., a source metal) only through the P+ region 1303 formed at the first location.

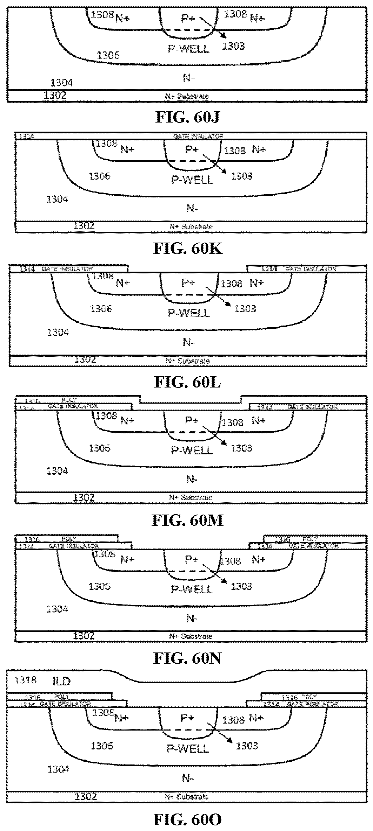

The third patterned hard mask layer 1309 is then removed as shown in FIG. 60J by at least one of a dry etching and a wet etching process once the P+ region 1303 is formed. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

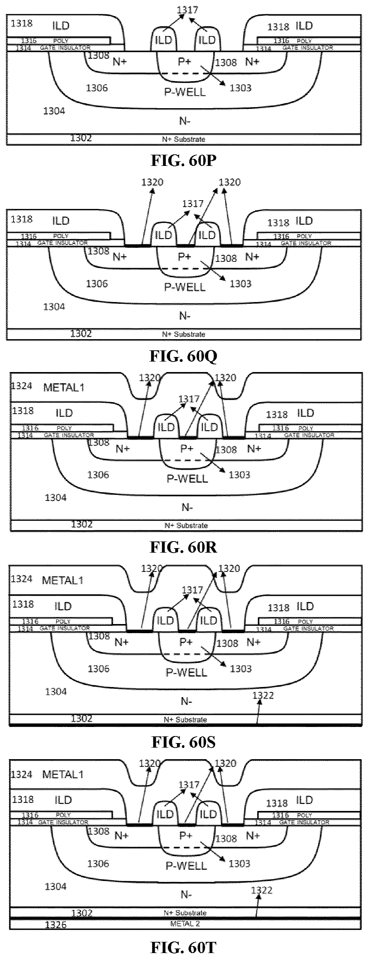

A gate insulator 1314 is then formed on top of the SiC substrate as shown in FIG. 60K. The gate insulator 1314 is then patterned as shown in FIG. 60L. A polysilicon layer 1316 is then formed on top of the SiC substrate as shown in FIG. 60M. The polysilicon layer 1316 is then patterned as shown in FIG. 60N. Contacts for the polysilicon layer 1316 is kept open for pad metal deposition for forming a gate pad region and one or more gate bus regions. An interlayer dielectric (ILD) 1318 is then formed on top of the SiC substrate as shown in FIG. 60O. The interlayer dielectric (ILD) 1318 is then patterned for exposing the portions of the SiC substrate via the openings of the ILD 1318 and leaving one or more ILD bumps 1317 as shown in FIG. 60P. A first silicide layer 1320 is then formed between the one or more ILD bumps 1317 on the exposed portions of top of the SiC substrate for forming a first Ohmic contact as shown in FIG. 60Q. In an embodiment, the first silicide layer 1320 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. The first pad metal 1324 is formed on top of the SiC substrate as shown in FIG. 60R. The P+ region 1303, formed at the first location, covers both portions of the first silicide layer 1320 between the adjacent ILD bumps 1317 and the portions under the ILD bumps 1317. The p-well region 1306 contacts with the first pad metal 1324 only through the P+ region 1303 formed at the first location.

A second silicide layer 1322 is then formed on bottom of the SiC substrate for forming a second Ohmic contact as shown in FIG. 60S. In an embodiment, the second silicide layer 1322 is then formed on back of the SiC substrate for forming the second Ohmic contact. In an embodiment, the second silicide layer 1322 is also the nickel-based silicide layer. A second pad metal 1326 is then formed on bottom of the second silicide layer 1322 of the SiC substrate as shown in FIG. 60T. In an embodiment, the second pad metal formation is performed by at least one of e-beam and sputtering.

A fourth patterned hard mask layer 1311 is then formed on the SiC substrate once the first Ohmic contact and the second Ohmic contact are formed on topside and bottom side/back side of the SiC substrate respectively. The fourth patterned hard mask layer 1311 is formed for selectively removing the exposed portions of the ILD layer 1318 and depositing a metal region (e.g., the Schottky metal region 1328) shown in FIG. 60D, 60E & 60F on top of the SiC substrate. The fourth patterned hard mask layer 1311 is used for both etching the portion of the ILD layer 1318 and lifting off the Schottky metal region 1328 when Schottky metal is deposited. The Schottky metal region 1328 is in direct contact with the top of the N- drift layer 1304 and bridge two adjacent P-well regions 1306 (i.e., bridges the adjacent unit cells). The Schottky metal region 1328 is then annealed with a predefined thermal budget for forming a Schottky metal contact between the Schottky metal region 1328 and the portion of the N- drift layer 1304 exposed at the top surface of the SiC substrate. In an embodiment, the predefined thermal budget ranges from 55°C to 1100°C. In fig. 59D, 59E & 59F, the first pad metal and the second pad metal formation are performed once the Schottky metal region 1328 formation is completed.

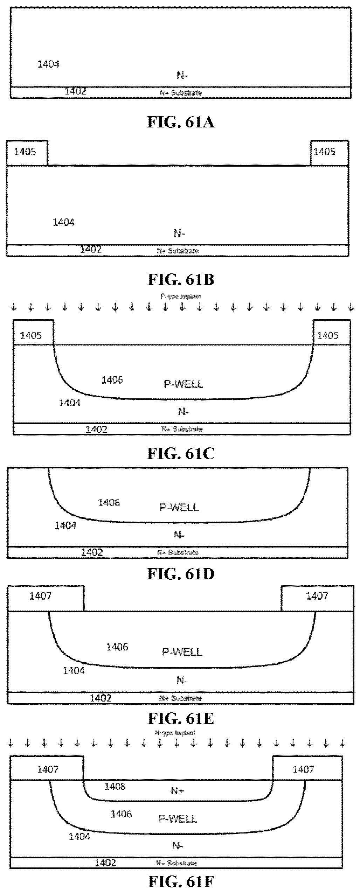

FIG. 61A to 61T illustrate an embodiment of a process of manufacturing the DMOSFET structure shown in FIG. 59B. The process of manufacturing the DMOSFET structure (shown in FIG. 61A) comprises preparing a silicon carbide (SiC) substrate having a N+ substrate 1402 and a N- drift layer 1404 as shown in FIG. 61A. The N- drift layer 1404 of the SiC substrate is epi-grown and prepared such that a doping concentration and a thickness of the N- drift layer 1404 are selected primarily based on blocking voltage and forward conduction loss. The N+ substrate 1402 is highly conductive when compared to the N- drift layer 1404 and the N+ substrate 1402 is directly located under the N- drift layer 1404. A first patterned hard mask layer 1405 is formed on top of the SiC substrate as shown in FIG. 61B. The first patterned hard mask layer 1405 is thick enough for completely blocking high energy impurities during implantation. In an embodiment, the first patterned hard mask layer 1405 is a hard mask of at least one of oxide, nitride, and a polysilicon layer.

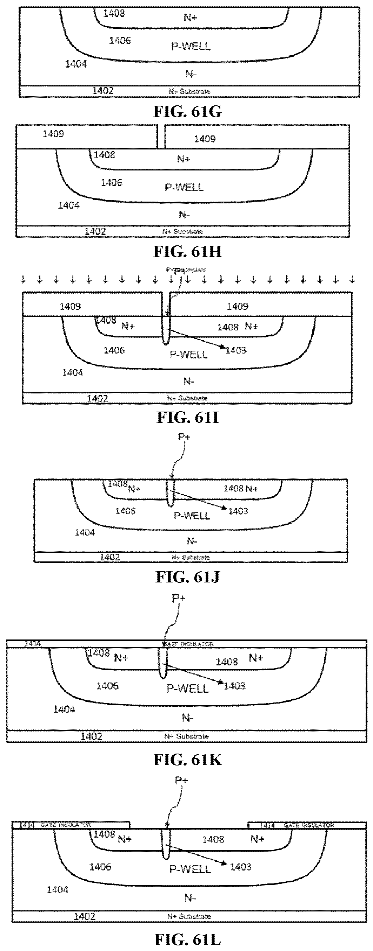

A first p-type ion implantation is formed in FIG. 61C through the first patterned hard mask layer 1405 to form a p-well region 1406. In an embodiment, the first p-type ion implantation is performed with one or more p-type impurities (e.g., aluminum, boron, etc.). In another embodiment, first p-type ion implantation may comprise a screen oxide layer. The first patterned hard mask layer 1405 is then removed, after the first p-type ion implantation, by at least one of dry etching process and wet etching process as shown in FIG. 61D. A second patterned hard mask layer 1407 is then formed on the top of the SiC substrate as shown in FIG. 61E for subsequent ion implantation. The second patterned hard mask layer 1407 is a photoresist based material and thick enough for preventing any unwanted high energy impurities particles penetrating the second patterned hard mask layer 1407. A first n-type ion implantation is formed through the second patterned hard mask layer 1407 to form a N+ source region 1408 within the p-well region 1406 as shown in FIG. 61F. In an embodiment, the first n-type ion implantation is performed with one or more n-type impurities (e.g., nitrogen, phosphorous etc.). The second patterned hard mask layer 1407 is then removed after the first n-type ion implantation by at least one of dry etching and wet etching process as shown in FIG. 61G.

A third patterned hard mask layer 1409 is then formed on top of the SiC substrate as shown in FIG. 61H. A second p-type implantation is performed through the third patterned hard mask layer 1409 to form a P+ region 1403, at a second location, within the p-well region 1406 as shown in FIG. 61I.

The third patterned hard mask layer 1409 is then removed as shown in FIG. 61J by at least one of a dry etching and a wet etching process once the P+ region 1403 is formed at the second location. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

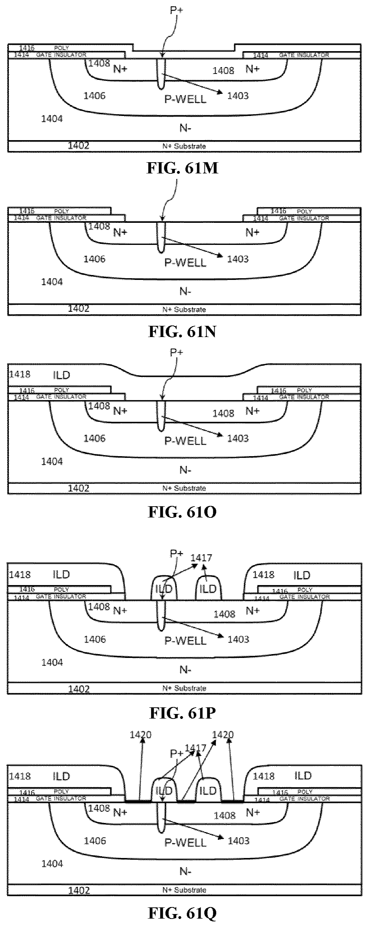

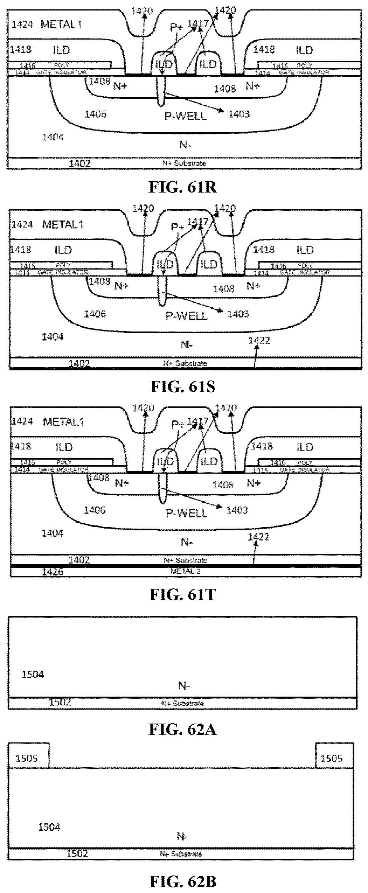

A gate insulator 1414 is then formed on top of the SiC substrate as shown in FIG. 61K. The gate insulator 1414 is then patterned as shown in FIG. 61L. A polysilicon layer 1416 is then formed on top of the SiC substrate as shown in FIG. 61M. The polysilicon layer 1416 is then patterned as shown in FIG. 61N. Contacts for the polysilicon layer are kept open for pad metal deposition for forming a gate pad region and one or more gate bus regions. An interlayer dielectric (ILD) 1418 is then formed on top of the SiC substrate as shown in FIG. 61O. The interlayer dielectric (ILD) 1418 is then patterned for exposing the portions of the SiC substrate via the openings of the ILD 1418 and leaving one or more ILD bumps 1417 on top of the SiC substrate as shown in FIG. 61P. A first silicide layer 1420 is then formed between the one or more ILD bumps 1417 on the exposed portions of top of the SiC substrate for forming a first Ohmic contacts as shown in FIG. 61Q. In an embodiment, the first silicide layer 1420 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 1424 is formed on top of the SiC substrate as shown in FIG. 61R. The P+ region 1403, formed at the second location, is under the one or more ILD bumps 1417 and do not form any direct contact with the first silicide layer 1420.

A second silicide layer 1422 is then formed on bottom of the SiC substrate for forming a second Ohmic contact as shown in FIG. 61S. In an embodiment, the second silicide layer 1422 is then formed on back of the SiC substrate for forming the second Ohmic contact. In an embodiment, the second silicide layer 1422 is also the nickel-based silicide layer. A second pad metal is then formed on bottom of the second silicide layer 1422 of the SiC substrate as shown in FIG. 61T. In an embodiment, the second pad metal formation is performed by at least one of e-beam and sputtering.

A fourth patterned hard mask layer 1411 is then formed on the SiC substrate once the first Ohmic contact and the second Ohmic contact are formed on topside and bottom side/back side of the SiC substrate respectively. The fourth patterned hard mask layer 1411 is formed for selectively removing the exposed portions of the ILD layer 1418 and depositing a metal region (i.e., a Schottky metal region 1428) shown in FIG. 59D, 59E & 59F on top of the SiC substrate. The fourth patterned hard mask layer 1411 is used for both etching the portion of the ILD layer 1418 and lifting off the Schottky metal region 1428 when Schottky metal is deposited. The Schottky metal region 1428 is in direct contact with the N- drift layer 1404 and bridge two adjacent P-well regions 1406 (i.e., bridges the adjacent unit cells). The Schottky metal region 1428 is then annealed with a predefined thermal budget for forming a Schottky metal contact between the Schottky metal region 1428 and the portion of the N- drift layer 1404 exposed at the top surface of the SiC substrate. In an embodiment, the predefined thermal budget ranges from 55°C to 1100°C. In fig. 59D, 59E & 59F, the first pad metal and the second pad metal formation are performed once the Schottky metal region 1428 formation is completed.

FIG. 62A to 62T illustrate an embodiment of a process of manufacturing the DMOSFET structure shown in FIG. 59C. The process of manufacturing the DMOSFET structure (shown in FIG. 62A) comprises preparing a silicon carbide (SiC) substrate having a N+ substrate 1502 and a N- drift layer 1504 as shown in FIG. 62A. The N- drift layer 1504 of the SiC substrate is epi-grown and prepared such that a doping concentration and a thickness of the N- drift layer 1504 are selected primarily based on blocking voltage and forward conduction loss. The N+ substrate 1502 is highly conductive when compared to the N- drift layer 1504 and the N+ substrate 1502 is directly located under the N- drift layer 1504. A first patterned hard mask layer 1505 is formed on top of the SiC substrate as shown in FIG. 62B. The first patterned hard mask layer 1505 is thick enough for completely blocking high energy impurities during implantation. In an embodiment, the first patterned hard mask layer 1505 is a hard mask of at least one of oxide, nitride, and a polysilicon layer.

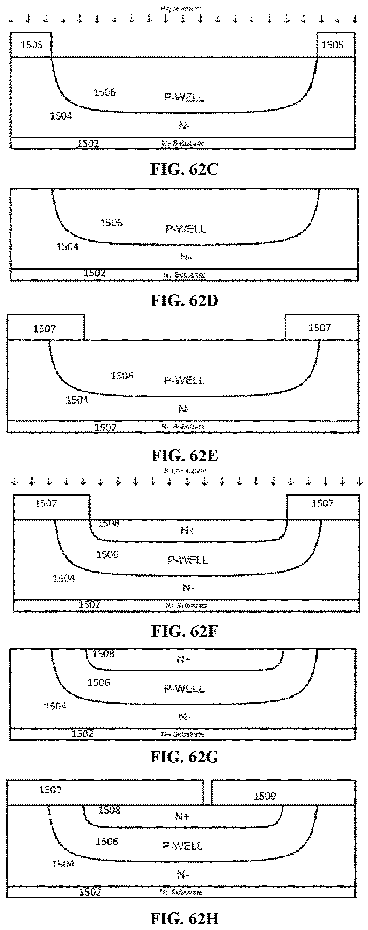

A first p-type ion implantation is formed in FIG. 62C through the first patterned hard mask layer 1505 to form a p-well region 1506. In an embodiment, the first p-type ion implantation is performed with one or more p-type impurities (e.g., aluminum, boron, etc.). In another embodiment, first p-type ion implantation may comprise a screen oxide layer. The first patterned hard mask layer 1505 is then removed, after the first p-type ion implantation, by at least one of dry etching process and wet etching process as shown in FIG. 62D. A second patterned hard mask layer 1507 is then formed on the top of the SiC substrate as shown in FIG. 62E for subsequent ion implantation. The second patterned hard mask layer 1507 is a photoresist based material and thick enough for preventing any unwanted high energy impurities particles penetrating the second patterned hard mask layer 1507. A first n-type ion implantation is formed through the second patterned hard mask layer 1507 to form a N+ source region 1508 within the p-well region 1506 as shown in FIG. 62F. In an embodiment, the first n-type ion implantation is performed with one or more n-type impurities (e.g., nitrogen, phosphorous etc.). The second patterned hard mask layer 1507 is then removed after the first n-type ion implantation by at least one of dry etching and wet etching process as shown in FIG. 62G.

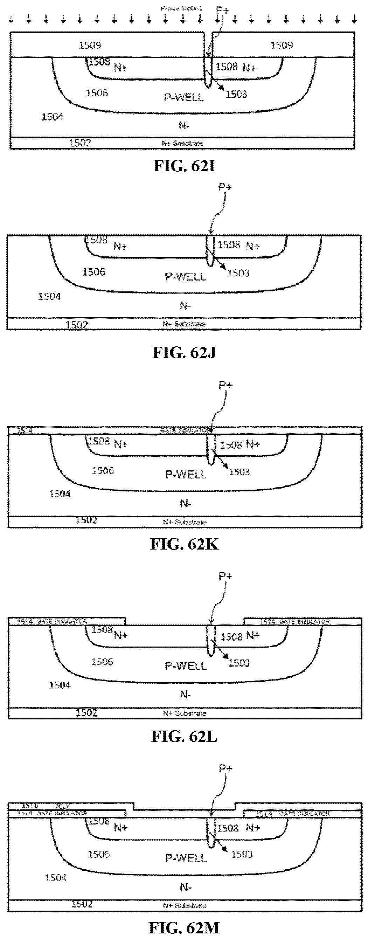

A third patterned hard mask layer 1509 is then formed on top of the SiC substrate as shown in FIG. 62H. A second p-type implantation is performed through the third patterned hard mask layer 1509 to form a P+ region 1503, at a third location, within the p-well region 1506 as shown in FIG. 62I.

The third patterned hard mask layer 1509 is then removed as shown in FIG. 62J by at least one of a dry etching and a wet etching process once the P+ region 1503 is formed at the second location. The SiC substrate undergoes thermal activation annealing with a carbon-based protection coating at a predefined temperature. In an embodiment, the predefined temperature for performing the thermal activation annealing is 1700-degree Celsius. The SiC substrate then may undergo an additional ion implantation for forming a current spreading layer to improve on-state resistance. Ion implantations (e.g., the first p-type implantation, the first n-type impanation, the second p-type implantation, edge termination implantation, current spreading layer implantation etc.) undergone by the SiC substrate is performed prior to the thermal activation annealing step. The carbon-based protection coating is then removed from the SiC substrate. The SiC substrate then undergoes a sacrificial oxide growth and subsequently the sacrificial oxide removal. An active region of the SiC DMOSFET is then patterned by forming and patterning field oxide layer on the SiC substrate.

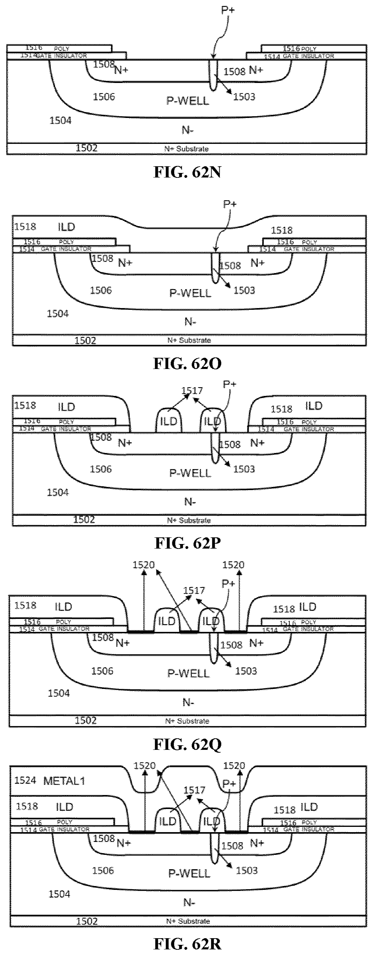

A gate insulator 1514 is then formed on top of the SiC substrate as shown in FIG. 62K. The gate insulator 1514 is then patterned as shown in FIG. 62L. A polysilicon layer 1516 is then formed on top of the SiC substrate as shown in FIG. 62M. The polysilicon layer 1516 is then patterned as shown in FIG. 62N. Contacts for the polysilicon layer are kept open for pad metal deposition for forming a gate pad region and one or more gate bus regions. An interlayer dielectric (ILD) 1518 is then formed on top of the SiC substrate as shown in FIG. 62O. The interlayer dielectric (ILD) 1518 is then patterned for exposing the portions of the SiC substrate via the openings of the ILD 1518 and leaving one or more ILD bumps 1517 on top of the SiC substrate as shown in FIG. 62P. A first silicide layer 1520 is then formed between the one or more ILD bumps 1517 on the exposed portions on top of the SiC substrate for forming a first Ohmic contact as shown in FIG. 62Q. In an embodiment, the first silicide layer 1520 is a nickel-based silicide layer. In another embodiment, the nickel-based silicide is formed by Nickel deposition on the top of the SiC substrate, thermal activation annealing of the deposited Nickel for silicide formation, and removal of any un-reacted Nickel from the SiC substrate. A first pad metal 1524 is formed on top of the SiC substrate as shown in FIG. 62R. The P+ region 1503, formed at the third location, is under the one or more ILD bumps 1517 and do not form any direct contact with the first silicide layer 1520.

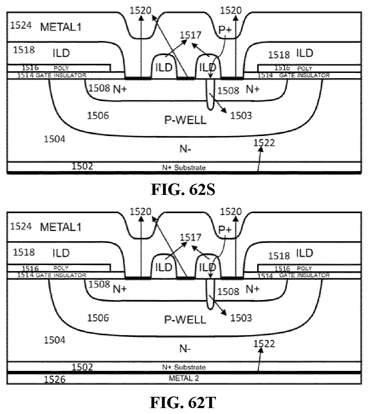

A second silicide layer 1522 is then formed on bottom of the SiC substrate for forming a second Ohmic contact as shown in FIG. 62S. In an embodiment, the second silicide layer 1522 is then formed on back of the SiC substrate for forming the second Ohmic contact. In an embodiment, the second silicide layer 1522 is also the nickel-based silicide layer. A second pad metal 1526 is then formed on bottom of the second silicide layer 1522 of the SiC substrate as shown in FIG. 62T. In an embodiment, the second pad metal formation is performed by at least one of e-beam and sputtering.

A fourth patterned hard mask layer 1511 is then formed on the SiC substrate once the first Ohmic contact and the second Ohmic contact are formed on topside and bottom side/back side of the SiC substrate respectively. The fourth patterned hard mask layer 1511 is formed for selectively removing the exposed portions of the ILD layer 1518 and depositing a metal region (e.g., a Schottky metal region 1528) shown in FIG. 59D, 59E & 59F on top of the SiC substrate. The fourth patterned hard mask layer 1511 is used for both etching the portion of the ILD layer 1518 and lifting off the Schottky metal region 1528 when Schottky metal is deposited. The Schottky metal region 1528 is in direct contact with the N- drift layer 1504 and bridge two adjacent P-well regions 1506 (i.e., bridges the adjacent unit cells). The Schottky metal region 1528 is then annealed with a predefined thermal budget for forming a Schottky metal contact between the Schottky metal region 1528 and the portion of the N- drift layer 1504 exposed at the top surface of the SiC substrate. In an embodiment, the predefined thermal budget ranges from 55°C to 1100°C. In FIG. 59D, 59E & 59F, the first pad metal and the second pad metal formation are performed once the Schottky metal region 1528 formation is completed.

Embodiments relate to MOSFET power device having inversion channels.

An embodiment relates to the MOSFET comprising a first metal oxide semiconductor (MOS) interface at a first section and a second metal oxide semiconductor (MOS) interface at a second section.

An embodiment relates to the MOSFET comprising the first metal oxide semiconductor (MOS) interface at the first section and a metal region formed adjacent to a first conductivity type layer at the second section.

An embodiment relates to the MOSFET comprising the first section and the second section arranged in at least one sequence along a lateral direction.

An embodiment relates to the MOSFET comprising a higher channel density.

An embodiment relates to the MOSFET for minimizing specific on-resistance.

An embodiment relates to the MOSFET for adjusting short-circuit withstand time.

An embodiment relates to the MOSFET for adjusting unclamped inductive switching energy.

An embodiment relates to the MOSFET for adjusting gate threshold voltage stability.

An embodiment relates to the MOSFET for increasing effective channel length for a given on-resistance target.

An embodiment relates to the MOSFET comprising the first metal region in direct contact with a first conductivity type drift layer.

An embodiment relates to the MOSFET comprising the first MOS interface comprising a first contact with a horizontal surface of a semiconductor substrate and a second contact with a trench sidewall of a trench region.

An embodiment relates to the MOSFET comprising the second MOS interface comprising a third contact solely with the trench sidewall of the trench region.

An embodiment relates to the formation of the second MOS interface at the second section, in which the trench region is in contact with the first conductivity type drift layer through a gap between a second conductivity type first well region and a second conductivity type second well region.

An embodiment relates to the MOSFET comprising the metal region at the second section, in which the trench region is not in contact with the first conductivity type drift layer.

An embodiment relates to the MOSFET comprising the metal region at the second section, in which the second conductivity type first well region and the second conductivity type second well region encloses bottom portion of the trench region.

An embodiment relates to the MOSFET, in which the second conductivity type first well region and the second conductivity type second well region overlaps at the first section.

An embodiment relates to the MOSFET, in which the second conductivity type first well region and the second conductivity type second well region overlaps at the first section and the second section.

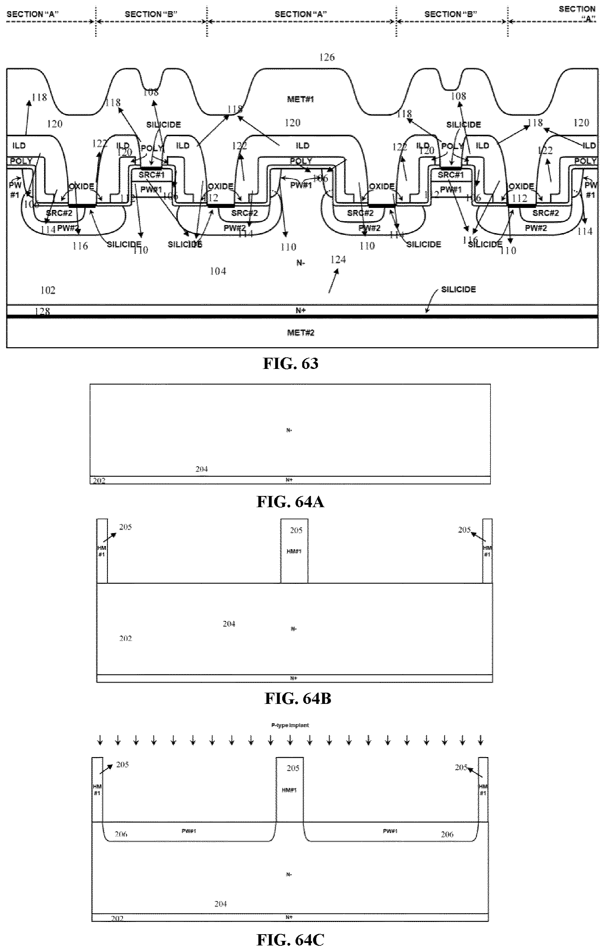

**FIG. 63** illustrates an embodiment of a cross-sectional structure of one or more unit cells of a power MOSFET, a first unit cell of the one or more unit cells comprising a first metal oxide semiconductor (MOS) interface on a horizontal surface of a semiconductor substrate and a trench sidewall, and a second unit cell of the one or more unit cells comprising a second metal oxide semiconductor (MOS) interface formed solely on the trench sidewall. The MOSFET (shown in FIG. 63) is a n-type MOSFET. For the n-type MOSFET, the terms "first conductivity type" and "second conductivity type", are used to describe n-type and p-type respectively. In an embodiment, the MOSFET is a p-type MOSFET. For the p-type MOSFET, the terms "first conductivity type" and "second conductivity type", are used to describe p-type and n-type respectively.

The MOSFET (shown in FIG. 63) comprises the semiconductor substrate. The semiconductor substrate comprises a N+ substrate 102 (i.e., a first conductivity type substrate) and a N- drift layer 104 (i.e., a first conductivity type drift layer). In an embodiment, the semiconductor substrate comprises a silicon carbide (SiC) substrate. The MOSFET comprises a first section and a second section that are contiguously located along a lateral direction within the MOSFET. The first section comprises the first metal oxide semiconductor (MOS) interface, and the second section comprises the second metal oxide semiconductor (MOS) interface. The first section and the second section are arranged in at least one sequence from left to right or right to left.

In an embodiment, the at least one sequence comprises the first section (i.e., section A as shown in FIG. 63) at a first location and the second section (i.e., section B as shown in FIG. 63) at a second location along the lateral direction. In another embodiment, the at least one sequence comprises the second section at the first location and the first section at the second location along the lateral direction. In yet another embodiment, the at least one sequence comprises the first section at the first location and the second location along the lateral direction. In yet another embodiment, the at least one sequence comprises the second section at the first location and the second location along the lateral direction. In yet another embodiment, at the least one sequence comprises the first section at the first location and a third location, and the second section at the second location along the lateral direction. In yet another embodiment, at the least one sequence comprises the second section at the first location and the third location, and the first section at the second location along the lateral direction. For example, assume the first section as 'A' and the second section as 'B', then the at least one sequence comprises 'AB', 'BA', 'AA', 'BB', 'ABA', 'AAB', 'BAA', 'ABB', 'BAB', 'BBA', 'ABAB', 'ABBA', 'BAAB', etc.

The MOSFET comprises a first P-well region 106 (i.e., a second conductivity type first well region), a second P-well region 112 (i.e., a second conductivity type second well region), a first source region 108, a second source region 114 and a trench region 110. The first source region 108 and the second source region 114 are two distinct source regions. Similarly, the first P-well region 106 and the second P-well region 112 are two distinct well regions. The first source region 108 is positioned (e.g., confined) within the first P-well region 106. The second source region 114 is positioned (e.g., confined) within the second P-well region 112. The second source region 114 and the second P-well region 112 are positioned closer to the first section and far away from the second section. The second P-well region 112 overlaps the first P-well region 106 at the first section. The MOSFET comprises a gap between the first P-well region 106 and the second P-well region 112 at the second section. The second P-well region 112 does not overlap the first P-well region 106 at the second section. The trench region 110 is extended through the first P-well region 106 and the first source region 108. The trench region 110 comprises a contact with the N-drift layer 104 through the gap between the first P-well region 106 and the second P-well region 112. The MOSFET comprises silicide layers 122, 124 on top of the first source region 108, the second source region 114 and bottom of the N+ substrate 102. The silicide layer 122 on top of the second source region 114 is partly positioned on top of the second P-well region 112.

The first section comprises the first metal oxide semiconductor (MOS) interface. The first MOS interface comprises a first portion and a second portion. The first portion comprises a first contact with a horizontal surface (e.g., an unetched surface) of the semiconductor substrate. In an embodiment, the first portion of the first MOS interface is positioned parallel to 0001 crystal plane of the semiconductor substrate. In another embodiment, the first portion of the first MOS interface is positioned parallel to 11-20 crystal plane of the semiconductor substrate. The second portion of the first MOS interface comprises a second contact with the trench sidewall of the trench region 110. In an embodiment, the second portion of the first MOS interface is positioned parallel to one of 11-20 crystal plane and 1-100 crystal plane of the semiconductor substrate. The first section comprises a combination of a planar MOSFET structure and a trench MOSFET structure. The second section comprises the second MOS interface. The second MOS interface comprises a third contact with the trench sidewall of the trench region 110. The second section comprises solely the trench MOSFET structure. The MOSFET (shown in FIG. 63), comprising the first section and the second section, comprises a higher channel density and reduced on-resistance of the MOSFET.

The trench region comprises the trench sidewall. In an embodiment, the trench sidewall of the trench region 110 comprises a sloped sidewall. The sloped sidewall comprises a sidewall angle ranging from 30° to 90°. In an embodiment, the trench region 110 comprises a depth ranging from 0.2 $\mu$m to 2.0 $\mu$m. A slope of the sloped sidewall is selected appropriately to orient the first MOS interface along a predefined crystal plane that comprises a low trap density. In an embodiment, the first portion of the first MOS interface is positioned parallel to one of 11-20 crystal plane and 0338 crystal plane of the sloped sidewall of the semiconductor substrate, when the trench sidewall comprises the sloped sidewall. The MOSFET comprising the sloped sidewall further comprises a higher channel mobility in addition to the higher channel density.

The MOSFET structure provides flexibility to a designer to increase/lower density of the first section comprising at least one of the trench MOSFET structure and the planar MOSFET structure, and the second section comprising the trench MOSFET structure alone. The density of the first section and the second section is increased or lowered depending on requirement of at least one of a specific on-resistance of the MOSFET and robustness metric such as a short-circuit withstand time, an unclamped inductive switching energy and a gate threshold voltage stability. The MOSFET shown in FIG. 63 further provides the flexibility to at least one of (a) increase an effective channel length for the given on-resistance and (b) reduce the on-resistance for a given chip size based on requirement.

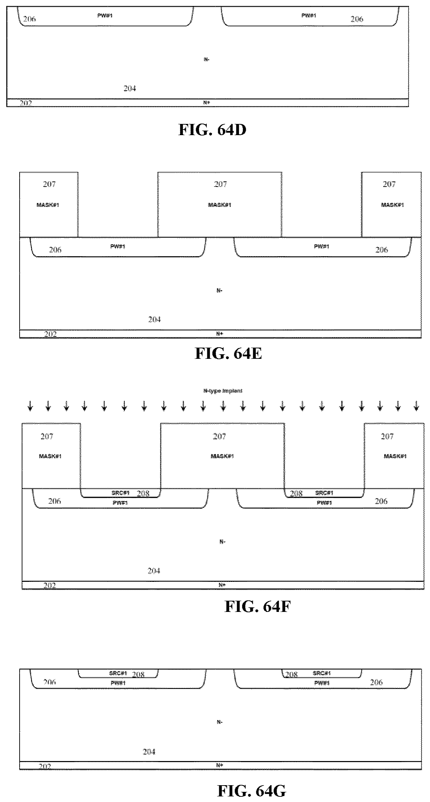

FIG. 64A to 64AB are cross-sectional views illustrating an embodiment of a process of manufacturing the MOSFET structure shown in FIG. 63. The process of manufacturing the MOSFET structure shown in FIG. 63 comprises preparing a semiconductor substrate having a N+ substrate 202 (i.e., a first conductivity type substrate) and a N- drift layer 204 (i.e., a first conductivity type drift layer) as shown in FIG. 64A. The N- drift layer 204 is grown on top of the N+ substrate 202. The N+ substrate 202 comprises a heavily doped substrate. A first patterned hard mask layer 205 is formed on topside of the semiconductor substrate as shown in FIG. 64B. A first p-type ion implantation (e.g., Aluminum, Boron) is formed on the topside of the semiconductor substrate through the first patterned hard mask layer 205 to form a first p-well region 206 as shown in FIG. 64C. The first patterned hard mask layer 205 is then removed from the topside of the semiconductor substrate as shown in FIG. 64D. In an embodiment, the first p-well region 206 is formed by a first epitaxial growth using a p-type impurity (e.g., Aluminum, Boron) into the N- drift layer 204. The first P-well region 206 comprises a first predefined implantation energy and a first predefined dosage. In an embodiment, the first predefined implantation energy ranges from 5 keV to 5 MeV and the first predefined dosage ranges from 1E13 cm-2 to 5E16 cm-2. In another embodiment, the first P-well region 206 is formed using a first single ion-implantation step comprising combination of the predefined implantation energy and the predefined dosage. In yet another embodiment, the first P-well region 206 is formed using a first sequence of multiple ion-implantation steps. An ion-implantation step of the first sequence of multiple ion-implantation steps is performed with a different implantation energy or a different dosage. In an embodiment, the first P-type ion implantation (i.e., second conductivity type first ion implantation) is performed at one of room temperature and at elevated temperature up to 1000°C.

A second patterned masking layer 207 is formed on the topside of the semiconductor substrate as shown in FIG. 64E. A first n-type ion (e.g., Nitrogen, Phosphorous) implantation is formed on the topside of the semiconductor substrate through the second patterned masking layer 207 to form a first source region 208 within the first P-well region 206 as shown in FIG. 64F. The second patterned masking layer 207 is then removed from the semiconductor substrate as shown in FIG. 64G. In an embodiment, the first source region 208 is formed by a second epitaxial growth using a n-type impurity (e.g., Nitrogen, Phosphorous) into the first P-well region 206. The first source region 208 comprises a second predefined implantation energy and a second predefined dosage. In an embodiment, the second predefined implantation energy ranges from 5 keV to 1 MeV and the second predefined dosage ranges from 5E13 cm-2 to 5E16 cm-2. In another embodiment, the first source region 208 is formed using a second single ion-implantation step comprising combination of the second predefined implantation energy and the second predefined dosage. In yet another embodiment, the first source region 208 is formed using a second sequence of multiple ion-implantation steps. An ion-implantation step of the second sequence of multiple ion-implantation steps is performed with a different implantation energy or a different dosage. In an embodiment, the first n-type ion implantation is performed at one of the room temperature and at the elevated temperature up to 1000°C.

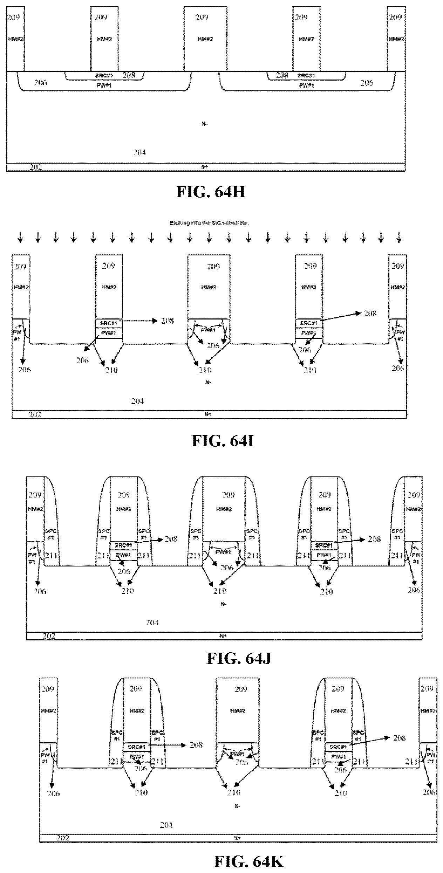

A third patterned hard mask layer 209 is formed on the topside of the semiconductor substrate as shown in FIG. 64H. A trench region 210 is then formed by performing etching onto the topside (e.g., a top surface) of the semiconductor substrate through the third patterned hard mask layer 209 as shown in FIG. 64I. In an embodiment the etching is performed using one of a reactive ion etching (RIE) and an inductively coupled plasma (ICP) etching. In another embodiment, the etching is controlled appropriately to form the trench region 210. The trench region 210 comprises a predefined depth and a predefined sidewall angle. The predefined depth of the trench region 210 ranges from 0.2 $\mu$m to 2.0 $\mu$m. The predefined sidewall angle ranges from 30° to 90°. The predefined depth of the trench region 210 is deeper than a depth of the first P-well region 206 (i.e., bottom portion of the trench region 210 may be in contact with the N- drift layer 204). The trench region 210 comprises a first section and a second section.

A first spacer 211 (i.e., sidewall spacer) is then formed on the semiconductor substrate along the trench sidewalls of the trench region 210 and the third patterned hard mask layer 209 as shown in FIG. 64J. In an embodiment, the first spacer 211 is formed using a dielectric material (e.g., silicon dioxide, silicon nitride). In an embodiment, the first spacer 211 and the hard mask layers (e.g., the first patterned hard mask layer 205, the second patterned hard mask layer 207) are formed using dis-similar dielectric materials to enable selective removal of one or more portions of the first spacer 211 without removal of the hard mask layers. The one or more portions of the first spacer 211, that are not in contact with the first source region 208, are selectively removed as shown in FIG. 64K.

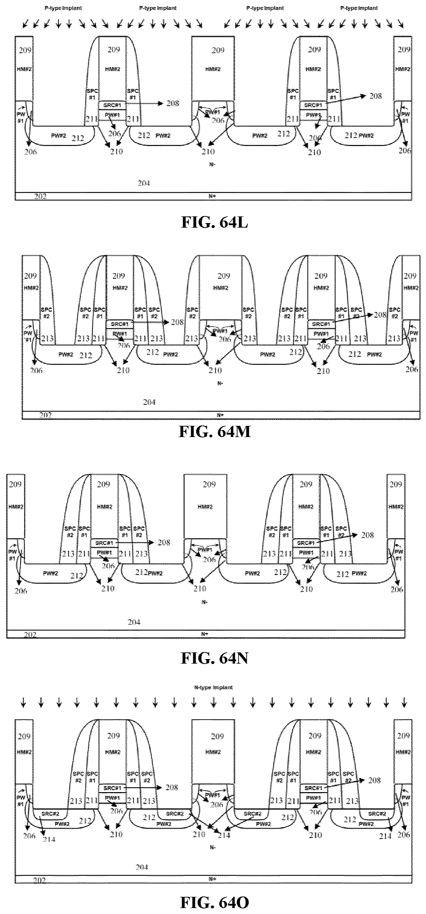

A second p-type ion implantation (e.g., Aluminum, Boron) is then performed to form a second P-well region 212 below the first P-well region 206 as shown in FIG. 64L. In an embodiment, the second p-type ion implantation (i.e., second conductivity type second ion implantation) comprises an angled implantation (i.e., at a predefined angle) to electrically short a portion of the second P-well region 212 and the first P-well region 206 at the first section. In an embodiment, the angled implantation is performed using a tilt angle away from normal incidence. The tilt angle for the angled implantation may range from 0° (normal incidence) to 60°. The second P-well region 212 comprises a third predefined implantation energy and a third predefined dosage. In an embodiment, the third predefined implantation energy ranges from 5 keV to 5 MeV and the third predefined dosage ranges from 5E13 cm-2 to 5E16 cm-2. In another embodiment, the second P-well region 212 is formed using a third single ion-implantation step comprising combination of the third predefined implantation energy and the third predefined dosage. In yet another embodiment, the second P-well region 212 is formed using a third sequence of multiple ion-implantation steps. An ion-implantation step of the third sequence of multiple ion-implantation steps is performed with a different implantation energy or a different dosage. In an embodiment, the second P-type ion implantation (i.e., the second conductivity type second ion implantation) is performed at one of the room temperature and the elevated temperature up to 1000°C.

A second spacer 213 (i.e., sidewall spacer) is then formed on the semiconductor substrate along the trench sidewalls of the trench region 210 and the third patterned hard mask layer 209 as shown in FIG. 64M. One or more portions of the second spacer 213, that are in contact with the first p-well region 206 (i.e., in contact with the first section), are selectively removed as shown in FIG. 64N. A second n-type ion implantation (e.g., Nitrogen, Phosphorous) is then performed through the second spacer 213 to form a second source region 214 within the second P-well region 212 as shown in FIG. 64O. The second source region 214 and the second P-well region 212 are formed closer to the first section and far away from the second section. The second source region 214 comprises a fourth predefined implantation energy and a fourth predefined dosage. In an embodiment, the fourth predefined implantation energy ranges from 5 keV to 1 MeV and the fourth predefined dosage ranges from 5E13 cm-2 to 5E16 cm-2. In another embodiment, the second source region 214 is formed using a fourth single ion-implantation step comprising combination of the fourth predefined implantation energy and the fourth predefined dosage. In yet another embodiment, the second source region 214 is formed using a fourth sequence of multiple ion-implantation steps. An ion-implantation step of the fourth sequence of multiple ion-implantation steps is performed with a different implantation energy or a different dosage. In an embodiment, the second n-type ion implantation is performed at one of the room temperature and the elevated temperature up to 1000°C.

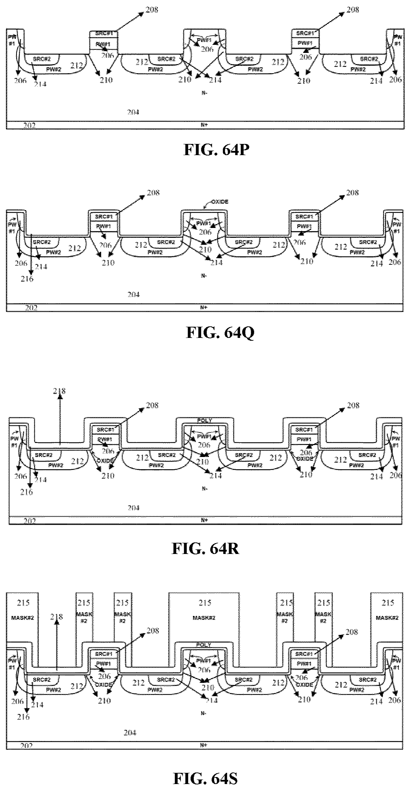

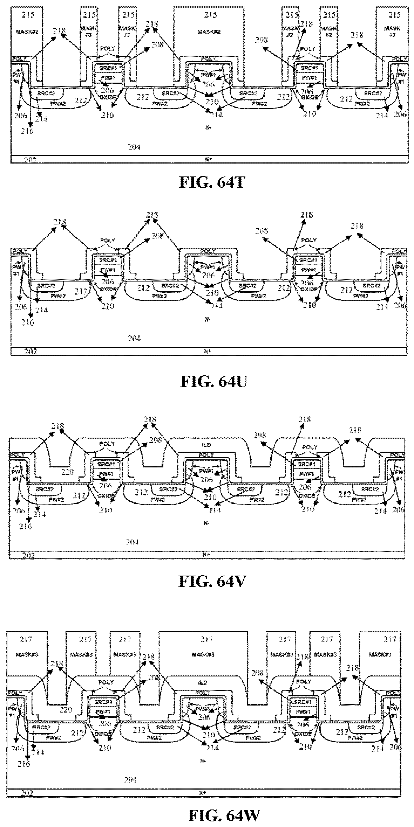

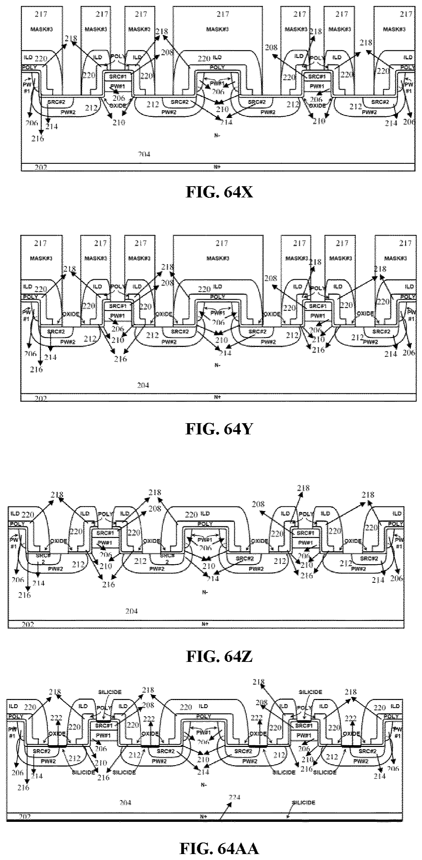

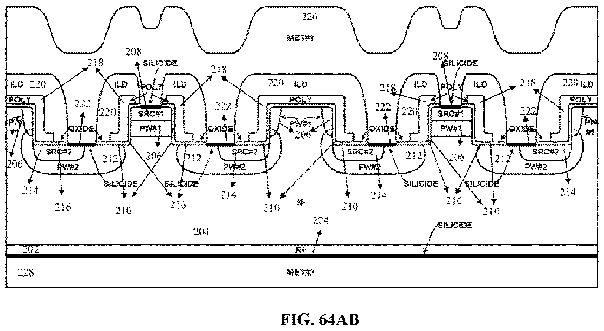

The hard mask layers (e.g., the first spacer 211, the second spacer 213, the third patterned hard mask layer 209) are removed as shown in FIG. 64P. The semiconductor substrate (e.g., wafers) is then subjected to high-temperature heat treatment for activating implanted ions and for implant damage alleviation. In an embodiment, the heat treatment or annealing is performed at a temperature ranging from 1700°C - 2000°C, for a duration ranging from 10 min to 2 hours. A gate dielectric layer 216 is then formed onto the topside of exposed portions of the semiconductor substrate as shown in FIG. 64Q. In an embodiment, the gate dielectric layer 216 is an oxide layer. In another embodiment, the gate dielectric layer 216 is formed by one of a thermal oxidation and a chemical vapor deposition (CVD) of a dielectric layer (e.g., silicon dioxide, silicon nitride, silicon oxynitride, etc.). Then a poly silicon layer 218 is formed onto the topside of the semiconductor substrate as shown in FIG. 64R. In an embodiment, the poly silicon layer 218 comprises a n-type doped layer. The n-type doped layer is doped using a n-type dopant (e.g., phosphorous). A fourth patterned masking layer 215 is then formed on top of the poly silicon layer 218 as shown in FIG. 64S. The poly silicon layer 218 is then selectively etched using the fourth patterned masking layer 215 to form one or more poly silicon regions as shown in FIG. 64T. The fourth patterned masking layer 215 is removed as shown in FIG. 64U. Then an interlayer dielectric (ILD) 220 is formed onto the topside of the semiconductor substrate as shown in FIG. 64V. A fifth patterned masking layer 217 is formed on top of the interlayer dielectric (ILD) 220 as shown in FIG. 64W. The interlayer dielectric (ILD) 220 is then selectively etched using the fifth patterned masking layer 217 as shown in FIG. 64X. The gate dielectric layer 216 is also selectively etched using the fifth patterned masking layer 217 as shown in FIG. 64Y. The fifth patterned masking layer 217 is then removed from the semiconductor substrate and the semiconductor substrate is exposed to air as shown in FIG. 64Z. A first silicide region 222 and a second silicide region 224 are then formed on the topside and bottom side of the semiconductor substrate to form a source terminal and a drain terminal respectively as shown in FIG. 64AA. The first silicide region 222 is formed on top of the first source region 208 and the second source region 214. The second silicide region 224 is formed on bottom of the N+ substrate 202. A first inter-connect metal layer 226 and a second inter-connect metal layer 228 is then formed on the topside and the bottom side of the semiconductor substrate respectively as shown in FIG. 64AB.

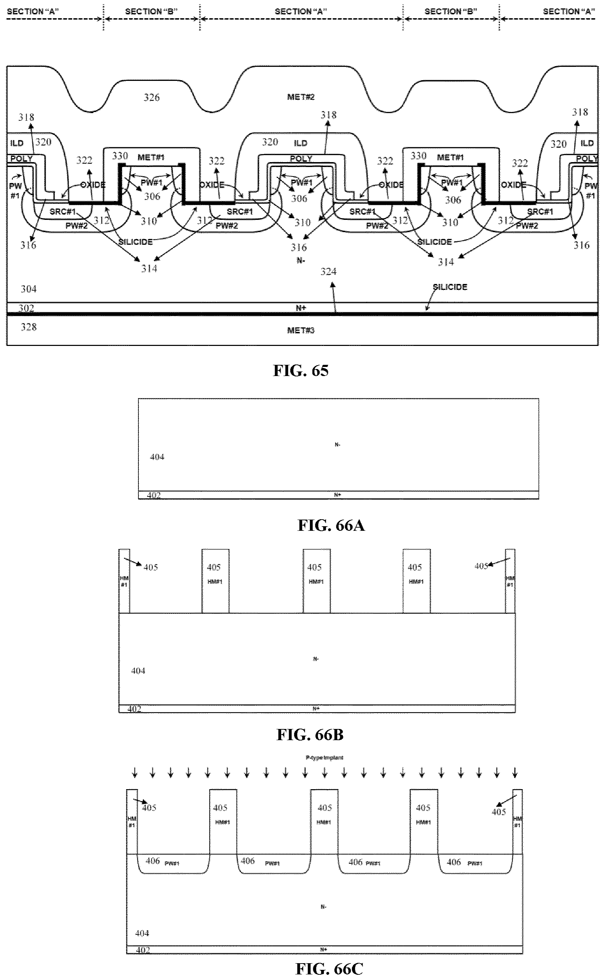

**FIG. 65** illustrates an embodiment of a cross-sectional structure of one or more unit cells of a power MOSFET, a first unit cell of the one or more unit cells comprising a first metal oxide semiconductor (MOS) interface on a horizontal surface of a semiconductor substrate and a trench sidewall, and a second unit cell of the one or more unit cells comprising a metal region 330 formed adjacent to a first conductivity type drift layer of the MOSFET. The MOSFET (shown in FIG. 65) is a n-type MOSFET. For the n-type MOSFET, the terms "first conductivity type" and "second conductivity type", are used to describe n-type and p-type respectively. In an embodiment, the MOSFET is a p-type MOSFET. For the p-type MOSFET, the terms "first conductivity type" and "second conductivity type", are used to describe p-type and n-type respectively.

The MOSFET (shown in FIG. 65) comprises the semiconductor substrate. The semiconductor substrate comprises a N+ substrate 302 (i.e., a first conductivity type substrate) and a N- drift layer 304 (i.e., a first conductivity type drift layer). In an embodiment, the semiconductor substrate comprises a silicon carbide (SiC) substrate. The MOSFET comprises a first section and a second section that are contiguously located along a lateral direction within the MOSFET. The first section comprises the first metal oxide semiconductor (MOS) interface, and the second section comprises the metal region 330. In an embodiment, the metal region comprises a junction barrier Schottky (JBS) diode region. The first section and the second section are arranged in at least one sequence from left to right or right to left.

In an embodiment, the at least one sequence comprises the first section at a first location and the second section at a second location along the lateral direction. In another embodiment, the at least one sequence comprises the second section at the first location and the first section at the second location along the lateral direction. In yet another embodiment, the at least one sequence comprises the first section at the first location and the second location along the lateral direction. In yet another embodiment, the at least one sequence comprises the second section at the first location and the second location along the lateral direction. In yet another embodiment, the at least one sequence comprises the first section at the first location and a third location, and the second section at the second location along the lateral direction. In yet another embodiment, the at least one sequence comprises the second section at the first location and the third location, and the first section at the second location along the lateral direction. For example, assume the first section as 'A' and the second section as 'B', then the at least one sequence comprises 'AB', 'BA', 'AA', 'BB', 'ABA', 'AAB', 'BAA', 'ABB', 'BAB', 'BBA', 'ABAB', 'ABBA', 'BAAB', etc.

The MOSFET comprises a first P-well region 306 (i.e., a second conductivity type first well region), a second P-well region 312 (i.e., a second conductivity type second well region), a source region 314, a metal region 330 and a trench region 310. The first P-well region 306 and the second P-well region 312 are two distinct well regions. The source region 314 is positioned (e.g., confined) within the second P-well region 312. The source region 314 and the second P-well region 312 are positioned closer to the first section and far away from the second section. The second P-well region 312 overlaps the first P-well region 306 at the first section and the second section. The trench region 310 is completely contained within the second P-well region 312. The trench region 310 is extended through the first P-well region 306. The first P-well region 306 and the second P-well region 312 completely enclose bottom portion (i.e., base) of the trench region 310 to shield the bottom portion from first high electric fields in off-state or during high-voltage blocking operation of the MOSFET. At the second section, the metal region (i.e., the junction barrier Schottky diode region) is shielded from second high electric fields present during high-voltage blocking condition. In an embodiment, spacing between the first P-well region 306 and the second P-well region 312 at the second section and the first section is adjusted suitably for maintaining a good trade-off between an on-state resistance, and a third electric field at the metal region and the first MOS interface. In another embodiment, a depth, and a doping concentration of the first P-well region 306 and the second P-well region 312 are adjusted for maintaining the good trade-off between the on-state resistance, and the third electric field at the metal region and the first MOS interface. In yet another embodiment, a width, and a depth of the trench region 310, and the implantation energy and the dosage of the first P-well region 306 and the second P-well region 312 are adjusted to control total extent and distribution of the first MOS interface.

The MOSFET further comprises silicide layers 322, 324 on top of the source region 314, and bottom of the N+ substrate (302). The silicide layer 322 on top of the source region 314 is partly positioned on top of the second P-well region 312 and the first P-well region 306. The first section comprises the first metal oxide semiconductor (MOS) interface. The first MOS interface comprises a first portion and a second portion. The first portion comprises a first contact with a horizontal surface (e.g., an unetched surface) of the semiconductor substrate. In an embodiment, the first portion of the first MOS interface is positioned parallel to 0001 crystal plane of the semiconductor substrate. In another embodiment, the first portion of the first MOS interface is positioned parallel to 11-20 crystal plane of the semiconductor substrate. The second portion of the first MOS interface comprises a second contact with a trench sidewall of the trench region 310. In an embodiment, the second portion of the first MOS interface is positioned parallel to one of 11-20 crystal plane and 1-100 crystal plane of the semiconductor substrate. The first section comprises a combination of a planar MOSFET structure and a trench MOSFET structure. The second section comprises the metal region 330 (e.g., the junction barrier Schottky diode region). The metal region 330 comprises a fourth contact with the N-drift layer 404 of the semiconductor substrate. The metal region 330 comprises a predefined work function. The metal region 330 comprises one of Ti, W, Mo, Au, Pt, TiW, TiN, etc.

The trench region 310 comprises the trench sidewall. In an embodiment, the trench sidewall of the trench region 310 comprises a sloped sidewall. The sloped sidewall comprises a sidewall angle ranging from 30° to 90°. In an embodiment, the trench region 310 comprises a depth ranging from 0.2 μm to 2.0 μm. A slope of the sloped sidewall is selected appropriately to orient the first MOS interface along a predefined crystal plane that comprises a low trap density. In an embodiment, the first portion of the first MOS interface is positioned parallel to 11-20 crystal plane and 0338 crystal plane of the sloped sidewall of the semiconductor substrate, when the trench sidewall comprises the sloped sidewall.

The MOSFET turns on when a drain terminal is biased positively as compared to a source terminal and the metal region turns on when the drain terminal is biased negatively with respect to the source terminal. The MOSFET shown in FIG. 65 depicts an equal number of unit cells of the metal regions and unit cells of the first MOS interfaces. In an embodiment, the MOSFET comprises an unequal number of the unit cells of the metal regions and the unit cells of the first MOS interfaces based on requirements. In another embodiment, a ratio of the number of the unit cells of the metal regions to the unit cells of first MOS interfaces is varied (e.g., increased, decreased) based on application.

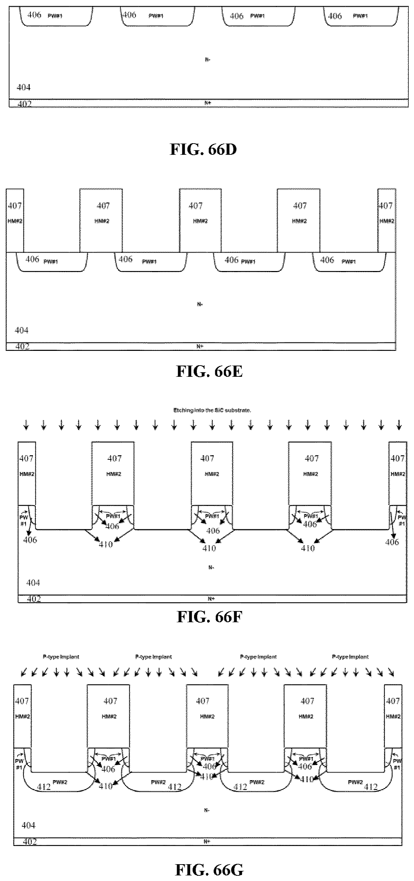

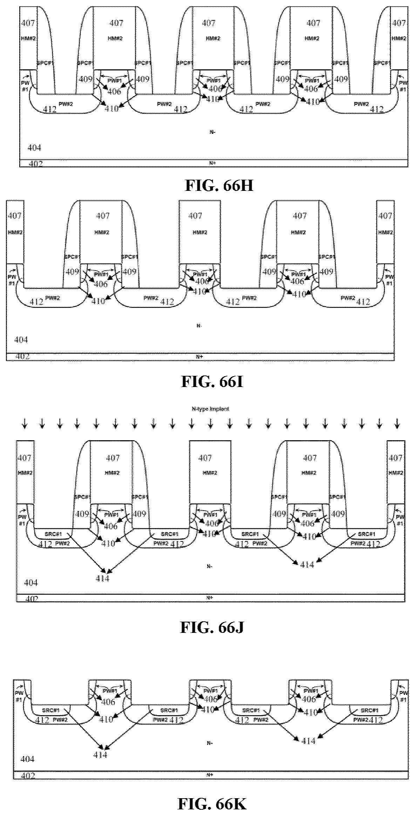

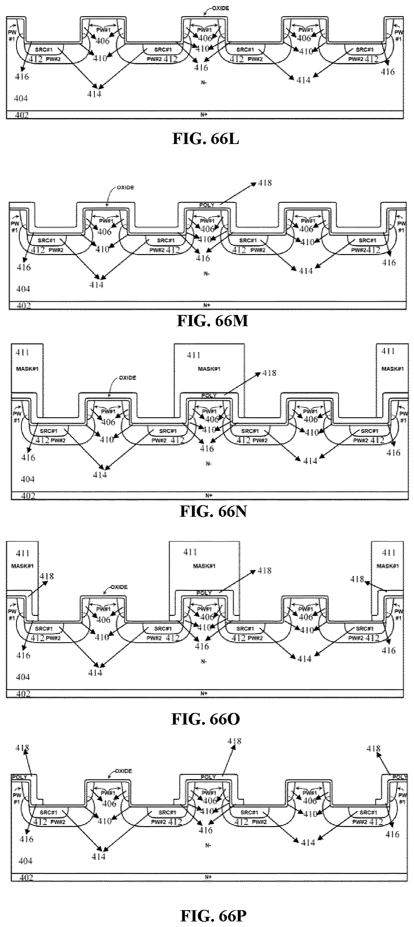

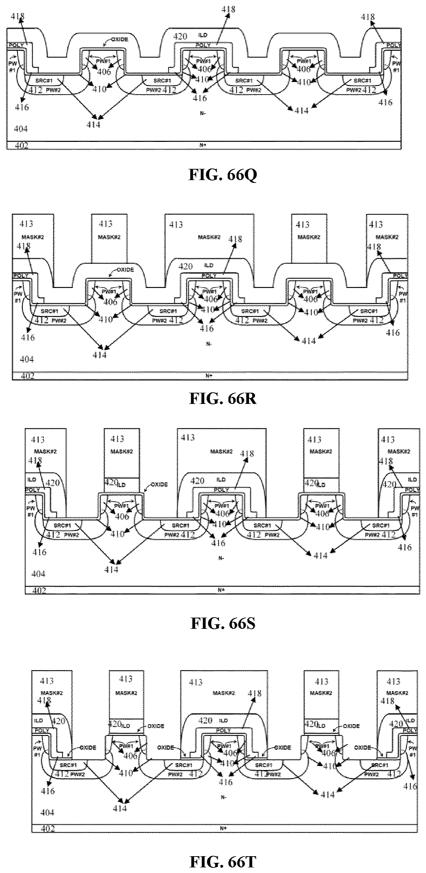

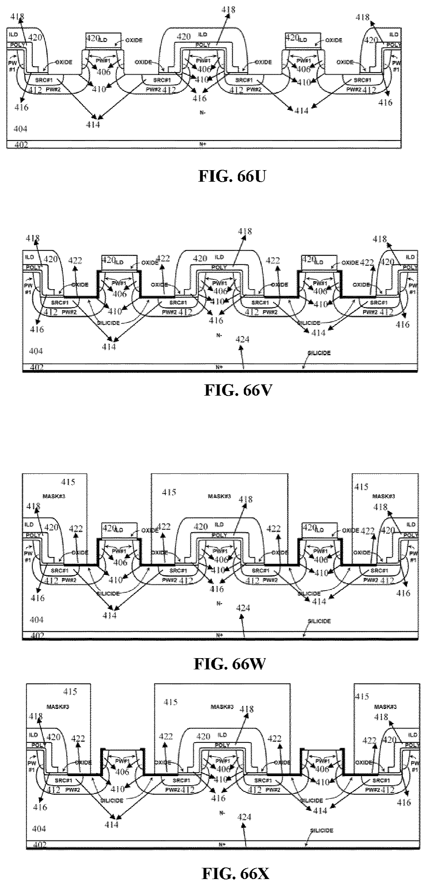

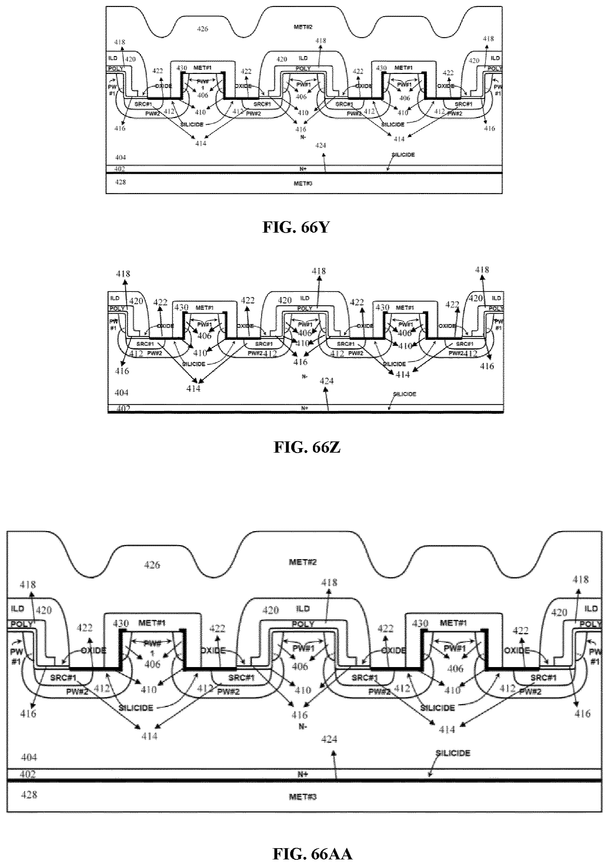

**FIG. 66 to 66AA** are cross-sectional views illustrating an embodiment of a process of manufacturing the MOSFET structure shown in FIG. 65. The process of manufacturing the MOSFET structure shown in FIG. 65 comprises preparing a semiconductor substrate having a N+ substrate 402 and a N- drift layer 404 as shown in FIG. 66A. The N- drift layer 404 is grown on top of the N+ substrate 402. The N+ substrate 402 comprises a heavily doped substrate. A first patterned hard mask layer 405 is formed on topside of the semiconductor substrate as shown in FIG. 66B. A first p-type ion (e.g., Aluminum, Boron) implantation is formed on the topside of the semiconductor substrate through the first patterned hard mask layer 405 to form a first p-well region 406 as shown in FIG. 66C. The first patterned hard mask layer 405 is removed from the topside of the semiconductor substrate as shown in FIG. 66D. In an embodiment, the first p-well region 406 is formed by a first epitaxial growth using a p-type impurity (e.g., Aluminum, Boron) into the N- drift layer 404. The first P-well region 406 comprises a first predefined implantation energy and a first predefined dosage. In an embodiment, the first predefined implantation energy ranges from 5 keV to 5 MeV and the first predefined dosage ranges from 1E13 cm-2 to 5E16 cm-2. In another embodiment, the first P-well region 406 is formed using a first single ion-implantation step comprising combination of the predefined implantation energy and the predefined dosage. In yet another embodiment, the first P-well region 406 is formed using a first sequence of multiple ion-implantation steps. An ion-implantation step of the first sequence of multiple ion-implantation steps is performed with a different implantation energy or a different dosage. In an embodiment, the first P-type ion implantation (i.e., second conductivity type first ion implantation) is performed at one of room temperature and at elevated temperature up to 1000°C.

A second patterned hard mask layer 407 is formed on the topside of the semiconductor substrate as shown in FIG. 66E. A trench region 410 is formed by performing etching onto the topside (e.g., a top surface) of the semiconductor substrate through the second patterned hard mask layer 407 as shown in FIG. 66F. In an embodiment the etching is performed using one of a reactive ion etching (RIE) and an inductively coupled plasma (ICP) etching. In another embodiment, the etching is controlled appropriately to form the trench region 410. The trench region 410 comprises a predefined depth and a predefined sidewall angle. The predefined depth of the trench region 410 ranges from 0.2 μm to 2.0 μm. The predefined sidewall angle ranges from 30° to 90°. The predefined depth of the trench region 410 is deeper than a depth of the first P-well region 406 (i.e., bottom portion of the trench region 410 may be in contact with the N- drift layer 404). The trench region 410 comprises a first section and a second section. In an embodiment, the trench region 410 is located within the MOSFET to delineate the first p-well region 406 to be in contact with the horizontal (or unetched) surface of the semiconductor substrate and the trench sidewall.

A second p-type ion implantation (e.g., Aluminum, Boron) is then performed to form a second P-well region 412 below the first P-well region 406 as shown in FIG. 84G. In an embodiment, the second p-type ion implantation (i.e., second conductivity type second ion implantation) comprises an angled implantation (i.e., at a predefined angle) to electrically short a portion of the second P-well region 412 and the first P-well region 406 at the first section and the second section (i.e., the second P-well region 412 overlaps the first P-well region 406 at the first section and the second section). In an embodiment, the angled implantation is performed using a tilt angle away from normal incidence. The tilt angle for the angled implantation may range from 0° (normal incidence) to 60°. The second P-well region 412 comprises a second predefined implantation energy and a second predefined dosage. In an embodiment, the second predefined implantation energy ranges from 5 keV to 5 MeV and the second predefined dosage ranges from 5E13 cm-2 to 5E16 cm-2. In another embodiment, the second P-well region 412 is formed using a second single ion-implantation step comprising combination of the predefined implantation energy and the predefined dosage. In yet another embodiment, the second P-well region 412 is formed using a second sequence of multiple ion-implantation steps. An ion-implantation step of the second sequence of multiple ion-implantation steps is performed with a different implantation energy or a different dosage. In an embodiment, the second P-type ion implantation is performed at one of the room temperature and the elevated temperature up to 1000°C. In an embodiment, the overlap between the first P-well region 406 and the second P-well region 412 are adjusted by varying at least one of the tilt angle and the second predefined implantation energy. The first P-well region 406 and the second P-well region 412 encloses the bottom portion of the trench region 410. The trench region 410 do not comprises a direct contact with the N- drift layer 404.

A first spacer 409 (i.e., sidewall spacer) is then formed on the semiconductor substrate along the trench sidewalls of the trench region 410 and the second patterned hard mask layer 407 as shown in FIG. 66H. In an embodiment, the first spacer 409 is formed using a dielectric material (e.g., silicon dioxide, silicon nitride). In an embodiment, the first spacer 409 and the hard mask layers (e.g., the first patterned hard mask layer 405, the second patterned hard mask layer 407) are formed using dis-similar dielectric materials to enable selective removal of one or more portions of the first spacer 409 without removal of the hard mask layers. The one or more portions of the first spacer 409, that are not in contact with the source region 414, are selectively removed as shown in FIG. 66I.

An n-type ion implantation (e.g., Nitrogen, Phosphorous) is then performed through the first spacer 409 to form the source region 414 within the second P-well region 412 as shown in FIG. 66J. The source region 414 and the second P-well region 412 are formed closer to the first section and far away from the second section. The source region 414 comprises a third predefined implantation energy and a third predefined dosage. In an embodiment, the third predefined implantation energy ranges from 5 keV to 1 MeV and the third predefined dosage ranges from 5E13 cm-2 to 5E16 cm-2. In another embodiment, the source region 414 is formed using a third single ion-implantation step comprising combination of the third predefined implantation energy and the third predefined dosage. In yet another embodiment, the source region 414 is formed using a third sequence of multiple ion-implantation steps. An ion-implantation step of the third sequence of multiple ion-implantation steps is performed with a different implantation energy or a different dosage. In an embodiment, the n-type ion implantation (i.e., first conductivity type ion implantation) is performed at one of the room temperature and the elevated temperature up to 1000°C.

The hard mask layers (e.g., the first spacer 409, the second patterned hard mask layer 407) are removed as shown in FIG. 66K. The semiconductor substrate (e.g., wafers) is then subjected to high-temperature heat treatment for activating implanted ions and for implant damage alleviation. In an embodiment, the heat treatment or annealing is performed at a temperature ranging from 1700°C - 2000°C, for a duration ranging from 10 min to 2 hours. A gate dielectric layer 416 is formed onto the topside of exposed portions of the semiconductor substrate as shown in FIG. 66L. In an embodiment, the gate dielectric layer 416 is an oxide layer. In another embodiment, the gate dielectric layer 416 is formed by one of a thermal oxidation and a chemical vapor deposition (CVD) of a dielectric layer (e.g., silicon dioxide, silicon nitride, silicon oxynitride, etc.). Then a poly silicon layer 418 is formed onto the topside of the semiconductor substrate as shown in FIG. 66M. In an embodiment, the poly silicon layer 418 comprises a n-type doped layer. The n-type doped layer is using a n-type dopant (e.g., phosphorous). A third patterned masking layer 411 is formed on top of the poly silicon layer 418 as shown in FIG. 66N. The poly silicon layer 418 is then selectively etched using the third patterned masking layer 411 to form one or more poly silicon regions as shown in FIG. 66O. The third patterned masking layer 411 is removed as shown in FIG. 66P. Then an interlayer dielectric (ILD) 420 is formed onto the topside of the semiconductor substrate as shown in FIG. 66Q. A fourth patterned masking layer 413 is formed on top of the interlayer dielectric (ILD) 420 as shown in FIG. 66R. The interlayer dielectric (ILD) 420 is then selectively etched using the fourth patterned masking layer 413 as shown in FIG. 66S. The gate dielectric layer 416 is also selectively etched using the fourth patterned masking layer 413 as shown in FIG. 66T. The fourth patterned masking layer 413 is then removed from the semiconductor substrate and the semiconductor substrate is exposed to air as shown in FIG. 66U. Silicide layers 422, 424 are then formed on the topside and bottom side of the semiconductor substrate to form a source terminal and a drain terminal respectively as shown in FIG. 66V. The silicide layer 422 on the topside of the semiconductor substrate is formed partly on the first P-well region 406, the second P-well region 412 and the source region 414. A fifth patterned masking layer 415 is formed on the topside of the semiconductor substrate as shown in FIG. 66W. Then the interlayer dielectric (ILD) 420 is selectively etched through the fifth patterned masking layer 415 as shown in FIG. 66X. Then a metal region 430 is deposited and patterned on the topside of the semiconductor substrate through the fifth patterned masking layer 415 as shown in FIG. 66Y. In an embodiment, the metal region 430 comprises a junction Schottky barrier diode region. The metal region comprises a predefined work function. The metal region comprises one of Ti, W, Mo, Au, Pt, TiW, TiN, etc. The fifth patterned masking layer 415 is then removed to lift off the metal region 430 on top of the fifth patterned masking layer as shown in FIG. 66Z. A first inter-connect metal layer 426 and a second inter-connect metal layer 428 is then formed on the topside and the bottom side of the semiconductor substrate respectively as shown in FIG. 66AA.

Further examples according to the present disclosure are described in the following non-limiting clauses, numbered C1 to C84:

C1. A device comprising a unit cell on a SiC substrate, the unit cell comprising:

a gate insulator film,

a trench in a well region,

a first sinker region having a second conduction type, wherein the first sinker region has a depth that is equal to or greater than a depth of the well region, and

a second sinker region having the second conduction type; and

wherein each of the first sinker region and the second sinker region is in contact with a region having a first conduction type to form a p-n junction.

C2. The device of clause C1, wherein the device comprises a semiconductor metal-insulator-semiconductor transistor component.

C3. The device of clause C1, wherein the well region is next to an insulator-semiconductor interface; and a source region of the first conduction type formed within the well region.

C4. The device of clause C3, wherein a depth of the trench is greater than or equal to a thickness of the source region.

C5. The device of clause C1, wherein the first sinker region is located below the trench.

C6. The device of clause C1, wherein a depth of the second sinker region is less than the depth of the first sinker region.

C7. The device of clause C1, wherein a depth of the second sinker region is greater than the depth of the well region.

C8. The device of clause C1, wherein the device has an on-resistance of less than 4 milliohm centimeter squared, a gate threshold voltage of greater than 1.5 Volt, a breakdown voltage of greater than 500 Volt, and an electric field of less than 3.5 megavolt per cm in the gate insulator film.

C9. A device comprising a unit cell on a SiC substrate, the unit cell comprising:

a gate insulator film,

a trench in a well region,

a first sinker region of a second conduction type,

a second sinker region of the second conduction type, and

a source region; and

wherein the source region is in direct contact with the second sinker region.

C10. The device of clause C9, wherein the device comprises a semiconductor metal-insulator-transistor component.

C11. The device of clause C9, wherein the unit cell further comprises a semiconductor body of a first conduction type that comprises a drift zone; the well region of the second conduction type next to an insulator-semiconductor interface; and the source region of the first conduction type formed within the well region.

C12. The device of clause C11, wherein a depth of the trench is greater than or equal to a thickness of the source region.

C13. The device of clause C9, wherein a depth of the trench is greater than a depth of the source region.

C14. The device of clause C9, wherein the device has an avalanche energy of greater than 10 Joule per centimeter squared, calculated by dividing an avalanche energy in Joules by a total die area in centimeter squared.

C15. The device of clause C9, wherein an avalanche failure is located within the unit cell.

C16. A device comprising a unit cell on a SiC substrate, the unit cell comprising:

a gate insulator film,

a trench in a well region,

a first sinker region of a second conduction type,

a second sinker region of the second conduction type, and

a source region;

wherein the first sinker region has a depth that is greater than a depth of the second sinker region; and

wherein the second sinker has a width that is greater than that of the first sinker.

C17. The device of clause C16, wherein the first sinker region is located below the trench.

C18. The device of clause C16, wherein the depth of the second sinker region is less than the depth of the first sinker region.

C19. The device of clause C16, wherein the depth of the second sinker region is greater than a depth of the well region.

C20. A device comprising a unit cell on a Silicon Carbide (SiC) substrate, the unit cell comprising:

a first conductivity type first source region;

a first conductivity type second source region;

a second conductivity type well region; and

a silicide layer,

wherein the device comprises a vertical Silicon Carbide (SiC) double-implantation metal oxide semiconductor field-effect transistor (DMOSFET) comprising a drain terminal on a backside of the SiC substrate and a source terminal on a topside of the SiC substrate,

wherein the first conductivity type second source region comprises a thickness lower than a thickness of the first conductivity type first source region, and

wherein the first conductivity type second source region is interspersed between the second conductivity type well region and the silicide layer; and

wherein the first conductivity type second source region comprises a sheet of source region located between a recessed SiC trench region and the second conductivity type well region.

C21. The device of clause C20, wherein the sheet of source region comprises a thin sheet of source region.

C22. The device of clause C20, wherein the first conductivity type second source region comprises at least one of (a) a target thickness and (b) a target doping concentration.

C23. The device of clause C22, wherein the target thickness of the first conductivity type second source region ranges from 1 nm to 1 $\mu$m and the target doping concentration ranges from $10^{15}$ cm$^{-3}$ to $10^{21}$ cm$^{-3}$.

C24. The device of clause C20, wherein the first conductivity type second source region comprises a sheet of source region located between the silicide layer and the second conductivity type well region.

C25. The device of clause C20, capable of carrying a drain current of less than negative 500 milliamperes at a drain voltage of negative 3 volts.

C26. A device comprising a unit cell on a silicon carbide (SiC) substrate, the unit cell comprising:

a first conductivity type source region;

a second conductivity type well region; and

a second conductivity type shield region,

wherein the second conductivity type shield region is confined within the second conductivity type well region.

C27. The device of clause C26, wherein the second conductivity type shield region is located within a metal oxide semiconductor field-effect transistor (MOSFET) channel.

C28. The device of clause C27, wherein the second conductivity type shield region is located closer to an edge of the second conductivity type well region.

C29. The device of clause C26, wherein a doping concentration inside the second conductivity type well region is non-uniform in a lateral direction.

C30. The device of clause C26, wherein a doping concentration inside the second conductivity type shield region is higher than a doping concentration inside the second conductivity type well region.

C31. The device of clause C26, wherein the second conductivity type shield region extends beyond a vertical extent of the second conductivity type well region.

C32. The device of clause C26, wherein the device further comprises a trench region in the second conductivity type well region,
the trench region comprises a depth of one of greater than and equal to a thickness of the first conductivity type source region.

C33. The device of clause C26, wherein the device comprises a gate oxide layer in contact with the second conductivity type well region and the first conductivity type source region,
the device comprises a double-implantation metal oxide semiconductor field-effect transistor (DMOSFET).

C34. The device of clause C26, wherein the device comprises multiple second conductivity type shield regions within a metal oxide semiconductor field-effect transistor (MOSFET) channel.

C35. The device of clause C34, wherein the multiple second conductivity type shield regions located closer to an edge of the second conductivity type well region.

C36. The device of clause C34, wherein the multiple second conductivity type shield regions extend beyond a vertical extent of the second conductivity type well region.

C37. The device of clause C27, wherein the second conductivity type shield region is buried within the second conductivity type well region.

C38. A device comprising a unit cell on a silicon carbide (SiC) substrate, the unit cell comprising:

a first conductivity type source region;

a second conductivity type well region; and

a second conductivity type shield region,

wherein the second conductivity type shield region is confined within the second conductivity type well region, and

wherein the second conductivity type shield region shields a metal oxide semiconductor field-effect transistor (MOSFET) channel from a high potential applied to a drain terminal.

C39. The device of clause C38, wherein the device further comprises a trench region in the second conductivity type well region, the trench region comprises a depth of one of greater than and equal to a thickness of the first conductivity type source region.

C40. The device of clause C39, wherein the device comprises a gate threshold voltage of greater than 2.5 volts, a breakdown voltage of greater than 3300 volts at a gate to source voltage of 0 volt, an on-resistance of less than 15 milliohm centimeter squared, and a short-circuit withstand time of greater than 4 microseconds at a drain voltage of 1500 volts.

C41. The device of clause C39, wherein the device comprises a gate threshold voltage of greater than 2 volts, a breakdown voltage of greater than 1200 volts at a gate to source voltage bias of 0 volt, an on-resistance of less than 4.5 milliohm centimeter squared, and a short-circuit withstand time of greater than 2.5 microseconds at a drain voltage of 800 volts.

C42. The device of clause C39, wherein the device comprises a gate threshold voltage of greater than 2.5 volts, a breakdown voltage of greater than 6500 volts at a gate to source voltage of 0 volt, an on-resistance of less than 50 milliohm centimeter squared, and a short-circuit withstand time of greater than 4 microseconds at a drain voltage of 3600 volts.

C43. The device of clause C39, wherein the device comprises a gate threshold voltage of greater than 2.5 volts, a breakdown voltage of greater than 10000 volts at a gate to source voltage of 0 volt, an on-resistance of less than 100 milliohm centimeter squared, and a short-circuit withstand time of greater than 4 microseconds at a drain voltage of 5000 volts.

C44. The device of clause C39, wherein the device comprises a gate threshold voltage of greater than 2.5 volts, a breakdown voltage of greater than 13000 volts at a gate to source voltage of 0 volt, an on-resistance of less than 400 milliohm centimeter squared, and a short-circuit withstand time of greater than 4 microseconds at a drain voltage of 10000 volts.

C45. The device of clause C38, wherein the second conductivity type shield region shields the metal oxide semiconductor field-effect transistor (MOSFET) channel from the high potential applied to the drain terminal during one of an off-state and a blocking operation.

C46. A method comprising: forming a silicon carbide (SiC) metal oxide semiconductor field-effect transistor (MOSFET); forming a second conductivity type well region; forming a first conductivity type source region within the second conductivity type well region; and forming a second conductivity type shield region, wherein the second conductivity type shield region is located outside the first conductivity type source region.

C47. The method of clause C46, wherein the second conductivity type shield region is located within the second conductivity type well region.

C48. The method of clause C46, wherein the second conductivity type shield region extends beyond the second conductivity type well region.

C49. The method of clause C46, wherein the SiC MOSFET is manufactured on SiC epi-wafer comprising a doping ranging from $10^{14}$ to $10^{18}$ cm$^{-3}$ and a thickness ranging from 1 micrometers ($\mu$m) to 300 micrometers ($\mu$m).

C50. The method of clause C46, wherein forming the second conductivity type well region comprises:

depositing a hard mask comprising at least one of a silicon dioxide layer, a silicon nitride layer, a polysilicon layer, a silicon oxynitride layer, and a metallic layer with a total thickness ranging from 50 nanometers to 5 micrometers;

patterning the hard mask;

etching the hard mask; and

performing one of an ion-implantation and an epitaxial growth using second conductivity type ions,

wherein performing the ion-implantation comprises implanting the second conductivity type ions at energies ranging from 10 keV to 1000 keV, and at implant doses ranging from $10^{12}$ cm$^{-2}$ to $10^{15}$ cm$^{-2}$, and

wherein the second conductivity type ions comprise one of aluminum and boron.

C51. The method of clause C46, wherein forming the second conductivity type shield region comprises forming the second conductivity type shield region closer to an edge of the second conductivity type well region.

C52. The method of clause C46, wherein forming the second conductivity type shield region comprises forming the second conductivity type shield region confined within the second conductivity type well region.

C53. The method of clause C46, further comprising forming a metal oxide semiconductor field-effect transistor (MOSFET) channel.

C54. The method of clause C53, wherein forming the second conductivity type shield region comprises forming the second conductivity type shield region in contact with the metal oxide semiconductor field-effect transistor (MOSFET) channel.

C55. The method of clause C53, wherein forming the second conductivity type shield region comprises forming multiple second conductivity type shield regions in contact with the metal oxide semiconductor field-effect transistor (MOSFET) channel.

C56. The method of clause C46, wherein forming the first conductivity type source region comprises forming the first conductivity type source region using one of nitrogen and phosphorus ions.

C57. The method of clause C46, further comprising:

forming a gate oxide layer;

forming a polysilicon gate layer;

forming an interlayer dielectric (ILD) layer;

forming a silicide region; and

forming an interconnect metal layer.

C58. The method of clause C57, wherein forming the gate oxide layer comprises performing either one or a stacked combination of a thermal oxidation and a chemical vapor deposition (CVD) of a dielectric layer of one of a silicon dioxide layer, a silicon nitride layer, and a silicon oxynitride layer, wherein the gate oxide layer is formed with a thickness ranging from 10 nanometers to 100 nanometers.

C59. The method of clause C57, wherein forming the polysilicon gate layer comprises depositing a polysilicon layer using one of a plasma-enhanced chemical vapor deposition (PECVD) and a low-pressure chemical vapor deposition (LPCVD) through one of an in-situ doping and a subsequent drive-in doping.

C60. The method of clause C57, wherein forming the interlayer dielectric (ILD) layer comprises depositing one of

at least one of a silicon dioxide layer, a silicon nitride layer, and a silicon oxynitride layer; and

a stacked combination of the silicon dioxide layer, the silicon nitride layer, and the silicon oxynitride layer,

the ILD layer comprises a thickness one of greater than and equal to 50 nanometers.

C61. The method of clause C57, wherein forming the silicide region comprises forming a nickel silicide region on exposed SiC surface.

C62. The method of clause C46, wherein forming the second conductivity type shield region comprises forming the second conductivity type shield region extending beyond a vertical extent of the second conductivity type well region.

C63. A method comprising: forming a silicon carbide (SiC) metal oxide semiconductor field-effect transistor (MOSFET); forming a second conductivity type well region; forming a first conductivity type source region within the second conductivity type well region; and forming a second conductivity type shield region, wherein the second conductivity type shield region is located outside the first conductivity type source region, wherein a doping concentration in the second conductivity type well region within a metal oxide semiconductor field-effect transistor (MOSFET) channel is non-uniform, and wherein at least a portion of the second conductivity type shield region is located within the second conductivity type well region.

C64. The method of clause C63, wherein doping concentration profiles of the second conductivity type shield region at different locations are different.

C65. The method of clause C63, wherein doping concentration profiles of the second conductivity type shield region at different locations are not different.

C66. A semiconductor component, comprising a semiconductor body of a first conduction type comprising a voltage blocking layer; and islands of a second conductivity type on a contact surface; and a metal layer on the voltage blocking layer, wherein the metal layer and the voltage blocking layer includes a Schottky contact, and a first conductivity type layer comprising the first conduction type not in contact with the Schottky contact that is interspersed between the islands of the second conductivity type.

C67. The semiconductor component of clause C66, wherein a vertical extent of the first conductivity type layer is lower than a bottom of the islands of the second conductivity type.

C68. The semiconductor component of clause C66, wherein a vertical extent of the first conductivity type layer is higher than a bottom of the islands of the second conductivity type.

C69. The semiconductor component of clause C66, wherein a doping concentration within the first conductivity type layer is non-uniform in a direction that is perpendicular to the Schottky contact.

C70. The semiconductor component of clause C66, wherein a vertical extent of the first conductivity type layer is higher or lower than a bottom of the islands of the second conductivity type.

C71. The semiconductor component of clause C66, wherein the first conductivity type layer has a doping concentration that does not vary in any direction along the contact surface.

C72. The semiconductor component of clause C66, wherein the first conductivity type layer has a first doping concentration that is higher than a second doping concentration of a drift region.

C73. The semiconductor component of clause C66, wherein the first conductivity type layer has a first doping concentration that is lower than a second doping concentration of a drift region.

C74. The semiconductor component of clause C66, wherein the Schottky contact comprises a metal comprising Al, Ag, Au, Mo, Ni, Ti, W, $Ti_xW_y$, $Ti_xN_y$, or combinations thereof.

C75. A diode comprising P+ islands interspersed within a N+ region and a N- region contacts with a Schottky layer.

C76. The diode of clause C75, wherein a vertical extent of the N+ region is lower than a bottom of the P+ islands.

C77. The diode of clause C75, wherein a vertical extent of the N+ region is higher than a bottom of the P+ islands.

C78. The diode of clause C75, wherein a doping concentration within the N+ region is non-uniform in a direction that is perpendicular to the Schottky layer.

C79. The diode of clause C75, wherein a vertical extent of the N+ region is higher or lower than a bottom of the P+ islands.

C80. A diode comprising N+ islands interspersed within a P+ region and a P- region contacts with a Schottky layer.

C81. The diode of clause C80, wherein a vertical extent of the P+ region is lower than a bottom of the N+ islands.

C82. The diode of clause C80, wherein a vertical extent of the P+ region is higher than a bottom of the N+ islands.

C83. The diode of clause C80, wherein a doping concentration within the P+ region is non-uniform in a direction that is perpendicular to the Schottky layer.

C84. The diode of clause C80, wherein a vertical extent of the P+ region is higher or lower than a bottom of the N+ islands.

The present disclosure may be embodied in other specific forms without departing from its spirit or characteristics. The described embodiments are to be considered in all respects only as illustrative and not restrictive. The scope is, therefore, indicated by the appended claims rather than by the foregoing description. All changes which come within the meaning and range of equivalency of the claims are to be embraced within their scope.
Other embodiments are also within the scope of the following claims.
Although, various embodiments which incorporate the teachings described in detail herein, those skilled in the art can readily devise many other varied embodiments that still incorporate these teachings. For example, a complementary SiC MOSFET device with a P+, P- drift layer and P+ source can be created in a N-well region. The embodiments described are all applicable to the complementary MOSFET as well.
All documents (patents, patent publications or other publications) mentioned in the specification are incorporated herein in their entirety by reference.

**INCORPORATION BY REFERENCE:**

All publications, patents, and patent applications cited in this Specification are hereby incorporated by reference in their entirety.

WO2011013042A1 entitled "Germanium n-MOSFET Devices and production methods";
EP0899791B1 entitled "Trench-gated MOSFET with bidirectional voltage clamping";
JP2008541459A entitled "Silicon carbide junction barrier Schottky diode with suppressed minority carrier injection";
US9875332 entitled "Contact Resistance Mitigation";
US5731605A entitled "Turn-off power semiconductor component with a particular ballast resistor structure";
US5461250 entitled "SiGe thin film or SOI MOSFET and method for making the same";
US9899512B2 entitled "Silicon Carbide device and method of making thereof";
US9876104B2 entitled "High voltage semiconductor devices and methods of making the devices";
US20190013312A1 entitled "MOSFET device of silicon carbide having an integrated diode and manufacturing process thereof";
US9318597B2 entitled "Layout configurations for integrating Schottky contacts into a power transistor device";
US8436367B1 entitled "SiC power vertical DMOS with increased safe operating area";
T. Kimoto, J.A. Cooper in Fundamentals of Silicon Carbide Technology, IEEE Press (2014);
U.S. patent application Serial No. 16/374,025, filed April 3, 2019, entitled "DESIGN AND MANUFACTURE OF POWER DEVICES HAVING INVERSION CHANNEL" and
U.S. patent application Serial No. 16/945,781, filed July 31, 2020, entitled "DESIGN AND MANUFACTURE OF POWER DEVICES HAVING INCREASED CROSS OVER CURRENT".

**Claims**

1. A device comprising a unit cell at least partially formed within a silicon carbide (SiC) substrate (801), the unit cell comprising:

   a drift region (802) formed in the SiC substrate and having a first conductivity type;
   a gate conductor (817);
   a gate insulator film (816) disposed between the gate conductor (817) and the SiC substrate;
   a well region (805) formed in the drift region (802) and having a second conductivity type;
   a trench (813) formed in a top surface of the SiC substrate and aligned with the well region (805);
   a first sinker region (815) formed in the drift region (802) and having the second conductivity type, wherein the first sinker region (815) is aligned with the trench (813) and has a depth that is equal to or greater than a depth of the well region (805);
   a second sinker region (802) formed in the drift region (802) and having the second conductivity type;
   wherein the first sinker region (815) is in contact with the drift region (802) forming a first junction; and
   wherein the second sinker region (809) is in contact with the drift region (802) forming a second junction.

2. The device of claim 1 wherein:

   the first conductivity type is N type; and
   the second conductivity type is P type.

3. The device of claim 1, further comprising a conductor (822) disposed in the trench (813) and conductively coupled with the well region (805).

4. The device of claim 1, further comprising:

   a conductor (822) disposed in the trench (813); and
   a silicide (821) disposed at a bottom of the trench (813) and in contact with the conductor (822) and with the well region (805).

5. The device of claim 1, further comprising a source region (807) formed in the well region (805) and having the first conductivity type.

6. The device of claim 5 wherein the source region (807) is adjacent to a first side of the well region (805) opposite a second side of the well region (804) to which the drift region (802) is adjacent.

7. The device of claim 5 wherein the source region (807) includes a first portion disposed adjacent a first side of the trench (813) and includes a second portion disposed adjacent a second side of the trench (813) opposite the first side of the trench (813).

8. The device of claim 1 wherein the first sinker region (815) extends through the well region (805) and into the second sinker region (809).

9. The device of claim 1, further comprising:

   a source region (807) formed in the well region (805) and having the first conductivity type;
   an insulator region (819) disposed over the gate conductor (817); and
   a source metal (822) disposed in the trench (813) and over the insulator region (819) and conductively coupled with the well region (805) and the source region (807).

10. The device of claim 1 wherein the trench (813) extends through the source region (807) and into the well region (805).

11. The device of claim 1 wherein the first sinker region (815) extends deeper into the drift region (802) than the second sinker region (809).

12. The device of claim 1, further comprising:

an insulator (819) disposed over the gate conductor (817); and
a source metal (822) disposed in the trench (813) and over the insulator (819) and electrically coupled with the source region (807).

13. The device of claim 1, further comprising:

an insulator (819) disposed over the gate conductor (817);
a silicide (821) disposed at a bottom of the trench (813) in contact with the well region (805) and the source region (807); and
a source metal (822) disposed over the insulator (819) and in the trench (813) in contact with the silicide (821).

14. The device of claim 1 wherein at least a portion of the drift region (802) is disposed beneath a bottom of the trench (813).

15. The device of claim 1 wherein at least a portion of the drift region (802) is disposed beneath a bottom of the well region (805).

FIG. 1A
PRIOR ART

5-kV Shielded 4H-SiC Inversion-Mode MOSFET Structure

FIG. 1B
PRIOR ART

5-kV Shielded 4H-SiC Inversion-Mode MOSFET Structure

FIG. 1C
PRIOR ART

FIG. 2A

FIG. 2B

FIG. 3

FIG. 4A

FIG. 4B

FIG. 4C

FIG. 4D

FIG. 4E

FIG. 4F

N-type Implant

↓ ↓ ↓ ↓ ↓ ↓ ↓ ↓ ↓ ↓ ↓ ↓ ↓ ↓ 408

FIG. 4G

P-type Implant

↓ ↓ ↓ ↓ ↓ ↓ ↓ ↓ ↓ ↓ ↓ ↓ ↓ 410

FIG. 4H

FIG. 4I

OXIDE 412

| 407 SRC | | SRC 407 |
| 405 PW | PS#1 Region 411 | PW 405 |

N- 402

N+ 401

FIG. 4J

413 POLY · OXIDE 412

| 407 SRC | | SRC 407 |
| 405 PW | PS#1 Region 411 | PW 405 |

N- 402

N+ 401

FIG. 4K

414 Mask · Mask 414

413 POLY · OXIDE 412

| 407 SRC | | SRC 407 |
| 405 PW | PS#1 Region 411 | PW 405 |

N- 402

N+ 401

FIG. 4L

414 Mask · Mask 414

413 POLY · OXIDE 412 · POLY 413

| 407 SRC | | SRC 407 |
| 405 PW | PS#1 Region 411 | PW 405 |

N- 402

N+ 401

FIG. 4M

FIG. 4N

FIG. 4O

FIG. 4P

FIG. 4Q

FIG. 4R

FIG. 5A

FIG. 5B

N- 602

N+ 601

FIG. 6A

Hard Mask 603

N- 602

N+ 601

FIG. 6B

H.M. 603

H.M. 603

N- 602

N+ 601

FIG. 6C

P-type Implant

↓ ↓ ↓ ↓ ↓ ↓ ↓ ↓ ↓ ↓ ↓ ↓ ↓ 604

H.M. 603

H.M. 603

N- 602

N+ 601

FIG. 6D

FIG. 6E

FIG. 6F

FIG. 6G

FIG. 6H

FIG. 6I

FIG. 6J

FIG. 7A

FIG. 7B

FIG. 8A

FIG. 8B

FIG. 8C

FIG. 8D

FIG. 8E

FIG. 8F

FIG. 8G

FIG. 8H

**FIG. 8I**

**FIG. 8J**

**FIG. 8K**

Etch into the substrate

**FIG. 8L**

FIG. 8M

FIG. 8N

FIG. 8O

FIG. 8P

FIG. 8Q

FIG. 8R

FIG. 8S

FIG. 8T

FIG. 8U

FIG. 8V

FIG. 8W

FIG. 8X

FIG. 8Y

FIG. 8Z

FIG. 8AA

FIG. 8BB

FIG. 9
PRIOR ART

FIG. 10

FIG. 11A

|  | 303 |
| --- | --- |
| N- DRIFT LAYER | 302 |
| N+ SUBSTRATE | 301 |

FIG. 11B

→303

| N- DRIFT LAYER | 302 |
| --- | --- |
| N+ SUBSTRATE | 301 |

FIG. 11C

P-type Implant ↓ ↓ ↓ ↓ ↓ ↓ ↓ ↓ ↓ ↓ ↓ ↓ ↓ ↓ ↓ ↓ ↓ ↓ ↓ 304

→303

| N- DRIFT LAYER | 302 |
| --- | --- |
| N+ SUBSTRATE | 301 |

FIG. 11D

→303

| PWELL | 305 |
| --- | --- |
| N- DRIFT LAYER | 302 |
| N+ SUBSTRATE | 301 |

FIG. 11E

303

| | 306 |
| --- | --- |
| PWELL | 304 |
| N- DRIFT LAYER | 302 |
| N+ SUBSTRATE | 301 |

FIG. 11F

Etch-back 307
↓ ↓ ↓ ↓ ↓ ↓ ↓ ↓ ↓ ↓ ↓ ↓ ↓ ↓ ↓ ↓ ↓ ↓ ↓

303

306
PWELL 304

N- DRIFT LAYER

302

N+ SUBSTRATE 301

FIG. 11G

306 SIDEWALL SPACER

303

PWELL 304

N- DRIFT LAYER

302

N+ SUBSTRATE 301

FIG. 11H

N-type Implant 308
↓ ↓ ↓ ↓ ↓ ↓ ↓ ↓ ↓ ↓ ↓ ↓ ↓ ↓ ↓ ↓ ↓ ↓ ↓

306
303

PWELL 304

N- DRIFT LAYER

302

N+ SUBSTRATE 301

FIG. 11I

306
303

N+ SOURCE 309
PWELL 304

N- DRIFT LAYER

302

N+ SUBSTRATE 301

FIG. 11J

N+ SOURCE 309
PWELL 304

N- DRIFT LAYER

302

N+ SUBSTRATE 301

FIG. 11K

109

FIG. 11L

FIG. 11M

FIG. 11N

FIG. 11O

FIG. 11P

N+ SOURCE

312

310

N+ SOURCE 309

PWELL

PWELL 304

312

314

P-TYPE PLUG 314

P-TYPE PLUG

N- DRIFT LAYER

302

N+ SUBSTRATE 301

## FIG. 11Q

N+ SOURCE

312

N+ SOURCE 309

PWELL

PWELL 304

312

314

P-TYPE PLUG 314

P-TYPE PLUG

N- DRIFT LAYER

302

N+ SUBSTRATE 301

## FIG. 11R

N+ SOURCE

312

N+ SOURCE 309

PWELL

PWELL 304

312

GATE OXIDE

314

P-TYPE PLUG 314

315

P-TYPE PLUG

N- DRIFT LAYER 302

N+ SUBSTRATE 301

## FIG. 11S

N+ SOURCE

312

POLY

312

N+ SOURCE 309

PWELL

PWELL 304

316

GATE OXIDE

314

P-TYPE PLUG 314

315

P-TYPE PLUG

N- DRIFT LAYER

302

N+ SUBSTRATE 301

## FIG. 11T

FIG. 11U

FIG. 11V

FIG. 11W

FIG. 11X

FIG. 11Y

FIG. 11Z

FIG. 11AA

FIG. 11BB

FIG. 11CC

FIG. 11DD

316
N+ SOURCE
ILD 318
POLY
312 320
SILICIDE
PWELL
GATE OXIDE
315
314
P-TYPE PLUG
ILD
POLY
N+ SOURCE    309
PWELL        304
N- DRIFT LAYER
GATE OXIDE   P-TYPE PLUG
312
321
318
316
314
302
N+ SUBSTRATE    SILICIDE    301
320

FIG. 11EE

316
N+ SOURCE
ILD 318
POLY
312 320
SILICIDE
PWELL
GATE OXIDE
315
314
P-TYPE PLUG
ILD
POLY
N+ SOURCE    309
PWELL        304
N- DRIFT LAYER
GATE OXIDE   P-TYPE PLUG
312
318
316
314
302
N+ SUBSTRATE    SILICIDE    301
320

FIG. 11FF

316
N+ SOURCE
ILD
POLY
312 320
SILICIDE
PWELL
GATE OXIDE
315
314
P-TYPE PLUG
METAL
(Source Interconnect) 322
ILD
N+ SOURCE    309
PWELL        304
N- DRIFT LAYER
DEVICE PERIPHERY
GATE OXIDE   P-TYPE PLUG
312
METAL
(Gate Interconnect)
318  322
316
314
302
N+ SUBSTRATE    SILICIDE 320    301
METAL

FIG. 11GG

410
PWELL
ILD
POLY
SILICIDE
P-TYPE
PLUG
P-WELL#2
GATE OXIDE   N+ SOURCE
407
METAL
(Source Interconnect)
ILD          409
POLY         408
N+ SOURCE    404
PWELL        403
405
N- DRIFT LAYER
DEVICE PERIPHERY
GATE OXIDE   P-TYPE PLUG
METAL
(Gate Interconnect)
412
406
402
N+ SUBSTRATE    SILICIDE 411    401
METAL        412

FIG. 12

FIG. 13A

FIG. 13B

FIG. 13C

FIG. 13D

FIG. 13E

503

506
PWELL 504

N- DRIFT LAYER 502

N+ SUBSTRATE 501

FIG. 13F

Etch-back 507

503

506
PWELL 504

N- DRIFT LAYER 502

N+ SUBSTRATE 501

FIG. 13G

SIDEWALL SPACER
506
503

PWELL 504

N- DRIFT LAYER 502

N+ SUBSTRATE 501

FIG. 13H

SIDEWALL SPACER
506
503

508
PWELL 504

N- DRIFT LAYER 502

N+ SUBSTRATE 501

FIG. 13I

N-type Implant 509

SIDEWALL SPACER
506
503

508
PWELL 504

N- DRIFT
LAYER 502

N+ SUBSTRATE 501

FIG. 13J

SIDEWALL SPACER
506

503

508

N+ SOURCE 510
PWELL 504

504

511

P-WELL#2

N- DRIFT
LAYER

502

N+ SUBSTRATE

501

FIG. 13K

N+ SOURCE 510
PWELL 504

504

511

P-WELL#2

N- DRIFT LAYER

502

N+ SUBSTRATE

501

FIG. 13L

512

N+ SOURCE 510
PWELL 504

504

511

P-WELL#2

N- DRIFT LAYER

502

N+ SUBSTRATE

501

FIG. 13M

512

512

N+ SOURCE 510
PWELL 504

511

P-WELL#2

N- DRIFT LAYER

502

N+ SUBSTRATE

501

FIG. 13N

P-type Implant

513

512

512

N+ SOURCE 510
PWELL 504

511

P-WELL#2

N- DRIFT
LAYER

502

N+ SUBSTRATE

501

FIG. 13O

FIG. 13P

FIG. 13Q

FIG. 13R

FIG. 13S

FIG. 13T

FIG. 13U

FIG. 13V

FIG. 13W

FIG. 13X

FIG. 13Y

FIG. 13Z

**FIG. 13AA**

519
ILD
POLY
520
PWELL
514
GATE OXIDE 515
P-TYPE PLUG
N+ SOURCE
P-WELL#2
519
ILD 518
POLY 516
N+ SOURCE 510
PWELL 504
511
GATE OXIDE
P-TYPE PLUG 514
N- DRIFT LAYER 502
N+ SUBSTRATE 501

**FIG. 13BB**

ILD
POLY
520
PWELL
514
GATE OXIDE 515
P-TYPE PLUG
N+ SOURCE
P-WELL#2
ILD 518
POLY 516
N+ SOURCE 510
PWELL 504
511
GATE OXIDE
P-TYPE PLUG 514
N- DRIFT LAYER 502
N+ SUBSTRATE 501

**FIG. 13CC**

521 SILICIDE
ILD
POLY
520
PWELL
514
GATE OXIDE 515
P-TYPE PLUG
N+ SOURCE
P-WELL#2
ILD 518
POLY 516
N+ SOURCE 510
PWELL 504
511
515
GATE OXIDE
P-TYPE PLUG 514
N- DRIFT LAYER 502
N+ SUBSTRATE
SILICIDE 521
501

**FIG. 13DD**

521 SILICIDE
522
ILD
POLY
520
PWELL
514
GATE OXIDE 515
P-TYPE PLUG
N+ SOURCE
P-WELL#2
ILD 518
POLY 516
N+ SOURCE 510
PWELL 504
511
515
GATE OXIDE
P-TYPE PLUG 514
N- DRIFT LAYER 502
N+ SUBSTRATE
521 SILICIDE
501

**FIG. 13EE**

521 SILICIDE
522
ILD
POLY
520
PWELL
514
GATE OXIDE 515
P-TYPE PLUG
N+ SOURCE
P-WELL#2
ILD 518
POLY 516
N+ SOURCE 510
PWELL 504
511
515
GATE OXIDE
P-TYPE PLUG 514
N- DRIFT LAYER 502
N+ SUBSTRATE
521 SILICIDE
501

**FIG. 13FF**

**FIG. 13GG**

**FIG. 14**

**FIG. 15A**

**FIG. 15B**

703

N- DRIFT LAYER

702

N+ SUBSTRATE

701

FIG. 15C

P-type Implant                                                    704

703

N- DRIFT LAYER                                                    702

N+ SUBSTRATE                                                      701

FIG. 15D

703

PWELL                                                            705

N- DRIFT LAYER                                                    702

N+ SUBSTRATE                                                      701

FIG. 15E

703                                                              706

PWELL                                                            705

N- DRIFT LAYER                                                    702

N+ SUBSTRATE                                                      701

FIG. 15F

Etch-back                                                         707

703                                                              706

PWELL                                                            705

N- DRIFT LAYER                                                    702

N+ SUBSTRATE                                                      701

FIG. 15G

706
SIDEWALL SPACER

703

PWELL 705

N- DRIFT LAYER 702

N+ SUBSTRATE 701

FIG. 15H

706
SIDEWALL SPACER

703 708 708

PWELL 705

N- DRIFT LAYER 702

N+ SUBSTRATE 701

FIG. 15I

N-type Implant 709

SIDEWALL SPACER
706

703 708 708

PWELL 705

N- DRIFT LAYER 702

N+ SUBSTRATE 701

FIG. 15J

SIDEWALL SPACER
706

703 708 708

N+ SOURCE 710 705
PWELL

N+ SOURCE

N- DRIFT LAYER 702

N+ SUBSTRATE 701

FIG. 15K

N+ SOURCE 710 705
PWELL

N+ SOURCE

N- DRIFT LAYER 702

N+ SUBSTRATE 701

FIG. 15L

711
N+ SOURCE 710
PWELL 705
N+ SOURCE

N- DRIFT LAYER 702

N+ SUBSTRATE 701

FIG. 15M

711
711
N+ SOURCE 710
PWELL 705
N+ SOURCE

N- DRIFT LAYER 702

N+ SUBSTRATE 701

FIG. 15N

P-type Implant 712
↓ ↓ ↓ ↓ ↓ ↓ ↓ ↓ ↓ ↓ ↓ ↓ ↓ ↓ ↓ ↓ ↓ ↓

711
711
N+ SOURCE 710
PWELL 705
N+ SOURCE

N- DRIFT LAYER 702

N+ SUBSTRATE 701

FIG. 15O

711 PWELL
711
N+ SOURCE 710
PWELL 705
713
P-TYPE PLUG
N+ SOURCE
P-TYPE PLUG 713

N- DRIFT LAYER 702

N+ SUBSTRATE 701

FIG. 15P

PWELL
N+ SOURCE 710
PWELL 705
713
P-TYPE PLUG
N+ SOURCE
P-TYPE PLUG 713

N- DRIFT LAYER 702

N+ SUBSTRATE 701

FIG. 15Q

PWELL

713
GATE
OXIDE
714  N+ SOURCE
P-TYPE PLUG

N+ SOURCE   710
PWELL   705

P-TYPE PLUG   713

N- DRIFT LAYER   702

N+ SUBSTRATE   701

FIG. 15R

PWELL

POLY   715

713
GATE
OXIDE
714  N+ SOURCE
P-TYPE PLUG

N+ SOURCE  710
PWELL   705

P-TYPE PLUG   713

N- DRIFT LAYER   702

N+ SUBSTRATE   701

FIG. 15S

716
PWELL
716
POLY   715

713
GATE
OXIDE
714  N+ SOURCE
P-TYPE PLUG

N+ SOURCE  710
PWELL   705

P-TYPE PLUG   713

N- DRIFT LAYER   702

N+ SUBSTRATE   701

FIG. 15T

716
POLY
PWELL
716
POLY   715

713
GATE
OXIDE
714  N+ SOURCE
P-TYPE PLUG

N+ SOURCE  710
PWELL   705

P-TYPE PLUG   713

N- DRIFT LAYER   702

N+ SUBSTRATE   701

FIG. 15U

POLY
PWELL
POLY   715

714
GATE
OXIDE
714  N+ SOURCE
P-TYPE PLUG

N+ SOURCE  710
PWELL   705

P-TYPE PLUG   714

N- DRIFT LAYER   702

N+ SUBSTRATE   701

FIG. 15V

PWELL

ILD   717
POLY
POLY   715

713
GATE
OXIDE
714  N+ SOURCE
P-TYPE PLUG

N+ SOURCE  710
PWELL   705

P-TYPE PLUG   713

N- DRIFT LAYER   702

N+ SUBSTRATE   701

FIG. 15W

FIG. 15X

FIG. 15Y

FIG. 15Z

FIG. 15AA

FIG. 15BB

FIG. 15CC

FIG. 15DD

FIG. 15EE

FIG. 15FF

FIG. 16

N- DRIFT LAYER      902

N+ SUBSTRATE      901

FIG. 17A

903

N- DRIFT LAYER      902

N+ SUBSTRATE      901

FIG. 17B

903

N- DRIFT LAYER      902

N+ SUBSTRATE      901

FIG. 17C

P-type Implant      904

903

N- DRIFT LAYER      902

N+ SUBSTRATE      901

FIG. 17D

903

PWELL      905

N- DRIFT LAYER      902

N+ SUBSTRATE      901

FIG. 17E

903      906

PWELL      905

N- DRIFT LAYER      902

N+ SUBSTRATE      901

FIG. 17F

Etch-back                                        907

PWELL 905

N- DRIFT LAYER 902

N+ SUBSTRATE 901

**FIG. 17G**

SIDEWALL SPACER 906

PWELL 905

N- DRIFT LAYER 902

N+ SUBSTRATE 901

**FIG. 17H**

SIDEWALL SPACER 906

908 908

PWELL 905

N- DRIFT LAYER 902

N+ SUBSTRATE 901

**FIG. 17I**

N-type Implant 909

SIDEWALL SPACER 906

908 908

PWELL 905

N- DRIFT
LAYER 902

N+ SUBSTRATE 901

**FIG. 17J**

SIDEWALL SPACER 906

908 908

N+ SOURCE 910

PWELL 905

N+ SOURCE

N- DRIFT LAYER 902

N+ SUBSTRATE 901

**FIG. 17K**

N+ SOURCE 910

PWELL 905

N+ SOURCE

N- DRIFT
LAYER 902

N+ SUBSTRATE 901

**FIG. 17L**

911
N+ SOURCE 910
PWELL 905
N+ SOURCE
N- DRIFT LAYER 902
N+ SUBSTRATE 901

FIG. 17M

911
911
N+ SOURCE 910
PWELL 905
N+ SOURCE
N- DRIFT LAYER 902
N+ SUBSTRATE 901

FIG. 17N

P-type Implant 912

911
911
N+ SOURCE 910
PWELL 905
N+ SOURCE
N- DRIFT LAYER 902
N+ SUBSTRATE 901

FIG. 17O

911
911
N+ SOURCE 910
PWELL
913
P-TYPE PLUG
PWELL 905
P-TYPE PLUG 913
N+ SOURCE
N- DRIFT LAYER 902
N+ SUBSTRATE 901

FIG. 17P

913
P-TYPE PLUG
PWELL
N+ SOURCE 910
PWELL 905
P-TYPE PLUG 913
N+ SOURCE
N- DRIFT LAYER 902
N+ SUBSTRATE 901

FIG. 17Q

PWELL
913
P-TYPE PLUG
N+ SOURCE 910
PWELL 905
P-TYPE PLUG 913
GATE INSULATOR 914
N+ SOURCE
N- DRIFT LAYER 902
N+ SUBSTRATE 901

FIG. 17R

POLY 915
913
N+ SOURCE 910
P-TYPE
PLUG
PWELL 905
P-TYPE PLUG 913
GATE
INSULATOR
914
N+ SOURCE
N- DRIFT LAYER 902
N+ SUBSTRATE 901

FIG. 17S

916      916      916      916      916
POLY
915
913
N+ SOURCE 910
P-TYPE
PLUG
PWELL 905
P-TYPE PLUG 913
GATE
INSULATOR
914
N+ SOURCE
N- DRIFT
LAYER 902
N+ SUBSTRATE 901

FIG. 17T

916      916      916      916      916
POLY 915   POLY 915  POLY 915  POLY 915  POLY 915
913
N+ SOURCE 910
P-TYPE
PLUG
PWELL 905
P-TYPE PLUG 913
GATE
INSULATOR
914
N+ SOURCE
N- DRIFT LAYER 902
N+ SUBSTRATE 901

FIG. 17U

916      916      916      916      916
POLY 915   POLY 915  POLY 915  POLY 915  POLY 915
913
N+ SOURCE 910
P-TYPE
PLUG
PWELL 905
P-TYPE
PLUG 913
GATE
INSULATOR  GATE       GATE       GATE      GATE 902
914        INSULATOR  INSULATOR  INSULATOR INSULATOR
N+ SOURCE
N- DRIFT LAYER
N+ SUBSTRATE 901

FIG. 17V

POLY 915   POLY 915  POLY 915  POLY 915  POLY 915
913
N+ SOURCE 910
P-TYPE
PLUG
PWELL 905
P-TYPE
PLUG 913
GATE
INSULATOR  GATE       GATE       GATE      GATE 902
914        INSULATOR  INSULATOR  INSULATOR INSULATOR
N+ SOURCE
N- DRIFT LAYER
N+ SUBSTRATE 901

FIG. 17W

915        915        917 915    915       915
POLY       POLY       POLY       POLY      POLY
913
N+ SOURCE 910
P-TYPE
PLUG
PWELL 905
P-TYPE
PLUG 913
GATE
INSULATOR  GATE       GATE       GATE      GATE 902
914        INSULATOR  INSULATOR  INSULATOR INSULATOR
N+ SOURCE
N- DRIFT LAYER
N+ SUBSTRATE 901

FIG. 17X

FIG. 17Y

FIG. 17Z

FIG. 17AA

FIG. 17BB

FIG. 17CC

FIG. 17DD

FIG. 17EE

FIG. 17FF

Source Interconnect Metallization **208**

207  ILD

Part of
MOSFET  **210**

206 Polysilicon Gate

**210**

Channel on
vertical
sidewall

207  ILD

206 Polysilicon Gate

203

204 N+ Source

Plug

P+ **209**

N+ Source **204**

203

Gate Oxide
**205**

P-Well

P-Well

Gate Oxide
**205**

N- Drift Layer

**202**

N+ Substrate

**201**

FIG. 18

N-

**302**

N+

**301**

FIG. 19A

Hard Mask

**303**

N-

**302**

N+

**301**

FIG. 19B

H.M
**303**

H.M
**303**

N-

**302**

N+

**301**

FIG. 19C

P-type
Implant

↓ ↓ ↓ ↓ ↓ ↓ ↓ ↓ ↓ ↓ ↓ ↓ ↓ ↓ ↓ 304

H.M
303

N-                                                    302

N+                                                    301

FIG. 19D

H.M
303

P-
WELL                          305

N-                                                    302

N+                                                    301

FIG. 19E

H.M.306                                      H.M.306

PW                           305

N-                                                    302

N+                                                    301

FIG. 19F

308 PW Trench        Etch into the        307
                     substrate

306H.M.              ↓ ↓ ↓ ↓ ↓ ↓ ↓ ↓ ↓ ↓ ↓ ↓      H.M.306

PW                            305

N-                                                    302

N+                                                    301

FIG. 19G

↓ ↓ ↓ ↓ ↓ ↓ ↓ ↓ ↓ ↓ ↓ ↓ ↓ 309

308 PW Trench        N-type
                     Implant

306H.M.                                      H.M.306

SRG                          310

PW                           305

N-                                                    302

N+                                                    301

FIG. 19H

308 PW Trench

| | |
|---|---|
| SRC | 310 |
| PW | 305 |

N-    302

N+    301

FIG. 19I

308 PW Trench

| | |
|---|---|
| H.M. | 311 |
| SRC | 310 |
| PW | 305 |

N-    302

N+    301

FIG. 19J

308 PW Trench

| 311 | H.M. | 311 |
|---|---|---|
| | SRC | 310 |
| | PW | 305 |

N-    302

N+    301

FIG. 19K

P-type Implant

312

308 PW Trench

311  H.M.          H.M.    311

SRC                  310

PW                   305

N-                   302

N+                   301

FIG. 19L

308 PW Trench

311 H.M.          H.M. 311

310 SRC    P+ Plug    SRC 310
                313
305  PW                PW 305

N-                   302

N+                   301

FIG. 19M

308 PW Trench

310  SRC    P+ Plug    SRC 310
                313
305   PW               PW 305

N-                   302

N+                   301

FIG. 19N

308 PW Trench

OXIDE 314

310 SRC

P+ Plug
313

SRC 310

305 PW

PW 305

N-

302

N+

301

FIG. 19O

308 PW Trench

POLY

315

OXIDE 314

310 SRC

P+ Plug
313

SRC 310

305 PW

PW 305

N-

302

N+

301

FIG. 19P

Mask 316

308 PW Trench

316 Mask

POLY 315

315 POLY

OXIDE 314

310 SRC

P+ Plug
313

SRC 310

305 PW

PW 305

N-

302

N+

301

FIG. 19Q

308 PW Trench

POLY 315

OXIDE 314

315 POLY

310 SRC

P+ Plug
313

SRC 310

305 PW

PW 305

N-

302

N+

301

FIG. 19R

ILD 317

308 PW Trench

317 ILD

POLY 315

OXIDE 314

315 POLY

310 SRC

P+ Plug
313

SRC 310

305 PW

PW 305

N-

302

N+

301

FIG. 19S

OXIDE 314

317

308 PW Trench

SILICIDE 318

317

POLY 315

315 POLY

310 SRC

P+ Plug
313

SRC 310

305 PW

PW 305

N-

302

SILICIDE 318

N+

301

FIG. 19T

OXIDE 314

ILD 317
308 RW Trench
POLY 315

SILICIDE 318

319

317
315 POLY

310 SRC
P+ Plug
313
SRC 310

305 PW
PW 305

N-
302

SILICIDE 318

N+
301

METAL
319

FIG. 19U

Source Interconnect Metallization 408

407 ILD
PW#2
407 ILD

406 Polysilicon Gate
406 Polysilicon Gate

PW 403
410
410
PW 403

Gate Oxide 405
404 N+ Source
411
PW#2
P+ Plug 409
N+ Source 404
PW#2
411
Gate Oxide 405

N- Drift Layer
402

N+ Substrate
401

FIG. 20

N-
502

N+
501

FIG. 21A

| | |
|---|---|
| Hard Mask | 503 |
| N- | 502 |
| N+ | 501 |

FIG. 21B

| | | |
|---|---|---|
| H.M 503 | | H.M 503 |
| | N- | 502 |
| | N+ | 501 |

FIG. 21C

P-type Implant

↓ ↓ ↓ ↓ ↓ ↓ ↓ ↓ ↓ ↓ ↓ ↓ ↓ 504

| | | |
|---|---|---|
| H.M 503 | | H.M 503 |
| | N- | 502 |
| | N+ | 501 |

FIG. 21D

FIG. 21E

FIG. 21F

FIG. 21G

FIG. 21H

FIG. 21I

FIG. 21J

FIG. 21K

FIG. 21L

FIG. 21M

508 PW Trench

505
PW.

512   H.M.          H.M.   512

510          P+   514          SRC   510
511          Plug          PW#2   511

N-          502

N+          501

FIG. 21N

508 PW Trench

505
PW.

510          P+   514          SRC   510
511          Plug          PW#2   511

N-          502

N+          501

FIG. 21O

508 PW Trench

OXIDE  515

505
PW.

510          P+   514          SRC   510
511          Plug          PW#2   511

N-          502

N+          501

FIG. 21P

FIG. 21Q

FIG. 21R

FIG. 21S

FIG. 21T

FIG. 21U

FIG. 21V

FIG. 22
PRIOR ART

FIG. 23A

FIG. 23B

FIG. 23C

FIG. 23D

FIG. 24A

Mask 303

N- 302

N+ 301

FIG. 24B

Mask 303

N- 302

N+ 301

FIG. 24C

p-type Implant

↓ ↓ ↓ ↓ ↓ ↓ ↓ ↓ ↓ ↓ ↓ ↓ ↓ 304

Mask 303

PWELL 305

302

N- 

N+ 301

FIG. 24D

FIG. 24E

FIG. 24F

FIG. 24G

p-type implant

307

| Mask | 306 | | Mask | 306 |

308

**PWELL** 305

302

**N-**

**N+** 301

FIG. 24H

308

**PWELL** 305

302

**N-**

**N+** 301

FIG. 24I

**Mask** 309

308

**PWELL** 305

302

**N-**

**N+** 301

FIG. 24J

FIG. 24K

n-type Implant

FIG. 24L

FIG. 24M

312
OXIDE

308

SOURCE 311

PWELL 305

302

N-

N+ 301

FIG. 24N

312
OXIDE

POLY 313

308

SOURC
E 311

PWELL 305

302

N-

N+ 301

FIG. 24O

312
OXIDE

POLY 313

308

SOURC
E 311

PWELL 305

302

N-

N+ 301

FIG. 24P

**312 OXIDE**

POLY 313

314

308

SOURCE 311

PWELL 305

302

N-

N+ 301

FIG. 24Q

**312 OXIDE**

314

POLY 313

306

SOURCE 311

PWELL 305

302

N-

N+ 301

FIG. 24R

**312 OXIDE**

ILD 314

POLY 313

306

SOURCE 311

PWELL 305

302

N-

N+ 301

FIG. 24S

FIG. 24T

FIG. 24U

FIG. 25A

FIG. 25B

FIG. 25C

FIG. 25D

N-                                      502

N+                                      501

FIG. 26A

Mask                                    503

N-                                      502

N+                                      501

FIG. 26B

Mask  503

N-                                      502

N+                                      501

FIG. 26C

p-type Implant

↓ ↓ ↓ ↓ ↓ ↓ ↓ ↓ ↓ ↓ ↓ ↓ ↓ ↓ 504

Mask 503

PWELL 505

502

N-

N+ 501

FIG. 26D

PWELL 505

502

N-

N+ 501

FIG. 26E

Mask 506

PWELL 505

502

N-

N+ 501

FIG. 26F

| Mask | 506 | | Mask | 506 |
|---|---|---|---|---|

PWELL 505

502

N- 

N+ 501

FIG. 26G

p-type implant

↓ ↓ ↓ ↓ ↓ ↓ ↓ ↓ ↓ ↓ ↓ ↓ ↓ ↓ 507

| Mask | 506 | | Mask | 506 |
|---|---|---|---|---|

508

PWELL 505

502

N-

N+ 501

FIG. 26H

508

PWELL 505

502

N-

N+ 501

FIG. 26I

Mask     509

508

PWELL     505

502

N-    

N+     501

FIG. 26J

Mask

508

PWELL     505

502

N-    

N+     501

FIG. 26K

n-type Implant

510

Mask 509

508

SOURCE     511

PWELL     505

502

N-    

N+     501

FIG. 26L

FIG. 26M

FIG. 26N

FIG. 26O

512
OXIDE

POLY 513

508

SOURCE 511

PWELL 505

502

N-

N+ 501

FIG. 26P

512
OXIDE

POLY 513

514

509

SOURCE 511

PWELL 505

502

N-

N+ 501

FIG. 26Q

514

512
OXIDE

POLY 513

508

SOURCE 511

PWELL 505

502

N-

N+ 501

FIG. 26R

FIG. 26S

FIG. 26T

FIG. 26U

FIG. 27 PRIOR ART

FIG. 28A

FIG. 28B

FIG. 28C

N-

302

N+

301

FIG. 29A

n-type implant

303

N-

302

N+

301

FIG. 29B

N-    302

N+    304

N-    302

N+

301

FIG. 29C

MASK
305

MASK
305

N-                          302

N+              304

N-

302

N+

301

FIG. 29D

p-type implant

306

MASK
305

MASK
305

N-                          302

N+              304

N-

302

N+

301

FIG. 29E

FIG. 29F

FIG. 29G

FIG. 29H

FIG. 29I

FIG. 29J

FIG. 29K

FIG. 29L

FIG. 30

N-

502

N+

501

FIG. 31A

n-type implant

503

N-

502

N+

501

FIG. 31B

| | |
|---|---|
| N- | 502 |
| N+ | 504 |
| N- | 502 |
| N+ | 501 |

FIG. 31C

| | |
|---|---|
| MASK 505 | MASK 505 |
| N- | 502 |
| N+ | 504 |
| N- | 502 |
| N+ | 501 |

FIG. 31D

FIG. 31E

FIG. 31F

FIG. 31G

FIG. 31H

FIG. 31I

FIG. 31J

FIG. 31K

FIG. 31L

METAL 2    606

METAL 1    605

N- 602

N

N

P+   N   603   P+   N   603   P+

604   N   604   N   604

N

N

N-

602

SILICIDE

607

N+   601

METAL 3    608

FIG. 32A

METAL 2    606

METAL 1    605

N- 602

N

P+   N   P+   N   P+

604   N   603   604   N   603   604

N

N-

602

SILICIDE

607

N+   601

METAL 3    608

FIG. 32B

FIG. 32C

FIG. 32D

FIG. 32E

FIG. 32F

EP 4 701 366 A1

FIG. 33AA

FIG. 33AB

181

N-     702a

N

N

N     704a

N

N

N-     702a

N+     701a

FIG. 33AC

MASK 705a     MASK 705a

N-     702a

N

N

N     704a

N

N

N-     702a

N+     701a

FIG. 33AD

FIG. 33AE

FIG. 33AF

FIG. 33AG

FIG. 33AH

FIG. 33AI

FIG. 33AJ

FIG. 33AK

FIG. 33AL

FIG. 33BA

FIG. 33BB

FIG. 33BC

FIG. 33BD

p-type implant

↓ ↓ ↓ ↓ ↓ ↓ ↓ ↓ ↓ ↓ ↓ 706b

MASK
705b

MASK
705b

N-                              702b

N

N

N                    704b

N

N-

702b

N+

701b

FIG. 33BE

MASK
705b

MASK
705b

N-  702b

N-  702b

N

N

N

N

P+          N  704b          P+          N  704b          P+

707b                707b                707b

N

N

N-

702b

N+

701b

FIG. 33BF

FIG. 33BG

FIG. 33BH

**METAL 2** 709b

**METAL 1** 708b

| | N- 702b | | P+ | | N- 702b | | P+ |
|---|---|---|---|---|---|---|---|
| P+ | N | | 707b | | N | | 707b |
| | N | | | | N | | |
| 707b | N 704b | | | | N 704b | | |
| | N | | | | N | | |

N-

702b

N+

701b

FIG. 33BI

**METAL 2** 709b

**METAL 1** 708b

| | N- 702b | | | | N- 702b | |
|---|---|---|---|---|---|---|
| P+ | N | | P+ | | N | P+ |
| | N | | | | N | |
| 707b | N 704b | | 707b | | N 704b | 707b |
| | N | | | | N | |

N-

702b

N+ 701b

FIG. 33BJ

FIG. 33BK

FIG. 33BL

N-

702e

N+

701e

FIG. 33EA

n-type implant

↓ ↓ ↓ ↓ ↓ ↓ ↓ ↓ ↓ ↓ ↓ 703e

N-

702e

N+

701e

FIG. 33EB

N-      702e

N

N

N      704e

N

N

N-      702e

N+      701e

FIG. 33EC

MASK 705e      MASK 705e

N-      702e

N

N

N      704e

N

N

N-      702e

N+      701e

FIG. 33ED

p-type implant

↓ ↓ ↓ ↓ ↓ ↓ ↓ ↓ ↓ ↓ ↓ 706e

MASK
705e

MASK
705e

N- 702e

N

N

N 704e

N

N

N-

702e

N+

701e

FIG. 33EE

MASK
705e

MASK
705e

| P | N- 702e | P | N- 702e | P |
| P | N | P | N | P |
| P | N | P | N | P |
| P 707e | N 704e | P 707e | N 704e 707e | P |
| P | N | P | N | P |
| P | N | P | N | P |

N-

702e

N+

701e

FIG. 33EF

FIG. 33EG

FIG. 33EH

| METAL 2 | 709e |
|---|---|
| METAL 1 | 708e |

| P | N- 702e | P | N- 702e | P |
|---|---|---|---|---|
| P | N | P | N | P |
| P | N | P | N | P |
| P 707e | N 704e | P 707e | N 704e | 707e P |
| P | N | P | N | P |
| P | N | P | N | P |

N-

702e

N+

701e

FIG. 33EI

| METAL 2 | 709e |
|---|---|
| METAL 1 | 708e |

| P | N- 702e | P | N- 702e | P |
|---|---|---|---|---|
| P | N | P | N | P |
| P | N | P | N | P |
| P 707e | N 704e | P 707e | N 704e | 707e P |
| P | N | P | N | P |
| P | N | P | N | P |

N-

702e

| N+ | 701e |
|---|---|

FIG. 33EJ

| METAL 2 | 709e |
| METAL 1 | 708e |

| P | N- 702e | P | N- 702e | P |
| P | N | P | N | P |
| P | N | P | N | P |
| P 707e | N 704e | P 707e | N 704e | 707e P |
| P | N | P | N | P |
| P | N | P | N | P |

N-

702e

SILICIDE
710e

N+        701e

FIG. 33EK

| METAL 2 | 709e |
| METAL 1 | 708e |

| P | N- 702e | P | N- 702e | P |
| P | N | P | N | P |
| P | N | P | N | P |
| P 707e | N 704e | P 707e | N 704e | 707e P |
| P | N | P | N | P |
| P | N | P | N | P |

N-

702e

SILICIDE
710e

N+        701e

| METAL 3 | 711e |

FIG. 33EL

EP 4 701 366 A1

N-

702f

N+

701f

FIG. 33FA

n-type implant

703f

N-

702f

N+

701f

FIG. 33FB

N-     702f

N

N

N     704f

N

N-     702f

N+     701f

FIG. 33FC

MASK     705f        MASK     705f

N-     702f

N

N

N     704f

N

N-     702f

N+     701f

FIG. 33FD

p-type implant

706f

MASK
705f

MASK
705f

| N- | | 702f |
|---|---|---|
| N | | |
| N | | |
| N | 704f | |
| N | | |

N-

702f

N+

701f

FIG. 33FE

MASK
705f

MASK
705f

| P | N- 702f | P | N- 702f | P |
|---|---|---|---|---|
| P | N | P | N | P |
| P | N | P | N | P |
| P 707f | N 704f | P 707f | N 704f | 707f P |
| P | N | P | N | P |
| P | | P | | P |

N-

702f

N+

701f

FIG. 33FF

| P | N– 702f | P | N– 702f | P |
|---|---|---|---|---|
| P | N | P | N | P |
| P | N | P | N | P |
| P 707f | N 704f | P 707f | N 704f | 707f P |
| P | N | P | N | P |
| P | | P | | P |

N–

702f

N+

701f

FIG. 33FG

| METAL 1 | | | 708f | |
|---|---|---|---|---|
| P | N– 702f | P | N– 702f | P |
| P | N | P | N | P |
| P | N | P | N | P |
| P 707f | N 704f | P 707f | N 704f | 707f P |
| P | N | P | N | P |
| P | | P | | P |

N–

702f

N+

701f

FIG. 33FH

| METAL 2 | 709f |
|---|---|
| METAL 1 | 708f |

| P | N- 702f | P | N- 702f | P |
|---|---|---|---|---|
| P | N | P | N | P |
| P | N | P | N | P |
| P 707f | N 704f | P 707f | N 704f | 707f P |
| P | N | P | N | P |
| P | | P | | P |

N-

702f

N+

701f

FIG. 33FI

| METAL 2 | 709f |
|---|---|
| METAL 1 | 708f |

| P | N- 702f | P | N- 702f | P |
|---|---|---|---|---|
| P | N | P | N | P |
| P | N | P | N | P |
| P 707f | N 704f | P 707f | N 704f | 707f P |
| P | N | P | N | P |
| P | | P | | P |

N-

702f

N+  701f

FIG. 33FJ

FIG. 33FK

FIG. 33FL

FIG. 34

N-

902

N+

901

FIG. 35A

n-type implant

↓ ↓ ↓ ↓ ↓ ↓ ↓ ↓ ↓ ↓ ↓ ↓ ↓ ↓ ↓ ↓ ↓ ↓ ↓ ↓ ↓ ↓

N-

902

N+

901

FIG. 35B

N-                                                                  902

N+                                                                  904

N-                                                                  902

N+                                                                  901

FIG. 35C

FIG. 35D

p-type implant

FIG. 35E

FIG. 35F

FIG. 35G

FIG. 35H

p-type implant

FIG. 35I

FIG. 35J

FIG. 35K

FIG. 35L

FIG. 35M

FIG. 35N

FIG. 35O

FIG. 35P

FIG. 36A

FIG. 36B

FIG. 36C

FIG. 36D

FIG. 37A

FIG. 37B

FIG. 38

FIG. 39A

1309 METAL1

1307 SILICIDE

1308 N+ SOURCE LAYER

1306 ILD

1305 N- DRIFT LAYER

1306 ILD

1307 SILICIDE

1304

1304

1307 SILICIDE

P+ GATE LAYER

N LAYER 1303

P+ GATE LAYER

N- DRIFT LAYER

1302

1307 SILICIDE

1301 N+ SUBSTRATE

1310 METAL 2

FIG. 39B

1309 METAL1

1307 SILICIDE

1308 N+ SOURCE LAYER

1306 ILD

1305 N- DRIFT LAYER

1306 ILD

1307 SILICIDE

1304

1304

1307 SILICIDE

P+ GATE LAYER

N LAYER 1303

P+ GATE LAYER

N- DRIFT LAYER

1302

1307 SILICIDE

1301 N+ SUBSTRATE

1310 METAL 2

FIG. 39C

FIG. 40A

FIG. 40B

**FIG. 40C**

**FIG. 41A**

1508
N+ SOURCE LAYER

N- DRIFT
LAYER

1502

1501    N+ SUBSTRATE

FIG. 41B

1508
N+ SOURCE LAYER

1502   N- DRIFT
LAYER

1504    N LAYER    1504

1503

P+ GATE LAYER    P+ GATE LAYER

N- DRIFT
LAYER

1502

1501    N+ SUBSTRATE

FIG. 41C

FIG. 41D

FIG. 41E

N- DRIFT
LAYER

1602

1601          N+ SUBSTRATE

FIG. 42A

| N+ | N- DRIFT LAYER | N+ | P+ | N+ | N- DRIFT LAYER | N+ |

1608          1605        1608  1604  1608      1605        1608
P-                                                          P-
WELL                    P-WELL                             WELL

1609                    1609        N LAYER              1609
                                    1603

N- DRIFT
1602          LAYER

1601          N+ SUBSTRATE

FIG. 42B

1611
1612 ILD
GATE METAL
GATE DIELECTRIC
1610

1612 ILD
GATE METAL
GATE DIELECTRIC
1611
1610

N+
N- DRIFT LAYER
N+
P+
N+
N- DRIFT LAYER
N+

1608
1605
1608 1604 1608
1605
1608

P-WELL
P-WELL
N LAYER
P-WELL

1609
1603
1609
1603
1609

N- DRIFT LAYER

1602

1601 N+ SUBSTRATE

FIG. 42C

1607 SILICIDE
1613 METAL 1
1607 SILICIDE

1611
1612 ILD
1607 SILICIDE
1612 ILD
1611

1610
GATE METAL
GATE DIELECTRIC
GATE METAL
GATE DIELECTRIC
1610

N+
N- DRIFT LAYER
N+
P+
N+
N- DRIFT LAYER
N+

1608
1605
1608 1604 1608
1605
1608

P-WELL
N LAYER
P-WELL
N LAYER
P-WELL

1609
1603
1609
1603
1609

N- DRIFT LAYER

1602

1607 SILICIDE

1601 N+ SUBSTRATE

1614 METAL 2

FIG. 42D

220

FIG. 43A

FIG. 43B

FIG. 44A

FIG. 44B

FIG. 45

FIG. 46

FIG. 47A

FIG. 47B

FIG. 47C

FIG. 47D

**FIG. 48A**

**FIG. 48B**

**FIG. 48C**

**FIG. 49A**

**FIG. 49B**

**FIG. 49C**

**FIG. 49D**

**FIG. 49E**

**FIG. 49F**

**FIG. 49G**

**FIG. 49H**

**FIG. 49I**

**FIG. 49J**

**FIG. 49K**

**FIG. 49L**

**FIG. 49M**

**FIG. 49N**

**FIG. 49O**

**FIG. 49P**

**FIG. 49Q**

**FIG. 49R**

EP 4 701 366 A1

**FIG. 49S**

**FIG. 49T**

229

FIG. 50A

FIG. 50B (Prior Art)

FIG. 50C (Prior art)

FIG. 50D (Prior Art)

EP 4 701 366 A1

**FIG. 51A**

**FIG. 51B**

**FIG. 52A**

231

505 | | 505

504

N-

502 | N+ Substrate

**FIG. 52B**

P-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓

505 | | 505

506 | P-WELL

504

N-

502 | N+ Substrate

**FIG. 52C**

506 | P-WELL

504

N-

502 | N+ Substrate

**FIG. 52D**

507 | 507 | 507

506 | P-WELL

504

N-

502 | N+ Substrate

**FIG. 52E**

N-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓

507                507                507

508  N+          508  N+

506              P-WELL

504
                  N-

502              N+ Substrate

**FIG. 52F**

508  N+          508  N+

506              P-WELL

504
                  N-

502              N+ Substrate

**FIG. 52G**

509                      509

508  N+          508  N+

506              P-WELL

504
                  N-

502              N+ Substrate

**FIG. 52H**

N-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

509                        509

508  N+              N+

506

P-WELL

510

504        N-

502        N+ Substrate

**FIG. 52I**

508  N+              N+

506

P-WELL

510

504        N-

502        N+ Substrate

**FIG. 52J**

514        GATE INSULATOR

508  N+              N+

506

P-WELL

510

504        N-

502        N+ Substrate

**FIG. 52K**

514  GATE INSULATOR        514  GATE INSULATOR

508  N+              N+

506

P-WELL

510

504        N-

502        N+ Substrate

**FIG. 52L**

**FIG. 52M**

**FIG. 52N**

**FIG. 52O**

**FIG. 52P**

**FIG. 52Q**

**FIG. 52R**

**FIG. 52S**

**FIG. 52T**

**FIG. 53A**

**FIG. 53B**

$V_{SD}$

Intrinsic P-N
diode

630 ◄

632 ◄

634 ◄

Anti-parallel
Schottky
diode

$I_{SD}$

Cross-over current

**FIG. 53C (Prior art)**

$V_{SD}$

Schottky diode
is inserted in
series with
intrinsic P-N
diode

638 ◄

Intrinsic P-N
diode

636

$I_{SD}$

**FIG. 53D**

704

N-

702        N+ Substrate

**FIG. 54A**

| 705 | | 705 |

704       N-

702    N+ Substrate

**FIG. 54B**

P-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

| 705 | | 705 |

706     P-WELL

704       N-

702    N+ Substrate

**FIG. 54C**

706     P-WELL

704       N-

702    N+ Substrate

**FIG. 54D**

| 707 | 707 | 707 |

706     P-WELL

704       N-

702    N+ Substrate

**FIG. 54E**

N-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

707          707          707
708  N+          708  N+
706
P-WELL

704          N-

702          N+ Substrate

**FIG. 54F**

708  N+          708  N+
706
P-WELL

704          N-

702          N+ Substrate

**FIG. 54G**

709          709
708  N+          708  N+
706
P-WELL

704          N-

702          N+ Substrate

**FIG. 54H**

P-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

709          709
708  N+    703  P+    708  N+
706
P-WELL

704          N-

702          N+ Substrate

**FIG. 54I**

**FIG. 54J**

**FIG. 54K**

**FIG. 54L**

**FIG. 54M**

**FIG. 54N**

**FIG. 54O**

**FIG. 54P**

**FIG. 54Q**

**FIG. 54R**

**FIG. 54S**

**FIG. 54T**

**FIG. 54U**

**FIG. 54V**

**FIG. 54W**

**FIG. 54X**

**FIG. 55A**

**FIG. 55B**

**FIG. 55C**

**FIG. 55D**

**FIG. 55E**

**FIG. 55F**

**FIG. 56A**

EP 4 701 366 A1

FIG. 56B

FIG. 56C

FIG. 56D

FIG. 56E

FIG. 56F

908 N+    908 N+
906
P-WELL
904
N-
902    N+ Substrate

**FIG. 56G**

909    909
908 N+    908 N+
906    P-WELL
904
N-
902    N+ Substrate

**FIG. 56H**

P-type Implant
↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

909    909
908 N+    P+903    908 N+
906
P-WELL
904
N-
902    N+ Substrate

**FIG. 56I**

908 N+    P+903    908 N+
906    P-WELL
904
N-
902    N+ Substrate

**FIG. 56J**

914    GATE INSULATOR
908 N+    P+ 903    908 N+
906    P-WELL
904
N-
902    N+ Substrate

**FIG. 56K**

914    GATE INSULATOR    914    GATE INSULATOR
908 N+    P+ 903    908 N+
906    P-WELL
904
N-
902    N+ Substrate

**FIG. 56L**

**FIG. 56M**

**FIG. 56N**

**FIG. 56O**

**FIG. 56P**

**FIG. 56Q**

**FIG. 56R**

**FIG. 56S**

**FIG. 56T**

**FIG. 57A**

**FIG. 57B**

P-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓ ↓

1005                                    1005

1006          P-WELL

1004

N-

1002          N+ Substrate

**FIG. 57C**

1006          P-WELL

1004

N-

1002          N+ Substrate

**FIG. 57D**

1007          1007          1007

1006          P-WELL

1004

N-

1002          N+ Substrate

**FIG. 57E**

N-type Implant

↓ ↓ ↓ ↓ ↓ ↓ ↓ ↓ ↓ ↓ ↓ ↓ ↓ ↓ ↓ ↓ ↓ ↓ ↓ ↓ ↓ ↓

1007          1007          1007

1008 N+          1008 N+

1006          P-WELL

1004

N-

1002          N+ Substrate

**FIG. 57F**

1008 N+          1008 N+

1006          P-WELL

1004

N-

1002          N+ Substrate

**FIG. 57G**

1009          1009

1008 N+          1008 N+

1006          P-WELL

1004

N-

1002          N+ Substrate

**FIG. 57H**

**FIG. 57I**

**FIG. 57J**

**FIG. 57K**

**FIG. 57L**

**FIG. 57M**

**FIG. 57N**

**FIG. 57O**

**FIG. 57P**

**FIG. 57Q**

**FIG. 57R**

**FIG. 57S**

**FIG. 57T**

**FIG. 58A**

**FIG. 58B**

**FIG. 58C**

**FIG. 58D**

**FIG. 58E**

**FIG. 58F**

**FIG. 58G**

**FIG. 58H**

**FIG. 58I**

P+

1108 N+          1108 N+

1106          P-WELL          1103

1104

N-

1102          N+ Substrate

**FIG. 58J**

P+

1114          GATE INSULATOR

1108 N+          1108 N+

1106          P-WELL          1103

1104

N-

1102          N+ Substrate

**FIG. 58K**

P+

1114 GATE INSULATOR          1114 GATE INSULATOR

1108 N+          1108 N+

1106          P-WELL          1103

1104

N-

1102          N+ Substrate

**FIG. 58L**

P+

1116          POLY

1114          GATE INSULATOR          1114          GATE INSULATOR

1108  N+          108  N+

1106          P-WELL          1103

1104

N-

1102          N+ Substrate

**FIG. 58M**

P+

1116          POLY          1116          POLY

1114 GATE INSULATOR          1114 GATE INSULATOR

1108 N+          1108  N+

1106          P-WELL          1103

1104

N-

1102          N+ Substrate

**FIG. 58N**

FIG. 58O

FIG. 58P

FIG. 58Q

FIG. 58R

**FIG. 58S**

**FIG. 58T**

**FIG. 59A**

**FIG. 59B**

**FIG. 59C**

**FIG. 59D**

FIG. 59E

FIG. 59F

**FIG. 59G**

**FIG. 60A**

**FIG. 60B**

**FIG. 60C**

**FIG. 60D**

**FIG. 60E**

**FIG. 60F**

**FIG. 60G**

**FIG. 60H**

**FIG. 60I**

**FIG. 60J**

**FIG. 60K**

**FIG. 60L**

**FIG. 60M**

**FIG. 60N**

**FIG. 60O**

FIG. 60P

FIG. 60Q

FIG. 60R

FIG. 60S

FIG. 60T

1404

N-

1402    N+ Substrate

**FIG. 61A**

1405                                    1405

1404

N-

1402    N+ Substrate

**FIG. 61B**

P-type Implant
↓ ↓ ↓ ↓ ↓ ↓ ↓ ↓ ↓ ↓ ↓ ↓ ↓ ↓ ↓ ↓ ↓ ↓ ↓ ↓ ↓ ↓

1405                                    1405

1406    P-WELL

1404

N-

1402    N+ Substrate

**FIG. 61C**

1406    P-WELL

1404

N-

1402    N+ Substrate

**FIG. 61D**

1407                                    1407

1406    P-WELL

1404

N-

1402    N+ Substrate

**FIG. 61E**

N-type Implant
↓ ↓ ↓ ↓ ↓ ↓ ↓ ↓ ↓ ↓ ↓ ↓ ↓ ↓ ↓ ↓ ↓ ↓ ↓ ↓ ↓ ↓

1407                                    1407

1408    N+

1406    P-WELL

1404

N-

1402    N+ Substrate

**FIG. 61F**

**FIG. 61G**

**FIG. 61H**

**FIG. 61I**

**FIG. 61J**

**FIG. 61K**

**FIG. 61L**

**FIG. 61M**

**FIG. 61N**

**FIG. 61O**

**FIG. 61P**

**FIG. 61Q**

**FIG. 61R**

**FIG. 61S**

**FIG. 61T**

**FIG. 62A**

**FIG. 62B**

271

P-type Implant

1505    1505

1506    P-WELL

1504

N-

1502    N+ Substrate

**FIG. 62C**

1506    P-WELL

1504

N-

1502    N+ Substrate

**FIG. 62D**

1507    1507

1506    P-WELL

1504

N-

1502    N+ Substrate

**FIG. 62E**

N-type Implant

1507    1507

1508    N+

1506    P-WELL

1504

N-

1502    N+ Substrate

**FIG. 62F**

1508    N+

1506    P-WELL

1504

N-

1502    N+ Substrate

**FIG. 62G**

1509    1509

1508    N+

1506    P-WELL

1504

N-

1502    N+ Substrate

**FIG. 62H**

P-type Implant    P+

1509                    1509

1508 N+    1508 N+

1506    P-WELL    1503

1504    N-

1502    N+ Substrate

**FIG. 62I**

P+

1508 N+    1508 N+

1506    P-WELL    1503

1504    N-

1502    N+ Substrate

**FIG. 62J**

P+

1514    GATE INSULATOR

1508 N+    1508 N+

1506    P-WELL    1503

1504    N-

1502    N+ Substrate

**FIG. 62K**

P+

1514 GATE INSULATOR    1514 GATE INSULATOR

1508 N+    1508 N+

1506    P-WELL    1503

1504    N-

1502    N+ Substrate

**FIG. 62L**

P+

1516    POLY

1514 GATE INSULATOR    1514 GATE INSULATOR

1508 N+    1508 N+

1506    P-WELL    1503

1504    N-

1502    N+ Substrate

**FIG. 62M**

**FIG. 62N**

**FIG. 62O**

**FIG. 62P**

**FIG. 62Q**

**FIG. 62R**

**FIG. 62S**

**FIG. 62T**

SECTION "A" — SECTION "B" — SECTION "A" — SECTION "B" — SECTION "A"

**FIG. 63**

**FIG. 64A**

**FIG. 64B**

**FIG. 64C**

276

**FIG. 64D**

**FIG. 64E**

**FIG. 64F**

**FIG. 64G**

FIG. 64H

FIG. 64I

FIG. 64J

FIG. 64K

**FIG. 64L**

**FIG. 64M**

**FIG. 64N**

**FIG. 64O**

**FIG. 64P**

**FIG. 64Q**

**FIG. 64R**

**FIG. 64S**

**FIG. 64T**

**FIG. 64U**

**FIG. 64V**

**FIG. 64W**

**FIG. 64X**

**FIG. 64Y**

**FIG. 64Z**

**FIG. 64AA**

**FIG. 64AB**

**FIG. 65**

**FIG. 66A**

**FIG. 66B**

**FIG. 66C**

406 PW#1    406 PW#1    406 PW#1    406 PW#1

N-

404

402    N+

**FIG. 66D**

407    407    407    407    407
HM#2   HM#2   HM#2   HM#2   HM#2

406 PW#1    406 PW#1    406 PW#1    406 PW#1

N-

404

402    N+

**FIG. 66E**

Etching into the SiC substrate.

↓ ↓ ↓ ↓ ↓ ↓ ↓ ↓ ↓ ↓ ↓ ↓ ↓ ↓ ↓ ↓ ↓ ↓ ↓ ↓ ↓ ↓

407    407    407    407    407
HM#2   HM#2   HM#2   HM#2   HM#2

PW#1   PW#1   PW#1   PW#1   PW
406    406    406    #1
406    410    410    410    406

N-

404

402    N+

**FIG. 66F**

P-type Implant    P-type Implant    P-type Implant    P-type Implant

407    407    407    407    407
HM#2   HM#2   HM#2   HM#2   HM#2

PW     PW#1   PW#1   PW#1   PW
#1     406    406    406    #1
412 PW#2   410   PW#2 412   412 PW#2   410   PW#2 412

N-

404

402    N+

**FIG. 66G**

**FIG. 66H**

**FIG. 66I**

**FIG. 66J**

**FIG. 66K**

**FIG. 66L**

**FIG. 66M**

**FIG. 66N**

**FIG. 66O**

**FIG. 66P**

**FIG. 66Q**

**FIG. 66R**

**FIG. 66S**

**FIG. 66T**

**FIG. 66U**

**FIG. 66V**

**FIG. 66W**

**FIG. 66X**

**FIG. 66Y**

**FIG. 66Z**

**FIG. 66AA**

**FIG. 67A (Prior Art)**

**FIG. 67B (Prior Art)**

**FIG. 67C (Prior Art)**

**FIG. 67D (Prior Art)**

# EUROPEAN SEARCH REPORT

Europäisches
Patentamt
European
Patent Office
Office européen
des brevets

**Application Number**

EP 25 18 8599

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/134402 A1 (YATSUO TSUTOMU [JP] ET AL) 28 May 2009 (2009-05-28) | 1-12,14, 15 | INV. H10D64/23 H10D30/66 H10D62/10 |
| Y | * Fig. 1 and associated text * | 13 | |
| | ----- | | |
| Y | US 2016/276443 A1 (KONO HIROSHI [JP]) 22 September 2016 (2016-09-22) * Fig. 1; paragraph [0036] - paragraph [0038] * | 13 | |
| | ----- | | |

**TECHNICAL FIELDS SEARCHED (IPC)**

H10D

The present search report has been drawn up for all claims

| Place of search | Date of completion of the search | Examiner |
|---|---|---|
| Munich | 20 January 2026 | Lantier, Roberta |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 18 8599

20-01-2026

| Patent document cited in search report | Publication date | Patent family member(s) | Publication date |
|---|---|---|---|
| US 2009134402 A1 | 28-05-2009 | CN 101065847 A | 31-10-2007 |
| | | EP 1814162 A1 | 01-08-2007 |
| | | JP 4604241 B2 | 05-01-2011 |
| | | JP 2006147789 A | 08-06-2006 |
| | | KR 20070083844 A | 24-08-2007 |
| | | US 2009134402 A1 | 28-05-2009 |
| | | WO 2006054394 A1 | 26-05-2006 |
| US 2016276443 A1 | 22-09-2016 | CN 105990439 A | 05-10-2016 |
| | | JP 2016174030 A | 29-09-2016 |
| | | TW 201635538 A | 01-10-2016 |
| | | US 2016276443 A1 | 22-09-2016 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 35269819
- US 43165519
- US 34276121
- US 37402519
- US 55024919
- US 23130121
- US 24265021
- US 77792820
- US 09930520
- US 67096319
- US 74180020
- US 94578120
- US 22789721
- US 22792121
- US 22793621
- US 22795121
- US 00701420
- US 63072473 A

- US 9899512 B2
- US 20190013312 A1
- WO 2011013042 A1, Daniele Caimi, Athanasios Dimoulas, Jean Fompeyrine, Chiara Marchiori, Christophe P. Rossel, Marilyne Sousa, Axelle M. Tapponnier, David J. Webb
- US 9318597 B2
- US 9876104 B2
- US 8436367 B1
- US 20180331174 A1, Tega
- EP 0899791 B1
- JP 2008541459 A
- US 9875332 B
- US 5731605 A
- US 5461250 A
- US 37402519 A
- US 94578120 A

### Non-patent literature cited in the description

- Key Reliability Issues for SiC Power MOSFETs. **A. LELIS** ; **D. HABERSAT** ; **R. GREEN** ; **E. MOORO**. ECS Transactions. the U.S. Army Research Laboratory, 2013, vol. 58, 87-93
- **B.J. BALIGA**. Advanced High-Voltage Power Device Concepts. Springer Press, 2011
- **R. HUANG et al.** Design and Fabrication of 1.2kV 4H-SiC DMOSFET. *2016 13th China International Forum on Solid State Lighting: International Forum on Wide Bandgap Semiconductors China (SSLChina: IFWS)*, 2016
- **R. HUANG et al.** *Design and Fabrication of 1.2 kV 4H-SiC DMOSFET*
- Challenges in SiC Power MOSFET Design. **KEVIN MATOCHA**. ISDRS 2007, December 12-14, 2007, College Park, MD, USA. GE Global Research Center - Semiconductor Technology Laboratory, 12 December 2007

- **B.J. BALIGA**. Silicon Carbide Power Devices. Springer Press, 2005, 234
- **B.J. BALIGA**. Silicon Carbide Power Devices. Springer Press, 2005, 235
- **T. KIMOTO** ; **J.A. COOPER**. Fundamentals of Silicon Carbide Technology. IEEE Press, 2014, 296
- **T. KIMOTO** ; **J.A. COOPER**. Fundamentals of Silicon Carbide Technology. IEEE Press, 2014, 320-324
- **M K YADAV** ; **K P PRADHAN** ; **P K SAHU**. A complete analytical potential based solution for a 4H-SiC MOSFET in nanoscale. 24 May 2016
- **HEYDARI, GHOLAMALI**. Re: Why are diodes connected anti-parallel across the MOSFET or IGBT in Inverter Module?. *Research gate*, 25 July 2013
- **T. KIMOTO** ; **J.A. COOPER**. Fundamentals of Silicon Carbide Technology. IEEE Press, 2014